(19) Europäisches Patentamt
European Patent Office
Office européen des brevets

(11) EP 2 288 026 A1

(12) # EUROPEAN PATENT APPLICATION

(43) Date of publication:
**23.02.2011 Bulletin 2011/08**

(51) Int Cl.:
***H03H 9/02*** *(2006.01)*

(21) Application number: **10178787.7**

(22) Date of filing: **30.05.2003**

(84) Designated Contracting States:
**AT BE BG CH CY CZ DE DK EE ES FI FR GB GR HU IE IT LI LU MC NL PT RO SE SI SK TR**

(30) Priority: **24.07.2002 JP 2002215614**
**19.02.2003 JP 2003041480**

(62) Document number(s) of the earlier application(s) in accordance with Art. 76 EPC:
**03291298.2 / 1 391 988**

(71) Applicant: **Murata Manufacturing Co., Ltd.**
**Kyoto 617-8555 (JP)**

(72) Inventors:
- **Nishiyama, Kenji**
  **Kyoto 617-8555 (JP)**
- **Nakao, Takeshi**
  **Kyoto 617-8555 (JP)**
- **Kadota, Michio**
  **Kyoto 617-8555 (JP)**

(74) Representative: **Thévenet, Jean-Bruno et al**
**Cabinet Beau de Loménie**
**158, rue de l'Université**
**75340 Paris Cédex 07 (FR)**

Remarks:
This application was filed on 23-09-2010 as a divisional application to the application mentioned under INID code 62.

(54) **Surface acoustic wave apparatus and manufacturing method therefor**

(57) A manufacturing method for a surface acoustic wave apparatus, comprises the steps of: preparing a piezoelectric substrate (41); forming an electrode (42) on the piezoelectric substrate; forming an insulating layer to cover the electrode (43); and planarizing a difference of the height of the insulating layer (43) between a portion where the electrode (42) is present and a portion where the electrode is not present.

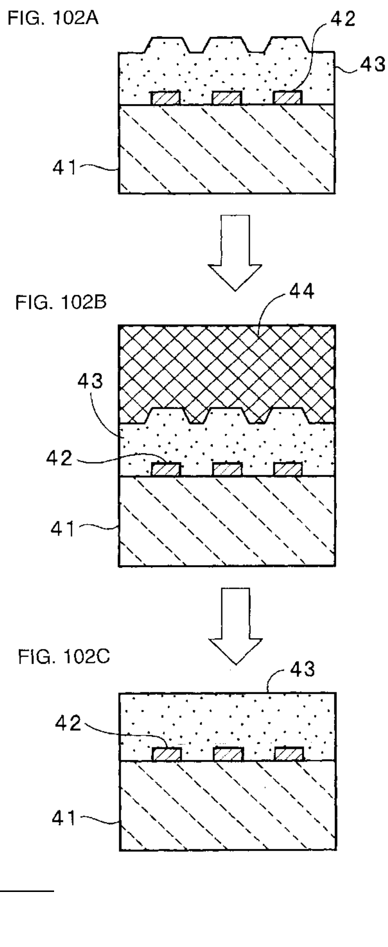


EP 2 288 026 A1

**Description**

BACKGROUND OF THE INVENTION

1. Field of the Invention

The present invention relates to a surface acoustic wave (SAW) apparatus used in, for example, resonators and bandpass filters, and also to a manufacturing method for this type of SAW apparatus. More specifically, the invention relates to a SAW apparatus having a structure in which an insulating layer is formed to cover an interdigital (IDT) electrode, and also to a manufacturing method for this type of SAW apparatus.

2. Description of the Related Art

It is demanded that DPX or RF filters used in mobile communications systems satisfy wide-band and good temperature characteristics. In known SAW apparatuses used in DPX or RF filters, piezoelectric substrates formed of 36° to 50°-rotated Y-cut X-propagating $LiTaO_3$ are used. This type of piezoelectric substrate has a temperature coefficient for the frequency (TCF) of about -40 to -30 ppm/°C. In order to improve the temperature characteristic, it is known that a $SiO_2$ film having a positive TCF is formed to cover an IDT electrode on a piezoelectric substrate. An example of a manufacturing method for this type of SAW apparatus is shown in Figs. 109A through 109D.

As shown in Fig. 109A, a resist pattern 52 is formed on a piezoelectric substrate 51, except for an area in which an IDT electrode is to be formed. Then, as shown in Fig. 109B, an electrode film 53, which serves as an IDT electrode, is formed on the entire surface of the piezoelectric substrate 51. Subsequently, by using a resist stripper, the resist pattern 52 and a metallic film attached on the resist pattern 52 are removed, thereby forming an IDT electrode 53A, as shown in Fig. 109C. Then, as shown in Fig. 109D, a $SiO_2$ film 54 is formed to cover the IDT electrode 53A.

For achieving an object other than an improvement in the TCF, another manufacturing method for a SAW apparatus in which an insulating or non-conductive protective film is formed to cover an IDT electrode is disclosed in Japanese Unexamined Patent Application Publication No. 11-186866 (document 1). Fig. 110 is a schematic sectional view illustrating a SAW apparatus 61 disclosed in this publication. In the SAW apparatus 61, an IDT electrode 63 made of Al or an alloy primarily including Al is disposed on an insulating substrate 62. In an area other than an area in which the IDT electrode 63 is disposed, an insulating or non-conductive inter-electrode-finger film 64 is formed. An insulating or non-conductive protective film 65 is also formed to cover the IDT electrode 63 and the inter-electrode-finger film 64. In the SAW apparatus 61 disclosed in this publication, the inter-electrode-finger film 64 and the protective film 65 are made of an insulating material, for example, $SiO_2$ or a non-conductive material, for example, silicone. By forming the inter-electrode-finger film 64, a characteristic deterioration of the SAW apparatus 61 due to discharging between the electrode fingers caused by a pyroelectric property unique to the piezoelectric substrate 62 can be suppressed.

Japanese Unexamined Patent Application Publication No. 61-136312 (document 2) discloses the following type of one-port SAW resonator. An electrode made of a metal, such as aluminum or gold, is disposed on a piezoelectric substrate made of quartz or lithium niobate. Then, after a $SiO_2$ film is formed, it is planarized. In this resonator, high resonance characteristics can be achieved by planarizing the $SiO_2$ film.

As shown in Figs. 109A through 109D, in the manufacturing method for a SAW apparatus in which the $SiO_2$ film 54 is formed for improving the TCF, the height of the $SiO_2$ film 54 is different between a portion with the IDT electrode 53A and a portion without the IDT electrode 53A. Accordingly, because of the difference in the height of the $SiO_2$ film 54, the insertion loss is increased. This difference in height is increased as the thickness of the IDT electrode 53A becomes larger. Thus, the thickness of the IDT electrode 53A cannot be increased.

In the SAW apparatus 61 disclosed in document 1, after the inter-electrode-finger film 64 is formed between the electrode fingers of the IDT electrode 63, the protective film 65 is formed. Accordingly, the height of the protective film 65 becomes the same, unlike the SAW apparatus shown in Figs. 109A through 109D.

In this configuration, however, since the inter-electrode-finger film 64 is formed in contact with the IDT electrode 63, which is made of Al or an alloy primarily including Al, a sufficient reflection coefficient cannot be obtained in the IDT electrode 63, thereby encouraging the generation of ripples in the resonance characteristic.

Also, in the manufacturing method disclosed in document 1, the resist formed on the inter-electrode-finger film 64 must be removed by a resist stripper before forming the protective film 65. In this case, the IDT electrode 63 may be disadvantageously eroded by the resist stripper. This requires the use of erosion-resistant metal for the IDT electrode 63, thereby decreasing the flexibility to select the type of metal forming the IDT electrode 63.

In the one-port SAW resonator disclosed in document 2, quartz or lithium niobate is used for the piezoelectric substrate, and the electrode is made of aluminum or gold. In the embodiment of this publication, however, an example in which an electrode made of Al is disposed on a quartz substrate is merely disclosed, and no specific reference is made to a SAW apparatus using a substrate made of another type of material or an electrode made of another type of metal.

Document 2 discloses that high resonance characteristics can be obtained by planarizing the $SiO_2$ film. Then, in order to obtain a wide-band filter, the present inventors formed a one-port SAW resonator having a structure similar to that disclosed in document 2, except that a $LiTaO_3$ substrate exhibiting a large electromechanical coupling coefficient was used as a piezoelectric substrate, and examined the characteristics of the one-port SAW filter. More specifically, an Al electrode was formed on the $LiTaO_3$ substrate, and then, a $SiO_2$ film was formed and the surface of the $SiO_2$ film was planarized. However, a considerable deterioration in the characteristics after the formation of the $SiO_2$ film was observed, and the present inventors found that this SAW resonator cannot be put to practical use.

By the use of a $LiTaO_3$ substrate or a $LiNbO_3$ substrate having a larger electromechanical coupling coefficient than quartz, the fractional bandwidth is considerably increased. However, after being committed to a study, the present inventors found that, after the formation of an Al electrode on a $LiTaO_3$ substrate and the formation of a $SiO_2$ film, the reflection coefficient was sharply decreased to about 0.02, as shown in Figs. 2 and 3, caused by the planarization of the $SiO_2$ film. Figs. 2 and 3 illustrate the relationship between the reflection coefficient and the thickness $H/\lambda$ of the IDT electrodes when the IDTs made of Al, Au, Pt, Cu, and Ag having various thickness values and a $SiO_2$ film were formed on a $LiTaO_3$ substrate having Euler angles (0°, 126°, 0°). The solid lines in Figs. 2 and 3 indicate the reflection coefficient when the surface of the $SiO_2$ film was not planarized, as schematically represented in Figs. 2 and 3. The broken lines indicate the reflection coefficient when the surface of the $SiO_2$ film was planarized.

Figs. 2 and 3 show that, when the Al electrode was used, the reflection coefficient is considerably decreased to about 0.02 by the planarization of the surface of the $SiO_2$ film, regardless of the thickness of the IDT electrode. Accordingly, a sufficient stop band cannot be achieved, causing the generation of sharp ripples in the vicinity of the antiresonant frequency.

It is known that the reflection coefficient becomes larger as the thickness of an electrode is increased. As is seen from Figs. 2 and 3, however, when an Al electrode is used and the surface of the $SiO_2$ film was planarized, the reflection coefficient is not increased as the thickness of the electrode is increased.

In contrast, as is seen from Fig. 2, by the use of the Au or Pt electrode, the reflection coefficient is increased as the thickness of the electrode is increased even when the surface of the $SiO_2$ film was planarized.

## SUMMARY OF THE INVENTION

After being committed to a study based on the above-described discovery, the present inventors have made the present invention. In view of the above background, it is an object of the present invention to provide a SAW apparatus in which an insulating layer is formed between electrode fingers of an IDT electrode and on the IDT electrode so as to exhibit a sufficiently large reflection coefficient of an IDT electrode and to suppress a characteristic deterioration caused by ripples generated in the resonance characteristic, resulting in a high resonance characteristic and a high filter characteristic, and also to provide a manufacturing method for such a SAW apparatus.

It is another object of the present invention to provide a SAW apparatus that exhibits improved characteristics, for example, a sufficiently large reflection coefficient of an IDT electrode, and that has a high flexibility to select the type of material forming the IDT electrode so as to decrease the possibility of erosion of the IDT electrode, and also to provide a manufacturing method for such a SAW apparatus.

It is still another object of the present invention to provide a SAW apparatus that exhibits improved characteristics, for example, a sufficiently large reflection coefficient of an IDT electrode, and decreases the possibility of erosion of the IDT electrode, and also that exhibits an improved temperature coefficient for the frequency (TCF), and also to provide a manufacturing method for such a SAW apparatus.

In order to achieve the above objects, according to a first aspect of the present invention, there is provided a SAW apparatus including: a piezoelectric substrate; at least one electrode formed on the piezoelectric substrate and made of a metal having a density higher than Al or an alloy primarily including the metal; a first insulating layer formed in an area other than an area in which the electrode is formed such that the first insulating layer has substantially the same thickness as the thickness of the electrode; and a second insulating layer formed to cover the electrode and the first insulating layer. The density of the electrode is 1.5 times or greater than that of the first insulating layer.

With this configuration, a sufficient reflection coefficient of the electrode can be obtained. Thus, ripples generated in the resonance characteristic or the antiresonance characteristic can be shifted outside the pass band, and the ripples themselves can be suppressed. The TCF is also improved. Additionally, since the height of the electrode is substantially the same as that of the first insulating layer, the insertion loss can be inhibited.

According to a second aspect of the present invention, there is provided a SAW apparatus including: a piezoelectric substrate; at least one electrode formed on the piezoelectric substrate; a protective metal film formed on the electrode and made of a metal or an alloy exhibiting a higher erosion-resistant characteristic than a metal or an alloy forming the electrode; a first insulating layer formed in an area other than an area in which the electrode is formed so that the thickness of the first insulating layer is substantially the same as the total thickness of the electrode and the protective metal film; and a second insulating layer formed to cover the protective metal film and the first insulating layer.

With this configuration, since the electrode is covered with the protective metal film and the first insulating layer, the erosion of the electrode by a resist stripper when removing a resist pattern according to a photolithographic technique can be suppressed.

In the second aspect of present invention, the average density of a laminated structure of the electrode and the protective metal film may be 1.5 times or greater than the density of the first insulating layer. With this arrangement, unwanted ripples appearing in the resonance characteristic or the filter characteristic are shifted outside the pass band, and resonance occurs.

In the first or second aspect of the present invention, the first and second insulating layers may be formed of $SiO_2$. It is thus possible to provide a SAW apparatus having an improved TCF.

In the first or second aspect of the present invention, the reflection of a SAW may be preferably utilized. The structure of a SAW apparatus utilizing the reflection of a SAW is not particularly restricted, and an end-face-reflection-type SAW apparatus utilizing the reflection of two opposing side faces of a piezoelectric substrate or a SAW apparatus provided with reflectors disposed to sandwich an electrode therebetween in the SAW propagating direction may be formed.

The SAW apparatus of the first or second aspect of the present invention can be used in various types of SAW resonators and SAW filters. The SAW resonator may be a one-port resonator or a two-port resonator, and the SAW filter may be a two-port resonator filter, a ladder filter, or a lattice filter.

In the first or second aspect of the present invention, the electrode may be an IDT electrode. The IDT electrode may be a unidirectional electrode, in which case, the insertion loss can be reduced. Alternatively, the electrode may be a reflector.

In the first or second aspect of the present invention, the piezoelectric substrate may be a $LiTaO_3$ substrate having Euler angles (0±3°, 104° to 140°, 0±3°); the first and second insulating layers may be formed of a $SiO_2$ film; the normalized thickness Hs/λ may range from 0.03 to 0.45 where Hs indicates a total thickness of the $SiO_2$ film forming the first and second insulating layers and λ represents the wavelength of a SAW; and the normalized thickness H/λ of the electrode may satisfy the following expression (1):

$$0.005 \le H/\lambda \le [(0.00025x\rho^2) - (0.01056x\rho) + (0.16473)] \qquad \text{Expression (1)}$$

where H indicates the thickness of the electrode, λ represents the wavelength of the SAW, and ρ represents the average density of the electrode.

As the metal forming the electrode, Au, Ag, Cu, W, Ta, Pt, Ni, or Mo may be used.

In the present invention, the electrode may be made of one of the above-described metals or an alloy primarily including such a metal, or formed of a laminated film including a primary metallic film made of one of the above-described metals or an alloy and at least one secondary metallic film made of another metal. In this case, according to the type of metal, the normalized thickness H/λ of the electrode, the Euler angles of the piezoelectric substrate, and the total normalized thickness Hs/λ of the first and second $SiO_2$ insulating layers are defined to specific ranges, thereby improving the electromechanical coupling coefficient, the reflection coefficient, and the TCF. The attenuation constant can also be reduced.

According to a third aspect of the present invention, there is provided a manufacturing method for the SAW apparatus according to the first aspect of the present invention. The manufacturing method includes the steps of: preparing a piezoelectric substrate; forming a first insulating layer on the entirety of one surface of the piezoelectric substrate; removing, by using a resist pattern for forming an electrode pattern including at least one electrode, the first insulating layer in an area in which the electrode is to be formed, and maintaining a laminated structure of the first insulating layer and the resist pattern in an area other than the area in which the electrode is to be formed; forming the electrode by forming an electrode film including a metal having a density higher than Al, or including an alloy primarily including the metal, in the area in which the first insulating layer is removed so that the thickness of the electrode film becomes substantially the same as the thickness of the first insulating layer; removing the resist pattern remaining on the first insulating layer; and forming a second insulating layer to cover the first insulating layer and the electrode.

With this configuration, since the second insulating layer is formed to cover the first insulating layer and the electrode, there is substantially no difference in the height of the top surface of the second insulating layer, thereby reducing the insertion loss. Additionally, since the electrode is made of a metal or an alloy having a density higher than Al, the reflection coefficient of the electrode can be improved, thereby suppressing a characteristic deterioration caused by unwanted ripples.

In the manufacturing method of the third aspect of the present invention, the density of the metal or the alloy forming the electrode may be 1.5 times or greater than that of the first insulating layer. With this arrangement, unwanted ripples appearing in the resonance characteristic or the filter characteristic are shifted outside the pass band, and resonance occurs.

According to a fourth aspect of the present invention, there is provided a manufacturing method for the SAW apparatus of the second aspect of the present invention. The manufacturing method includes the steps of: preparing a piezoelectric substrate; forming a first insulating layer on the entirety of one surface of the piezoelectric substrate; removing, by using a resist pattern for forming at least one electrode, the first insulating layer in an area in which the electrode is to be formed, and maintaining a laminated structure of the first insulating layer and the resist pattern in an area other than the area in which the electrode is to be formed; forming the electrode by forming a metal or an alloy in the area in which the first insulating layer is removed; forming, after the formation of the electrode, a protective metal film made of a metal or an alloy exhibiting a higher erosion-resistant characteristic than the metal or the alloy forming the electrode on the entire surface of the electrode so that the height of the protective metal film becomes substantially the same as the height of the first insulating layer; removing the resist pattern on the first insulating layer and the protective metal film; and forming a second insulating layer to cover the protective metal film formed on the electrode and the first insulating layer.

With this configuration, in the step of removing the resist pattern on the first insulating layer and the protective metallic film, since the side surfaces of the electrode are covered with the first insulating layer and the top surface is covered with the protective metal film, the erosion of the electrode can be suppressed.

In the fourth aspect of the present invention, the metal or the alloy forming the electrode, and the metal or the alloy forming the protective metal film, may be selected so that the average density of the laminated structure of the electrode and the protective metal film becomes 1.5 times or greater than the density of the first insulating layer. With this arrangement, unwanted ripples appearing in the resonance characteristic or the filter characteristic are shifted outside the pass band, and resonance occurs.

According to a fifth aspect of the present invention, there is provided a manufacturing method for a SAW apparatus. The manufacturing method includes the steps of: preparing a piezoelectric substrate; forming an electrode on the piezoelectric substrate; forming an insulating layer to cover the electrode; and planarizing a difference of the height of the insulating layer between a portion with the electrode and a portion without the electrode. Accordingly, a characteristic deterioration caused by the difference of the height of the top surface of the insulating layer can be suppressed.

In the fifth aspect of the present invention, the planarizing step may preferably be performed by an etch back process, a reverse sputtering process, or a polishing process.

The above and other objects, features and advantages of the present invention will become clear from the following description of preferred embodiments thereof, given by way of example, illustrated with reference to the appended drawings, in which:

## BRIEF DESCRIPTION OF THE DRAWINGS

Figs. 1A through 1G are partial sectional views schematically illustrating a manufacturing method for a SAW apparatus according to a first embodiment of the present invention;

Fig. 2 illustrates the relationship between the reflection coefficient and the electrode thickness when the surface of a $SiO_2$ film is planarized and when the surface of the $SiO_2$ film is not planarized in a one-port SAW resonator in which IDT electrodes made of aluminum (Al), Gold (Au), or platinum (Pt) having various thickness values and the $SiO_2$ film having a normalized thickness of 0.2 are formed on a $LiTaO_3$ substrate having Euler angles (0°, 126°, 0°);

Fig. 3 illustrates the relationship between the reflection coefficient and the electrode thickness when the surface of a $SiO_2$ film is planarized and when the surface of the $SiO_2$ film is not planarized in a one-port SAW resonator in which IDT electrodes made of Al, copper (Cu), or silver (Ag) having various thickness values and the $SiO_2$ film having a normalized thickness of 0.2 are formed on a $LiTaO_3$ substrate having Euler angles (0°, 126°, 0°);

Fig. 4 illustrates the impedance characteristic and the phase characteristic with respect to the frequency when the $SiO_2$ film of a SAW resonator formed by a manufacturing method of a first comparative example was changed;

Fig. 5 illustrates the relationship between the Figure of Merit (MF) of the resonator and the normalized thickness of the $SiO_2$ film of the SAW resonator of the first comparative example;

Fig. 6 is a schematic plan view illustrating a one-port SAW resonator obtained by the manufacturing method shown in Figs. 1A through 1G;

Fig. 7 illustrates the impedance characteristic and the phase characteristic with respect to the frequency when the $SiO_2$ film of the SAW resonator obtained by the manufacturing method of the first embodiment was changed;

Fig. 8 illustrates the relationship of $\gamma$ to the normalized thickness of the $SiO_2$ film of the SAW resonator obtained by the manufacturing method of the first embodiment and that of the first comparative example;

Fig. 9 illustrates the relationship of the MF to the normalized thickness of the $SiO_2$ film of the SAW resonator obtained by the manufacturing method of the first embodiment and that of the first comparative example;

Fig. 10 illustrates the relationship between the temperature coefficient for the frequency (TCF) and the normalized thickness of the $SiO_2$ film of the SAW resonator obtained by the manufacturing method of the first embodiment and that of the first comparative example;

Fig. 11 illustrates the impedance characteristic and the phase characteristic with respect to the frequency of a SAW resonator with a $SiO_2$ film, and a SAW resonator without a $SiO_2$ film, both manufactured by a second comparative example;

Figs. 12A through 12E illustrate the impedance characteristic with respect to the frequency when the ratio of the average density of the IDT electrode and the protective metal film to the density of the first insulating layer was changed;

Fig. 13 illustrates a change in the electromechanical coupling coefficient when IDT electrodes made of various metals having various thickness values were formed on a $LiTaO_3$ substrate having Euler angles (0°, 126°, 0°);

Fig. 14 illustrates the relationship of the range of the electrode normalized thickness that exhibits greater electromechanical coupling coefficients than Al to the density of the corresponding electrode when IDTs made of various metals were formed on a $LiTaO_3$ substrate;

Fig. 15 is a plan view illustrating a SAW apparatus according to a second embodiment of the present invention;

Fig. 16 illustrates the relationship between the electromechanical coupling coefficient and the normalized thickness of IDTs when the IDTs made of Au, Ta, Ag, Cr, W, Cu, Zn, Mo, Ni, and Al were formed on a 36°-rotated Y-cut X-propagating $LiTaO_3$ substrate having Euler angles (0°, 126°, 0°);

Fig. 17 illustrates the relationship between the reflection coefficient of a single electrode finger and the normalized thickness of the IDTs of IDTs made of various electrode materials on a 36°-rotated Y-cut X-propagating $LiTaO_3$ substrate having Euler angles (0°, 126°, 0°);

Fig. 18 illustrates the relationship between the attenuation constant $\alpha$ and the normalized thickness of IDTs when the IDTs made of Au, Ta, Ag, Cr, W, Cu, Zn, Mo, Ni, and Al were formed on a 36°-rotated Y-cut X-propagating $LiTaO_3$ substrate having Euler angles (0°, 126°, 0°);

Fig. 19 illustrates a change in the TCF with respect to the normalized thickness of a $SiO_2$ film when an Au IDT having a normalized thickness of 0.02 was formed on a 36°-rotated Y-cut X-propagating LiTaO3 substrate having Euler angles (0°, 126°, 0°);

Fig. 20 illustrates a change in the attenuation constant $\alpha$ with respect to the normalized thickness of a $SiO_2$ film when Au IDTs having various thickness values were formed on a 36°-rotated Y-cut X-propagating $LiTaO_3$ substrate having Euler angles (0°, 126°, 0°);

Fig. 21 illustrates a change in the attenuation constant $\alpha$ with respect to the normalized thickness of a $SiO_2$ film when Au IDTs having various thickness values were formed on a 38°-rotated Y-cut X-propagating $LiTaO_3$ substrate having Euler angles (0°, 128°, 0°);

Fig. 22 illustrates the attenuation-vs.-frequency characteristics of the SAW apparatus of the first embodiment before and after a $SiO_2$ film was formed;

Fig. 23 illustrates a change in the acoustic velocity of a leaky SAW with respect to the normalized thickness of an Au IDT when the Au IDT and $SiO_2$ films having various thickness values were formed on a 36°-rotated Y-cut X-propagating $LiTaO_3$ substrate having Euler angles (0°, 126°, 0°);

Fig. 24 illustrates a change in the acoustic velocity of a leaky SAW with respect to the normalized thickness of a $SiO_2$ film when Au IDTs having various thickness values and the $SiO_2$ film were formed on a 36°-rotated Y-cut X-propagating $LiTaO_3$ substrate having Euler angles (0°, 126°, 0°);

Fig. 25 illustrates a change in the electromechanical coupling coefficient with respect to $\theta$ of Euler angles (0°, $\theta$, 0°) when the normalized thickness of an Au IDT and the normalized thickness of a $SiO_2$ film were changed;

Fig. 26 illustrates a change in the Q factor with respect to $\theta$ of Euler angles (0° , $\theta$, 0°) when the normalized thickness of a $SiO_2$ film was changed;

Figs. 27A through 27C are schematic sectional views illustrating a SAW apparatus of a modified example of the present invention provided with a contact layer;

Fig. 28 illustrates a change in the attenuation constant $\alpha$ with respect to $\theta$ of Euler angles (0°, $\theta$, 0°) when the normalized thickness of a $SiO_2$ film was 0.1 and when Au electrodes having various thickness values were formed;

Fig. 29 illustrates a change in the attenuation constant $\alpha$ with respect to $\theta$ of Euler angles (0°, $\theta$, 0°) when the normalized thickness of a $SiO_2$ film was 0.15 and when Au electrodes having various thickness values were formed;

Fig. 30 illustrates a change in the attenuation constant $\alpha$ with respect to $\theta$ of Euler angles (0°, $\theta$, 0°) when the normalized thickness of a $SiO_2$ film is 0.2 and when Au electrodes having various thickness values are formed;

Fig. 31 illustrates a change in the attenuation constant $\alpha$ with respect to $\theta$, of Euler angles (0°, $\theta$, 0°) when the normalized thickness of a $SiO_2$ film was 0.25 and when Au electrodes having various thickness values were formed;

Fig. 32 illustrates a change in the attenuation constant $\alpha$ with respect to $\theta$ of Euler angles (0°, $\theta$, 0°) when the normalized thickness of a $SiO_2$ film was 0.3 and when Au electrodes having various thickness values were formed;

Fig. 33 illustrates a change in the attenuation constant α with respect to θ of Euler angles (0°, θ, 0°) when the normalized thickness of a $SiO_2$ film was 0.35 and when Au electrodes having various thickness values were formed;
Fig. 34 illustrates a change in the attenuation constant with respect to θ of Euler angles (0°, θ, 0°) when the normalized thickness of a $SiO_2$ film was 0.40 and when Au electrodes having various thickness values were formed;
Fig. 35 illustrates a change in the attenuation constant α with respect to θ of Euler angles (0°, θ, 0°) when the normalized thickness of a $SiO_2$ film was 0.45 and when Au electrodes having various thickness values were formed;
Fig. 36 illustrates the relationship between the electromechanical coupling coefficient and the normalized thickness of an Ag electrode formed on a $LiTaO_3$ substrate having Euler angles (0°, 126°, 0°) according to a third embodiment of the present invention;
Fig. 37 illustrates the relationship between the TCF and the normalized thickness of $SiO_2$ films formed on three $LiTaO_3$ substrate having Euler angles (0°, 113°, 0°), (0°, 126°, 0°), and (0°, 129°, 0°);
Fig. 38 illustrates a change in the attenuation constant α when Ag films having a normalized thickness of 0.1 or smaller and $SiO_2$ films having a normalized thickness of 0 to 0.5 were formed on a $LiTaO_3$ substrate having Euler angles (0°, 120°, 0°);
Fig. 39 illustrates a change in the attenuation constant α when Ag films having a normalized thickness of 0.1 or smaller and $SiO_2$ films having a normalized thickness of 0 to 0.5 were formed on a $LiTaO_3$ substrate having Euler angles (0°, 140°, 0°);
Fig. 40 illustrates a change in the attenuation constant α when Ag films having a normalized thickness of 0.1 or smaller and a $SiO_2$ film having a normalized thickness of 0.1 were formed on a $LiTaO_3$ substrate having Euler angles (0°, θ, 0°);
Fig. 41 illustrates a change in the attenuation constant α when Ag films having a normalized thickness of 0.1 or smaller and a $SiO_2$ film having a normalized thickness of 0.15 were formed on a $LiTaO_3$ substrate having Euler angles (0°, θ, 0°);
Fig. 42 illustrates a change in the attenuation constant α when Ag films having a normalized thickness of 0.1 or smaller and a $SiO_2$ film having a normalized thickness of 0.2 were formed on a $LiTaO_3$ substrate having Euler angles (0°, θ, 0°);
Fig. 43 illustrates a change in the attenuation constant α when Ag films having a normalized thickness of 0.1 or smaller and a $SiO_2$ film having a normalized thickness of 0.25 were formed on a $LiTaO_3$ substrate having Euler angles (0°, θ, 0°);
Fig. 44 illustrates a change in the attenuation constant α when Ag films having a normalized thickness of 0.1 or smaller and a $SiO_2$ film having a normalized thickness of 0.3 were formed on a $LiTaO_3$ substrate having Euler angles (0°, θ, 0°);
Fig. 45 illustrates a change in the attenuation constant α when Ag films having a normalized thickness of 0.1 or smaller and a $SiO_2$ film having a normalized thickness of 0.35 were formed on a $LiTaO_3$ substrate having Euler angles (0°, θ, 0°);
Fig. 46 illustrates a change in the attenuation constant α when Ag films having a normalized thickness of 0.1 or smaller and a $SiO_2$ film having a normalized thickness of 0.4 were formed on a $LiTaO_3$ substrate having Euler angles (0°, θ, 0°);
Fig. 47 illustrates a change in the attenuation constant α when Ag films having a normalized thickness of 0.1 or smaller and a $SiO_2$ film having a normalized thickness of 0.45 were formed on a $LiTaO_3$ substrate having Euler angles (0°, θ, 0°);
Fig. 48 illustrates a change in the attenuation constant α when Cu films having a normalized thickness of 0.1 or smaller and $SiO_2$ films having a normalized thickness of 0 to 0.5 were formed on a $LiTaO_3$ substrate having Euler angles (0°, 120°, 0°) according to a fourth embodiment of the present invention;
Fig. 49 illustrates a change in the attenuation constant α when Cu films having a normalized thickness of 0.1 or smaller and $SiO_2$ films having a normalized thickness of 0 to 0.5 were formed on a $LiTaO_3$ substrate having Euler angles (0°, 135°, 0°);
Fig. 50 illustrates a change in the attenuation constant α when Cu films having a normalized thickness of 0.1 or smaller and a $SiO_2$ film having a normalized thickness of 0.1 were formed on a $LiTaO_3$ substrate having Euler angles (0°, θ, 0°);
Fig. 51 illustrates a change in the attenuation constant α when Cu films having a normalized thickness of 0.1 or smaller and a $SiO_2$ film having a normalized thickness of 0.15 were formed on a $LiTaO_3$ substrate having Euler angles (0°, θ, 0°);
Fig. 52 illustrates a change in the attenuation constant α when Cu films having a normalized thickness of 0.1 or smaller and a $SiO_2$ film having a normalized thickness of 0.2 were formed on a $LiTaO_3$ substrate having Euler angles (0°, θ, 0°);
Fig. 53 illustrates a change in the attenuation constant α when Cu films having a normalized thickness of 0.1 or smaller and a $SiO_2$ film having a normalized thickness of 0.25 were formed on a $LiTaO_3$ substrate having Euler

angles (0°, θ, 0°);
Fig. 54 illustrates a change in the attenuation constant α when Cu films having a normalized thickness of 0.1 or smaller and a $SiO_2$ film having a normalized thickness of 0.3 were formed on a $LiTaO_3$ substrate having Euler angles (0°, θ, 0°);
Fig. 55 illustrates a change in the attenuation constant α when Cu films having a normalized thickness of 0.1 or smaller and a $SiO_2$ film having a normalized thickness of 0.35 were formed on a $LiTaO_3$ substrate having Euler angles (0°, θ, 0°);
Fig. 56 illustrates a change in the attenuation constant α when Cu films having a normalized thickness of 0.1 or smaller and a $SiO_2$ film having a normalized thickness of 0.4 were formed on a $LiTaO_3$ substrate having Euler angles (0°, θ, 0°);
Fig. 57 illustrates a change in the attenuation constant α when Cu films having a normalized thickness of 0.1 or smaller and a $SiO_2$ film having a normalized thickness of 0.45 were formed on a $LiTaO_3$ substrate having Euler angles (0°, θ, 0°);
Fig. 58 illustrates the relationship between the reflection coefficient per electrode finger of an Al electrode and that of a Cu electrode and the normalized thickness of the corresponding electrode when the normalized thickness of a $SiO_2$ film was 0.02;
Fig. 59 illustrates the relationship between $\theta_{min}$ that reduces the attenuation constant α to 0 or minimizes the attenuation constant α and the normalized thickness of a $SiO_2$ film when the normalized thickness of a Cu film was changed;
Fig. 60 illustrates a change in the attenuation constant α when $SiO_2$ films having various thickness values and tungsten IDTs having various thickness values were formed on a $LiTaO_3$ substrate (0°, 120°, 0°) according to a fifth embodiment of the present invention;
Fig. 61 illustrates a change in the attenuation constant α when $SiO_2$ films having various thickness values and tungsten IDTs having various thickness values were formed on a $LiTaO_3$ substrate (0°, 140°, 0°);
Fig. 62 illustrates the relationship of the attenuation constant α to θ and the normalized thickness of tungsten electrodes when the tungsten electrodes having various thickness values and a $SiO_2$ film having a normalized thickness of 0.1 were formed on a $LiTaO_3$ substrate having Euler angles (0°, θ, 0°);
Fig. 63 illustrates the relationship of the attenuation constant α to θ and the normalized thickness of tungsten electrodes when the tungsten electrodes having various thickness values and a $SiO_2$ film having a normalized thickness of 0.2 were formed on a $LiTaO_3$ substrate having Euler angles (0°, θ, 0°);
Fig. 64 illustrates the relationship of the attenuation constant α to θ and the normalized thickness of tungsten electrodes when the tungsten electrodes having various thickness values and a $SiO_2$ film having a normalized thickness of 0.3 were formed on a $LiTaO_3$ substrate having Euler angles (0°, θ, 0°);
Fig. 65 illustrates the relationship of the attenuation constant α to θ and the normalized thickness of tungsten electrodes when the tungsten electrodes having various thickness values and a $SiO_2$ film having a normalized thickness of 0.4 were formed on a $LiTaO_3$ substrate having Euler angles (0°, θ, 0°);
Fig. 66 illustrates the relationship between the acoustic velocity and the normalized thickness of $SiO_2$ films when tungsten films having various thickness values and the $SiO_2$ films are formed on a $LiTaO_3$ substrate having Euler angles (0°, 126°, 0°);
Fig. 67 illustrates the relationship between the acoustic velocity and the normalized thickness of tungsten films when the tungsten films and $Si0_2$ films having various thickness values were formed on a $LiTaO_3$ substrate having Euler angles (0°, 126°, 0°);
Fig. 68 illustrates a change in the attenuation constant α when tantalum IDTs having various thickness values and $SiO_2$ films having various thickness values were formed on a $LiTaO_3$ substrate having Euler angles (0°, 120°, 0°) according to a sixth embodiment of the present invention;
Fig. 69 illustrates a change in the attenuation constant α when tantalum IDTs having various thickness values and $SiO_2$ films having various thickness values were formed on a $LiTaO_3$ substrate having Euler angles (0°, 140°, 0°);
Fig. 70 illustrates the relationship between the attenuation constant α and θ when tantalum electrode films having various thickness values and a $SiO_2$ film having a normalized thickness of 0.1 were formed on a $LiTaO_3$ substrate having Euler angles (0°, θ, 0');
Fig. 71 illustrates the relationship between the attenuation constant α and θ when tantalum electrode films having various thickness values and a $SiO_2$ film having a normalized thickness of 0.2 were formed on a $LiTaO_3$ substrate having Euler angles (0°, θ, 0°);
Fig. 72 illustrates the relationship between the attenuation constant α and θ when tantalum electrode films having various thickness values and a $SiO_2$ film having a normalized thickness of 0.3 were formed on a $LiTaO_3$ substrate having Euler angles (0° , θ, 0');
Fig. 73 illustrates the relationship between the attenuation constant α and θ when tantalum electrode films having various thickness values and a $SiO_2$ film having a normalized thickness of 0.4 were formed on a $LiTaO_3$ substrate

having Euler angles (0°, θ, 0');

Fig. 74 illustrates the relationship between the acoustic velocity and the normalized thickness of $SiO_2$ films when tantalum IDTs having various thickness values and the $SiO_2$ films were formed on a $LiTaO_3$ substrate having Euler angles (0°, 126°, 0°);

Fig. 75 illustrates the relationship between the acoustic velocity and the normalized thickness of tantalum IDTs when the tantalum IDTs and $SiO_2$ films having various thickness values were formed on a $LiTaO_3$ substrate having Euler angles (0°, 126°, 0°);

Fig. 76 illustrates a change in the attenuation constant α when platinum IDTs having various thickness values and $SiO_2$ films having various thickness values were formed on a $LiTaO_3$ substrate having Euler angles (0°, 125°, 0°) according to a seventh embodiment of the present invention;

Fig. 77 illustrates a change in the attenuation constant α when platinum IDTs having various thickness values and $SiO_2$ films having various thickness values are formed on a $LiTaO_3$ substrate having Euler angles (0°, 140°, 0°);

Fig. 78 illustrates the relationship between the attenuation constant α and θ when platinum electrode films having various thickness values and a $SiO_2$ film having a normalized thickness of 0.1 were formed on a $LiTaO_3$ substrate having Euler angles (0°, θ, 0°);

Fig. 79 illustrates the relationship between the attenuation constant α and θ when platinum electrode films having various thickness values and a $SiO_2$ film having a normalized thickness of 0.15 were formed on a $LiTaO_3$ substrate having Euler angles (0°, θ, 0°);

Fig. 80 illustrates the relationship between the attenuation constant α and θ when platinum electrode films having various thickness values and a $SiO_2$ film having a normalized thickness of 0.2 were formed on a $LiTaO_3$ substrate having Euler angles (0°, θ, 0°);

Fig. 81 illustrates the relationship between the attenuation constant α and θ when platinum electrode films having various thickness values and a $SiO_2$ film having a normalized thickness of 0.25 were formed on a $LiTaO_3$ substrate having Euler angles (0°, θ, 0°);

Fig. 82 illustrates the relationship between the attenuation constant α and θ when platinum electrode films having various thickness values and a $SiO_2$ film having a normalized thickness of 0.3 were formed on a $LiTaO_3$ substrate having Euler angles (0°, θ, 0°);

Fig. 83 illustrates the relationship between the attenuation constant α and θ when platinum electrode films having various thickness values and a $SiO_2$ film having a normalized thickness of 0.4 were formed on a $LiTaO_3$ substrate having Euler angles (0°, θ, 0°);

Fig. 84 illustrates the relationship between the acoustic velocity and the normalized thickness of $SiO_2$ films when platinum IDTs having various thickness values and the $SiO_2$ films were formed on a $LiTaO_3$ substrate having Euler angles (0°, 126°, 0°);

Fig. 85 illustrates the relationship between the acoustic velocity and the normalized thickness of platinum IDTs when the platinum IDTs and $SiO_2$ films having various thickness values were formed on a $LiTaO_3$ substrate having Euler angles (0°, 126°, 0°);

Fig. 86 illustrates a change in the attenuation constant α when nickel IDTs having various thickness values and $SiO_2$ films having various thickness values were formed on a $LiTaO_3$ substrate having Euler angles (0°, 120°, 0°) according to an eighth embodiment of the present invention;

Fig. 87 illustrates a change in the attenuation constant α when nickel IDTs having various thickness values and $SiO_2$ films having various thickness values were formed on a $LiTaO_3$ substrate having Euler angles (0°, 140°, 0°);

Fig. 88 illustrates a change in the attenuation constant α when molybdenum IDTs having various thickness values and $SiO_2$ films having various thickness values were formed on a $LiTaO_3$ substrate having Euler angles (0°, 120°, 0°);

Fig. 89 illustrates a change in the attenuation constant α when molybdenum IDTs having various thickness values and $SiO_2$ films having various thickness values were formed on a $LiTaO_3$ substrate having Euler angles (0°, 140°, 0°);

Fig. 90 illustrates the relationship between the attenuation constant α and θ when nickel electrode films having various thickness values and a $SiO_2$ film having a normalized thickness of 0.1 were formed on a $LiTaO_3$ substrate having Euler angles (0°, θ, 0°);

Fig. 91 illustrates the relationship between the attenuation constant α and θ when nickel electrode films having various thickness values and a $SiO_2$ film having a normalized thickness of 0.2 were formed on a $LiTaO_3$ substrate having Euler angles (0°, θ, 0');

Fig. 92 illustrates the relationship between the attenuation constant α and θ when nickel electrode films having various thickness values and a $SiO_2$ film having a normalized thickness of 0.3 were formed on a $LiTaO_3$ substrate having Euler angles (0°, θ, 0°);

Fig. 93 illustrates the relationship between the attenuation constant α and θ when nickel electrode films having various thickness values and a $SiO_2$ film having a normalized thickness of 0.4 were formed on a $LiTaO_3$ substrate having Euler angles (0°, θ, 0°);

Fig. 94 illustrates the relationship between the attenuation constant α and θ when molybdenum electrode films having various thickness values and a $SiO_2$ film having a normalized thickness of 0.1 were formed on a $LiTaO_3$ substrate having Euler angles (0°, θ, 0°);

Fig. 95 illustrates the relationship between the attenuation constant α and θ when molybdenum electrode films having various thickness values and a $SiO_2$ film having a normalized thickness of 0.2 were formed on a $LiTaO_3$ substrate having Euler angles (0°, θ, 0°);

Fig. 96 illustrates the relationship between the attenuation constant α and θ when molybdenum electrode films having various thickness values and a $SiO_2$ film having a normalized thickness of 0.3 are formed on a $LiTaO_3$ substrate having Euler angles (0°, θ, 0°);

Fig. 97 illustrates the relationship between the attenuation constant α and θ when molybdenum electrode films having various thickness values and a $SiO_2$ film having a normalized thickness of 0.4 were formed on a $LiTaO_3$ substrate having Euler angles (0°, θ, 0°);

Fig. 98 illustrates the relationship between the acoustic velocity and the normalized thickness of nickel IDTs when the nickel IDTs and $SiO_2$ films having various thickness values were formed on a $LiTaO_3$ substrate having Euler angles (0°, 126°, 0°);

Fig. 99 illustrates the relationship between the acoustic velocity and the normalized thickness of $SiO_2$ films when nickel IDTs having various thickness values and the $SiO_2$ films were formed on a $LiTaO_3$ substrate having Euler angles (0°, 126°, 0°);

Fig. 100 illustrates the relationship between the acoustic velocity and the normalized thickness of molybdenum IDTs when the molybdenum IDTs and $SiO_2$ films having various thickness values were formed on a $LiTaO_3$ substrate having Euler angles (0°, 126°, 0°);

Fig. 101 illustrates the relationship between the acoustic velocity and the normalized thickness of $SiO_2$ films when molybdenum IDTs having various thickness values and the $SiO_2$ films were formed on a $LiTaO_3$ substrate having Euler angles (0°, 126°, 0°);

Figs. 102A through 102C are schematic sectional views illustrating an etch back process for planarizing the surface of an insulating layer;

Figs. 103A through 103D are schematic sectional views illustrating a reverse sputtering process for planarizing the surface of an insulating layer;

Figs. 104A and 104B are schematic sectional views illustrating another process for planarizing the surface of an insulating layer;

Figs. 105A through 105C are schematic sectional views illustrating still another process for planarizing the surface of an insulating layer;

Figs. 106A and 106B are schematic plan views illustrating a one-port SAW resonator and a two-port SAW resonator, respectively, to which the present invention can be applied;

Fig. 107 is a schematic plan view illustrating a ladder filter to which the present invention can be applied;

Fig. 108 is a schematic plan view illustrating a lattice filter to which the present invention can be applied;

Figs. 109A through 109D are schematic sectional views illustrating one example of a known manufacturing method for a SAW apparatus; and

Fig. 110 illustrates a schematic sectional view illustrating another example of a known manufacturing method for a SAW apparatus.

## DESCRIPTION OF THE PREFERRED EMBODIMENTS

The present invention is described in detail below with reference to the accompanying drawings through illustration of preferred embodiments.

A manufacturing method for a SAW apparatus according to a first embodiment of the present invention is described below with reference to Figs. 1A through 1G, and 6.

As shown in Fig. 1A, a $LiTaO_3$ substrate 1 is first prepared as a piezoelectric substrate. In the first embodiment, a 36°-rotated Y-cut X-propagating $LiTaO_3$ substrate having Euler angles (0°, 126°, 0°) is used. As the piezoelectric substrate, a $LiTaO_3$ substrate having different crystal orientations may be used, or a substrate made of another piezoelectric single crystal may be used. Alternatively, a piezoelectric substrate formed by laminating piezoelectric thin films on an insulating substrate may be used. θ of the Euler angles (φ, θ, ψ) can be expressed by θ = cut angle + 90°.

As shown in Fig. 1A, a first insulating layer 2 is formed on the entire surface of the $LiTaO_3$ substrate 1. In this embodiment, the first insulating layer 2 is formed of a $SiO_2$ film. The first insulating layer 2 is formed according to a suitable technique, such as printing, deposition, or sputtering. The thickness of the first insulating layer 2 is set to be equal to that of an IDT electrode, which is formed in a later step.

Then, as shown in Fig. 1B, a resist pattern 3 is formed according to a photolithographic technique in an area other than an area in which an IDT electrode is to be formed.

Subsequently, as indicated by the arrows in Fig. 1C, as a result of reactive ion etching (RIE) by applying ion beams, the first insulating layer 2 is removed, except for the portion disposed under the resist pattern 3.

When the $SiO_2$ film (first insulating layer 2) is etched by RIE using a fluorinated gas, a residue may be generated after polymerization. In this case, a buffered hydrofluoric acid (BHF) may be applied after performing RIE.

Thereafter, a Cu film and a Ti film are formed such that the thickness thereof is equal to that of the first insulating layer 2. More specifically, as shown in Fig. 1D, a Cu film 4, which serves as an IDT electrode 4A, is formed on the area without the first insulating layer 2, and the Cu film 4 is also formed on the resist pattern 3. Then, as shown in Fig. 1E, as a protective metal film, a Ti film 5 is formed on the top surface of an IDT electrode 4A and on the Cu film 4 formed on the resist pattern 3. Accordingly, the side surfaces of the IDT electrode 4A are covered with the first insulating layer 2, and the top surface thereof is covered with the Ti film 5. As discussed above, the IDT electrode 4A and the protective metal film (Ti film 5) are formed such that the total thickness of the IDT electrode 4A and the Ti film 5 are equal to the thickness of the first insulating layer 2.

Subsequently, the resist pattern 3 is removed by using a resist stripper. Then, as shown in Fig. 1F, the IDT electrode 4A is disposed in an area other than the area in which the first insulating layer 2 is formed, and the top surface of the IDT electrode 4A is covered with the Ti film 5.

Thereafter, as shown in Fig. 1G, a $SiO_2$ film, which serves as a second insulating layer 6, is formed on the entire surface.

Then, a one-port SAW resonator 11 shown in Fig. 6 is fabricated.

In Figs. 1A through 1G, only the portion in which the IDT electrode 4A is formed is shown. However, as shown in Fig. 6, the SAW resonator 11 is also provided with reflectors 12 and 13 in a SAW propagating direction such that they sandwich the IDT electrode 4A therebetween. The reflectors 12 and 13 are also formed in the same steps as those of the IDT electrodes 4A.

In the above-described first embodiment, since the one-port SAW resonator 11 is formed, only one IDT electrode 4A is formed on the $LiTaO_3$ substrate 1. However, a plurality of IDT electrodes may be formed according to the intended purpose of use of the SAW apparatus. Reflectors and an IDT electrode may be simultaneously formed. Alternatively, reflectors do not have to be formed.

For comparison, a one-port SAW resonator was formed as a first comparative example according to the known manufacturing method shown in Figs. 109A through 109D for a SAW apparatus provided with a $SiO_2$ film. As in the first embodiment, a 36°-rotated Y-cut X-propagating $LiTaO_3$ substrate having Euler angles (0°, 126°, 0°) was used. An IDT electrode was formed by using Cu. According to the manufacturing method shown in Figs. 109A through 109D, since the $SiO_2$ film 54 is formed after the IDT electrode 53A, the height of the $SiO_2$ film 54 becomes different. Fig. 4 shows an impedance characteristic and a phase characteristic of the first comparative example when the normalized thickness $h/\lambda$ (h represents the thickness of the IDT electrode 53A and $\lambda$ designates the SAW wavelength) of the IDT electrode 53A is 0.042, and when the normalized thickness $Hs/\lambda$ (Hs represents the thickness of the $SiO_2$ film 54) of the $SiO_2$ film 54 is 0.11, 0.22, and 0.33. Fig. 4 shows that the ratio of the impedance of the antiresonance point to the impedance of the resonance point, i.e., the impedance ratio, becomes smaller as the normalized thickness $Hs/\lambda$ of the $SiO_2$ film 54 is increased.

Fig. 5 illustrates the relationship between the normalized thickness $Hs/\lambda$ of the $SiO_2$ film 54 of the SAW resonator manufactured by the known method in the first comparative example and the Figure of Merit (MF) of the SAW resonator. Fig. 5 reveals that MF is decreased as the normalized thickness $Hs/\lambda$, of the $SiO_2$ film 54 becomes larger.

That is, in the first comparative example in which the IDT electrode 53A and the $SiO_2$ film 54 were formed according to the manufacturing method shown in Figs. 109A through 109D, the performance of the resonator is considerably decreased as the thickness of the $SiO_2$ film 54 is increased even if the IDT electrode 53A is made of Cu. This is probably due to the difference of the surface height of the $SiO_2$ film 54.

The characteristics of the SAW resonator 11 manufactured according to the first embodiment are shown in Figs. 7 through 9.

Fig. 7 illustrates a change in the impedance characteristic and a change in the phase characteristic of the SAW resonator 11 manufactured according to the method of the above-described first embodiment when the thickness of the $SiO_2$ film, i.e., the second insulating layer 6, is changed. The two-dot-chain lines in Figs. 8 and 9 indicate a change in $\gamma$ and a change in MF of the SAW resonator 11, respectively, when the normalized thickness $Hs/\lambda$ of the $SiO_2$ film is changed. For comparison, the corresponding characteristics of the known resonator manufactured in the first comparative example are also indicated by the solid lines in Figs. 8 and 9.

By comparing the characteristics of Fig. 7 with those of Fig. 4, it is seen that a decrease in the impedance is small even though the normalized thickness $Hs/\lambda$ of the $SiO_2$ film is increased.

Figs. 8 and 9 also show that a characteristic deterioration of this embodiment can be suppressed even though the normalized thickness $Hs/\lambda$ of the $SiO_2$ film is increased.

That is, according to the manufacturing method of the first embodiment, a decrease in the impedance ratio is small and a characteristic deterioration can be suppressed even though the thickness of the $SiO_2$ film is increased.

Fig. 10 illustrates the relationship between the temperature coefficient for the frequency (TCF) and the thickness

of the $SiO_2$ film of the SAW resonator of the first embodiment and that of the first comparative example. In Fig. 10, the solid line indicates the first comparative example, and the two-dot-chain line indicates the first embodiment.

Fig. 10 indicates that the TCF can be ideally improved by increasing the thickness of the $SiO_2$ film according to the manufacturing method of the first embodiment.

Thus, according to the manufacturing method of the first embodiment, it is possible to provide a SAW resonator in which a characteristic deterioration can be suppressed and the temperature characteristic can be effectively improved.

Additionally, according to the manufacturing method of the first embodiment, since the IDT electrode 4A is made of Cu, which has a density higher than Al, it has a sufficient reflection coefficient, thereby suppressing the generation of undesirable ripples in the resonance characteristic. This is described in detail below.

For comparison, a SAW resonator was formed as a second comparative example in a manner similar to the first embodiment, except that Al was used for an IDT electrode instead of Cu, and the normalized thickness $Hs/\lambda$ of the $SiO_2$ film, i.e., the first insulating layer, was 0.08. The impedance characteristic and the phase characteristic of the SAW resonator of the second comparative example are indicated by the solid lines of Fig. 11.

The impedance characteristic and the phase characteristic of a SAW resonator formed in a manner similar to the second comparative example, except that a $SiO_2$ film was not formed, are also indicated by broken lines in Fig. 11.

The solid lines of Fig. 11 indicate that large ripples indicated by the arrows A are generated between the resonance point and the antiresonance point when the IDT electrode was formed of Al and the $SiO_2$ film was formed in the second comparative example. In contrast, the broken lines of Fig. 11 indicate that such ripples are not generated in the SAW resonator without a $SiO_2$ film.

Accordingly, even though the $SiO_2$ film was formed to improve the TCF, the above-described ripples A are generated if the IDT electrode is formed by using Al, resulting in a characteristic deterioration. After further studying this point, the present inventors discovered that the reflection coefficient of the IDT electrode can be increased by using a metal having a density higher than Al for the IDT electrode so as to suppress the above-described ripples A.

Then, a SAW resonator was formed in a manner similar to the above-described first embodiment, except that the density of the metal for the IDT electrode was varied. The impedance characteristics of the SAW resonator are shown in Figs. 12A through 12E. Figs. 12A through 12E illustrate the impedance characteristics when the ratio $\rho_1/\rho_2$ of the average density $\rho_1$ of the laminated structure including the IDT electrode and the protective metal film to the density $\rho_2$ of the first insulating layer is 2.5, 2.0, 1.5, 1.2, and 1.0, respectively.

Figs. 12A through 12C show that the ripples A are shifted to the range outside the pass band, and more particularly, Fig. 12A shows that the ripples A are considerably suppressed.

Accordingly, as is seen from Figs. 12A through 12E, the ripples A can be shifted to the range outside the band pass between the resonant frequency and the antiresonant frequency when the density ratio of the laminated structure including the IDT electrode and the protective metal film to the first insulating layer is 1.5 or greater, thereby exhibiting improved characteristics. When the density ratio is 2.5 or greater, the ripples can be considerably suppressed.

In the examples of Figs. 12A through 12E, since the Ti film is laminated on the IDT electrode 4A, the average density was calculated. However, in the present invention, the provision of the protective metal film on an IDT is not essential. In this case, the thickness of the IDT electrode is set to be equal to that of the first insulating layer, and the ratio of the density of the IDT electrode to that of the first insulating layer is set to be 1.5 or greater, and more preferably, 2.5 or greater. Then, advantages similar to those obtained by the above-described example can be achieved.

Accordingly, in a SAW resonator in which a $SiO_2$ film is formed to cover an IDT electrode, the reflection coefficient of the IDT electrode can be increased if the density of the IDT electrode, or the average density of a laminated structure including the IDT electrode and a protective metal film, is set to be greater than the density of a first insulating layer disposed along the side surfaces of the IDT electrode, thereby suppressing the generation of ripples between the resonance point and the antiresonance point.

A metal or an alloy having a higher density than Al includes, not only Cu, but also Ag or Au or an alloy essentially consisting Ag or Au.

As in the first embodiment, a protective metal film is preferably disposed on the IDT electrode. Then, according to the manufacturing method shown in Figs. 1A through 1G, when the resist pattern 3 is removed, the erosion of the IDT electrode 4A can be prevented since the side surfaces of the IDT electrode 4A are covered with the first insulating layer 2 and the top surface thereof is covered with the protective metal film 5. It is thus possible to provide a SAW resonator exhibiting a higher level of performance.

The first and second insulating layers may be formed by an insulating material other than $SiO_2$, such as $SiO_xN_y$, which contributes to an improvement in the temperature characteristic. The first and second insulating layers may be made of the same insulating materials, as the first embodiment, or may be formed of different insulating materials.

Fig. 13 illustrates the relationship between the electromechanical coupling coefficient and the normalized thickness $H/\gamma$, of IDT electrodes made of various metals and having various thickness values on a $LiTaO_3$ substrate having Euler angles (0°, 126°, 0°).

The types of metals exhibiting larger electromechanical coefficients than Al were extracted from Fig. 13, and the normalized thickness values of such metals, as well as those of Ti and Pt, are shown in Fig. 14. That is, Fig. 14 illustrates the electrode thickness range that exhibits greater electromechanical coefficients than Al.

In Fig. 14, the upper limit of the normalized thickness range of the IDT electrodes indicates the threshold for exhibiting a greater electromechanical coupling coefficient than Al, and the lower limit of the normalized thickness range represents the thickness of the IDT electrode that can be manufactured. By approximating the upper limit to a quadratic expression when the electrode normalized thickness range exhibiting greater electromechanical coupling coefficients is y and the electrode density is x, the equation expressed by $y = 0.00025x^2 - 0.01056x + 0.16473$ can be found.

Accordingly, as is seen from subsequent embodiments in which SAW resonators are formed by specifying electrode materials, it is now assumed that an IDT electrode is formed on a 14° to 50°-rotated Y-cut X-propagating $LiTaO_3$ piezoelectric substrate having Euler angles (0°, 104° to 140°, 0°), and the normalized thickness $Hs/\lambda$ of a $SiO_2$ film ranges from 0.03 to 0.45. In this case, the electromechanical coupling coefficient can be increased, as shown in Fig. 14, when the normalized thickness $H/\lambda$ of the IDT electrode satisfies the following expression (1):

$$0.005 \leq H/\lambda \leq 0.00025 \times \rho^2 - 0.01056 \times \rho + 0.16473 \quad \ldots(1)$$

wherein ρ represents the average density of the IDT electrode.

In the present invention, a metal having a higher density than Al is used for the IDT electrode. In this case, the IDT electrode may be made of a metal having a higher density than Al or an alloy primarily including such a metal. Alternatively, the IDT electrode may be formed of a laminated structure including a primary metallic film made of a metal having a higher density than Al or an alloy primarily including such a metal and a secondary metallic film made of a metal different from that of the primary metallic film. In this case, the average density of the laminated film must satisfy the expression represented by $\rho0 \times 0.75 \leq \rho \leq \rho0 \times 1.3$ where ρ indicates the average density of the IDT electrode and ρ0 designates the density of the primary metallic film.

In the present invention, as described above, the surface of the second insulating layer may be planarized. However, the height of the second insulating film may be different within a range of 30% or smaller of the thickness of the IDT electrode. If this height difference exceeds 30%, the advantage achieved by the planarized level of the second insulating layer cannot be sufficiently obtained.

The second insulating layer can be planarized by various techniques, such as by performing an etch back process, by utilizing an oblique incidence effect by means of reverse sputtering, by polishing the surface of the insulating layer, and by polishing the electrode. The planarization of the second insulating layer may be performed by a combination of two or more types of the above-described techniques. Details of such techniques are discussed below with reference to Figs. 102A through 105C.

Figs. 102A through 102C are schematic sectional views illustrating a planarization technique for the surface of the insulating layer according to an etch back process. As shown in Fig. 102A, an electrode 42 is first formed on a piezoelectric substrate 41, and then, an insulating layer 43 is formed by, for example, $SiO_2$. As shown in Fig. 102B, a resist pattern 44 is formed on the insulating layer 43 by, for example, spin coating. In this case, the surface of the resist pattern 44 is flat. Thus, by etching the resist pattern 44 according to RIE, i.e., by an etch back process, the surface of the insulating layer 43 can be planarized, as shown in Fig. 102C.

Figs. 103A through 103D are schematic sectional views illustrating the reverse sputtering process. The electrode 42 is first formed on the piezoelectric substrate 41, and then, the insulating layer 43 is formed. Then, argon ions, which are used for sputtering the substrate 41, are applied onto the surface of the insulating layer 43 by sputtering. When sputtering is performed by ion bombardment on the surface of the substrate, a greater sputtering effect is produced if ions are applied onto an oblique surface rather than a flat surface. This is known as the "oblique incidence effect". Due to this effect, the insulating layer 43 is planarized as the sputtering proceeds, as shown in Figs. 103B through 103D.

Figs. 104A and 104B are schematic sectional views illustrating a planarization technique by polishing the insulating layer. As shown in Fig. 104A, after the electrode 42 and the insulating layer 43 are formed on the substrate 41, the insulating layer 43 is mechanically or chemically polished so as to be planarized.

Figs. 105A through 105C are schematic sectional views illustrating a planarization technique by polishing the electrode. As shown in Fig. 105A, a first insulating layer 45 is formed on the substrate 41, and a metallic film 42A, which is made of an electrode material, is formed on the entire surface by deposition. Then, as shown in Fig. 105B, by mechanically or chemically polishing the metallic film 42A, the electrode 42 and the first insulating layer 45, which is disposed around the electrode 42, are formed. Thus, the first insulating layer 45 and the electrode 42 are planarized so that they are flush with each other. Thereafter, as shown in Fig. 105C, a second insulating layer 46 is formed. According to this technique, the surface of the insulating layer is planarized.

The present invention is applicable to various types of SAW apparatuses. Examples of such SAW apparatuses are shown in Figs. 106A through 108. Figs. 106A and 106B are schematic plan views illustrating a one-port SAW resonator 47 and a two-port SAW resonator 48, respectively. By using the same electrode structure as that of the two-port SAW resonator 48 shown in Fig. 106B, a two-port SAW resonator filter may be formed.

Figs. 107 and 108 are schematic plan views illustrating the electrode structures of a ladder filter 49a and a lattice filter 49b, respectively. By forming the electrode structure of the ladder filter 49a and the lattice filter 49b on the piezoelectric substrate, a ladder filter and a lattice filter can be formed according to the present invention.

The present invention is not restricted to the SAW apparatuses having the electrode structures shown in Figs. 106A, 106B, and 107, and may be used in various types of SAW apparatuses.

In the present invention, preferably, a SAW apparatus using a leaky SAW is manufactured. Japanese Unexamined Patent Application Publication No. 6-164306 discloses a SAW apparatus having an electrode made of a heavy metal, such as Au, and utilizing the Love wave, which is free from the propagation attenuation. In this SAW apparatus, by using a heavy metal for the electrode, the acoustic velocity of a propagating SAW becomes lower than that of a transversal bulk wave in the substrate so as to eliminate leaky components. In this manner, the Love wave is utilized as a non-leaky SAW.

In the Love wave, however, since the acoustic velocity inevitably becomes low, and accordingly, the IDT pitch must be decreased. This increases the difficulty in processing the SAW apparatus, thereby decreasing the processing precision. Additionally, the linewidth of the IDT becomes smaller, and the loss caused by the resistance is increased.

In the present invention, unlike the above-described SAW apparatus utilizing the Love wave, even though the electrode made of a metal heavier than Al is used, a leaky SAW having a high acoustic velocity can be effectively utilized, thereby achieving a reduction in the propagation loss. It is thus possible to provide a low-insertion SAW apparatus.

Based on the above-described results, electrodes were formed by using different metals having a higher density than Al.

Metals having a higher density than Al used in the present invention includes: (1) a metal having a density of 15000 to 23000 kg/$m^3$ and a Young's modulus of 0.5 x $10^{11}$ to 1.0 x $10^{11}$N/$m^2$ or having a transversal-wave acoustic velocity of 1000 to 2000 m/s, for example, Au; (2) a metal having a density of 5000 to 15000 kg/$m^3$ and a Young's modulus of 0.5 x $10^{11}$ to 1.0 x $10^{11}$N/$m^2$ or having a transversal-wave acoustic velocity of 1000 to 2000 m/s, for example, Ag; (3) a metal having a density of 5000 to 15000 kg/$m^3$ and a Young's modulus of 1.0 x $10^{11}$ to 2.05 x $10^{11}$N/$m^2$ or having a transversal-wave acoustic velocity of 2000 to 2800 m/s, for example, Cu; (4) a metal having a density of 15000 to 23000 kg/$m^3$ and a Young's modulus of 2.0 x $10^{11}$ to 4.5 x $10^{11}$N/$m^2$ or having a transversal-wave acoustic velocity of 2800 to 3500 m/s, for example, tungsten; (5) a metal having a density of 15000 to 23000 kg/$m^3$ and a Young's modulus of 1.0 x $10^{11}$ to 2.0 x $10^{11}$N/$m^2$ or having a transversal-wave acoustic velocity of 2000 to 2800 m/s, for example, tantalum; (6) a metal having a density of 15000 to 23000 kg/$m^3$ and a Young's modulus of 1.0 x $10^{11}$ to 2.0 x $10^{11}$N/$m^2$ or having a transversal-wave acoustic velocity of 1000 to 2000 m/s, for example, platinum; and (7) a metal having a density of 5000 to 15000 kg/$m^3$ and a Young's modulus of 2.0 x $10^{11}$ to 4.5 x $10^{11}$N/$m^2$ or having a transversal-wave acoustic velocity of 2800 to 3500 m/s, for example, Ni and Mo.

Fig. 15 is a plan view illustrating a longitudinally coupled resonator filter as a SAW apparatus 21 according to a second embodiment of the present invention. In the second embodiment, Au is used for electrodes.

In the SAW apparatus 21, IDTs 23a and 23b and reflectors 24a and 24b are formed on the top surface of a $LiTaO_3$ substrate 22. A $SiO_2$ film 25 is formed to cover the IDTs 23a and 23b and the reflectors 24a and 24b. As the $LiTaO_3$ substrate 22, a 25° to 58°-rotated Y-cut X-propagating $LiTaO_3$ substrate having Euler angles (0°, 115° to 148°, 0°) is used. If a Y-cut X-propagating $LiTaO_3$ substrate having a cut angle other than the above range is used, the attenuation constant is increased, and the TCF is deteriorated.

The IDTs 23a and 23b and the reflectors 24a and 24b are made of a metal having a density higher than Al. As such a metal, at least one metal selected from the group including Au, Pt, W, Ta, Ag, Mo, Cu, Ni, Co, Cr, Fe, Mn, Zn, and Ti, or an alloy primarily including at least one metal of the above-described group may be used.

As described above, since the IDTs 23a and 23b and the reflectors 24a and 24b are made of a metal having a density higher than Al, the electromechanical coupling coefficient and the reflection coefficient can be improved, as shown in Figs. 16 and 17, respectively, even when the thickness of the IDTs 23a and 23b and that of the reflectors 24a and 24b are formed to be smaller than that of the IDTs and the reflectors made of Al.

The thickness of the electrodes can be decreased, as stated above. The thickness of the $SiO_2$ film 25 is preferably determined so that the thickness $Hs/\lambda$ normalized by the SAW wavelength $\lambda$ ranges from 0.03 to 0.45, which can be clearly seen in the subsequent examples. In this case, Hs indicates the total thickness of first and second $SiO_2$ insulating layers. With this range, the attenuation constant can be considerably decreased compared to a SAW apparatus without a $SiO_2$ film, thereby achieving a reduction in the loss.

The ideal thickness of the IDTs 23a and 23b normalized by the SAW wavelength is different according to the material forming the IDTs 23a and 23b. If the IDTs are made of Au, the normalized thickness of the IDTs 23a and 23b is preferably from 0.013 to 0.030. If the Au film is too thin, the IDTs 23a and 23b exhibit a resistance. Accordingly, the normalized thickness of the IDTs 23a and 23b is, more preferably, from 0.021 to 0.030.

According to the SAW apparatus of the second embodiment, the IDTs 23a and 23b are made of a metal having a density higher than A1 on the $SiO_2$ substrate 22, and the thickness of the IDTs 23a and 23b can be decreased. Thus, the SAW apparatus exhibits improved characteristics and also improves the TCF by the formation of the $SiO_2$ film 25. This is described in greater detail by specific examples.

The electromechanical coupling coefficient $K_{SAW}$, the reflection coefficient |ref|, and the attenuation constant ($\alpha$) with respect to the normalized thickness of IDTs when the IDTs were made of Al, Au, Ta, Ag, Cr, W, Cu, Zn, Mo, and Ni on a 36°-rotated Y-cut X-propagating $LiTaO_3$ substrate having Euler angles (0°, 126°, 0°) are shown in Figs. 16, 17, and 18, respectively. It should be noted that calculations were made according to the method indicated in J. J. Chambell and W. R. Jones: IEEE Trans. Sonic & Ultrason. SU-15. p209 (1968), assuming that the electrodes were uniformly formed.

Fig. 16 shows that, in the IDT made of Al, the electromechanical coupling coefficient $K_{SAW}$ is about 0.27 when the normalized thickness H/$\lambda$ (H represents the thickness of the IDT and $\lambda$ designates the wavelength) is 0.10. In contrast, in the IDTs made of Au, Ta, Ag, Cr, W, Cu, Zn, Mo, and Ni, higher electromechanical coupling coefficients $K_{SAW}$ can be implemented when H/$\lambda$ ranges from 0.013 to 0.035. Fig. 18 reveals that, however, in the IDTs made of Au, Ta, Ag, Cr, W, Cu, Zn, Mo, and Ni, the attenuation constants $\alpha$ become very large, while, in the IDT made of Al, the attenuation constant $\alpha$ is substantially 0 regardless of the normalized thickness H/ $\lambda$.

Fig. 25 illustrates the relationship between the electromechanical coupling coefficient and $\theta$ of the Euler angles (0°, $\theta$, 0°) when the Au IDT and the $SiO_2$ film are formed on a $LiTaO_3$ substrate having Euler angles (0°, $\theta$, 0°). In this case, the normalized thickness of the IDT was changed to 0.022, 0.025, and 0.030, and the normalized thickness Hs/$\lambda$ of the $SiO_2$ film was varied to 0.00 (without $SiO_2$ film), 0.10, 0.20, 0.30, and 0.45.

Fig. 25 shows that the electromechanical coupling coefficient $K_{SAW}$ becomes smaller as the thickness of the $SiO_2$ film is increased. It is now assumed that the thickness of the IDT is decreased for suppressing a characteristic deterioration caused by the formation of $SiO_2$ film, which is described in detail below. Fig. 16 shows that the electromechanical coupling coefficient $K_{SAW}$ is decreased to 0.245 when the normalized thickness of the Al IDT is reduced to 0.04 without the formation of $SiO_2$ film. If the normalized thickness of the Al IDT is reduced to 0.04 with the formation of a $SiO_2$ film, the electromechanical coupling coefficient $K_{SAW}$ becomes even smaller, which makes it difficult to achieve a wider band when the resulting SAW apparatus is put to practical use.

In contrast, as is seen from Fig. 25, when the IDT is formed of Au and a $SiO_2$ film is formed, the electromechanical coupling coefficient $K_{SAW}$ can be increased to 0.245 or greater by setting $\theta$ of the Euler angles to be 128.5° or smaller even though the normalized thickness Hs/$\lambda$ of the $SiO_2$ film is about 0.45. When the normalized thickness of the $SiO_2$ film is about 0.30, the electromechanical coupling coefficient $K_{SAW}$ can be increased to 0.245 or greater by setting $\theta$ of the Euler angles to be 132° or smaller. As discussed below, when $\theta$ of the Euler angles is smaller than 115°, the attenuation constant is increased, which makes it difficult put the SAW apparatus to practical use. Thus, preferably, a 25° to 42°-rotated Y-cut X-propagating $LiTaO_3$ substrate having Euler angles (0$\pm$3 °, 115° to 132 °, 0$\pm$3°), and more preferably, a 25° to 38.5°-rotated Y-cut X-propagating $LiTaO_3$ substrate having Euler angles (0$\pm$3°, 115 to 128.5°, 0$\pm$3°) is used.

The temperature coefficient for the frequency (TCF) of a 36°-rotated Y-cut X-propagating $LiTaO_3$ substrate having Euler angles (0°, 126°, 0°) is -30 to -40 ppm/°C, which is not sufficient. In order to improve the TCF to be $\pm$20 ppm/°C, an Au IDT was formed on a 36°-rotated Y-cut X-propagating $LiTaO_3$ substrate having Euler angles (0°, 126°, 0°), and the thickness of the $SiO_2$ film was changed. In this case, the TCF with respect to the normalized thickness of the $SiO_2$ film is shown in Fig. 19. In Fig. 19, O indicates the ideal values, and x designates the values measured. In this case, the normalized thickness H/$\lambda$ of the Au IDT is 0.020.

Fig. 19 shows that the formation of the $SiO_2$ film improves the TCF, and in particular, when the normalized thickness Hs/$\lambda$ of the $SiO_2$ film is about 0.25, the TCF becomes zero.

Also, by using two types of rotated Y-cut X-propagating $LiTaO_3$ substrates, i.e., a substrate having a cut angle of 36° (Euler angles (0°, 126°, 0°)), and a substrate having a cut angle of 38° (Euler angles (0°, 128°, 0°)), the normalized thickness H/$\lambda$ of an Au IDT and the normalized thickness Hs/$\lambda$ of a $SiO_2$ film were changed. The attenuation constants $\alpha$ with respect to the normalized thickness of the $SiO_2$ film are shown in Figs. 20 and 21. Figs. 20 and 21 reveal that the attenuation constant $\alpha$ can be made smaller if the thickness of the $SiO_2$ film is suitably selected regardless of the thickness of the IDT. More specifically, as is seen from Figs. 20 and 21, if the normalized thickness Hs/$\lambda$, of the $SiO_2$ film ranges from 0.03 to 0.45, and more preferably, from 0.10 to 0.35, the attenuation constant $\alpha$ can be reduced to a minimal level regardless of the above-described two types of Euler angles of the $LiTaO_3$ substrate and the thickness of the Au IDT.

Fig. 17 shows that the use of an Au IDT achieves a sufficiently large reflection coefficient even with a small thickness of the IDT compared to an Al IDT.

Thus, according to the results of Figs. 16 through 21, when an Au IDT having a normalized thickness H/$\lambda$ of 0.013 to 0.030 is formed on a $LiTaO_3$ substrate, a large electromechanical coupling coefficient can be implemented, and also, the attenuation coefficient $\alpha$ can be reduced to a minimal level, and a sufficient reflection coefficient can be implemented if the normalized thickness Hs/$\lambda$ of the $SiO_2$ film is set to range from 0.03 to 0.45.

In the second embodiment, the SAW apparatus 11 was manufactured by forming an Au IDT having a normalized thickness H/λ of 0.020 and a $SiO_2$ film having a normalized thickness Hs/λ of 0.1 on a $LiTaO_3$ substrate having a cut angle of 36° (Euler angles of (0°, 126°, 0°)). The attenuation-vs.-frequency characteristic of the SAW apparatus 11 is indicated by the broken line of Fig. 22. For comparison, the attenuation-vs.-frequency characteristic of the SAW apparatus 11 before the formation of the $SiO_2$ film is also indicated by the solid line of Fig. 22.

Fig. 22 reveals that, because of the formation of the $SiO_2$ film, the insertion loss is decreased even though the electromechanical coupling coefficient is slightly reduced from 0.30 to 0.28. Accordingly, it has been proved that the attenuation constant α can be decreased if the thickness of the $SiO_2$ film is set to the above-described specific range.

After discovering the above-described fact, the present inventors formed one-port SAW resonators on an experimental basis by forming an Au IDT having a normalized thickness of 0.02 and a $SiO_2$ film on rotated Y-cut X-propagating $LiTaO_3$ substrates having different Euler angles. In this case, the normalized thickness of the $SiO_2$ film was varied to 0.10, 0.20, 0.30, and 0.45. The Q factors of the one-port SAW resonators are shown in Fig. 26.

Generally, as the Q factor of a resonator is increased, the sharpness of the filter characteristic of the resonator from the pass band to the attenuation range is increased. Accordingly, if a sharp filter characteristic is required, a greater Q factor is desirable. As is seen from Fig. 26, when the cut angle of the substrate is 48° (Euler angles (0°, 138°, 0°)), the Q factor becomes maximum, and when the cut angle ranges from 42° to 58° (Euler angles of (0°, 132° to 148°, 0°)), the Q factor becomes comparatively large regardless of the thickness of the $SiO_2$ film.

Accordingly, as is seen from Fig. 26, by forming a SAW resonator such that at least one IDT made of a metal having a density higher than Al is formed on a Y-cut $LiTaO_3$ substrate having a cut angle of 42° to 58° (Euler angles (0°, 132 to 148°, 0°)), and a $SiO_2$ film is formed to cover the IDT on the $LiTaO_3$ substrate, a large Q factor can be obtained. It is preferable that the cut angle of the $LiTaO_3$ substrate is 46.5° to 53° (Euler angles (0°, 136.5° to 143°, 0°)), as can be seen from Fig. 26.

In the present invention, a contact layer may be formed on the top surface of the IDT. More specifically, as shown in Fig. 27A, an IDT 33 is formed on a $LiTaO_3$ substrate 32, and a contact layer 34 may be formed on the top surface of the IDT 33. The contact layer 34 is disposed between the IDT 33 and a $SiO_2$ film 35, so that it increases the contact strength of the $SiO_2$ film 35 to the IDT 33. As the material for the contact layer 34, Pd or Al, or an alloy thereof may be suitably used. The contact layer 34 is not restricted to a metal, and a piezoelectric material, such as ZnO, or ceramics, such as $Ta_2O_3$ or $Al_2O_3$, may be used. The formation of the contact layer 34 increases the contact strength between the IDT 33 and the $SiO_2$ film 35, thereby preventing the $SiO_2$ film 35 from peeling off.

The thickness of the contact layer 34 is preferably about 1% or less of the SAW wavelength so as to minimize the influence on the SAW by the formation of the contact layer 34. Although the contact layer 34 is formed only on the top surface of the IDT 33 in Fig. 27A, it may also be formed at the interface between the $LiTaO_3$ substrate 33 and the $SiO_2$ film 35, as shown in Fig. 27B. Alternatively, as shown in Fig. 27C, the contact layer 34 may also be formed, not only on the top surface of the IDT 33, but also on the side surfaces of the IDT 33.

As another configuration for improving the contact strength of the $SiO_2$ film, a plurality of electrodes including bus bars and externally connecting pads other than IDTs may be laminated with an underlying metal layer formed of the same material as the IDT, and an upper metal layer made of Al or an Al alloy laminated with the underlying metal layer. For example, as an electrode film forming the reflectors 24a and 24b shown in Fig. 15, an underlying metal layer made of the same material as the IDTs 23a and 23b and an Al film may be laminated on the underlying metal layer. Accordingly, by providing an upper metal layer made of Al or an Al alloy, the contact strength of the $SiO_2$ film can be enhanced. Additionally, the cost of the electrode can be reduced, and the Al wedge bonding can also be enhanced.

The electrodes other than IDTs include, not only reflectors, bus bars, and externally connecting pads, but also wiring electrodes, which are formed if necessary. The Al alloy may include an Al-Ti alloy and an Al-Ni-Cr alloy by way of examples only.

The present inventors have confirmed that there is a certain range of thickness of a $SiO_2$ film that minimizes the attenuation constant α as long as an Au IDT is formed even when a Y-cut X-propagating $LiTaO_3$ substrate having Euler angles other than the above-described angles is used. That is, if the normalized thickness Hs/λ of the $SiO_2$ film is set to be a specific range, the attenuation constant α can be reduced, as in the above-described example. The relationship between the attenuation constant α and the Euler angle θ when the normalized thickness Hs/λ of the $SiO_2$ film was set to be 0.1 to 0.45 are shown in Figs. 28 through 35. Figs. 28 through 35 show that the Euler angle θ that minimizes the attenuation constant α becomes smaller as the thickness of the $SiO_2$ film is increased. Accordingly, even when a Y-cut X-propagating $LiTaO_3$ substrate having Euler angles other than the above-described angles is used, it is possible to provide a SAW apparatus that exhibits a large electromechanical coupling coefficient and a large reflection coefficient, and that reduces the TCF to one half of a known SAW apparatus if an Au IDT is formed, and a $SiO_2$ film having a suitable thickness is laminated. Preferable combinations of the Euler angles, the thickness of the Au IDT, and the thickness of the $SiO_2$ film that achieve the above-described advantages are shown in Table 1 and Table 2.

Table 1

| θ of Euler angles (0±3°, θ, 0±3°) | Au normalized thickness (H/λ) | $SiO_2$ film normalized thickness (Hs/λ) |
|---|---|---|
| 120.0° ≤ θ < 123.0° | 0.013 - 0.018 | 0.15 - 0.45 |
| 123.0º ≤ θ 124.5º | 0.013 - 0.022 | 0.10 - 0.40 |
| 124.50 ≤ θ < 125.5° | 0.013 - 0.025 | 0.07 - 0.40 |
| 125.5° ≤ θ < 127.5° | 0.013 - 0.025 | 0.06 - 0.40 |
| 127.5º ≤ θ < 129.0° | 0.013 - 0.028 | 0.04 - 0.40 |
| 129.0° ≤ θ < 130.0° | 0.017 - 0.030 | 0.03 - 0.42 |
| 130.0º ≤ θ < 131.5° | 0.017 - 0.030 | 0.03 - 0.42 |
| 131.5° ≤ θ < 133.0° | 0.018 - 0.028 | 0.05 - 0.33 |
| 1 33.0° ≤ θ < 135.0° | 0.018 - 0.030 | 0.05 - 0.30 |
| 135.0º ≤ θ < 137.0º | 0.019 - 0.032 | 0.05 - 0.25 |
| 137.0º ≤ θ ≤ 140.0º | 0.019 - 0.032 | 0.05 - 0.25 |

Table 2

| θ of Euler angles (0±3°, θ, 0±3°) | Au normalized thickness (H/λ) | $SiO_2$ film normalized thickness (Hs/λ) |
|---|---|---|
| 129.0º ≤ θ < 130.0° | 0.022 - 0.028 | 0.04 - 0.40 |
| 130.0º ≤ θ < 131.5° | 0.022 - 0.028 | 0.04 - 0.40 |
| 131.5º ≤ θ < 133.0° | 0.022 - 0.028 | 0.05 - 0.33 |
| 133.0º ≤ θ < 135.0° | 0.022 - 0.030 | 0.05 - 0.30 |
| 135.0° ≤ θ < 137.0° | 0.022 - 0.032 | 0.05 - 0.25 |
| 137.0º ≤ θ 140.0º | 0.022 - 0.032 | 0.05 - 0.25 |

θ of the Euler angles may sometimes deviate from the desired angle by -2° to +4°. This deviation is generated due to the fact that calculations were made in this embodiment, assuming that a metallic film was formed on the entire surface of the substrate, and there may be some errors within the above range in actual SAW apparatuses.

When manufacturing the SAW apparatus according to the present invention, it is preferable that an IDT primarily including Au is formed on a rotated Y-cut X-propagating $LiTaO_3$ substrate, and in this state, the frequency is adjusted, and then, a $SiO_2$ film having a thickness that can reduce the attenuation constant α is formed. This is explained below with reference to Figs. 23 and 24. Au IDTs having different thickness values and $SiO_2$ films having different thickness values were formed on a 36°-rotated Y-cut X-propagating $LiTaO_3$ substrate (Euler angles (0°, 126°, 0°)). Fig. 23 illustrates a change in the acoustic velocity of a leaky SAW with respect to the thickness of the IDT. Fig. 24 illustrates a change in the acoustic velocity of a leaky SAW with respect to the thickness of the $SiO_2$ film. Figs. 23 and 24 show that a change in the acoustic velocity of the SAW is much larger when the thickness of the IDT is varied than when the thickness of the $SiO_2$ film is varied. Accordingly, it is desirable that the frequency is adjusted before the formation of the $SiO_2$ film, for example, it is desirable that the frequency is adjusted after an Au IDT is formed by laser etching or ion etching. More preferably, the normalized thickness of the Au IDT ranges from 0.015 to 0.030, in which case, a change in the acoustic velocity by a variation of a $SiO_2$ film becomes small, and a frequency fluctuation due to a variation of the $SiO_2$ film can be decreased.

θ of the Euler angles may sometimes deviate from the desired angle by -2° to +4°. This deviation is generated due to the fact that calculations were made in this embodiment, assuming that a metallic film was formed on the entire surface of the substrate, and there may be some errors within the above range in actual SAW apparatuses.

When manufacturing SAW apparatuses, although ϕ and ψ of the Euler angles deviate from 0° by ±3°, substantially the same characteristic as that when ϕ and ψ are 0° can be obtained.

A SAW apparatus of a third embodiment is described below. The SAW apparatus of the third embodiment is similar to the SAW apparatus 21 of the second embodiment shown in Fig. 15, except that the IDTs 23a and 23b are made of Ag.

As stated below, when the IDTs 23a and 23b are made of Ag, the thickness H/λ of the IDTs 23a and 23b standardized by the SAW wavelength λ is preferably from 0.01 to 0.08.

According to the SAW apparatus of the third embodiment, the IDTs 23a and 23b are made of Ag on the $LiTaO_3$ substrate 22, and the thickness of the IDTs 23a and 23b can be decreased. Since the $LiTaO_3$ substrate having particular Euler angles is used, the attenuation constant can be considerably decreased, thereby achieving low insertion loss. By the formation of the $SiO_2$ film 25, a desirable level of temperature coefficient for the frequency (TCP) can be implemented. This is described in detail below by way of specific examples.

SAWs propagating in a $LiTaO_3$ substrate include, not only Rayleigh wave, but also leaky SAW (LSAW). Although the LSAW has a higher acoustic velocity and a greater electromechanical coupling coefficient than the Rayleigh wave, it propagates while radiating energy in the substrate. Accordingly, the LSAW causes attenuation, resulting in the insertion loss.

Fig. 36 illustrates the relationship between the electromechanical coupling coefficient $K_{SAW}$ and the normalized thickness H/λ of an Ag IDT on a 36°-rotated Y-cut X-propagating $LiTaO_3$ substrate (having Euler angles (0°, 126°, 0°)). It should be noted that λ represents the wavelength at the center frequency of the SAW apparatus.

Fig. 36 shows that, when the normalized thickness H/λ of the Ag film ranges from 0.01 to 0.08, the electromechanical coupling coefficient $K_{SAW}$ becomes 1.5 times or greater than a SAW apparatus without an Ag film (H/λ =0). When the normalized thickness H/λ of the Ag film ranges from 0.02 to 0.06, the electromechanical coupling coefficient $K_{SAW}$ becomes 1.7 times or greater than a SAW apparatus without an Ag film. When the normalized thickness H/λ of the Ag film ranges from 0.03 to 0.05, the electromechanical coupling coefficient $K_{SAW}$ becomes 1.8 times or greater than a SAW apparatus without an Ag film.

If the normalized thickness H/λ of the Ag film exceeds 0.08, it becomes difficult to form an Ag IDT. Accordingly, in order to obtain a large electromechanical coupling coefficient without a difficulty in forming an Ag IDT, the normalized thickness of the Ag IDT is desirably from 0.01 to 0.08, and more preferably, from 0.02 to 0.06, and further preferably, 0.03 to 0.05.

The relationship between the TCF and the normalized thickness Hs/λ of a $SiO_2$ film formed on a $LiTaO_3$ substrate is shown in Fig. 37. In Fig. 37, the results obtained when three types of $LiTaO_3$ substrates having Euler angles (0°, 113°, 0°), (0°, 126°, 0°), (0°, 129°, 0°) were used are shown. In this example, an electrode is not formed.

Fig. 37 reveals that the TCF ranges from -20 to +20 ppm/°C when the normalized thickness Hs/λ of the $SiO_2$ film is from 0.15 to 0.45 regardless of whether the angle of θ is 113°, 126°, or 129°. However, since it takes time to form a $SiO_2$ film, the normalized thickness Hs/λ of the $SiO_2$ film is desirably from 0.15 to 0.40.

It is known that the TCF of the Rayleigh wave is improved by the formation of a $SiO_2$ film on a $LiTaO_3$ substrate. No experiments have been made, however, that an Ag electrode is formed on a $LiTaO_3$ substrate and a $SiO_2$ film is laminated by considering the thickness of the Ag electrode, the thickness of the $SiO_2$ film, the Euler angles, and the attenuation constant of a leaky SAW.

Fig. 38 illustrates a change in the attenuation constant α when Ag electrodes having a normalized thickness H/λ of 0.10 or smaller and $SiO_2$ films having a normalized thickness Hs/λ of 0 to 0.5 were formed on a $LiTaO_3$ substrate having Euler angles (0°, 120°, 0°). Fig. 38 shows that the attenuation constant α is small when the normalized thickness Hs/λ of the $SiO_2$ film is 0.2 to 0.4, and when the normalized thickness H/λ of the Ag film is 0.01 to 0.10.

Fig. 39 illustrates a change in the attenuation constant α when Ag electrodes having a normalized thickness H/λ of 0 to 0.10 and $SiO_2$ films having a normalized thickness Hs/λ of 0 to 0.5 were formed on a $LiTaO_3$ substrate having Euler angles (0°, 140°, 0°). As is seen from Fig. 39, when θ is 140°, the attenuation constant α becomes larger as the thickness of the $SiO_2$ film is changed as described above when the normalized thickness of the Ag film is 0.06 or smaller.

That is, in order to achieve an improved TCF, a large electromechanical coupling coefficient, and a small attenuation constant, it is necessary to suitably combine the cut angle, i.e., the Euler angles, of a $LiTaO_3$ substrate, the thickness of a $SiO_2$ film, and the thickness of an Ag film.

Figs. 40 through 47 illustrate the relationship between the attenuation constant α and θ of the Euler angles when Ag films having a normalized thickness H/λ of 0.1 or smaller were formed on a $LiTaO_3$ substrate and when the normalized thickness Hs/λ of the $SiO_2$ film was changed to 0.1, 0.15, 0.2, 0.25, 0.3, 0.35, 0.4, and 0.45, respectively.

As is seen from Figs. 40 through 47, by setting the normalized thickness of the Ag film to be 0.01 to 0.08 and by selecting any of the following combinations of the $SiO_2$ film and θ of the Euler angles shown in Table 3, it is possible to implement a high level of TCF, a large electromechanical coupling coefficient, and a small attenuation constant α. It is desirable that more preferable Euler angles are selected shown at the right side of Table 3, in which case, a higher level of characteristics can be exhibited.

Table 3

| Ag normalized thickness H/λ: 0.01 to 0.08 | | |
|---|---|---|
| $SiO_2$ normalized thickness (Hs/λ) | Euler angles $LiTaO_3$ (°) | More preferable Euler angles (°) |
| 0.15 - 0.18 | 0±3, 117 to 137, 0±3 | 0±3, 120 to 135, 0±3 |
| 0.18 - 0.23 | 0±3, 117 to 136, 0±3 | 0±3, 118 to 133, 0±3 |
| 0.23 - 0.28 | 0±3, 115 to 135, 0±3 | 0±3, 117 to 133, 0±3 |
| 0.28 - 0.33 | 0±3, 113 to 133, 0±3 | 0±3, 115 to 132, 0±3 |
| 0.33 - 0.38 | 0±3, 113 to 135, 0±3 | 0±3, 115 to 133, 0±3 |
| 0.38 - 0.40 | 0±3, 113 to 132, 0±3 | 0±3, 115 to 130, 0±3 |

More preferably, when the standard thickness H/λ of the Ag film is 0.02 to 0.06, any of the following combinations shown in Table 4 of the normalized thickness of the $SiO_2$ film and θ of the Euler angles, and even more desirably, more preferable Euler angles at the right side of Table 4, are selected, and then, a higher level of desirable characteristics is obtained.

Table 4

| Ag normalized thickness H/λ: 0.02 to 0.06 | | |
|---|---|---|
| $SiO_2$ normalized thickness (Hs/λ) | Euler angles $LiTaO_3$ (°) | More preferable Euler angles (°) |
| 0.15 - 0.18 | 0±3, 120 to 133, 0±3 | 0±3, 122 to 130, 0±3 |
| 0.18 - 0.23 | 0±3, 120 to 137, 0±3 | 0±3, 122 to 136, 0±3 |
| 0.23 - 0.28 | 0±3, 120 to 135, 0±3 | 0±3, 122 to 133, 0±3 |
| 0.28 - 0.33 | 0±3, 118 to 135, 0±3 | 0±3, 120 to 133, 0±3 |
| 0.33 - 0.38 | 0±3, 115 to 133, 0±3 | 0±3, 117 to 130, 0±3 |
| 0.38 - 0.40 | 0±3, 113 to 130, 0±3 | 0±3, 115 to 128, 0±3 |

Even more preferably, when the standard thickness H/λ of the Ag film is 0.03 to 0.05, any of the following combinations shown in Table 5 of the normalized thickness of the $SiO_2$ film and θ of the Euler angles, and even more desirably, more preferable Euler angles at the right side of Table 5, are selected, and then, the characteristics can be further improved.

Table 5

| Ag normalized thickness H/λ: 0.03 to 0.05 | | |
|---|---|---|
| $SiO_2$ normalized thickness (Hs/λ) | Euler angles $LiTaO_3$ (°) | More preferable Euler angles (°) |
| 0.15 - 0.18 | 0±3, 122 to 142, 0±3 | 0±3, 123 to 140, 0±3 |
| 0.18 - 0.23 | 0±3, 120 to 140, 0±3 | 0±3, 122 to 137, 0±3 |
| 0.23 - 0.28 | 0±3, 117 to 138, 0±3 | 0±3, 120 to 135, 0±3 |
| 0.28 - 0.33 | 0±3, 116 to 136, 0±3 | 0±3, 118 to 134, 0±3 |
| 0.33 - 0.38 | 0±3, 114 to 135, 0±3 | 0±3, 117 to 133, 0±3 |
| 0.38 - 0.40 | 0±3, 113 to 130, 0±3 | 0±3, 115 to 128, 0±3 |

In the present embodiment, the IDT may be made of only Ag. Alternatively, the IDT may be made of an Ag alloy or a laminated electrode of Ag and another metal as long as such an alloy or a laminated electrode essentially consists of Ag. In this case, it is necessary that Ag constitutes 80% by weight of the total IDT. Accordingly, an Al thin film or a Ti thin film may be formed as an underlying layer of the Ag IDT, in which case, it is necessary that Ag constitutes 80% by weight of a total of the underlying layer and the IDT.

In the above-described example, a $LiTaO_3$ substrate having Euler angles (0°, θ, 0°) was used, and normally, there is a variation of 0±3° in $\phi$ and $\psi$. However, even in a $LiTaO_3$ substrate having such a variation, i.e., (0±3°, 113° to 142°, 0±3°), advantages of the present invention can be achieved.

$\theta$ of the Euler angles may sometimes deviate from the desired angle by -2° to +4°. This deviation is generated due to the fact that calculations were made in this embodiment, assuming that a metallic film was formed on the entire surface of the substrate, and there may be some errors within the above range in actual SAW apparatuses.

A SAW apparatus of a fourth embodiment is described below. The SAW apparatus of the fourth embodiment is similar to the SAW apparatus 21 of the second embodiment shown in Fig. 15, except that the IDTs 23a and 23b are made of Cu. Since the electrodes are made of Cu having a higher density than Al, the electromechanical coupling coefficient and the reflection coefficient can be improved.

Fig. 58 illustrates the relationship between the reflection coefficient of a Cu electrode and that of an Al electrode and the normalized thickness of the corresponding electrode when the normalized thickness of a $SiO_2$ film is 0.20.

Fig. 58 shows that the reflection coefficient per electrode finger can be increased when the Cu electrode was used rather than the Al electrode so that the number of electrode fingers can be decreased. Thus, the size of the reflectors can be reduced, and accordingly, the overall size of the resulting SAW apparatus can be reduced.

As discussed below, the thickness $H/\lambda$ of the IDTs 23a and 23b standardized by the wavelength $\lambda$ is preferably from 0.01 to 0.08.

Fig. 48 illustrates a change in the attenuation constant $\alpha$ when Cu electrodes having a normalized thickness of $H/\lambda$ of 0.10 or smaller and $SiO_2$ films having a normalized thickness $Hs/\lambda$ of 0 to 0.5 were formed on a $LiTaO_3$ substrate having Euler angles (0°, 120°, 0°). Fig. 48 shows that the attenuation constant $\alpha$ is small when the normalized thickness $Hs/\lambda$, of the $SiO_2$ film is 0.2 to 0.4 and when the normalized thickness $H/\lambda$ of the Cu film is 0.01 to 0.10.

Fig. 49 illustrates a change in the attenuation constant $\alpha$ when Cu electrodes having a normalized thickness of $H/\lambda$ of 0 to 0.10 and $SiO_2$ films having a normalized thickness $Hs/\lambda$ of 0 to 0.5 were formed on a $LiTaO_3$ substrate having Euler angles (0°, 135°, 0°). As is seen from Fig. 49, when $\theta$ is 135°, the attenuation constant $\alpha$ becomes larger as the thickness of the Cu film and that of the $SiO_2$ film are changed as described above.

Accordingly, it order to achieve an improved TCF, a large electromechanical coupling coefficient, and a small attenuation constant, it is necessary to suitably combine the cut angle, i.e., the Euler angles, of a $LiTaO_3$ substrate, the thickness of a $SiO_2$ film, and the thickness of a Cu electrode.

Figs. 50 through 57 illustrate the relationship between the attenuation constant $\alpha$ and $\theta$ of the Euler angles when Cu films having a normalized thickness $H/\lambda$ of 0.1 or smaller were formed on a $LiTaO_3$ substrate and when the normalized thickness $Hs/\lambda$ of the $SiO_2$ film was changed to 0.1, 0.15, 0.2, 0.25, 0.3, 0.35, 0.4, and 0.45, respectively.

As is seen from Figs. 50 through 57, by setting the normalized thickness $H/\lambda$ of the Cu film to be 0.01 to 0.08 and by selecting any of the following combinations of the normalized thickness of the $SiO_2$ film and $\theta$ of the Euler angles shown in Table 6, it is possible to implement an improved TCF (±20 ppm/°C), a large electromechanical coupling coefficient, and a small attenuation constant $\alpha$. It is desirable that more preferable Euler angles shown at the right side of Table 6 are selected, in which case, a higher level of characteristics can be exhibited.

Table 6

| $SiO_2$ normalized thickness ($Hs/\lambda$) | Euler angles of $LiTaO_3$ (°) | More preferable Euler angles (°) |
|---|---|---|
| 0.15 - 0.18 | 0±3, 117 to 137, 0±3 | 0±3, 120 to 135, 0±3 |
| 0.18 - 0.23 | 0±3, 117 to 136, 0±3 | 0±3, 118 to 133, 0±3 |
| 0.23 - 0.28 | 0±3, 115 to 135, 0±3 | 0±3, 117 to 133, 0±3 |
| 0.28 - 0.33 | 0±3, 113 to 133, 0±3 | 0±3, 115 to 132, 0±3 |
| 0.33 - 0.38 | 0±3, 113 to 135, 0±3 | 0±3, 115 to 133, 0±3 |
| 0.38 - 0.40 | 0±3, 113 to 132, 0±3 | 0±3, 115 to 130, 0±3 |

As can be inferred from the electromechanical coupling coefficient $K_{SAW}$ when the Au electrode was used shown in Fig. 25, the electromechanical coupling coefficient $K_{SAW}$ is considerably increased when $\theta$ of the Euler angle is 125° or smaller. Accordingly, it is more preferable that the combinations of the normalized thickness $Hs/\lambda$ of the $SiO_2$ film and the Euler angles shown in Table 7 are selected.

Table 7

| $SiO_2$ normalized thickness ($Hs/\lambda$) | Euler angles of $LiTaO_3$ (°) |
|---|---|
| 0.15 - 0.18 | 0±3, 117 to 125, 0±3 |

(continued)

| $SiO_2$ normalized thickness (Hs/λ) | Euler angles of $LiTaO_3$ (°) |
|---|---|
| 0.18 - 0.23 | 0±3, 117 to 125, 0±3 |
| 0.23 - 0.28 | 0±3, 115 to 125, 0±3 |
| 0.28 - 0.33 | 0±3, 113 to 125, 0±3 |
| 0.33 - 0.38 | 0±3, 113 to 125, 0±3 |
| 0.38 - 0.40 | 0±3, 113 to 125, 0±3 |

The Euler angle $\theta_{min}$ that reduces the attenuation constant α to 0 or minimizes the attenuation constant α with respect to the normalized thickness Hs/λ, of the $SiO_2$ film and the normalized thickness H/λ of the Cu film was determined from the results of Figs. 48 through 56. Such an Euler angle $\theta_{min}$ is shown in Fig. 59.

By approximating the curves shown in Fig. 59 by a cubic polynomial when the normalized thickness H/λ of the Cu film is 0, 0.02, 0.04, 0.06, and 0.08, the following equations A through E are found.

(a) When $0 < H/\lambda \leq 0.01$

$$\theta_{min} = [(-139.713xHs^3) + (43.07132xHs^2) - (20.568011xHs) + 125.8314] \quad ...A$$

(b) When $0.01 < H/\lambda \leq 0.03$

$$\theta_{min} = [(-139.660xHs^3) + (46.02985xHs^2) - (21.141500xHs) + 127.4181] \quad ...B$$

(c) When $0.03< H/\lambda \leq 0.05$

$$\theta_{min} = [(-139.607xHs^3) + (48.98838xHs^2) - (21.714900xHs) + 129.0048] \quad ...C$$

(d) When $0.05< H/\lambda \leq 0.07$

$$\theta_{min} = [(-112.068xHs^3) + (39.60355xHs^2) - (21.186000xHs) + 129.9397] \quad ...D;$$

and

(e) When $0.07 < H/\lambda \leq 0.09$

$$\theta_{min} = [(-126.954xHs^3) + (67.40488xHs^2)- (29.432000xHs) + 131.5686] \quad ...E$$

Accordingly, it is preferable that θ of the Euler angles (0±3°, θ, 0±3°) is $\theta_{min}$ expressed by the above-described equations A through E. However, when $\theta_{min} - 2° < \theta \leq \theta_{min} + 2°$, the attenuation constant can be effectively decreased.

In the present embodiment, the IDT may be made of only Cu. Alternatively, the IDT may be made of a Cu alloy or a laminated electrode of Cu and another metal as long as such an alloy or a laminated electrode essentially consists of Cu. More specifically, the IDT primarily including Cu must satisfy the following condition when the average density of the electrode is indicated by ρ (average):

$$\rho\ (Cu) \times 0.7 \leq \rho\ (average) \leq \rho\ (Cu) \times 1.3,$$

i.e., 6.25 g/cm$^3$ ≤ ρ (average) ≤ 11.6 g/cm$^3$.

An upper layer or an underlying layer made of a metal having a density higher than Al, such as W, Ta, Au, Pt, Ag, or Cr, may be laminated on the Cu electrode so that ρ (average) satisfies the above-described condition. In this case, advantages similar to those obtained by a single Cu layer can be achieved.

θ of the Euler angles may sometimes deviate from the desired angle by -2° to +4°. This deviation is generated due to the fact that calculations were made in this embodiment, assuming that a metallic film was formed on the entire surface of the substrate, and there may be some errors within the above range in actual SAW apparatuses.

When manufacturing SAW apparatuses, there is a variation of 0±3° in ϕ and ψ of the Euler angles. However, substantially the same characteristic as that when ϕ and ψ are 0° can be obtained.

A SAW apparatus of a fifth embodiment is described below. The SAW apparatus of the fifth embodiment is similar to the SAW apparatus 21 of the second embodiment shown in Fig. 15, except that the IDTs 23a and 23b and the reflectors 24a and 24b are made of tungsten (W). The normalized thickness H/λ of the IDTs is 0.0025 to 0.06.

As the piezoelectric substrate 22, a 22° to 48°-rotated Y-cut X-propagating $LiTaO_3$ substrate having Euler angles (0°, 112° to 138°, 0°) was used.

In the fifth embodiment, since the 22° to 48°-rotated Y-cut X-propagating $LiTaO_3$ substrate 22, the IDTs 23a and 23b made of tungsten having a normalized thickness H/λ of 0.0025 to 0.06, and the $SiO_2$ film 25 having a normalized thickness Hs/λ of 0.10 to 0.40 were used, it is possible to provide a SAW apparatus that has an improved TCF, a large electromechanical coupling coefficient $K_{SAW}$, and a small propagation loss. The fifth embodiment is described in detail below by way of a specific example.

Figs. 60 and 61 illustrate a change in the attenuation constant α when tungsten IDTs having different thickness values and $SiO_2$ films having different thickness values were formed on a $LiTaO_3$ substrate having Euler angles (0°, 120°, 0°) and a $LiTaO_3$ substrate having Euler angles (0°, 140°, 0°), respectively.

As is seen from Fig. 60, when θ is 120°, the attenuation constant α is small when the normalized thickness Hs/λ of the $SiO_2$ film is 0.1 to 0.4 and the normalized thickness H/λ of the tungsten electrode is 0.0 to 0.10. As is seen from Fig. 61, when θ is 140° the attenuation constant α is increased compared to the case where $\theta_{min}$ is 120° for normalized thickness H/λ of the tungsten electrode 0.0 to 0.10, regardless of the normalized thickness Hs/λ of the $SiO_2$ film.

That is, in order to reduce the TCF to ±20 ppm/°C, to achieve a large electromechanical coupling coefficient, and to decrease the attenuation constant, three conditions, i.e., the Euler angles of the $LiTaO_3$ substrate, the thickness of the $SiO_2$ film, and the thickness of the tungsten electrode, must be considered.

Figs. 62 through 65 illustrate the relationship between the attenuation constant α and θ of the Euler angles when the normalized thickness Hs/λ of the $SiO_2$ film and the normalized thickness H/λ of the tungsten electrode were changed.

As is seen from Figs. 62 through 65, optimal combinations of the normalized thickness of the $SiO_2$ film and θ when the normalized thickness H/λ of the tungsten electrode is 0.012 to 0.053 and is 0.015 to 0.042 can be shown in Table 8 and Table 9. θ shown in Table 8 and Table 9 may vary by about -2° to +4° due to a variation in the electrode finger width of the tungsten electrode or a variation in the single crystal substrate. The thickness values which are not shown in Figs. 62 through 65 were determined by the proportional distribution.

Table 8

| Tungsten normalized thickness H/λ: 0.012 to 0.053 | | |
|---|---|---|
| $SiO_2$ normalized thickness (Hs/λ) | Euler angles of $LiTaO_3$ (°) | More preferable Euler angles (°) |
| 0.10 - 0.15 | 0±3, 114.2 to 138.0, 0±3 | 0±3, 117.7 to 134.0, 0±3 |
| 0.15 - 0.20 | 0±3, 113.0 to 137.8, 0±3 | 0±3, 117.0 to 133.5, 0±3 |
| 0.20 - 0.30 | 0±3, 113.0 to 137.5, 0±3 | 0±3, 116.5 to 133.0, 0±3 |
| 0.30 - 0.35 | 0±3, 112.7 to 137.0, 0±3 | 0±3, 116.5 to 133.0, 0±3 |
| 0.35 - 0.40 | 0±3, 112.5 to 136.0, 0±3 | 0±3, 116.5 to 132.3, 0±3 |

Table 9

| Tungsten normalized thickness H/λ: 0.015 to 0.042 | | |
|---|---|---|
| $SiO_2$ normalized thickness (Hs/λ) | Euler angles of $LiTaO_3$ (°) | More preferable Euler angles (°) |
| 0.10 - 0.15 | 0±3, 114.3 to 138.0, 0±3 | 0±3, 117.7 to 133.5, 0±3 |

(continued)

| Tungsten normalized thickness H/λ: 0.015 to 0.042 | | |
|---|---|---|
| $SiO_2$ normalized thickness (Hs/λ) | Euler angles of $LiTaO_3$ (°) | More preferable Euler angles (°) |
| 0.15 - 0.20 | 0±3, 113.0 to 137.5, 0±3 | 0±3, 117.7 to 133.5, 0±3 |
| 0.20 - 0.30 | 0±3, 112.5 to 137.0, 0±3 | 0±3, 117.0 to 132.5, 0±3 |
| 0.30 - 0.35 | 0±3, 112.2 to 136.5, 0±3 | 0±3, 116.8 to 132.5, 0±3 |
| 0.35 - 0.40 | 0±3, 112.0 to 135.3, 0±3 | 0±3, 116.0 to 131.5, 0±3 |

When the normalized thickness H/λ of the tungsten electrode is 0.012 to 0.053, as indicated in Table 8, the normalized thickness Hs/λ of the $SiO_2$ film is set to be 0.1 to 0.4 in order to set the range of the TCF to be ±20 ppm/°C. In this case, θ of the Euler angles of the $LiTaO_3$ substrate must be 112° to 138° (corresponding to the rotation angle of 20° to 50°), and more preferably, the Euler angles indicated at the right side of Table 8 are selected.

Similarly, when the normalized thickness H/λ of the tungsten electrode is 0.015 to 0.042, as indicated in Table 9, the normalized thickness Hs/λ of the $SiO_2$ film is set to be 0.1 to 0.4 in order to set the range of the TCF to be ±20 ppm/°C. In this case, θ of the Euler angles of the $LiTaO_3$ substrate must be 112° to 138°, and more preferably, the Euler angles indicated at the right side of Table 9 are selected according to the normalized thickness of the $SiO_2$ film.

The Euler angles of $LiTaO_3$ shown in Table 8 and Table 9 were selected so that the attenuation constant becomes 0.05 or lower. The more preferable Euler angles shown in Table 8 and Table 9 were selected so that the attenuation constant becomes 0.025 or lower. The relationships between the Hs/λ of the $SiO_2$ film and the Euler angles shown in Table 8 and Table 9 when the normalized thickness H/λ of the tungsten electrode is 0.012, 0.015, 0.042, and 0.053 were determined in terms of the normalized thickness H/λ of the tungsten electrode shown in Figs. 62 through 65.

When manufacturing the SAW apparatus of this embodiment, it is preferable that an IDT primarily including tungsten is formed on a rotated Y-cut X-propagating $LiTaO_3$ substrate, and in this state, the frequency is adjusted, and then, a $SiO_2$ film having a thickness that can reduce the attenuation constant α is formed. This is explained below with reference to Figs. 66 and 67. Tungsten IDTs having different thickness values and $SiO_2$ films having different thickness values were formed on a rotated Y-cut X-propagating $LiTaO_3$ substrate (Euler angles (0°, 126°, 0°)). Fig. 66 illustrates a change in the acoustic velocity of a leaky SAW with respect to the normalized thickness of the $SiO_2$ film. Fig. 67 illustrates a change in the acoustic velocity of a leaky SAW with respect to the normalized thickness of the tungsten electrode. Figs. 66 and 67 show that a change in the acoustic velocity of the SAW is much larger when the thickness of the tungsten IDT is varied than when the thickness of the $SiO_2$ film is varied. Accordingly, it is desirable that the frequency is adjusted before the formation of the $SiO_2$ film, for example, it is desirable that the frequency is adjusted after a tungsten IDT is formed by laser etching or ion etching.

In this embodiment, a 22° to 48°-rotated Y-cut X-propagating $LiTaO_3$ substrate having Euler angles (0°, 112° to 138°, 0°), a tungsten IDT having a normalized thickness H/λ of 0.0025 to 0.06, and a $SiO_2$ film having a normalized thickness Hs/λ of 0.10 to 0.40 are used. The number and the structure of IDTs are not particularly restricted. That is, the present embodiment can be applied to, not only the SAW apparatus shown in Fig. 15, but also various types of SAW resonators and SAW filters as long as the above-described conditions are satisfied.

θ of the Euler angles may sometimes deviate from the desired angle by -2° to +4°. This deviation is generated due to the fact that calculations were made in this embodiment, assuming that a metallic film was formed on the entire surface of the substrate, and there may be some errors within the above range in actual SAW apparatuses.

When manufacturing SAW apparatuses, although ϕ and ψ of the Euler angles deviate from 0° by ±3°, substantially the same characteristic as that when ϕ and ψ are 0° can be obtained.

A SAW apparatus of a sixth embodiment is described below. The SAW apparatus of the sixth embodiment is similar to the SAW apparatus 21 of the second embodiment shown in Fig. 15. However, as the piezoelectric substrate 22, a 14° to 58°-rotated Y-cut X-propagating $LiTaO_3$ substrate having Euler angles (0°, 104° to 148°, 0°) was used, and IDTs made of tantalum (Ta) having the normalized thickness H/λ of 0.004 to 0.055 were used.

In the sixth embodiment, since the 14° to 58°-rotated Y-cut X-propagating $LiTaO_3$ substrate 22 having Euler angles (0°, 104° to 148°, 0°), the IDTs 23a and 23b made of tantalum having a normalized thickness H/λ of 0.004 to 0.055, and the $SiO_2$ film 25 having a normalized thickness Hs/λ of 0.10 to 0.40 were used, it is possible to provide a SAW apparatus that has an improved TCF, a large electromechanical coupling coefficient $K_{SAW}$, and a small propagation loss. The sixth embodiment is described in detail below by way of a specific example.

Figs. 68 and 69 illustrate a change in the attenuation constant α when tantalum IDTs having different thickness values and $SiO_2$ films having different thickness values were formed on a $LiTaO_3$ substrate having Euler angles (0°, 120°, 0°) and a $LiTaO_3$ substrate having Euler angles (0°, 140°, 0°).

As is seen from Fig. 68, when θ is 120°, the attenuation constant α is small when the normalized thickness Hs/λof the $SiO_2$ film is 0.1 to 0.4 and when the thickness H/λof the tantalum electrode is 0.0 to 0.1. In contrast, as is seen from Fig. 69, when θ is 140°, the attenuation constant α is large when the normalized thickness H/λ of the tantalum electrode is 0.0 to 0.06 regardless of the normalized thickness Hs/λ of the $SiO_2$ film.

That is, in order to decrease the absolute value of the TCF, to achieve a large electromechanical coupling coefficient, and to decrease the attenuation constant, three conditions, i.e., the Euler angles of the $LiTaO_3$ substrate, the thickness of the $SiO_2$ film, and the thickness of the tantalum electrode, must be considered.

Figs. 70 and 73 illustrate relationships between the attenuation constant α and θ when the normalized thickness Hs/λ of the $SiO_2$ film and the normalized thickness H/λ of the tantalum electrode were changed.

As is seen from Figs. 70 through 73, optimal combinations of the normalized thickness Hs/λ of the $SiO_2$ film and θ when the normalized thickness H/λ of the tantalum electrode is 0.01 to 0.055 and 0.016 to 0.045 can be shown in Table 10 and Table 11, respectively. θ shown in Table 10 and Table 11 may vary by about -2° to +4° due to a variation in the electrode finger width of the tantalum electrode or a variation in the single crystal substrate.

Table 10

| Tantalum normalized thickness H/λ: 0.01 to 0.055 | | |
|---|---|---|
| $SiO_2$ normalized thickness (Hs/λ) | Euler angles of $LiTaO_3$ (°) | More preferable Euler angles (°) |
| 0.10 - 0.15 | 0±3, 110.5 to 148.0, 0±3 | 0±3, 116.0 to 143.0, 0±3 |
| 0.15 - 0.20 | 0±3, 108.0 to 147.5, 0±3 | 0±3, 115.0 to 141.5, 0±3 |
| 0.20 - 0.30 | 0±3, 105.0 to 148.0, 0±3 | 0±3, 111.0 to 139.0, 0±3 |
| 0.30 - 0.35 | 0±3, 104.5 to 148.0, 0±3 | 0±3, 111.0 to 139.0, 0±3 |
| 0.35 - 0.40 | 0±3, 104.0 to 145.0, 0±3 | 0±3, 110.0 to 138.5, 0±3 |

Table 11

| Tantalum normalized thickness H/λ: 0.016 to 0.045 | | |
|---|---|---|
| $SiO_2$ normalized thickness (Hs/λ) | Euler angles of $LiTaO_3$ (°) | More preferable Euler angles (°) |
| 0.10 - 0.15 | 0±3, 113.0 to 144.0, 0±3 | 0±3, 118.0 to 140.0, 0±3 |
| 0.15 - 0.20 | 0±3, 111.0 to 144.0, 0±3 | 0±3, 117.0 to 139.5, 0±3 |
| 0.20 - 0.30 | 0±3, 108.0 to 144.0, 0±3 | 0±3, 113.0 to 139.0, 0±3 |
| 0.30 - 0.35 | 0±3, 107.5 to 143.0, 0±3 | 0±3, 112.5 to 137.0, 0±3 |
| 0.35 - 0.40 | 0±3, 107.0 to 140.5, 0±3 | 0±3, 112.0 to 135.5, 0±3 |

When the normalized thickness H/λ of the tantalum electrode is 0.01 to 0.055, as indicated in Table 10, the normalized thickness Hs/λ of the $SiO_2$ film is set to be 0.1 to 0.4 in order to set the range of the TCF to be ±20 ppm/°C. In this case, θ of the Euler angles of the $LiTaO_3$ substrate must be 104° to 148° (corresponding to the rotation angle of 14° to 58°), and more preferably, the Euler angles indicated at the right side of Table 10 are selected according to the normalized thickness Hs/λ of the $SiO_2$ film.

Similarly, when the normalized thickness H/λ of the tantalum electrode is 0.016 to 0.045, as indicated in Table 11, the normalized thickness Hs/λ of the $SiO_2$ film is set to be 0.1 to 0.4 in order to improve the TCF. In this case, θ of the Euler angles of the $LiTaO_3$ substrate must be 107° to 144°, and more preferably, the Euler angles indicated at the right side of Table 11 are selected according to the normalized thickness of the $SiO_2$ film.

The Euler angles of $LiTaO_3$ shown in Table 10 and Table 11 were selected so that the attenuation constant becomes 0.05 or lower. The more preferable Euler angles shown in Table 10 and Table 11 were selected so that the attenuation constant becomes 0.025 or lower. The relationships between the Hs/λ of the $SiO_2$ film and the Euler angles shown in Table 10 and Table 11 when the normalized thickness H/λ of the tantalum electrode is 0.012, 0.015, 0.042, and 0.053 were determined in terms of the normalized thickness H/λ of the tantalum electrode shown in Figs. 70 through 73.

When manufacturing the SAW apparatus of this embodiment, it is preferable that an IDT primarily including tantalum is formed on a rotated Y-cut X-propagating $LiTaO_3$ substrate, and in this state, the frequency is adjusted, and

then, a $SiO_2$ film having a thickness that can reduce the attenuation constant $\alpha$ is formed. This is explained below with reference to Figs. 74 and 75. Tantalum IDTs having different thickness values and $SiO_2$ films having different thickness values were formed on a rotated Y-cut X-propagating $LiTaO_3$ substrate (Euler angles (0°, 126°, 0°)). Fig. 74 illustrates a change in the acoustic velocity of a leaky SAW with respect to the normalized thickness of the $SiO_2$ film. Fig. 75 illustrates a change in the acoustic velocity of a leaky SAW with respect to the normalized thickness of the tantalum electrode. Figs. 74 and 75 show that a change in the acoustic velocity of the SAW is much larger when the thickness of the tantalum IDT is varied than when the thickness of the $SiO_2$ film is varied. Accordingly, it is desirable that the frequency is adjusted before the formation of the $SiO_2$ film, for example, it is desirable that the frequency is adjusted after a tantalum IDT is formed by laser etching or ion etching.

In this embodiment, as described above, a 14° to 58°-rotated Y-cut X-propagating $LiTaO_3$ substrate having Euler angles (0°, 104° to 48°, 0), a tantalum IDT having a normalized thickness $H/\lambda$ of 0.004 to 0.055, and a $SiO_2$ film having a normalized thickness $Hs/\lambda$ of 0.10 to 0.40 are used. The number and the structure of IDTs are not particularly restricted. That is, the present embodiment can be applied to, not only the SAW apparatus shown in Fig. 15, but also various types of SAW resonators and SAW filters as long as the above-described conditions are satisfied.

$\theta$ of the Euler angles may sometimes deviate from the desired angle by about - 2° to +4°. This deviation is generated due to the fact that calculations were made in this embodiment, assuming that a metallic film was formed on the entire surface of the substrate, and there may be some errors within the above range in actual SAW apparatuses.

When manufacturing SAW apparatuses, although $\phi$ and $\psi$ of the Euler angles deviate from 0° by $\pm$3°, substantially the same characteristic as that when $\phi$ and $\psi$ are 0° can be obtained.

A SAW apparatus of a seventh embodiment is described below. The SAW apparatus of the seventh embodiment is similar to the SAW apparatus 21 of the second embodiment shown in Fig. 15. However, as the piezoelectric substrate 22, a 0° to 79°-rotated Y-cut X-propagating $LiTaO_3$ substrate having Euler angles (0°, 90° to 69°, 0°) was used, and IDTs made of platinum having the normalized thickness $H/\lambda$ of 0.005 to 0.054 were used.

In the seventh embodiment, since the 0° to 79°-rotated Y-cut X-propagating $LiTaO_3$ substrate 22 having Euler angles (0° , 90° to 69°, 0°), the IDTs 23a and 23b made of platinum having a normalized thickness $H/\lambda$ of 0.005 to 0.054, and the $SiO_2$ film 25 having a normalized thickness $Hs/\lambda$ of 0.10 to 0.40 were used, it is possible to provide a SAW apparatus that has an improved TCF, a large electromechanical coupling coefficient $K_{SAW}$, and a small propagation loss. The seventh embodiment is described in detail below by way of a specific example.

Figs. 76 and 77 illustrate a change in the attenuation constant $\alpha$ when platinum IDTs having different thickness values and $SiO_2$ films having different thickness values were formed on a $LiTaO_3$ substrate having Euler angles (0°, 125°, 0°) and a $LiTaO_3$ substrate having Euler angles (0°, 140°, 0°), respectively.

As is seen from Fig. 76, when $\theta$ is 125°, the attenuation constant $\alpha$ is small when the normalized thickness $Hs/\lambda$ of the $SiO_2$ film is 0.1 to 0.4 and when the normalized thickness $H/\lambda$, of the platinum electrode is 0.005 to 0.06. In contrast, as is seen from Fig. 77, when $\theta$ is 140°, the attenuation constant $\alpha$ is large when the normalized thickness $H/\lambda$ of the platinum electrode is 0.005 to 0.06 regardless of the normalized thickness $Hs/\lambda$ of the $SiO_2$ film.

That is, in order to decrease the absolute value of the TCF, to achieve a large electromechanical coupling coefficient, and to decrease the attenuation constant, three conditions, i.e., the Euler angles of the $LiTaO_3$ substrate, the thickness of the $SiO_2$ film, and the thickness of the platinum electrode, must be considered.

Figs. 78 and 83 illustrate relationships between the attenuation constant $\alpha$ and $\theta$ when the normalized thickness $Hs/\lambda$ of the $SiO_2$ film and the normalized thickness $H/\lambda$ of the platinum electrode were changed.

As is seen from Figs. 78 through 83, it is desirable that $\theta$ is from 90° to 169° when the normalized thickness $H/\lambda$ a of the platinum electrode is 0.005 to 0.054. Combinations of the normalized thickness $Hs/\lambda$ of the $SiO_2$ film and $\theta$ that can reduce the attenuation constant $\alpha$ when the normalized thickness $H/\lambda$ of the platinum electrode is from 0.01 to 0.04 and from 0.013 to 0.033 are shown in Table 12 and Table 13, respectively. The Euler angles of $LiTaO_3$ shown in Table 12 and Table 13 were selected so that the attenuation constant $\alpha$ becomes 0.05 or lower. The more preferable Euler angles shown in Table 12 and Table 13 were selected so that the attenuation constant $\alpha$ becomes 0.025 or lower. $\theta$ shown in Table 12 and Table 13 may vary by about -2° to +4° due to a variation in the electrode finger width of the platinum electrode or a variation in the single crystal substrate.

When manufacturing SAW apparatuses, although $\phi$ and $\psi$ of the Euler angles deviate from 0° by $\pm$ 3°, substantially the same characteristic as that when $\phi$ and $\psi$ are 0° can be obtained.

Table 12

| Platinum normalized thickness $H/\lambda$: 0.01 to 0.04 | | |
|---|---|---|
| $SiO_2$ normalized thickness ($Hs/\lambda$) | Euler angles of $LiTaO_3$ (°) | More preferable Euler angles (°) |
| $0.10 \leq Hs/\lambda < 0.15$ | 0$\pm$3, 90 to 169, 0$\pm$3 | 0$\pm$3, 105 to 153, 0$\pm$3 |
| $0.15 \leq Hs/\lambda < 0.20$ | 0$\pm$3, 90 to 167, 0$\pm$3 | 0$\pm$3, 105 to 152, 0$\pm$3 |

(continued)

| Platinum normalized thickness H/λ: 0.01 to 0.04 | | |
|---|---|---|
| $SiO_2$ normalized thickness (Hs/λ) | Euler angles of $LiTaO_3$ (°) | More preferable Euler angles (°) |
| 0.20 ≤ Hs/λ < 0.25 | 0±3, 90 to 167, 0±3 | 0±3, 107 to 152, 0±3 |
| 0.25 ≤ Hs/λ < 0.30 | 0±3, 90 to 164, 0±3 | 0±3, 104 to 151, 0±3 |
| 0.30 ≤ Hs/λ < 0.40 | 0±3, 90 to 163, 0±3 | 0±3, 105 to 150, 0±3 |

Table 13

| Platinum normalized thickness H/λ: 0.013 to 0.033 | | |
|---|---|---|
| $SiO_2$ normalized thickness (Hs/λ) | Euler angles of $LiTaO_3$ (°) | More preferable Euler angles (°) |
| 0.10 ≤ Hs/λ < 0.15 | 0±3, 106 to 155, 0±3 | 0±3, 116.0 to 147.5, 0±3 |
| 0.15 ≤ Hs/λ < 0.20 | 0±3, 104 to 155, 0±3 | 0±3, 113.5 to 150.0, 0±3 |
| 0.20 ≤ Hs/λ < 0.25 | 0±3, 102 to 155, 0±3 | 0±3, 111.5 to 150.0, 0±3 |
| 0.25 ≤ Hs/λ < 0.30 | 0±3, 102 to 154, 0±3 | 0±3, 112.0 to 146.0, 0±3 |
| 0.30 ≤ Hs/λ < 0.40 | 0±3, 102 to 153, 0±3 | 0±3, 110.0 to 144.5, 0±3 |

When the normalized thickness H/λ of the platinum electrode is 0.01 to 0.04, as indicated in Table 12, the normalized thickness Hs/λ of the $SiO_2$ film is set to be 0.1 to 0.4 in order to set the range of the TCF to be +/-20 ppm/°C. In this case, θ of the Euler angles of the $LiTaO_3$ substrate must be 90° to 169° (corresponding to the rotation angle of 0° to 79°), and more preferably, the Euler angles indicated at the right side of Table 12 are selected according to the normalized thickness Hs/λ of the $SiO_2$ film.

Similarly, when the normalized thickness H/λ of the platinum electrode is 0.013 to 0.033, as indicated in Table 13, the normalized thickness Hs/λ of the $SiO_2$ film is set to be 0.1 to 0.4 in order to set the range of the TCF to be ±20 ppm/°C. In this case, θ of the Euler angles of the $LiTaO_3$ substrate must be 102° to 155°, and more preferably, the Euler angles indicated at the right side of Table 13 are selected according to the normalized thickness of the $SiO_2$ film.

The relationships between the Hs/λ of the $SiO_2$ film and the Euler angles shown in Table 12 and Table 13 when the normalized thickness H/λ of the platinum electrode is from 0.013 to 0.033 were determined in terms of the normalized thickness H/λ of the platinum electrode shown in Figs. 78 through 83.

When manufacturing the SAW apparatus of this embodiment, it is preferable that an IDT primarily including platinum is formed on a rotated Y-cut X-propagating $LiTaO_3$ substrate, and in this state, the frequency is adjusted, and then, a $SiO_2$ film having a thickness that can reduce the attenuation constant α is formed. This is explained below with reference to Figs. 84 and 85. Platinum IDTs having different thickness values and $SiO_2$ films having different thickness values were formed on a rotated Y-cut X-propagating $LiTaO_3$ substrate (Euler angles (0°, 126°, 0°)). Fig. 84 illustrates a change in the acoustic velocity of a leaky SAW with respect to the normalized thickness of the $SiO_2$ film. Fig. 85 illustrates a change in the acoustic velocity of a leaky SAW with respect to the normalized thickness of the platinum electrode. Figs. 84 and 85 show that a change in the acoustic velocity of the SAW is much larger when the thickness of the platinum IDT is varied than when the thickness of the $SiO_2$ film is varied. Accordingly, it is desirable that the frequency is adjusted before the formation of the $SiO_2$ film, for example, it is desirable that the frequency is adjusted after a platinum IDT is formed by laser etching or ion etching.

In this embodiment, a 0° to 79°-rotated Y-cut X-propagating $LiTaO_3$ substrate having Euler angles (0°, 90° to 169°, 0°), a platinum IDT having a normalized thickness H/λ, of 0.005 to 0.054, and a $SiO_2$ film having a normalized thickness Hs/λ of 0.10 to 0.40 are used. The number and the structure of IDTs are not particularly restricted. That is, the present embodiment can be applied to, not only the SAW apparatus shown in Fig. 15, but also various types of SAW resonators and SAW filters as long as the above-described conditions are satisfied.

A SAW apparatus of an eighth embodiment is described below. The SAW apparatus of the eighth embodiment is similar to the SAW apparatus 21 of the second embodiment shown in Fig. 15. However, as the piezoelectric substrate 22, a 14° to 50°-rotated Y-cut X-propagating $LiTaO_3$ substrate having Euler angles (0°, 104° to 140°, 0°) was used, and electrodes made of nickel (Ni) or molybdenum (Mo) were used.

The IDTs 23a and 23b and the reflectors 24a and 24b are made of a metal having a density of 8700 to 10300 $kg/m^3$, a Young's modulus of $1.8 \times 10^{11}$ to $4 \times 10^{11} N/m^2$ and a transversal-wave acoustic velocity of 3170 to 3290 m/s.

Such a metal includes nickel, molybdenum, or an alloy primarily including nickel or molybdenum. The normalized thickness H/λ of the IDTs 23a and 23b ranges from 0.008 to 0.06.

In the eighth embodiment, since the 14° to 50°-rotated Y-cut X-propagating $LiTaO_3$ substrate 22 having Euler angles (0°, 104° to 140°, 0°), the IDTs 23a and 23b made of the above-described type of metal having a normalized thickness H/λ of 0.008 to 0.06, and the $SiO_2$ film 25 having a normalized thickness Hs/λ of 0.10 to 0.40 were used, it is possible to provide a SAW apparatus that has an improved TCF, a large electromechanical coupling coefficient $K_{sAw}$, and a small propagation loss. The eighth embodiment is described in detail below by way of a specific example.

Figs. 86 and 87 illustrate a change in the attenuation constant α when nickel IDTs having different thickness values and $SiO_2$ films having different thickness values were formed on a $LiTaO_3$ substrate having Euler angles (0°, 120°, 0°) and a $LiTaO_3$ substrate having Euler angles (0°, 140°, 0°).

As is seen from Fig. 86, when θ is 120°, the attenuation constant α is small when the normalized thickness His/λ of the $SiO_2$ film is 0.1 to 0.4 and when the normalized thickness H/λ of the nickel electrode is 0.008 to 0.08. In contrast, as is seen from Fig. 87, when θ is 140°, the attenuation constant α is large when the normalized thickness H/λ of the nickel electrode is 0.008 to 0.08 regardless of the normalized thickness Hs/λ of the $SiO_2$ film.

Figs. 88 and 89 illustrate a change in the attenuation constant α when molybdenum IDTs having different thickness values and $SiO_2$ films having different thickness values were formed on a $LiTaO_3$ substrate having Euler angles (0°, 120°, 0°) and a $LiTaO_3$ substrate having Euler angles (0°, 140°, 0°).

As is seen from Fig. 88, when θ is 120°, the attenuation constant α is small when the normalized thickness Hs/λ of the $SiO_2$ film is 0.1 to 0.4 and when the normalized thickness H/λ of the molybdenum electrode is 0.008 to 0.08. In contrast, as is seen from Fig. 89, when θ is 140°, the attenuation constant α is large when the normalized thickness H/λ of the molybdenum electrode is 0.008 to 0.08 regardless of the normalized thickness Hs/λ of the $SiO_2$ film.

That is, in order to decrease the absolute value of the TCF, to achieve a large electromechanical coupling coefficient, and to decrease the attenuation constant, three conditions, i.e., the Euler angles of the $LiTaO_3$ substrate, the thickness of the $SiO_2$ film, and the thickness of a metal having the above-described density, the Young's modulus, and the transversal-wave acoustic velocity, must be considered.

Figs. 90 through 93 illustrate relationships between the attenuation constant α and θ when the normalized thickness Hs/λ of the $SiO_2$ film and the normalized thickness H/A of the nickel electrode were changed.

Figs. 94 through 97 illustrate relationships between the attenuation constant α and θ when the normalized thickness Hs/A of the $SiO_2$ film and the normalized thickness H/A of the molybdenum electrode were changed.

As is seen from Figs. 90 through 97, optimal combinations of the normalized thickness Hs/λ of the $SiO_2$ film and θ when the normalized thickness H/A of the nickel or molybdenum electrode is 0.008 to 0.06, 0.017 to 0.06, and 0.023 to 0.06 are shown in Table 14. θ shown in Table 14 may vary by about -2° to +4° due to a variation in the electrode finger width or a variation in the single crystal substrate.

When manufacturing SAW apparatuses, although ϕ and ψ of the Euler angles deviate from 0° by ±3°, substantially the same characteristic as that when ϕ and ψ are 0° can be obtained.

Table 14

| $SiO_2$ normalized thickness (Hs/λ) | Euler angles of $LiTaO_3$ (°) | More preferable Euler angles (°) |
|---|---|---|
| 0.1 - 0.2 | 0±3, 105 to 140, 0±3 | 0±3, 110 to 135, 0±3 |
| 0.2 - 0.3 | 0±3, 105 to 140, 0±3 | 0±3, 108 to 135, 0±3 |
| 0.3 - 0.4 | 0±3, 104 to 139, 0±3 | 0±3, 108 to 133, 0±3 |

Optimal combinations of the normalized thickness Hs/λ of the $SiO_2$ film and θ when the normalized thickness H/λ of the nickel electrode is 0.008 to 0.06, 0.02 to 0.06, and 0.027 to 0.06 shown in Figs. 90 through 93 are shown in Table 15.

Table 15

| $SiO_2$ normalized thickness (Hs/λ) | Euler angles of $LiTaO_3$ (°) | More preferable Euler angles (°) |
|---|---|---|
| 0.1 - 0.2 | 0±3, 106 to 140, 0±3 | 0±3, 110 to 135, 0±3 |
| 0.2 - 0.3 | 0±3, 105 to 137, 0±3 | 0±3, 108 to 134, 0±3 |
| 0.3 - 0.4 | 0±3, 104 to 133, 0±3 | 0±3, 108 to 132, 0±3 |

Optimal combinations of the normalized thickness Hs/λ of the $SiO_2$ film and θ when the normalized thickness H/λ of the molybdenum electrode is 0.008 to 0.06, 0.017 to 0.06, and 0.023 to 0.06 shown in Figs. 94 through 97 are shown in Table 16.

Table 16

| $SiO_2$ normalized thickness (Hs/λ) | Euler angles of $LiTaO_3$ (°) | More preferable Euler angles (°) |
|---|---|---|
| 0.1 - 0.2 | 0±3, 107 to 141, 0±3 | 0±3, 110 to 135, 0±3 |
| 0.2 - 0.3 | 0±3, 104 to 141, 0±3 | 0±3, 109 to 135, 0±3 |
| 0.3 - 0.4 | 0±3, 104 to 138, 0±3 | 0±3, 108 to 133, 0±3 |

When the normalized thickness H/A of the electrode made of a metal having the above-described density, Young's modulus, and transversal-wave sonic velocity is 0.008 to 0.06, 0.017 to 0.06, and 0.023 to 0.06, as indicated in Table 14, the normalized thickness Hs/A of the $SiO_2$ film is set to be 0.1 to 0.4 in order to set the range of the TCF to be ±20 ppm/°C. In this case, θ of the Euler angles of the $LiTaO_3$ substrate must be 104° to 140° (corresponding to the rotation angle of 14° to 50°), and more preferably, the Euler angles indicated at the right side of Table 14 are selected according to the normalized thickness Hs/λ of the $SiO_2$ film.

Similarly, when the normalized thickness H/λ of the nickel electrode is 0.008 to 0.06, 0.02 to 0.06, and 0.027 to 0.06, the normalized thickness Hs/λ of the $SiO_2$ film is set to be 0.1 to 0.4 in order to set the range of the TCF to be ±20 ppm/°C. In this case, θ of the Euler angles of the $LiTaO_3$ substrate must be 104° to 140°, and more preferably, the Euler angles indicated at the right side of Table 15 are selected according to the normalized thickness His/λ of the $SiO_2$ film.

Similarly, when the normalized thickness H/λ of the molybdenum electrode is 0.008 to 0.06, 0.02 to 0.06, and 0.027 to 0.06, the normalized thickness Hs/λ of the $SiO_2$ film is set to be 0.1 to 0.4 in order to set the range of the TCF to be +/-20 ppm/°C. In this case, θ of the Euler angles of the $LiTaO_3$ substrate must be 104° to 141 °, and more preferably, the Euler angles indicated at the right side of Table 16 are selected according to the thickness of the $SiO_2$ film.

The Euler angles of $LiTaO_3$ shown in Table 14 through Table 16 were selected so that the attenuation constant becomes 0.1 or lower. The more preferable Euler angles shown in Table 14 through Table 16 were selected so that the attenuation constant becomes 0.05 or lower. The relationships between the Hs/λ of the $SiO_2$ film and the Euler angles shown in Table 14 through Table 16 when the normalized thickness H/λ of the electrode is from 0.095, 0.017, and 0.023 were determined in terms of the normalized thickness H/λ of the nickel or molybdenum electrode shown in Figs. 90 through 97.

When manufacturing the SAW apparatus of this embodiment, it is preferable that an IDT made of the above-described specific metal, such as nickel or molybdenum, is formed on a rotated Y-cut X-propagating $LiTaO_3$ substrate, and in this state, the frequency is adjusted, and then, a $SiO_2$ film having a thickness that can reduce the attenuation constant α is formed. This is explained below with reference to Figs. 98 through 101. Nickel and molybdenum IDTs having different thickness values and $SiO_2$ films having different thickness values were formed on a rotated Y-cut X-propagating $LiTaO_3$ substrate (Euler angles (0°, 126°, 0°)). Figs. 98 and 100 illustrate a change in the acoustic velocity of a leaky SAW with respect to the normalized thickness of the nickel electrode and the normalized thickness of the molybdenum electrode, respectively. Figs. 99 and 101 illustrate a change in the acoustic velocity of a leaky SAW with respect to the normalized thickness of the $SiO_2$ film. By comparing Figs. 98 and 99, and Figs. 100 and 101, it is seen that a change in the acoustic velocity of the SAW is much larger when the thickness of the electrode is varied than when the thickness of the $SiO_2$ film is varied. Accordingly, it is desirable that the frequency is adjusted before the formation of the $SiO_2$ film, for example, it is desirable that the frequency is adjusted after a nickel or molybdenum IDT is formed by laser etching or ion etching.

In this embodiment, a 14° to 50°-rotated Y-cut X-propagating $LiTaO_3$ substrate having Euler angles (0°, 104° to 140°, 0°), an IDT made of a metal having the above-described density, Young's modulus, and transversal-wave acoustic velocity, such as nickel or molybdenum, having a normalized thickness H/A of 0.008 to 0.06, and a $SiO_2$ film having a normalized thickness Hs/λ of 0.10 to 0.40 are used. The number and the structure of IDTs are not particularly restricted. That is, the present embodiment can be applied to, not only the SAW apparatus shown in Fig. 15, but also various types of SAW resonators and SAW filters as long as the above-described conditions are satisfied.

Further aspects of the invention are described in the following numbered paragraphs.

1. A surface acoustic wave apparatus comprising:

   a piezoelectric substrate made of $LiTaO_3$ or $LiNbO_3$ whose electromechanical coupling coefficient is 15% or greater;
   at least one electrode provided on said piezoelectric substrate and made of a metal having a density higher than Al or of an alloy primarily including said metal, or made of a laminated film including a metal having a density higher than Al or including an alloy primarily including the metal and another metal;
a first insulating layer provided in an area other than an area in which said at least one electrode is provided, said first insulating layer having substantially the same thickness as the thickness of said at least one electrode; and
a second insulating layer disposed to cover said at least one electrode and said first insulating layer,
wherein the density of said at least one electrode is 1.5 times or greater than the density of said first insulating layer.

2. A surface acoustic wave apparatus comprising:

a piezoelectric substrate;
at least one electrode provided on said piezoelectric substrate;
a protective metal film provided on said at least one electrode and made of a metal or an alloy exhibiting a higher erosion-resistant characteristic than a metal or an alloy constituting said at least one electrode;
a first insulating layer provided in an area other than an area in which said at least one electrode is provided, the thickness of said first insulating layer being substantially the same as a total thickness of said at least one electrode and said protective metal film; and
a second insulating layer arranged to cover said protective metal film and said first insulating layer.

3. A surface acoustic wave apparatus according to paragraph 2, wherein the average density ($\rho_1$) of a laminated structure of said at least one electrode and said protective metal film is 1.5 times or greater than the density ($\rho_2$) of said first insulating layer.
4. A surface acoustic wave apparatus according to paragraph 1, wherein the said first and second insulating layers are made of $SiO_2$.
5. A surface acoustic wave apparatus according to paragraph 1, wherein said surface acoustic wave apparatus utilizes the reflection of a surface acoustic wave.
6. A surface acoustic wave apparatus according to paragraph 1, wherein: said piezoelectric substrate is a $LiTaO_3$ substrate having Euler angles (0±3°, 104° to 140°, 0±3°); said first and second insulating layers are formed of a $SiO_2$ film; the normalized thickness Hs/λ, ranges from 0.03 to 0.45 where Hs indicates a total thickness of the $SiO_2$ film forming said first and second insulating layers, and λ represents a wavelength of a surface acoustic wave; and the normalized thickness H/λ of said at least one electrode satisfies the following expression (1):

$$0.005 \leq H/\lambda \leq [(0.00025\times\rho^2) - (0.01056\times\rho) + (0.16473)] \quad \text{Expression (1)}$$

where H indicates the thickness of said at least one electrode, λ represents the wavelength of the surface acoustic wave, and ρ represents the average density of said at least one electrode.
7. A surface acoustic wave apparatus according to paragraph 1, wherein:

said piezoelectric substrate is a $LiTaO_3$ substrate having Euler angles (0±3°, 115° to 148°, 0±3°); said first and second insulating layers are formed of a $SiO_2$ film; the normalized thickness Hs/λ ranges from 0.03 to 0.45 where Hs indicates a total thickness of the $SiO_2$ film forming said first and second insulating layers and λ represents a wavelength of a surface acoustic wave; the metal having a density higher than Al has a density of 15000 to 23000 kg/$m^3$, a Young's modulus of $0.5\times10^{11}$ to $1.0\times10^{11}$N/$m^2$, or a transversal-wave acoustic velocity of 1000 to 2000 m/s; and the normalized thickness H/λ ranges from 0.013 to 0.032 where H indicates the thickness of said at least one electrode, and λ represents the wavelength of the surface acoustic wave.

8. A surface acoustic wave apparatus according to paragraph 7, wherein the metal having a density higher than Al is Au.
9. A surface acoustic wave apparatus according to paragraph 7, wherein the Euler angles of the piezoelectric $LiTaO_3$ substrate are (0±3°, 132° to 148°, 0±3°).
10. A surface acoustic wave apparatus according to paragraph 7, wherein θ of the Euler angles of the piezoelectric $LiTaO_3$ substrate is 115° or greater but smaller than 132°.
11. A surface acoustic wave apparatus according to paragraph 7, wherein the Euler angles (0±3°, θ, 0±3°) of the piezoelectric $LiTaO_3$ substrate, the normalized thickness H/λ of said at least one electrode, and the normalized thickness Hs/λ of the $SiO_2$ film forming said first and second insulating layers are any one of combinations indicated in Table 1 above.

12. A surface acoustic wave apparatus according to paragraph 7, wherein the Euler angles (0±3°, θ, 0±3°) of the piezoelectric $LiTaO_3$ substrate, the normalized thickness H/λ of said at least one electrode and the normalized thickness Hs/λ of the $SiO_2$ film forming said first and second insulating layers are any one of combinations indicated in Table 2 above.

13. A surface acoustic wave apparatus according to paragraph 1, wherein: said piezoelectric substrate is a $LiTaO_3$ substrate having Euler angles (0±3°, 113 to 142, 0±3°); said first and second insulating layers are formed of a $SiO_2$ film; the normalized thickness Hs/λ ranges from 0.10 to 0.40 where Hs indicates a total thickness of the $SiO_2$ film forming said first and second insulating layers and λ represents a wavelength of a surface acoustic wave; the metal having a density higher than Al has a density of 5000 to 15000 kg/$m^3$, a Young's modulus of $0.5 \times 10^{11}$ to $1.0 \times 10^{11}$ N/$m^2$, or a transversal-wave acoustic velocity of 1000 to 2000 m/s; and the normalized thickness H/λ ranges from 0.01 to 0.08 where H indicates the thickness of said at least one electrode, and λ represents the wavelength of the surface acoustic wave.

14. A surface acoustic wave apparatus according to paragraph 13, wherein the metal having a density higher than Al is Ag.

15. A surface acoustic wave apparatus according to paragraph 13, wherein the normalized thickness H/λ of said at least one electrode is 0.01 to 0.08, the normalized thickness Hs/λ of the $SiO_2$ film forming said first and second insulating layers and the Euler angles of the piezoelectric $LiTaO_3$ substrate are any one of combinations indicated in Table 3 above.

16. A surface acoustic wave apparatus according to paragraph 13, wherein the normalized thickness H/λ of said at least one electrode is 0.02 to 0.06, the normalized thickness Hs/λ of the $SiO_2$ film forming said first and second insulating layers and the Euler angles of the piezoelectric $LiTaO_3$ substrate are any one of combinations indicated in Table 4 above.

17. A surface acoustic wave apparatus according to paragraph 13, wherein the normalized thickness H/λ of said at least one electrode is 0.03 to 0.05, the normalized thickness Hs/λ of the $SiO_2$ film forming said first and second insulating layers and the Euler angles of the piezoelectric $LiTaO_3$ substrate are any one of combinations indicated in Table 5 above.

18. A surface acoustic wave apparatus according to paragraph 1, wherein: said piezoelectric substrate is a $LiTaO_3$ substrate having Euler angles (0±3°, 113° -137°, 0±3°); said first and second insulating layers are formed of a $SiO_2$ film; the normalized thickness Hs/λ ranges from 0.10 to 0.40 where Hs indicates a total thickness of the $SiO_2$ film forming said first and second insulating layers and λ represents a wavelength of a surface acoustic wave; the metal having a density higher than Al has a density of 5000 to 15000 kg/$m^3$, a Young's modulus of $1.0\times10^{11}$ to $2.05\times10^{11}$N/$m^2$, or a transversal-wave acoustic velocity of 2000 to 2800 m/s; and the normalized thickness H/λ, ranges from 0.01 to 0.08 where H indicates the thickness of said at least one electrode and λ represents the wavelength of the surface acoustic wave.

19. A surface acoustic wave apparatus according to paragraph 18, wherein the metal having a density higher than Al is Cu.

20. A surface acoustic wave apparatus according to paragraph 18, wherein the normalized thickness Hs/λ of the $SiO_2$ film forming said first and second insulating layers and the Euler angles of the piezoelectric $LiTaO_3$ substrate are any one of combinations indicated in Table 6 above.

21. A surface acoustic wave apparatus according to paragraph 18, wherein θ of the Euler angles (0±3°, θ, 0±3°) of the piezoelectric $LiTaO_3$ substrate is in a range indicated by the following expression:

$$\theta_{min} - 2^{\circ} < \theta \leq \theta_{min} + 2^{\circ} \quad \text{...Expression (2)}$$

where $\theta_{min}$ is indicated by a value expressed by one of the following equation A through equation E when the normalized thickness H/λ of said at least one electrode is in a range (a) through (e):

(a) When 0 < H/λ ≤ 0.01

$$\theta_{min} = [(-139.713\times Hs^3) + (43.07132\times Hs^2) - (20.568011\times Hs) + 125.8314] \quad \text{...A}$$

(b) When 0.01 < H/λ ≤ 0.03

$$\theta_{min} = [(-139.660 \times Hs^3) + (46.02985 \times Hs^2) - (21.141500 \times Hs) + 127.4181] \quad ...B$$

(c) When $0.03 < H/\lambda \leq 0.05$

$$\theta_{min} = [(-139.607 \times Hs^3) + (48.98838 \times Hs^2) - (21.714900 \times Hs) + 129.0048] \quad ...C$$

(d) When $0.05 < H/\lambda \leq 0.07$

$$\theta_{min} = [(-112.068 \times Hs^3) + (39.60355 \times Hs^2) - (21.186000 \times Hs) + 129.9397] \quad ...D;$$

and
(e) When $0.07 < H/\lambda \leq 0.09$

$$\theta_{min} = [(-126.954 \times Hs^3) + (67.40488 \times Hs^2) - (29.432000 \times Hs) + 131.5686] \quad ...E$$

22. A surface acoustic wave apparatus according to paragraph 18, wherein the normalized thickness $Hs/\lambda$ of the $SiO_2$ film forming said first and second insulating layers and the Euler angles of the piezoelectric $LiTaO_3$ substrate are any one of combinations indicated in Table 7 above.
23. A surface acoustic wave apparatus according to paragraph 1, wherein: said piezoelectric substrate is a $LiTaO_3$ substrate having Euler angles (0±3°, 112° - 138°, 0±3°); said first and second insulating layers are formed of a $SiO_2$ film; the normalized thickness $Hs/\lambda$ ranges from 0.10 to 0.40 where Hs indicates a total thickness of the $SiO_2$ film forming said first and second insulating layers and $\lambda$ represents a wavelength of a surface acoustic wave; the metal having a density higher than Al has a density of 15000 to 23000 $kg/m^3$, a Young's modulus of $2.0 \times 10^{11}$ to $4.5 \times 10^{11} N/m^2$, or a transversal-wave acoustic velocity of 2800 to 3500 m/s; and the normalized thickness $H/\lambda$ ranges from 0.0025 to 0.06 where H indicates the thickness of said at least one electrode and $\lambda$ represents the wavelength of the surface acoustic wave.
24. A surface acoustic wave apparatus according to paragraph 23, wherein the metal having a density higher than Al is tungsten.
25. A surface acoustic wave apparatus according to paragraph 23, wherein the normalized thickness $H/\lambda$ of said at least one electrode is 0.012 to 0.053.
26. A surface acoustic wave apparatus according to claim 25, wherein the normalized thickness $H/\lambda$ of said at least one electrode is 0.015 to 0.042.
27. A surface acoustic wave apparatus according to paragraph 23, wherein said piezoelectric substrate is a $LiTaO_3$ substrate having Euler angles (0±3°, 115° -135°, 0±3°).
28. A surface acoustic wave apparatus according to paragraph 23, wherein the normalized thickness $H/\lambda$ of said at least one electrode is 0.012 to 0.053, the normalized thickness $Hs/\lambda$ of the $SiO_2$ film forming said first and second insulating layers and the Euler angles of the piezoelectric $LiTaO_3$ substrate are any one of combinations indicated in Table 8 above.
29. A surface acoustic wave apparatus according to paragraph 23, wherein the normalized thickness $H/\lambda$, of said at least one electrode is 0.015 to 0.042, the normalized thickness $Hs/\lambda$ of the $SiO_2$ film forming said first and second insulating layers and the Euler angles of the piezoelectric $LiTaO_3$ substrate are any one of combinations indicated in Table 9 above.
30. A surface acoustic wave apparatus according to paragraph 1, wherein: said piezoelectric substrate is a $LiTaO_3$ substrate having Euler angles (0±3°, 104°-148°, 0±3°); said first and second insulating layers are formed of a $SiO_2$ film; the normalized thickness $Hs/\lambda$, ranges from 0.10 to 0.40 where Hs indicates a total thickness of the $SiO_2$ film forming said first and second insulating layers and $\lambda$ represents a wavelength of a surface acoustic wave; the metal having a density higher than Al has a density of 15000 to 23000 $kg/m^3$, a Young's modulus of $1.0 \times 10^{11}$ to $2.0 \times 10^{11} N/m^2$, or a transversal-wave acoustic velocity of 2000 to 2800 m/s; and the normalized thickness $H/\lambda$ ranges from 0.004 to 0.055 where H indicates the thickness of said at least one electrode and $\lambda$ represents the wavelength of the surface acoustic wave.

31. A surface acoustic wave apparatus according to paragraph 30, wherein the metal having a density higher than Al is tantalum.

32. A surface acoustic wave apparatus according to paragraph 30, wherein the normalized thickness H/λ of said at least one electrode is 0.01 to 0.055.

33. A surface acoustic wave apparatus according to paragraph 30, wherein the normalized thickness H/λ of said at least one electrode is 0.016 to 0.045.

34. A surface acoustic wave apparatus according to paragraph 30, wherein said piezoelectric substrate is a $LiTaO_3$ substrate having Euler angles (0±3°, 111 ° - 143°, 0±3°).

35. A surface acoustic wave apparatus according to paragraph 30, wherein the normalized thickness H/λ of said at least one electrode is 0.01 to 0.055, the normalized thickness $H_S/\lambda$ of the $SiO_2$ film forming said first and second insulating layers and the Euler angles of the piezoelectric $LiTaO_3$ substrate are any one of combinations indicated in Table 10 above.

36. A surface acoustic wave apparatus according to paragraph 30, wherein the normalized thickness H/λ of said at least one electrode is 0.016 to 0.045, the normalized thickness Hs/λof the $SiO_2$ film forming said first and second insulating layers and the Euler angles of the piezoelectric $LiTaO_3$ substrate are any one of combinations indicated in Table 11 above.

37. A surface acoustic wave apparatus according to paragraph 1, wherein: said piezoelectric substrate is a $LiTaO_3$ substrate having Euler angles (0±3°, 90° -169°, 0±3°); said first and second insulating layers are formed of a $SiO_2$ film; the normalized thickness Hs/λ ranges from 0.10 to 0.40 where Hs indicates a total thickness of the $SiO_2$ film forming said first and second insulating layers and presents a wavelength of a surface acoustic wave; the metal having a density higher than Al has a density of 15000 to 23000 kg/m$^3$, a Young's modulus of $1.0\times10^{11}$ to $2.0\times10^{11}$N/m$^2$, or a transversal-wave acoustic velocity of 1000 to 2000 m/s; and the normalized thickness H/λ ranges from 0.005 to 0.054 where H indicates the thickness of said at least one electrode and λ represents the wavelength of the surface acoustic wave.

38. A surface acoustic wave apparatus according to paragraph 37, wherein the metal having a density higher than Al is platinum.

39. A surface acoustic wave apparatus according to paragraph 37, wherein said piezoelectric substrate is a $LiTaO_3$ substrate having Euler angles (0±3°, 90° -155°, 0±3°), and the normalized thickness H/λ of said at least one electrode is 0.01 to 0.04.

40. A surface acoustic wave apparatus according to paragraph 39, wherein the normalized thickness Hs/λ of the $SiO_2$ film forming said first and second insulating layers and the Euler angles of the piezoelectric $LiTaO_3$ substrate are any one of combinations indicated in Table 12 above.

41. A surface acoustic wave apparatus according to paragraph 37, wherein said piezoelectric substrate is a $LiTaO_3$ substrate having Euler angles (0±3°, 102° - 150°, 0±3°), and the normalized thickness H/λ of said at least one electrode is 0.013 to 0.033.

42. A surface acoustic wave apparatus according to paragraph 41, wherein the normalized thickness Hs/λ of the $SiO_2$ film forming said first and second insulating layers and the Euler angles of the piezoelectric $LiTaO_3$ substrate are any one of combinations indicated in Table 13 above.

43. surface acoustic wave apparatus according to paragraph 1, wherein: said piezoelectric substrate is a $LiTaO_3$ substrate having Euler angles (0±3 °, 104° - 150°, 0±3°); said first and second insulating layers are formed of a $SiO_2$ film; the normalized thickness Hs/λ ranges from 0.10 to 0.40 where Hs indicates a total thickness of the $SiO_2$ film forming said first and second insulating layers and λ represents a wavelength of a surface acoustic wave; the metal having a density higher than A1 has a density of 5000 to 15000 kg/m$^3$, a Young's modulus of $2.0\times10^{11}$ to $4.5\times10^{11}$N/m$^2$, or a transversal-wave acoustic velocity of 2800 to 3500 m/s; and the normalized thickness H/λ, ranges from 0.008 to 0.06 where H indicates the thickness of said at least one electrode and λ represents the wavelength of the surface acoustic wave.

44. A surface acoustic wave apparatus according to paragraph 43, wherein the metal having a density higher than Al is Ni.

45. A surface acoustic wave apparatus according to paragraph 44, wherein the normalized thickness H/λ of said at least one electrode is 0.02 to 0.06.

46. A surface acoustic wave apparatus according to paragraph 44, wherein the normalized thickness H/λ of said at least one electrode is 0.027 to 0.06.

47. A surface acoustic wave apparatus according to paragraph 44, wherein the normalized thickness Hs/λ of the $SiO_2$ film forming said first and second insulating layers and the Euler angles of the piezoelectric $LiTaO_3$ substrate are any one of combinations indicated in Table 15 above.

48. A surface acoustic wave apparatus according to paragraph 43, wherein the metal having a density higher than Al is Mo.

49. A surface acoustic wave apparatus according to paragraph 48, wherein the normalized thickness H/λ of said at least one electrode is 0.017 to 0.06.

50. A surface acoustic wave apparatus according to paragraph 48, wherein the normalized thickness H/λ of said at least one electrode is 0.023 to 0.06.

51. A surface acoustic wave apparatus according to paragraph 48, wherein the normalized thickness Hs/λ of the $SiO_2$ film forming said first and second insulating layers and the Euler angles of the piezoelectric $LiTaO_3$ substrate are any one of combinations indicated in Table 16 above.

52. surface acoustic wave apparatus according to paragraph 1, wherein said at least one electrode is formed of a laminated film including an electrode layer made of a metal or of an alloy having a density higher than Al, and at least one electrode layer made of another metal, and the average density p of said at least one electrode is indicated by the following expression:

$$\rho 0 \times 0.7 \leq \rho \leq \rho 0 \times 1.3$$

wherein ρ0 indicates the density of the metal having a density higher than Al.

53. A surface acoustic wave apparatus according to paragraph 1, wherein a difference of the height of the surface of said second insulating layer is 30% or smaller of the thickness of said at least one electrode.

54. A surface acoustic wave apparatus according to paragraph 1, wherein a leaky surface acoustic wave is used.

55. A manufacturing method for a surface acoustic wave apparatus, comprising the steps of:

preparing a piezoelectric substrate;
forming a first insulating layer on the entirety of one surface of the piezoelectric substrate;
removing, by using a resist pattern for forming an electrode pattern including at least one electrode, the first insulating layer in an area in which said at least one electrode is to be formed, and maintaining a laminated structure of the first insulating layer and the resist pattern in an area other than the area in which said at least one electrode is to be formed;
forming said at least one electrode by forming an electrode film including a metal having a density higher than Al, or including an alloy primarily including the metal, in the area in which the first insulating layer is removed such that the thickness of the electrode film becomes substantially the same as the thickness of the first insulating layer;
removing the resist pattern remaining on the first insulating layer; and
forming a second insulating layer to cover the first insulating layer and said at least one electrode.

56. A manufacturing method according to paragraph 55, wherein the density of the metal or the alloy forming said at least one electrode is 1.5 times or greater than the density of the first insulating layer.

57. A manufacturing method for a surface acoustic wave apparatus, comprising the steps of:

preparing a piezoelectric substrate;
forming a first insulating layer on the entirety of one surface of the piezoelectric substrate;
removing, by using a resist pattern for forming at least one electrode, the first insulating layer in an area in which said at least one electrode is to be formed, and maintaining a laminated structure of the first insulating layer and the resist pattern in an area other than the area in which said at least one electrode is to be formed;
forming said at least one electrode by forming a metal or an alloy in the area in which the first insulating layer is removed;
forming, after the formation of said at least one electrode, a protective metal film made of a metal or alloy exhibiting a higher erosion-resistant characteristic than the metal or the alloy forming said at least one electrode, on the entire surface of said at least one electrode such that the height of the electrode plus protective metal film becomes substantially the same as the height of the first insulating layer;
removing the resist pattern on the first insulating layer and the protective metal film laminated on that resist pattern; and
forming a second insulating layer to cover the first insulating layer and the protective metal film formed on said at least one electrode.

58. A manufacturing method according to paragraph 57, wherein the metal or the alloy forming said at least one electrode and the metal or the alloy forming the protective metal film are selected such that the average density ($\rho_1$) of the laminated structure of said at least one electrode and the protective metal film becomes 1.5 times or greater than the density ($\rho_2$) of the first insulating layer.

59. A manufacturing method for a surface acoustic wave apparatus, comprising the steps of:

preparing a piezoelectric substrate;
forming an electrode on the piezoelectric substrate;
forming an insulating layer to cover the electrode; and
planarizing a difference of the height of the insulating layer between a portion where the electrode is present and a portion where the electrode is not present.

60. A manufacturing method according to paragraph 59, wherein the planarizing step is performed by an etch back process, a reverse sputtering process, or a polishing process.
61. A manufacturing method according to paragraph 55, wherein the metal constituting said electrode is made of a material selected from the group consisting of Au, Cu, Ag, W, Ta, Pt, Ni, Mo and an alloy primarily including these metals, and the insulating layer is made of $SiO_2$.

## Claims

**1.** A manufacturing method for a surface acoustic wave apparatus, comprising the steps of:

preparing a piezoelectric substrate (41);
forming an electrode (42) on the piezoelectric substrate;
forming an insulating layer to cover the electrode (43); and
planarizing a difference of the height of the insulating layer (43) between a portion where the electrode (42) is present and a portion where the electrode is not present.

**2.** A manufacturing method according to claim 1, wherein the planarizing step is performed by an etch back process, a reverse sputtering process, or a polishing process.

FIG. 1A

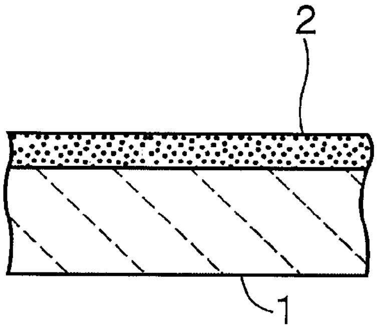


FIG. 1B

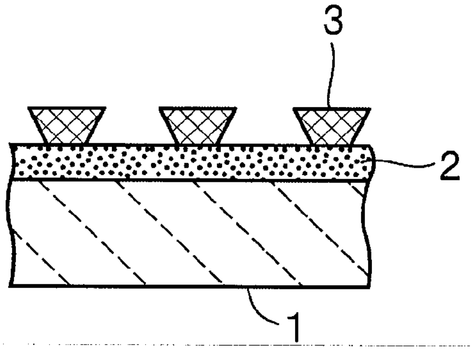


FIG. 1C

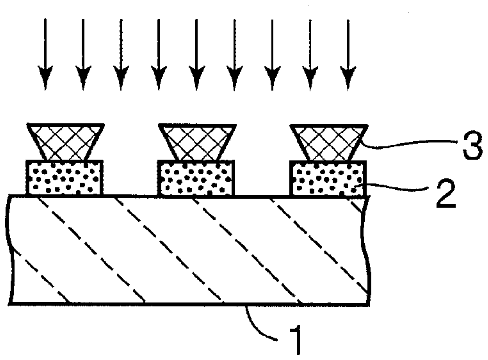


FIG. 1D

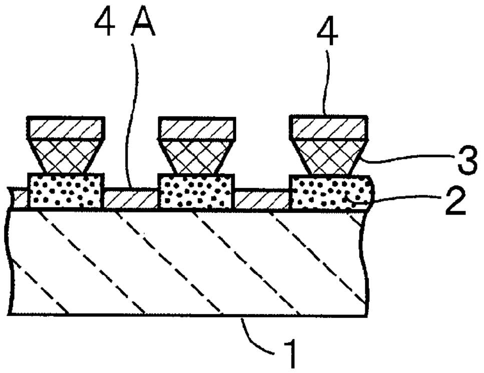


FIG. 1E

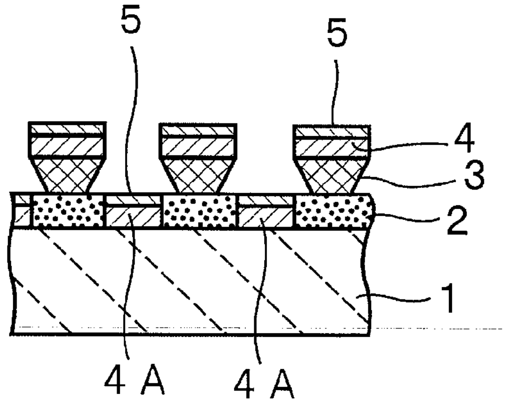


FIG. 1F

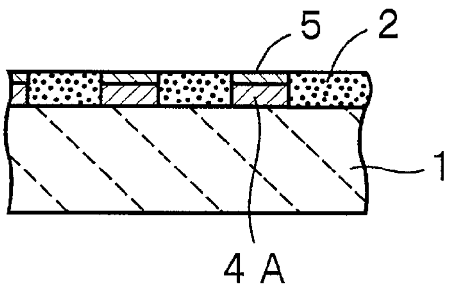


FIG. 1G

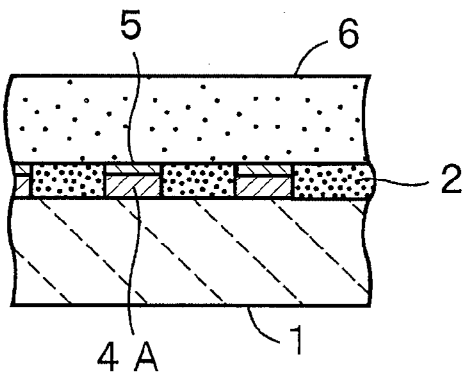

FIG. 2

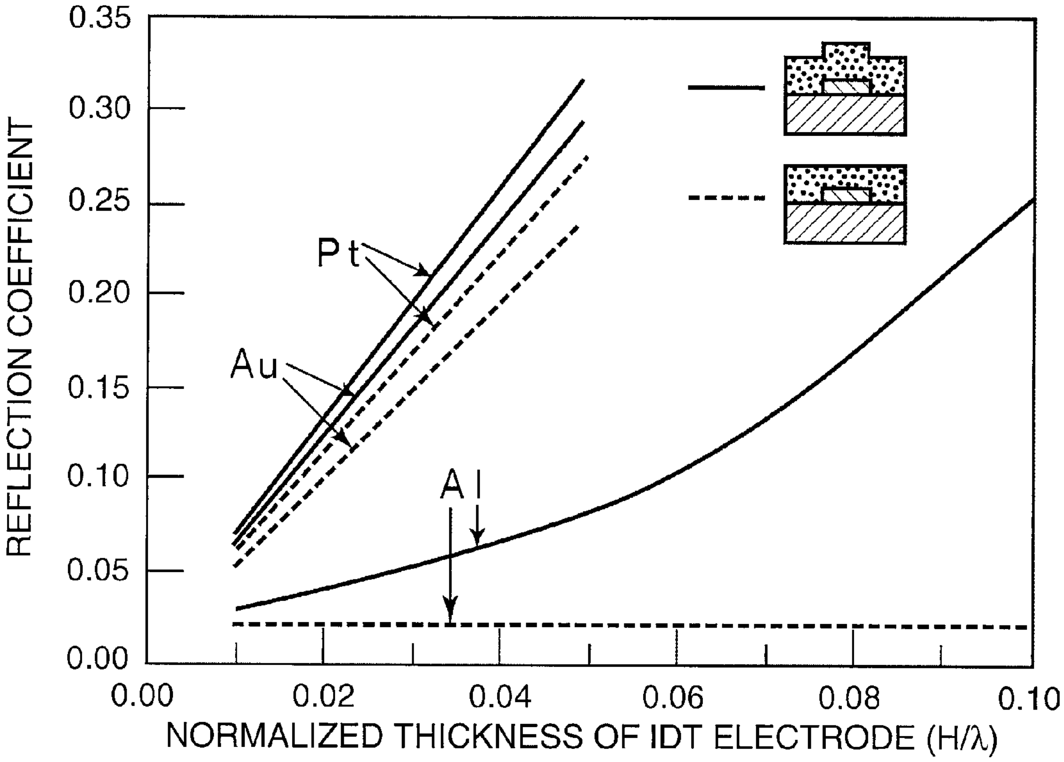
0.35
0.30
0.25
0.20
0.15
0.10
0.05
0.00
REFLECTION COEFFICIENT
Pt
Au
Al
0.00
0.02
0.04
0.06
0.08
0.10
NORMALIZED THICKNESS OF IDT ELECTRODE (H/λ)

FIG. 3

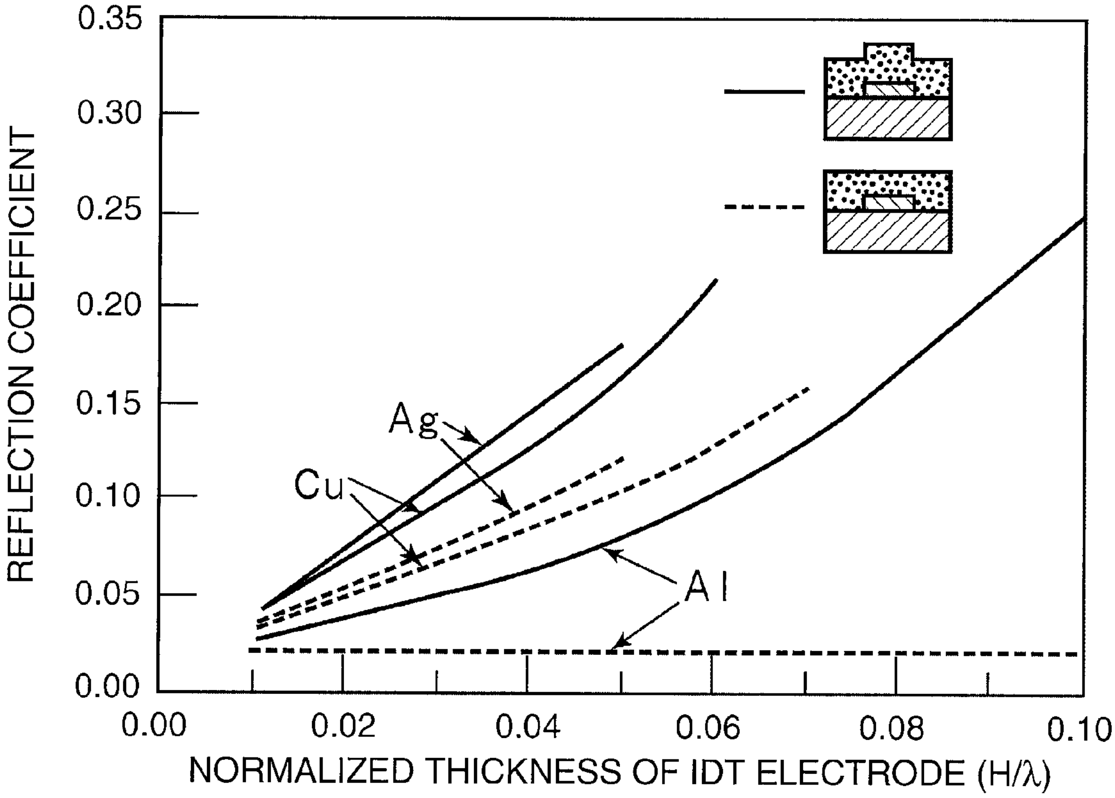
0.35
0.30
0.25
0.20
0.15
0.10
0.05
0.00
REFLECTION COEFFICIENT
Ag
Cu
Al
0.00
0.02
0.04
0.06
0.08
0.10
NORMALIZED THICKNESS OF IDT ELECTRODE (H/λ)

FIG. 4

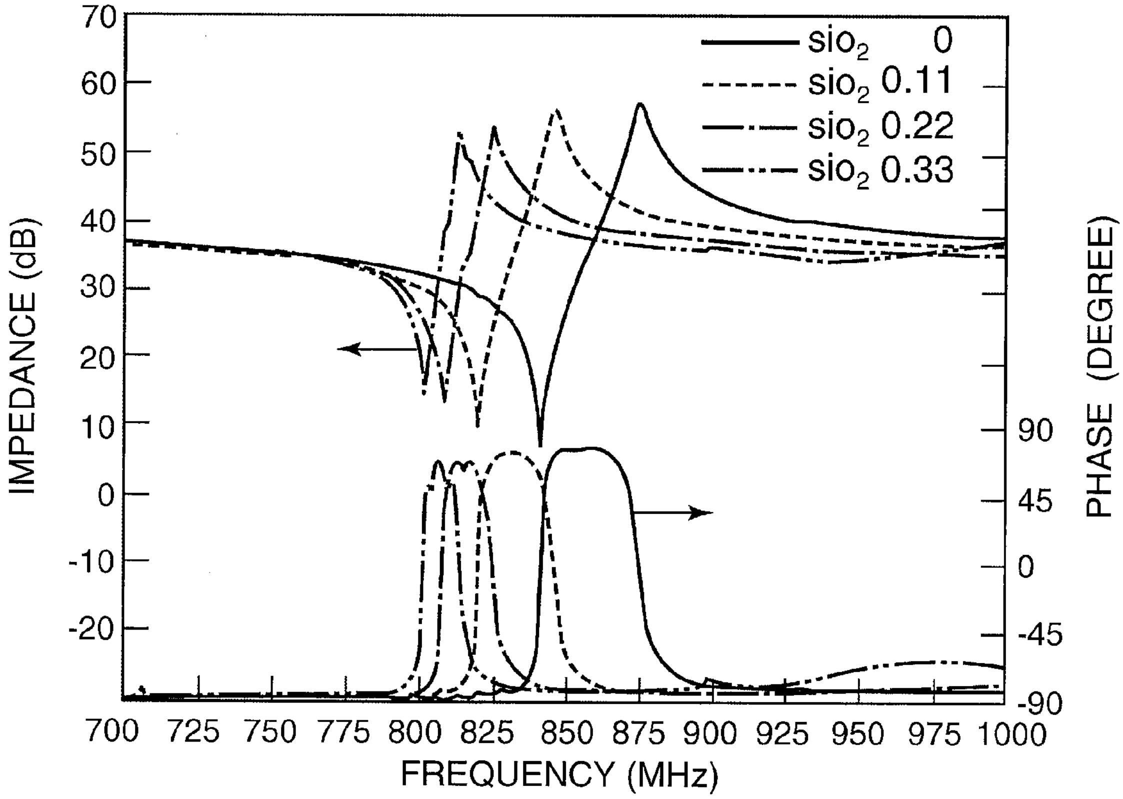
70
60
50
40
30
20
10
0
-10
-20
IMPEDANCE (dB)
sio2 0
sio2 0.11
sio2 0.22
sio2 0.33
90
45
0
-45
-90
PHASE (DEGREE)
700 725 750 775 800 825 850 875 900 925 950 975 1000
FREQUENCY (MHz)

FIG. 5

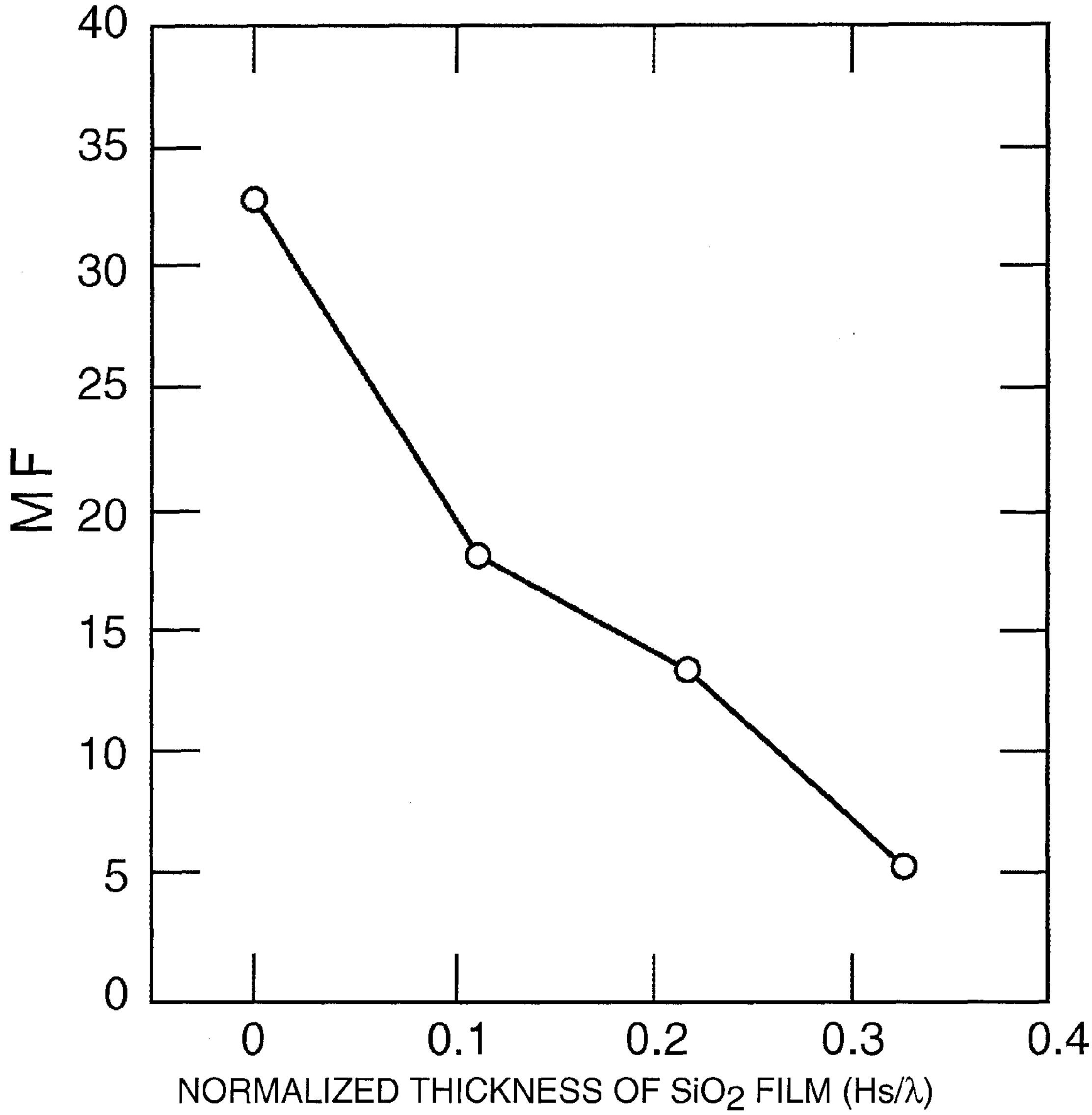
40
35
30
25
20
15
10
5
0
MF
0
0.1
0.2
0.3
0.4
NORMALIZED THICKNESS OF SiO2 FILM (Hs/λ)

FIG. 6

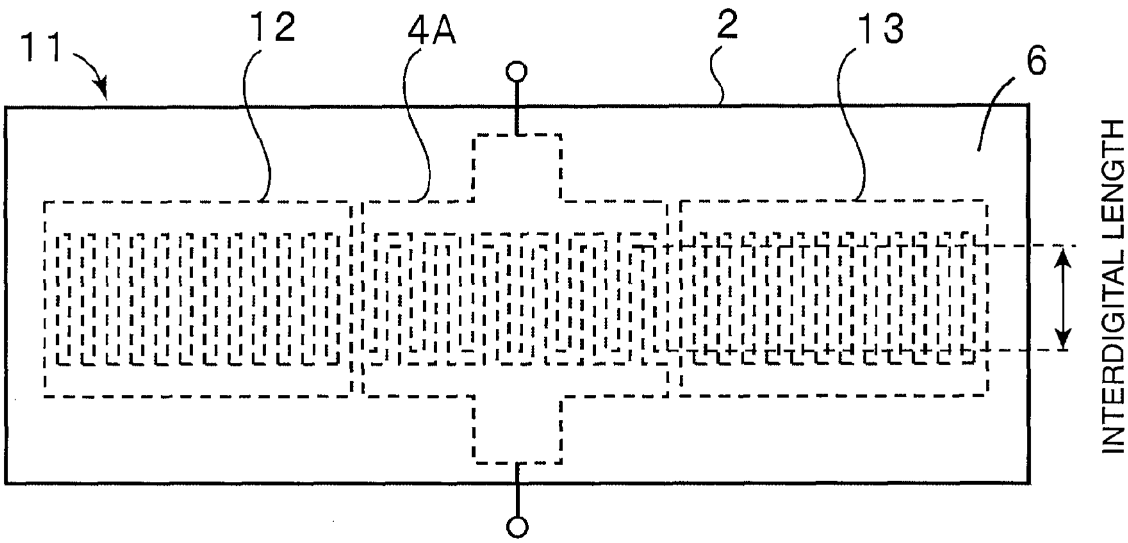

FIG. 7

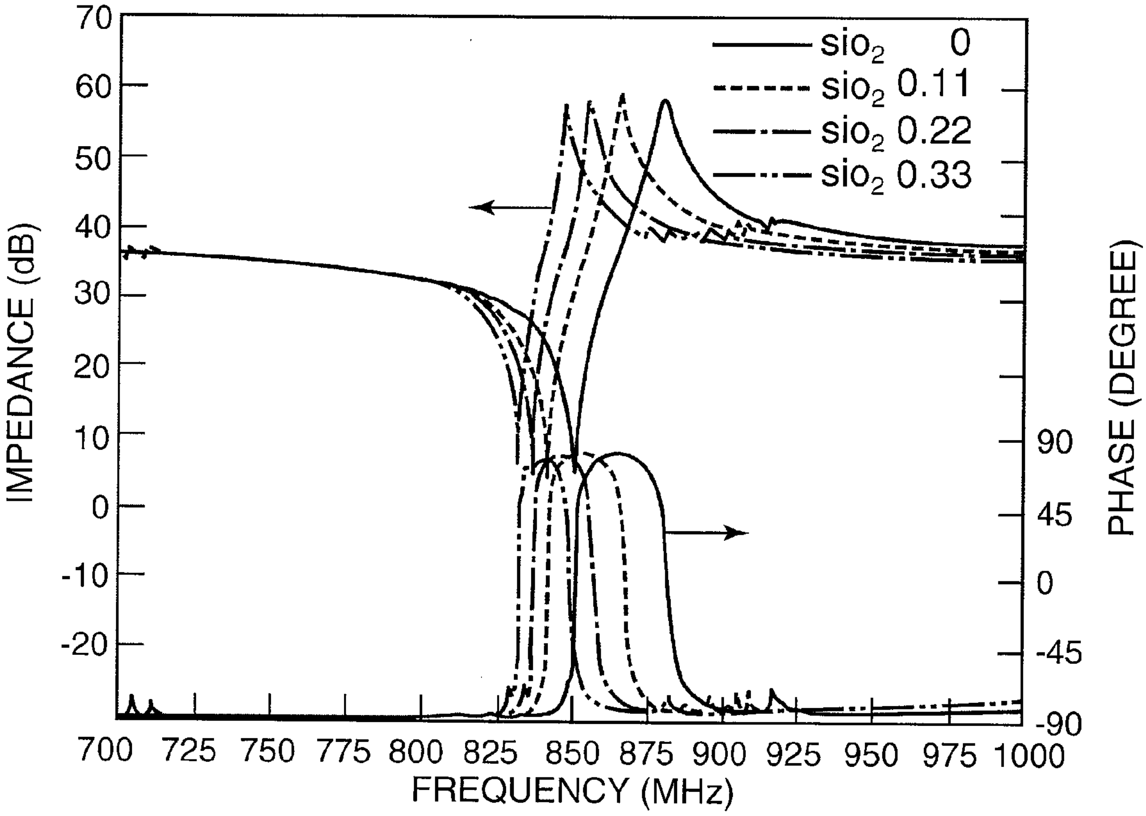
sio2 0
sio2 0.11
sio2 0.22
sio2 0.33
IMPEDANCE (dB)
PHASE (DEGREE)
FREQUENCY (MHz)
70
60
50
40
30
20
10
0
-10
-20
90
45
0
-45
-90
700 725 750 775 800 825 850 875 900 925 950 975 1000

FIG. 8

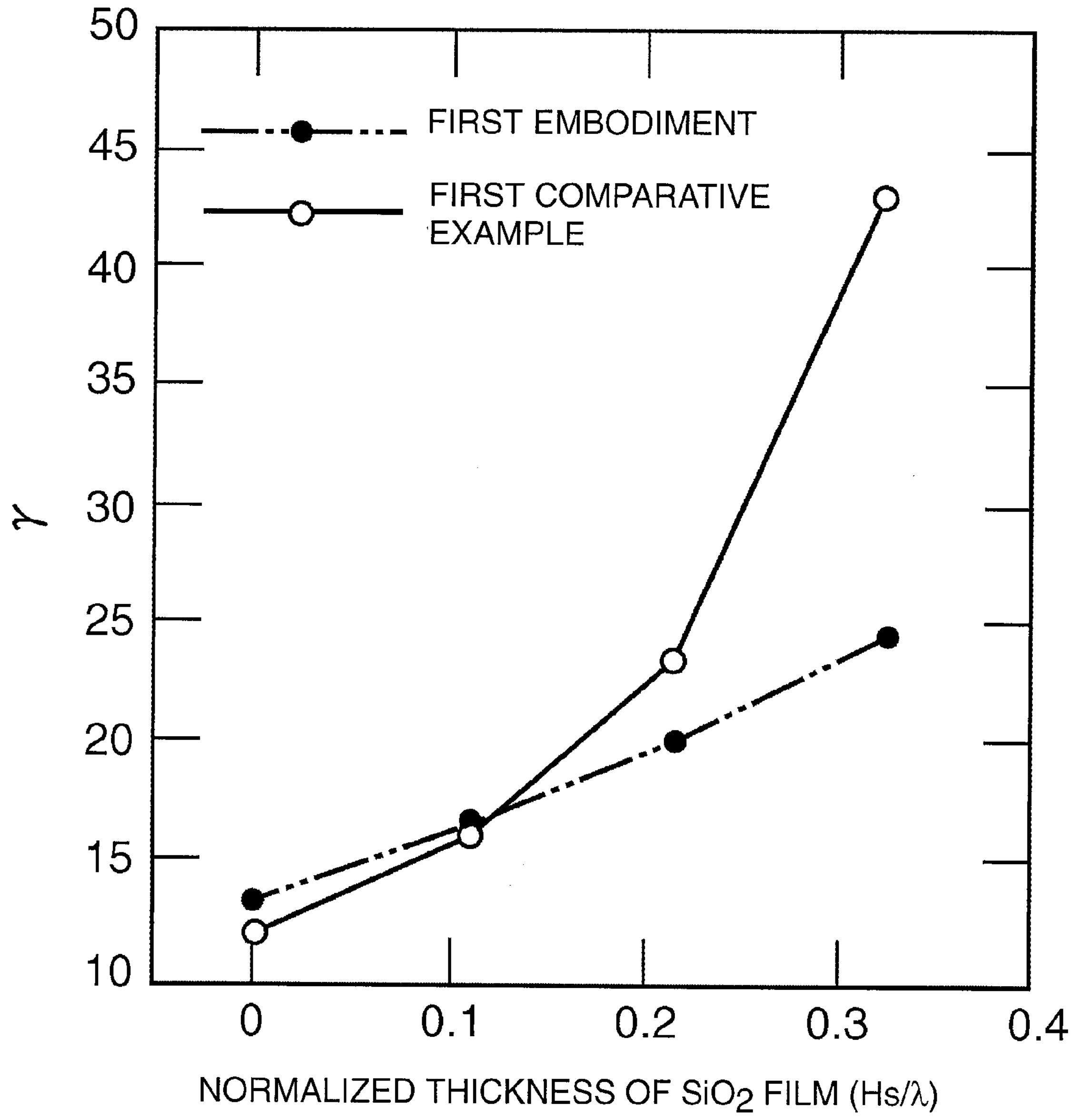
50
45
40
35
30
25
20
15
10
γ
FIRST EMBODIMENT
FIRST COMPARATIVE EXAMPLE
0
0.1
0.2
0.3
0.4
NORMALIZED THICKNESS OF SiO2 FILM (Hs/λ)

FIG. 9

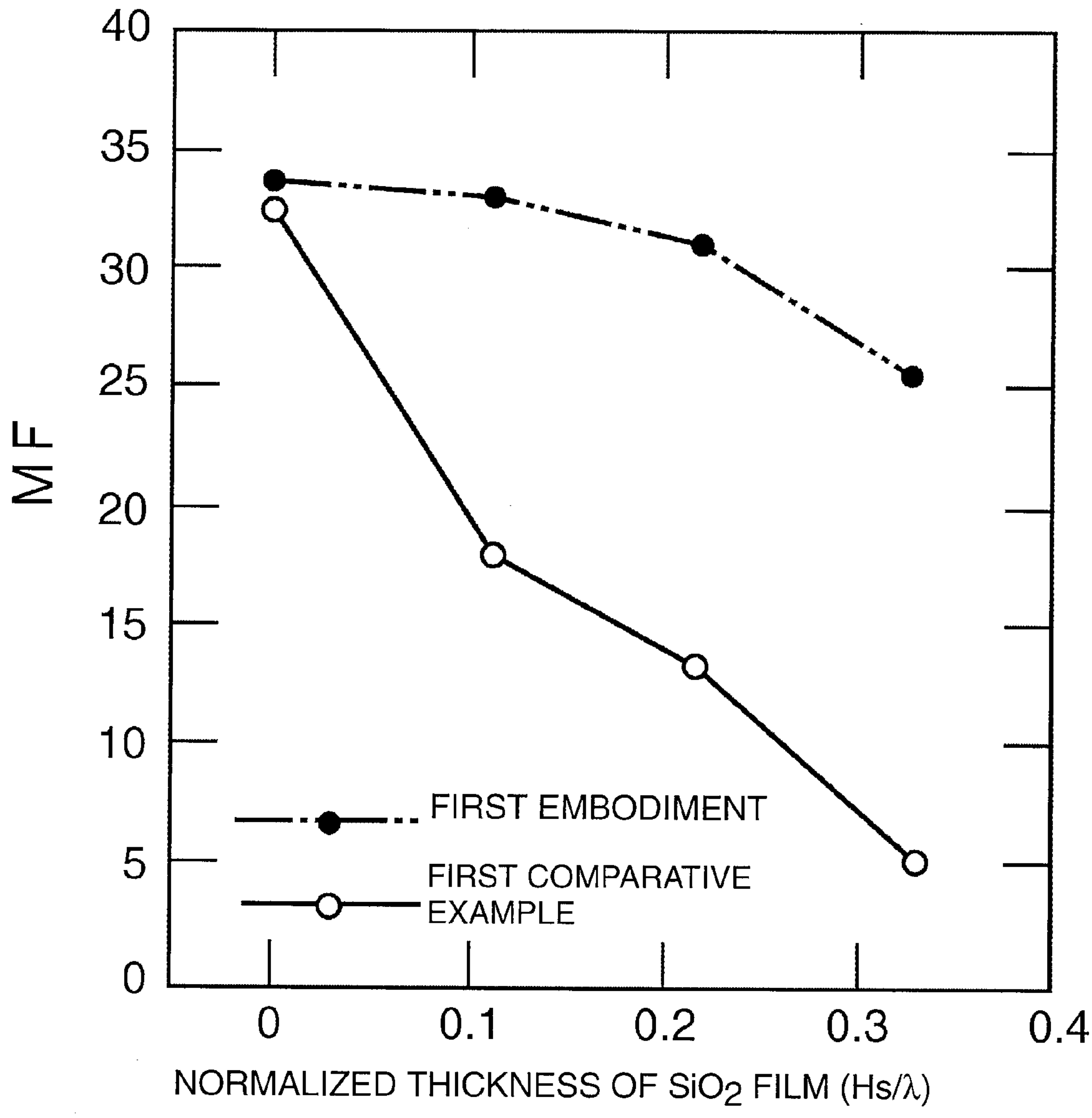
40
35
30
25
20
15
10
5
0
MF
FIRST EMBODIMENT
FIRST COMPARATIVE EXAMPLE
0
0.1
0.2
0.3
0.4
NORMALIZED THICKNESS OF SiO2 FILM (Hs/λ)

FIG. 10

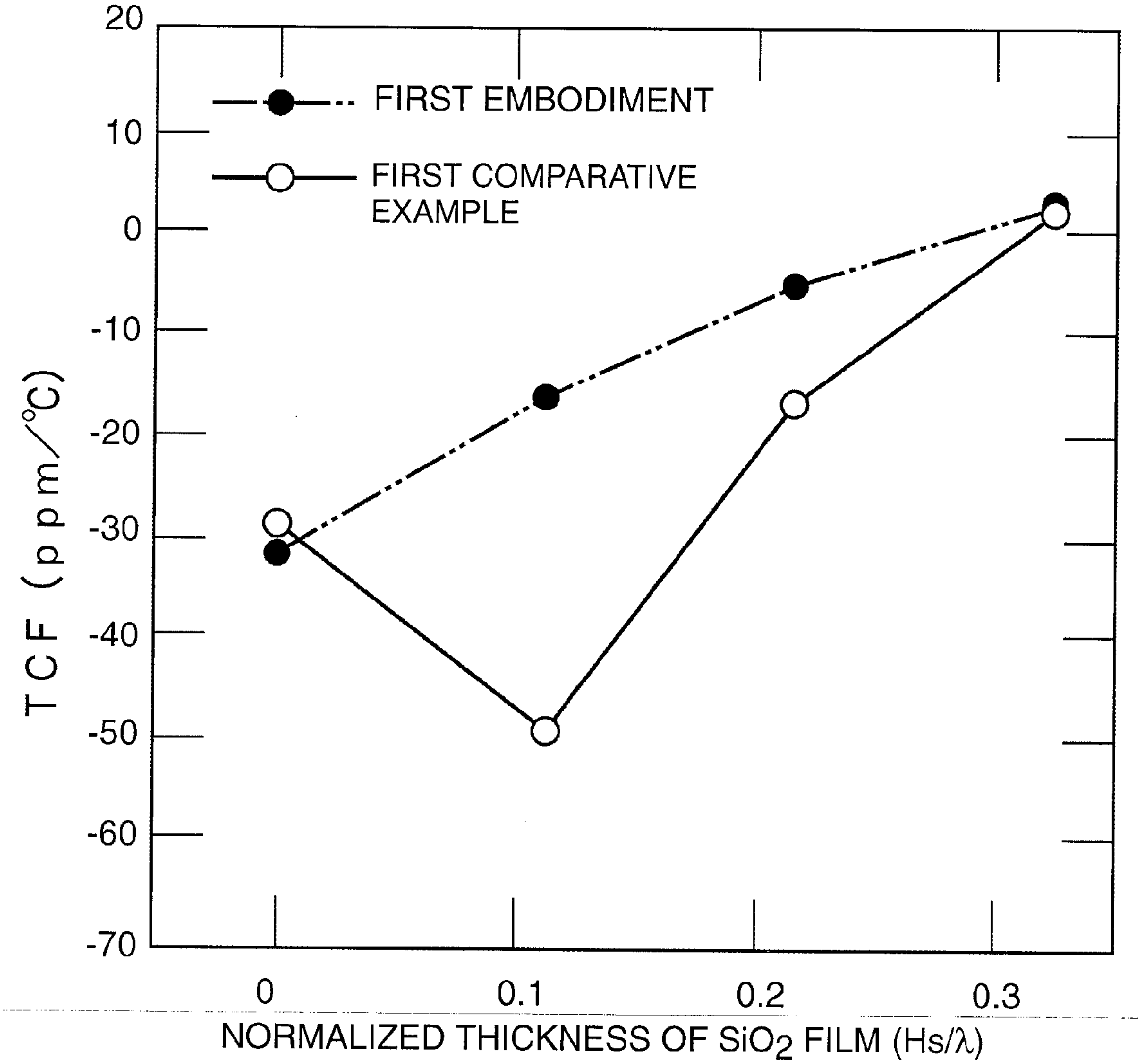
20
10
0
-10
-20
-30
-40
-50
-60
-70
TCF (ppm/°C)
FIRST EMBODIMENT
FIRST COMPARATIVE EXAMPLE
0
0.1
0.2
0.3
NORMALIZED THICKNESS OF SiO2 FILM (Hs/λ)

FIG. 11

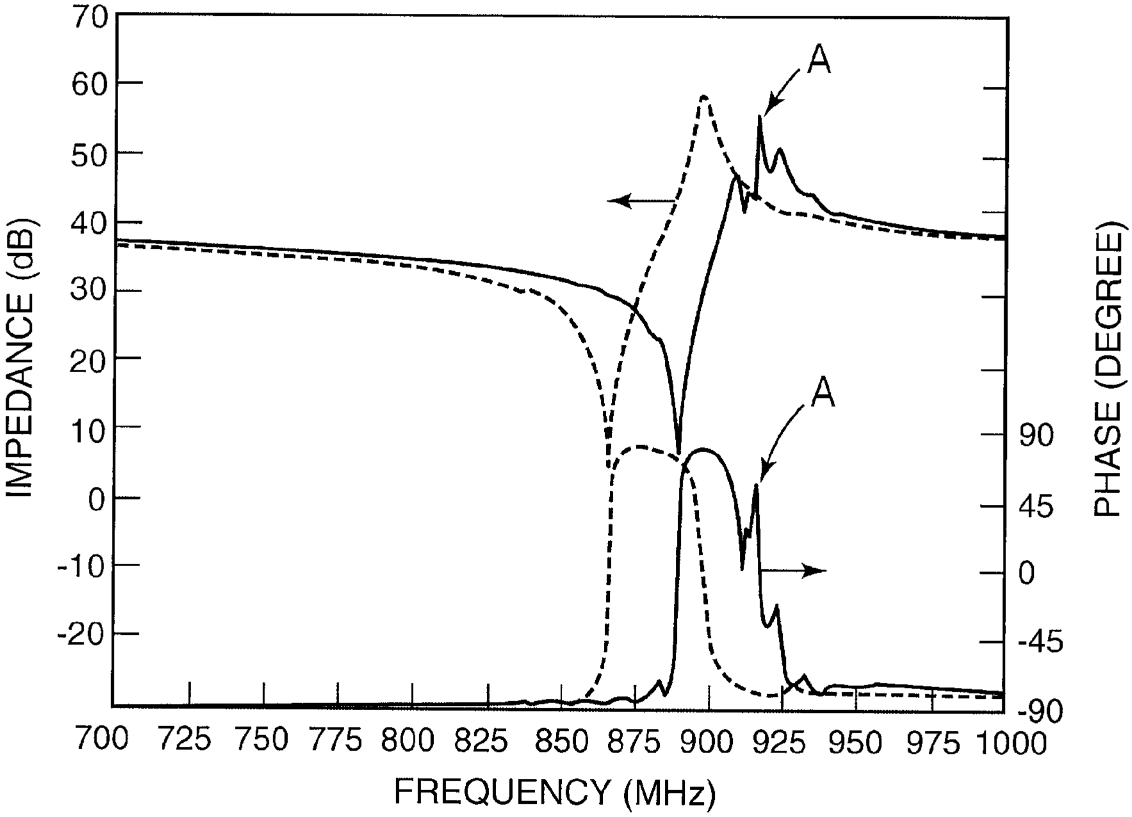

IMPEDANCE (dB)
70
60
50
40
30
20
10
0
-10
-20
A
A
PHASE (DEGREE)
90
45
0
-45
-90
700
725
750
775
800
825
850
875
900
925
950
975
1000
FREQUENCY (MHz)

FIG. 12A

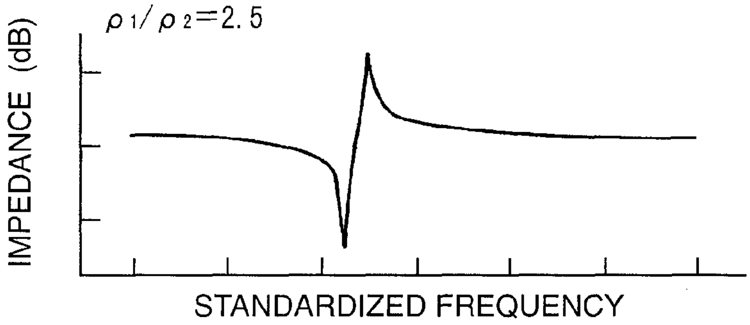


FIG. 12B

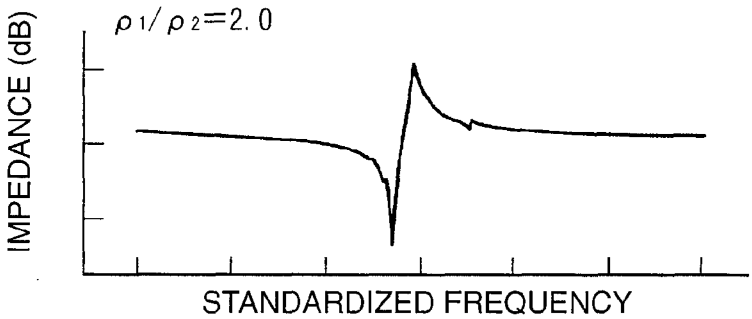


FIG. 12C

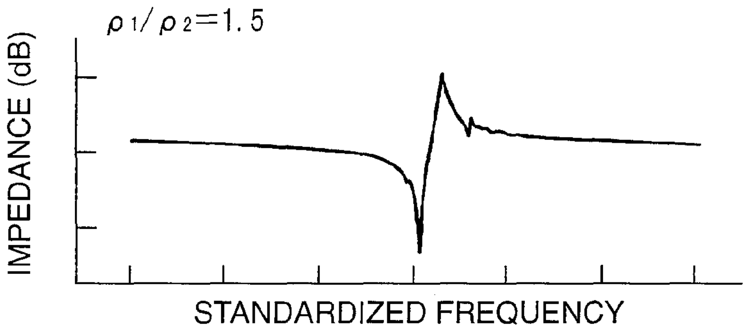


FIG. 12D

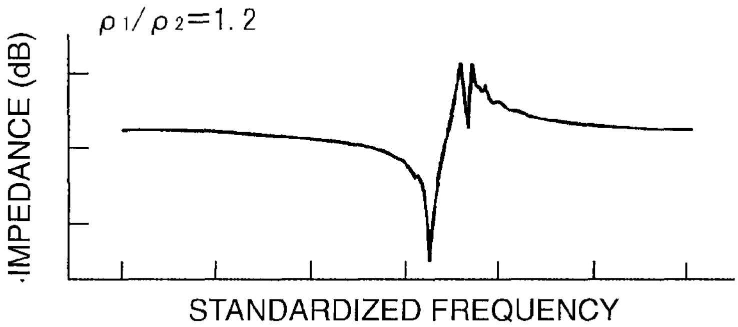


FIG. 12E

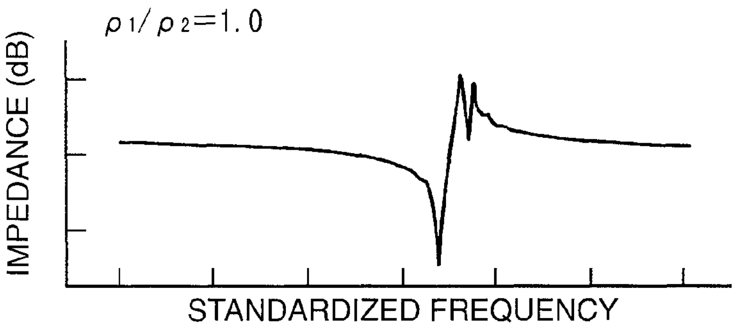

FIG. 13

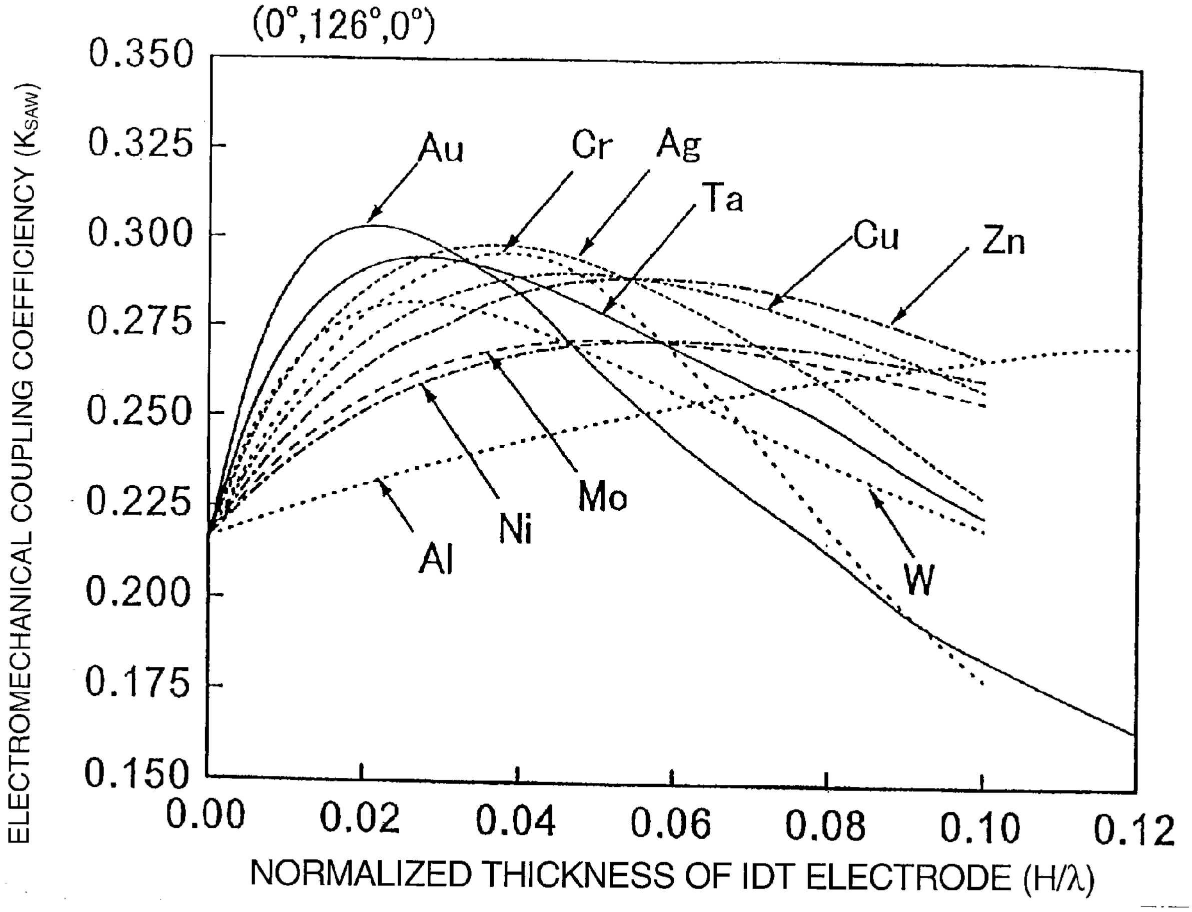
(0°,126°,0°)
ELECTROMECHANICAL COUPLING COEFFICIENCY (KSAW)
0.350
0.325
0.300
0.275
0.250
0.225
0.200
0.175
0.150
Au
Cr
Ag
Ta
Cu
Zn
Mo
Ni
Al
W
0.00
0.02
0.04
0.06
0.08
0.10
0.12
NORMALIZED THICKNESS OF IDT ELECTRODE (H/λ)

FIG. 14

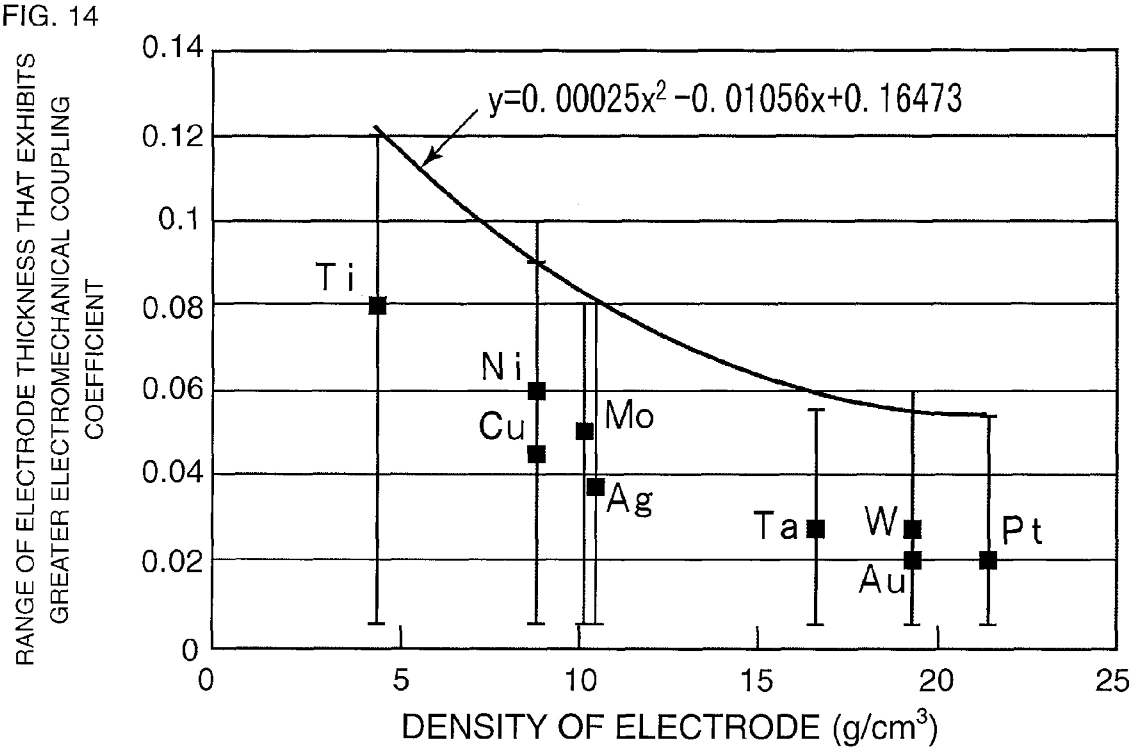

RANGE OF ELECTRODE THICKNESS THAT EXHIBITS GREATER ELECTROMECHANICAL COUPLING COEFFICIENT
0.14
0.12
0.1
0.08
0.06
0.04
0.02
0
y=0. 00025x2 -0. 01056x+0. 16473
Ti
Ni
Cu
Mo
Ag
Ta
W
Au
Pt
0
5
10
15
20
25
DENSITY OF ELECTRODE (g/cm3)

FIG. 15

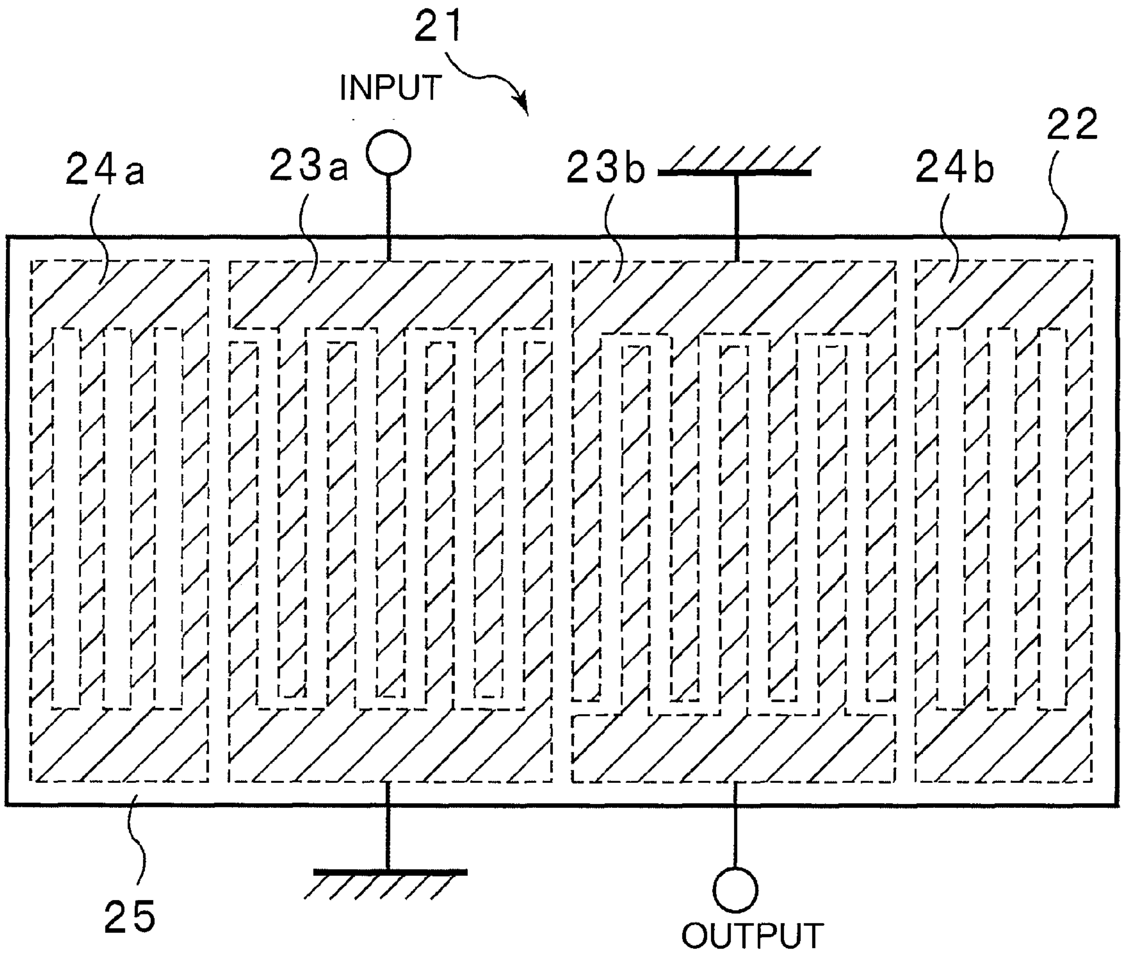

FIG. 16

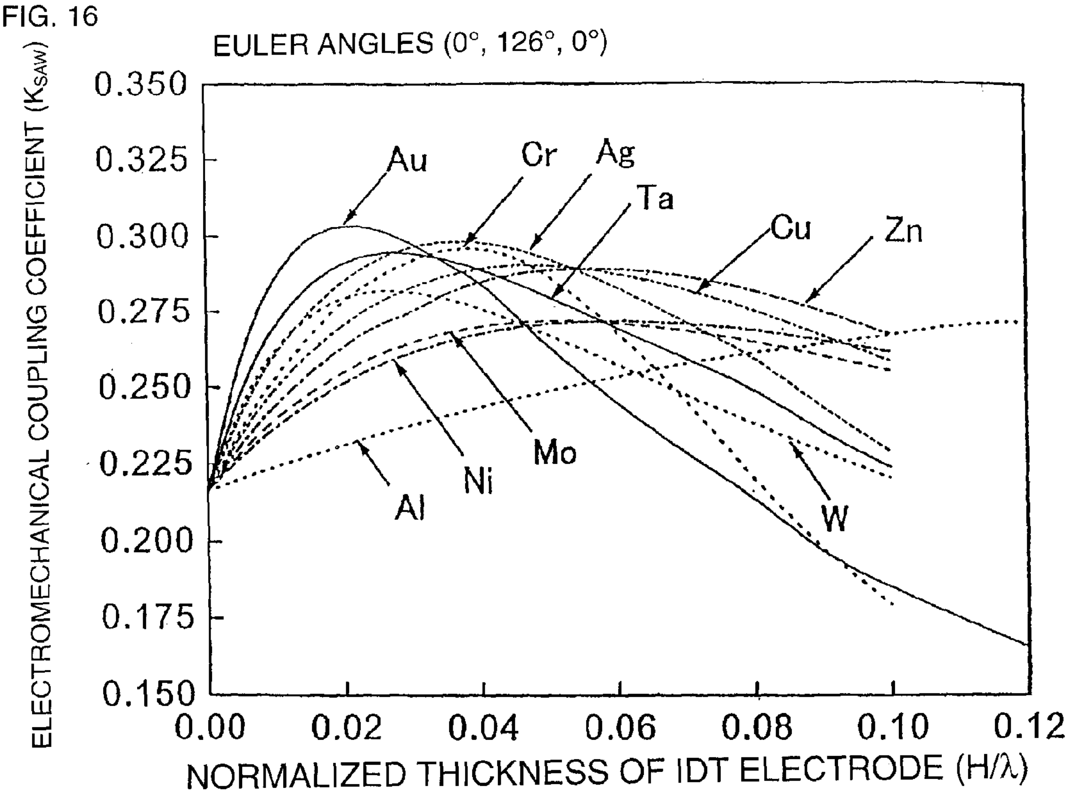
EULER ANGLES (0°, 126°, 0°)
ELECTROMECHANICAL COUPLING COEFFICIENT ($K_{SAW}$)
0.350
0.325
0.300
0.275
0.250
0.225
0.200
0.175
0.150
0.00
0.02
0.04
0.06
0.08
0.10
0.12
NORMALIZED THICKNESS OF IDT ELECTRODE (H/λ)
Au
Cr
Ag
Ta
Cu
Zn
Mo
Ni
Al
W

FIG. 17

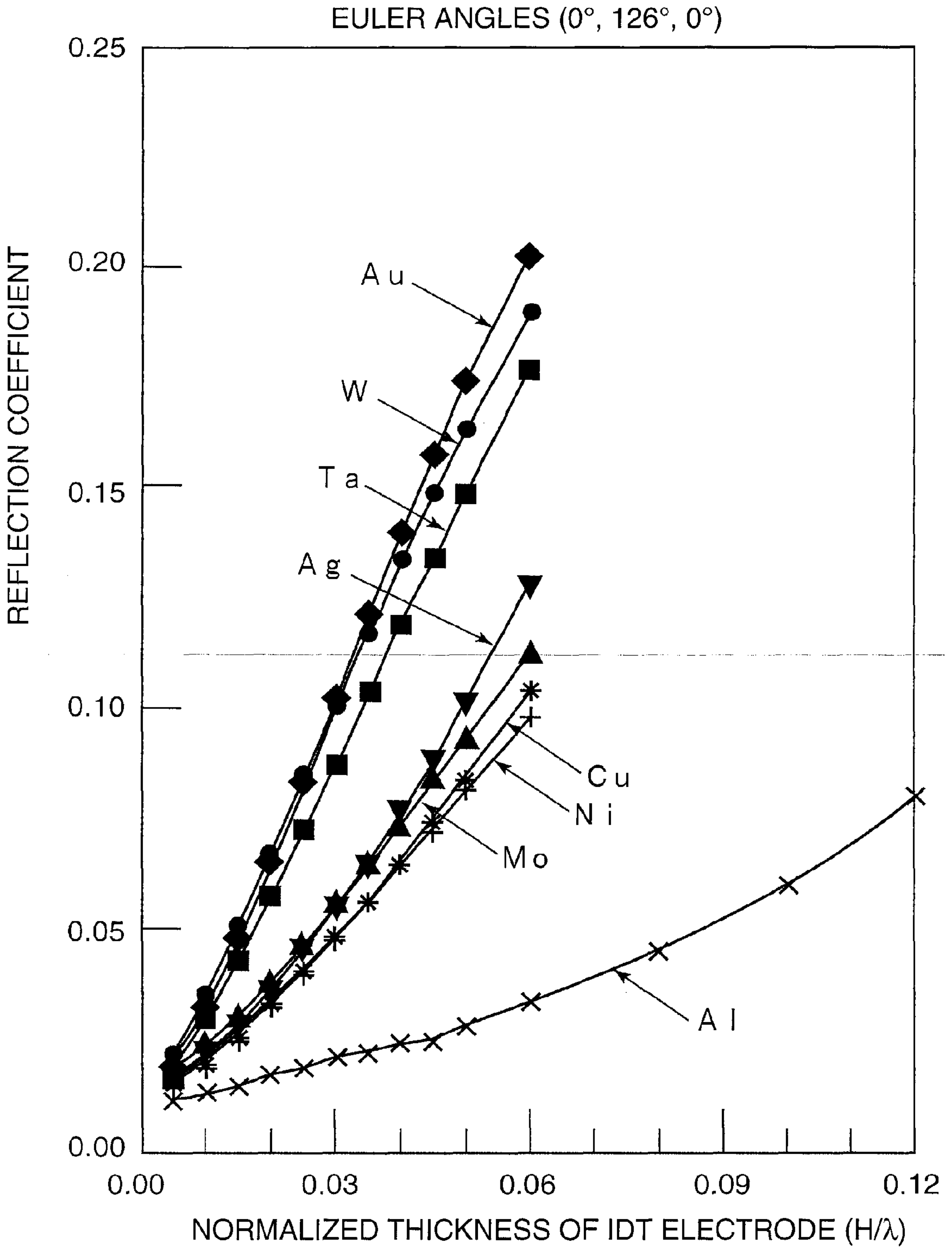
EULER ANGLES (0°, 126°, 0°)
0.25
0.20
0.15
0.10
0.05
0.00
REFLECTION COEFFICIENT
0.00
0.03
0.06
0.09
0.12
NORMALIZED THICKNESS OF IDT ELECTRODE (H/λ)
Au
W
Ta
Ag
Cu
Ni
Mo
Al

FIG. 18

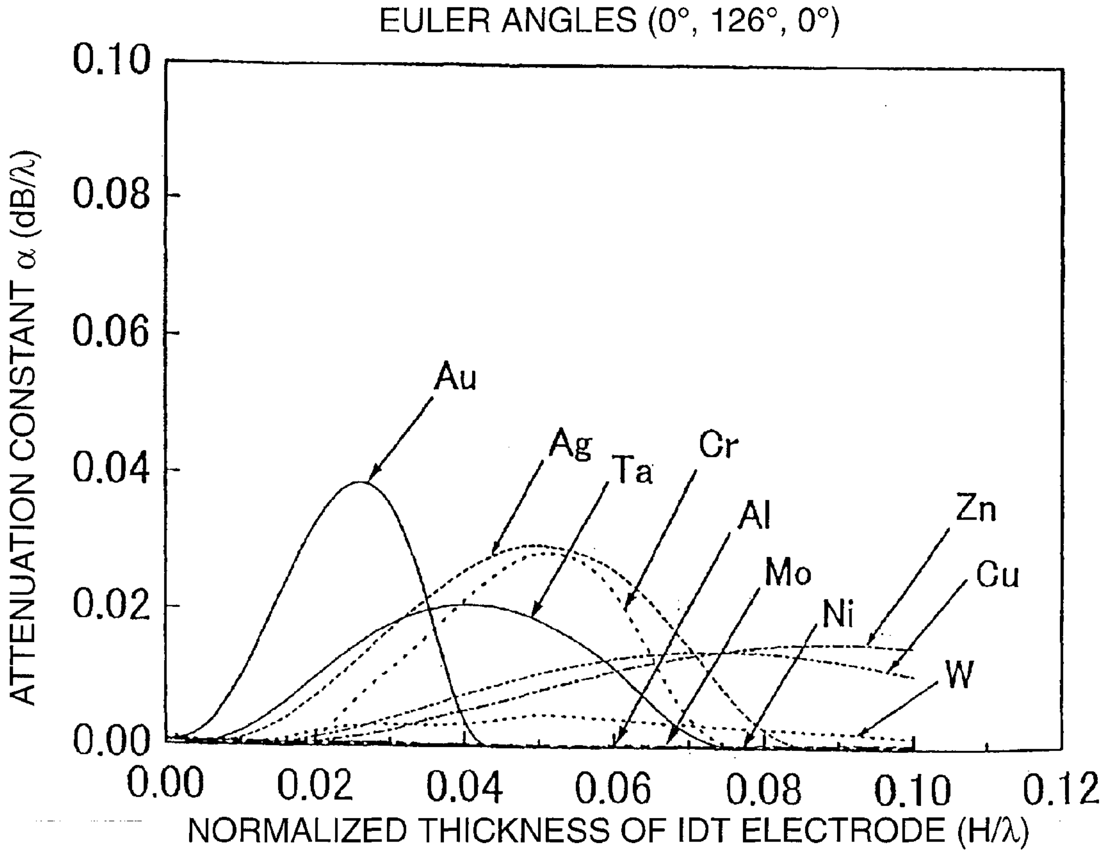
EULER ANGLES (0°, 126°, 0°)
0.10
0.08
0.06
0.04
0.02
0.00
ATTENUATION CONSTANT α (dB/λ)
Au
Ag
Ta
Cr
Al
Mo
Ni
Zn
Cu
W
0.00
0.02
0.04
0.06
0.08
0.10
0.12
NORMALIZED THICKNESS OF IDT ELECTRODE (H/λ)

FIG. 19

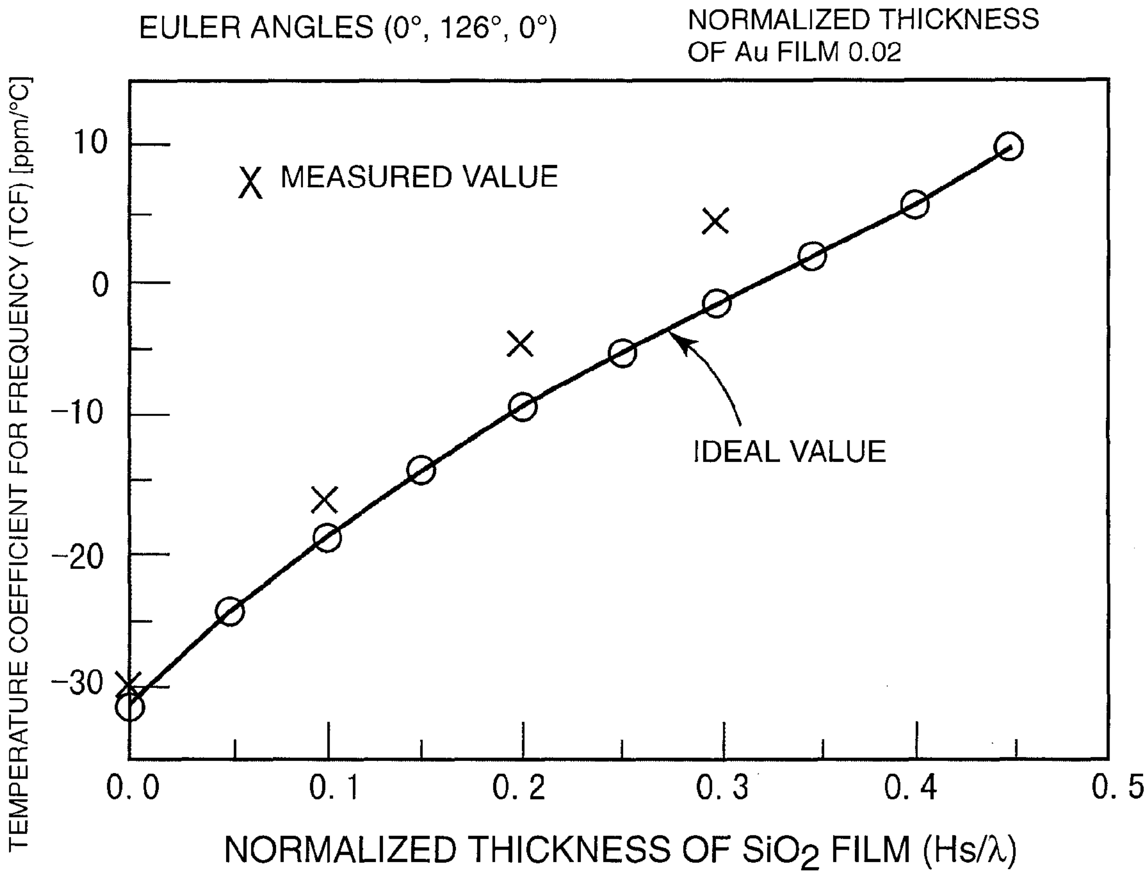
EULER ANGLES (0°, 126°, 0°)
NORMALIZED THICKNESS OF Au FILM 0.02
X MEASURED VALUE
IDEAL VALUE
TEMPERATURE COEFFICIENT FOR FREQUENCY (TCF) [ppm/°C]
10
0
−10
−20
−30
0. 0
0. 1
0. 2
0. 3
0. 4
0. 5
NORMALIZED THICKNESS OF SiO2 FILM (Hs/λ)

FIG. 20

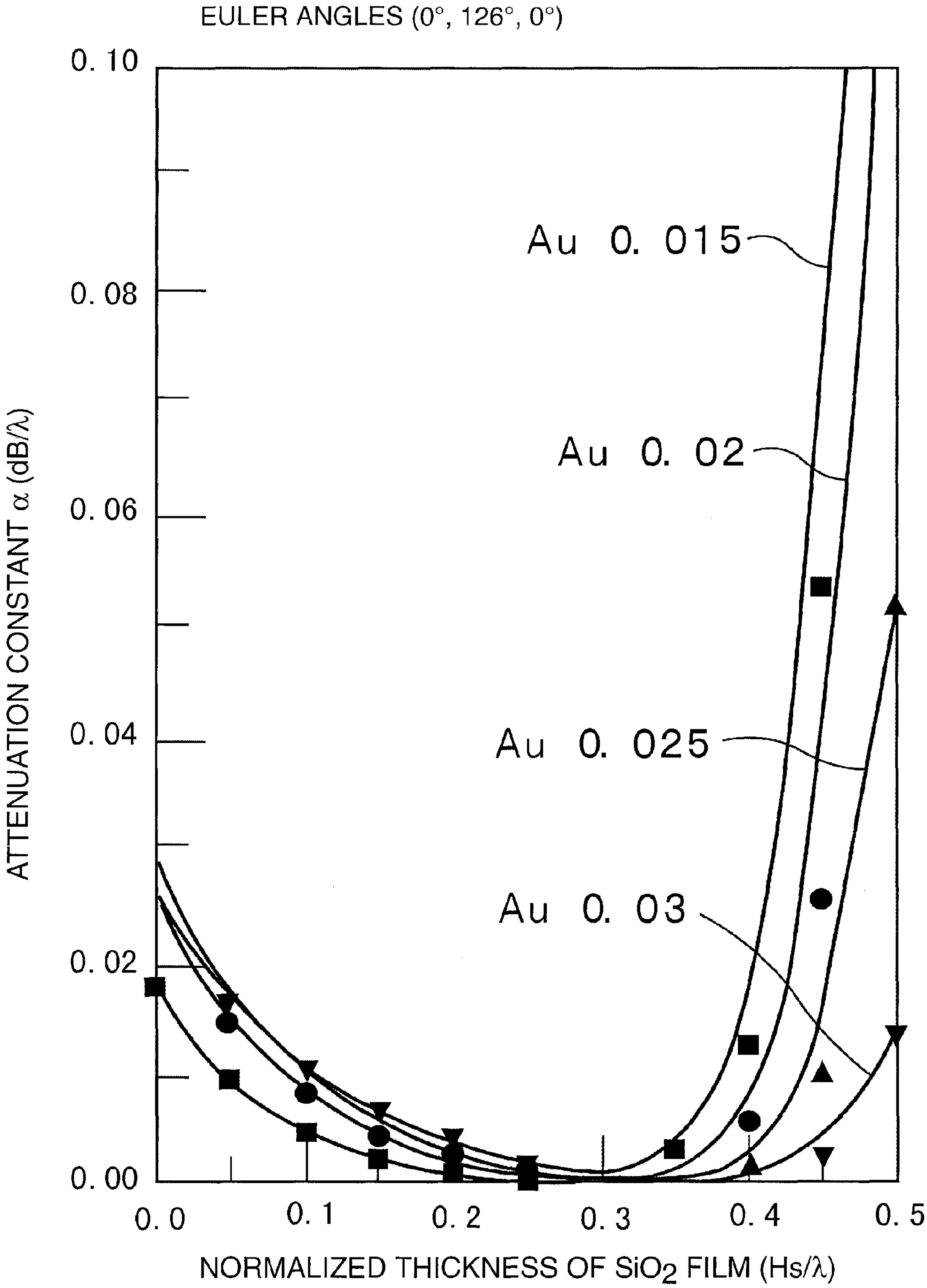
EULER ANGLES (0°, 126°, 0°)
0. 10
0. 08
0. 06
0. 04
0. 02
0. 00
ATTENUATION CONSTANT α (dB/λ)
Au 0. 015
Au 0. 02
Au 0. 025
Au 0. 03
0. 0
0. 1
0. 2
0. 3
0. 4
0. 5
NORMALIZED THICKNESS OF SiO2 FILM (Hs/λ)

FIG. 21

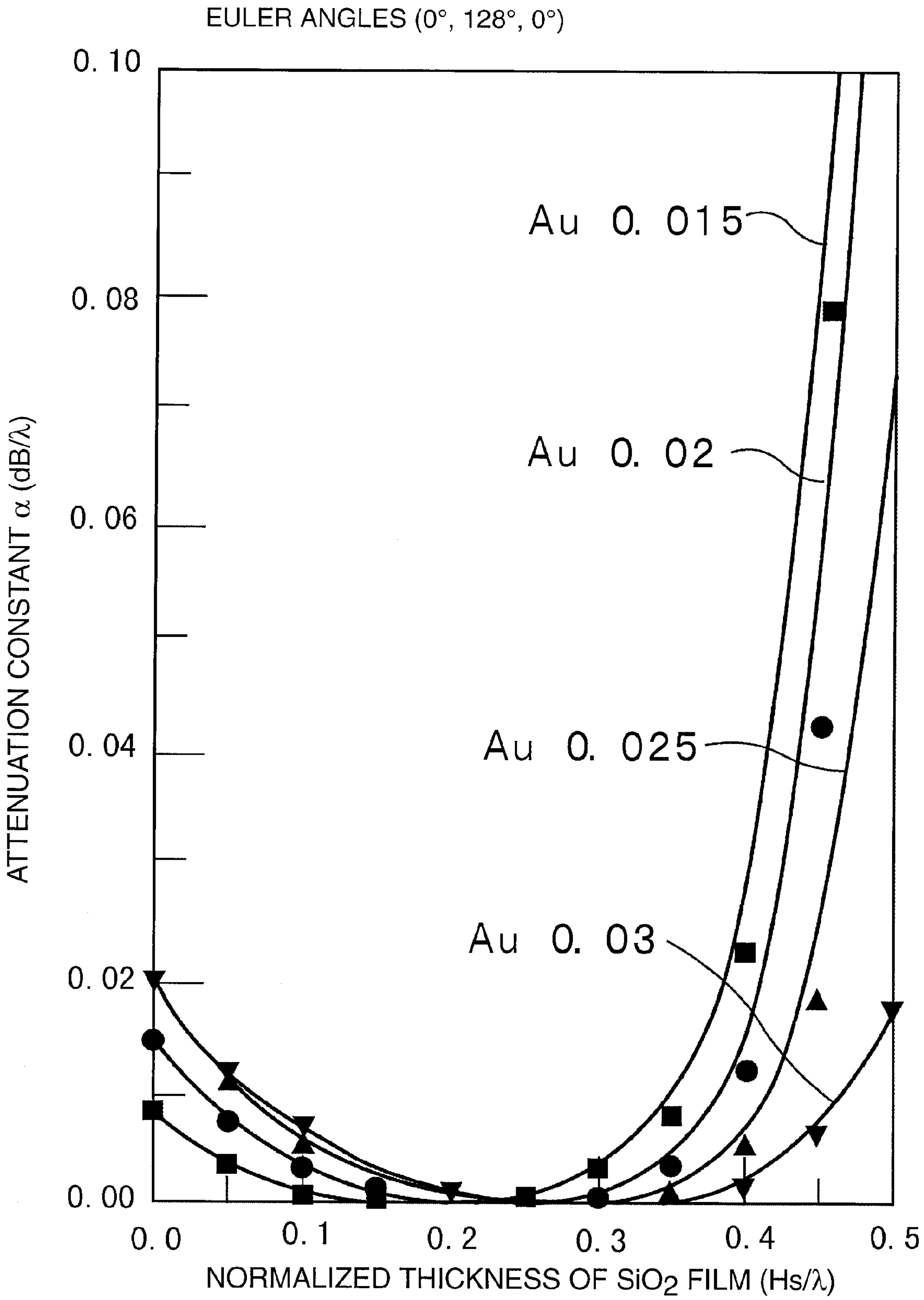
EULER ANGLES (0°, 128°, 0°)
0. 10
0. 08
0. 06
0. 04
0. 02
0. 00
ATTENUATION CONSTANT α (dB/λ)
Au 0. 015
Au 0. 02
Au 0. 025
Au 0. 03
0. 0
0. 1
0. 2
0. 3
0. 4
0. 5
NORMALIZED THICKNESS OF SiO2 FILM (Hs/λ)

FIG. 22

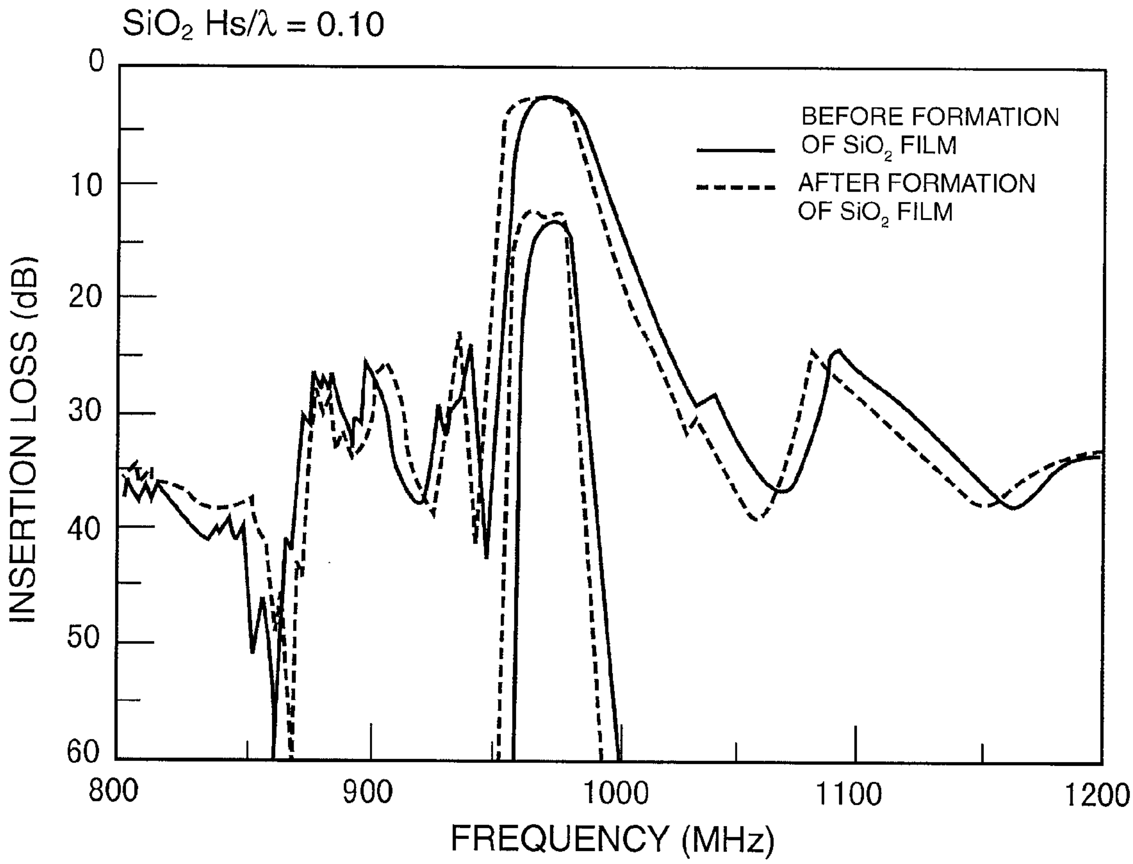
SiO2 Hs/λ = 0.10
INSERTION LOSS (dB)
0
10
20
30
40
50
60
800
900
1000
1100
1200
FREQUENCY (MHz)
BEFORE FORMATION OF SiO2 FILM
AFTER FORMATION OF SiO2 FILM

FIG. 23

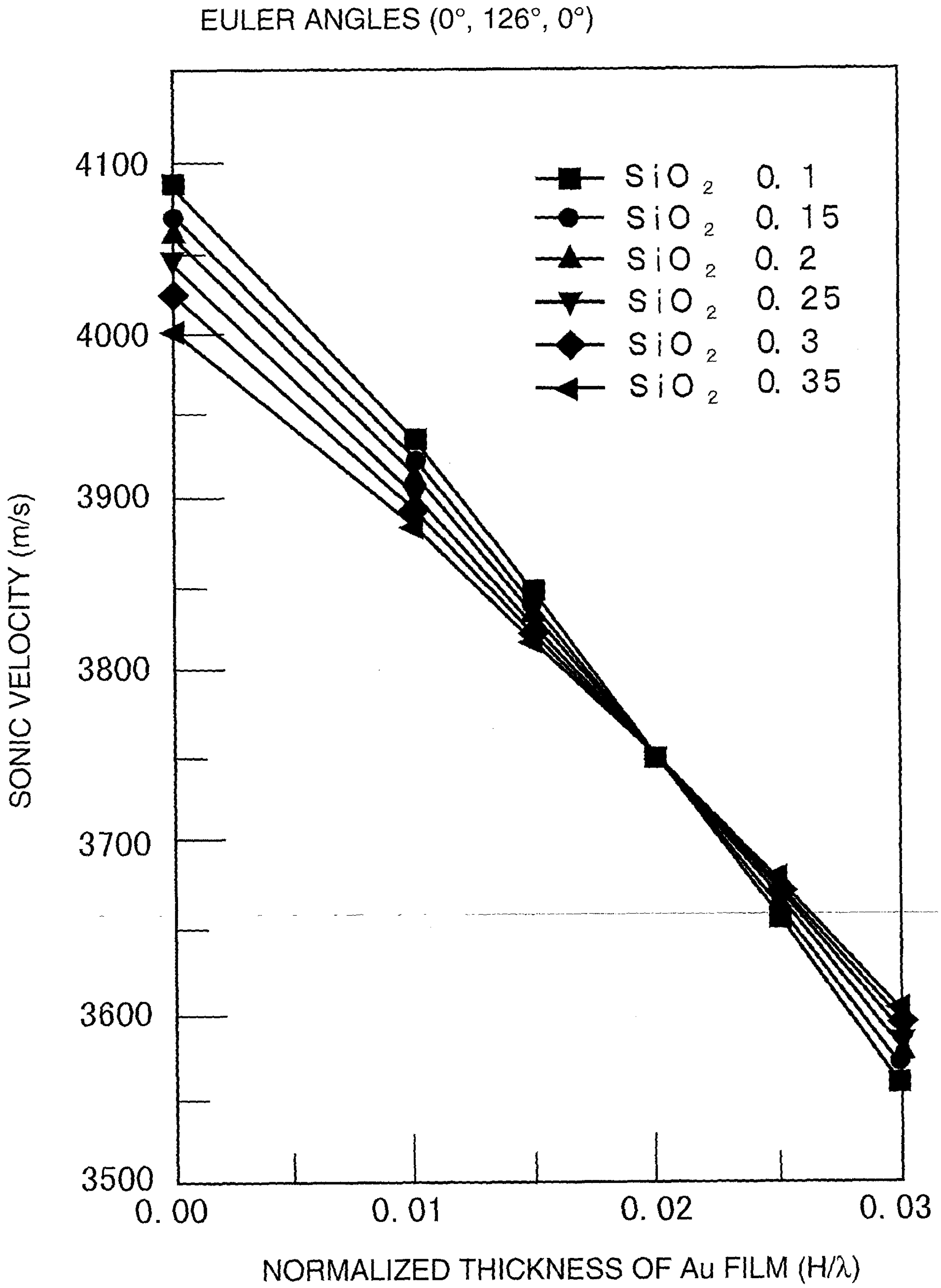
EULER ANGLES (0°, 126°, 0°)
SiO2 0. 1
SiO2 0. 15
SiO2 0. 2
SiO2 0. 25
SiO2 0. 3
SiO2 0. 35
4100
4000
3900
3800
3700
3600
3500
SONIC VELOCITY (m/s)
0. 00
0. 01
0. 02
0. 03
NORMALIZED THICKNESS OF Au FILM (H/λ)

FIG. 24

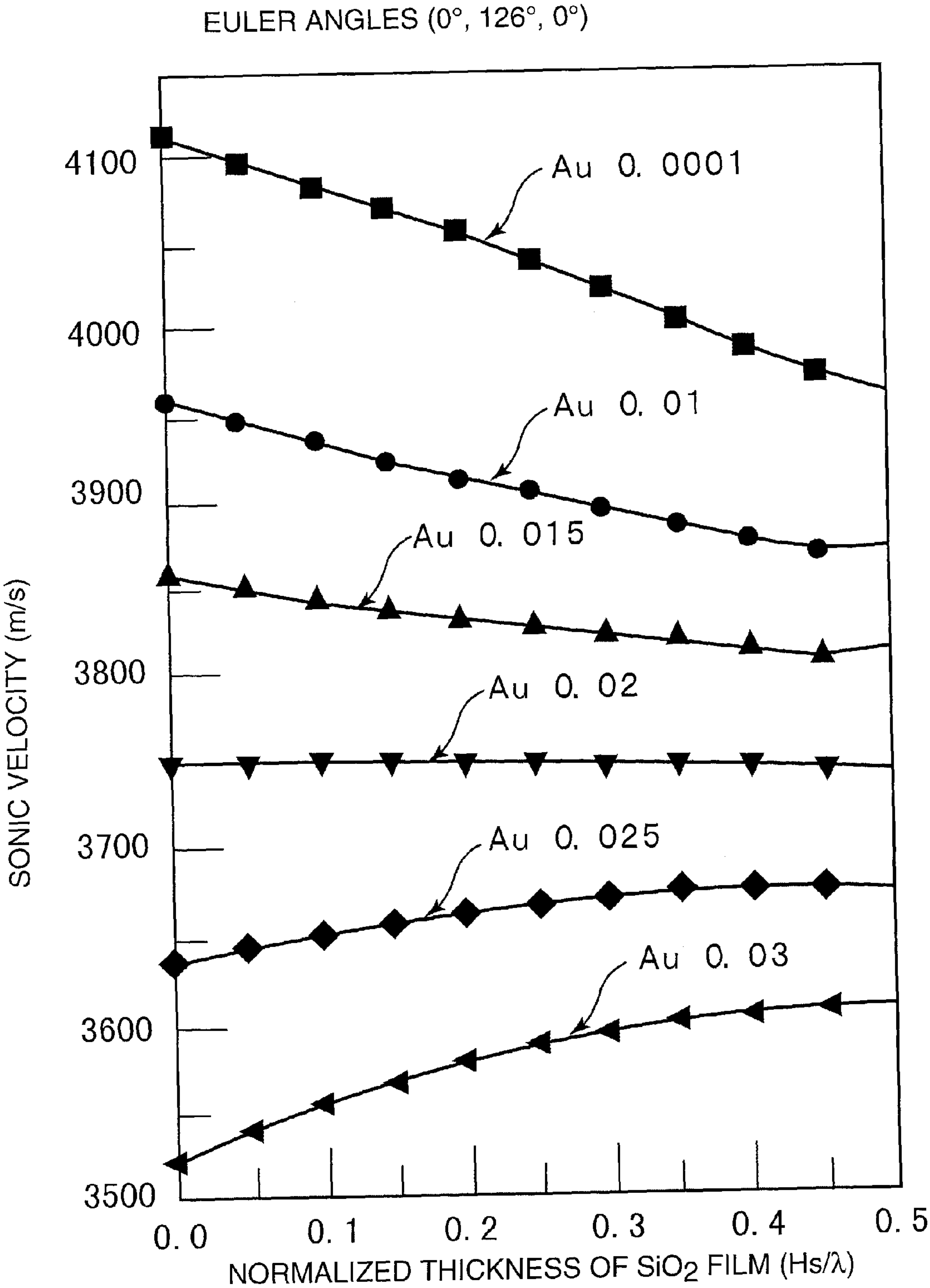
EULER ANGLES (0°, 126°, 0°)
Au 0. 0001
Au 0. 01
Au 0. 015
Au 0. 02
Au 0. 025
Au 0. 03
SONIC VELOCITY (m/s)
4100
4000
3900
3800
3700
3600
3500
0. 0
0. 1
0. 2
0. 3
0. 4
0. 5
NORMALIZED THICKNESS OF SiO2 FILM (Hs/λ)

FIG. 25

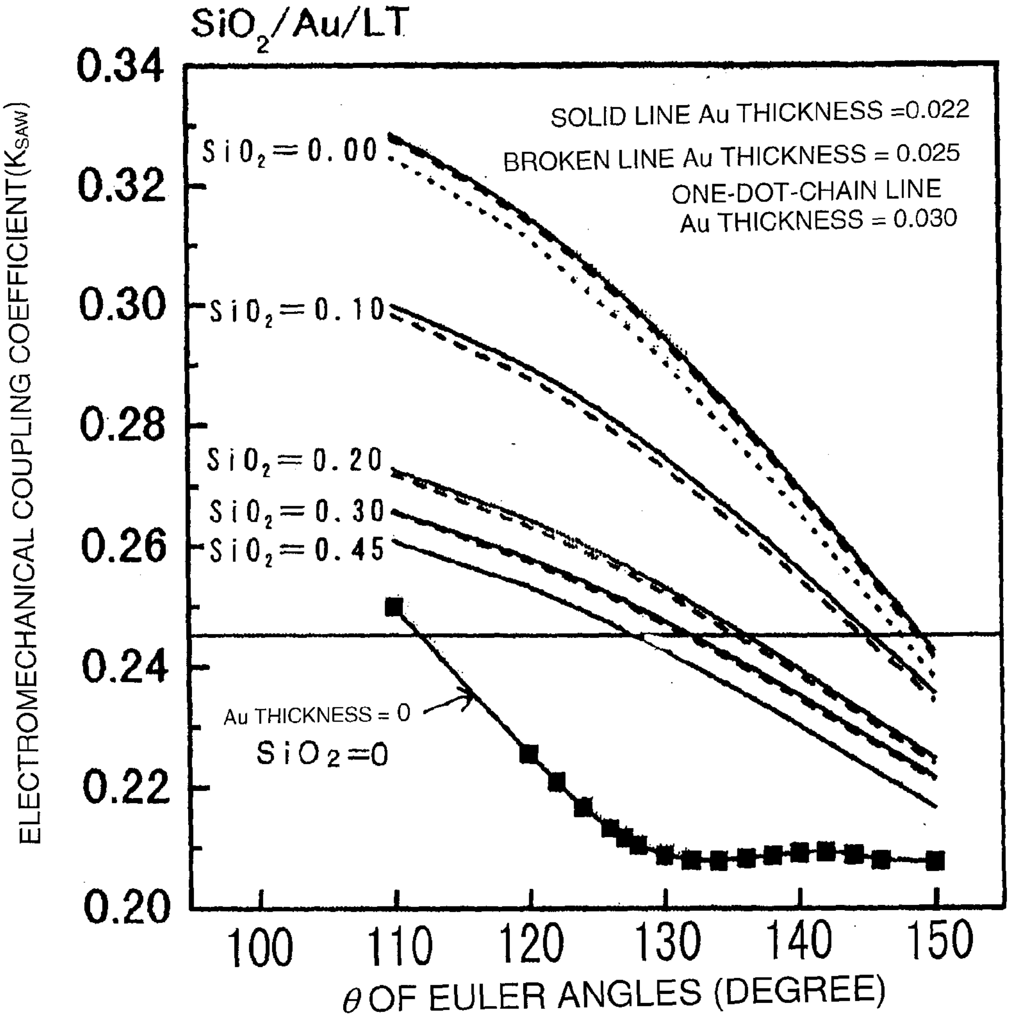
SiO2/Au/LT
SOLID LINE Au THICKNESS =0.022
BROKEN LINE Au THICKNESS = 0.025
ONE-DOT-CHAIN LINE
Au THICKNESS = 0.030
SiO2=0.00
SiO2=0.10
SiO2=0.20
SiO2=0.30
SiO2=0.45
Au THICKNESS = 0
SiO2=0
ELECTROMECHANICAL COUPLING COEFFICIENT(KSAW)
0.34
0.32
0.30
0.28
0.26
0.24
0.22
0.20
100
110
120
130
140
150
θ OF EULER ANGLES (DEGREE)

FIG. 26

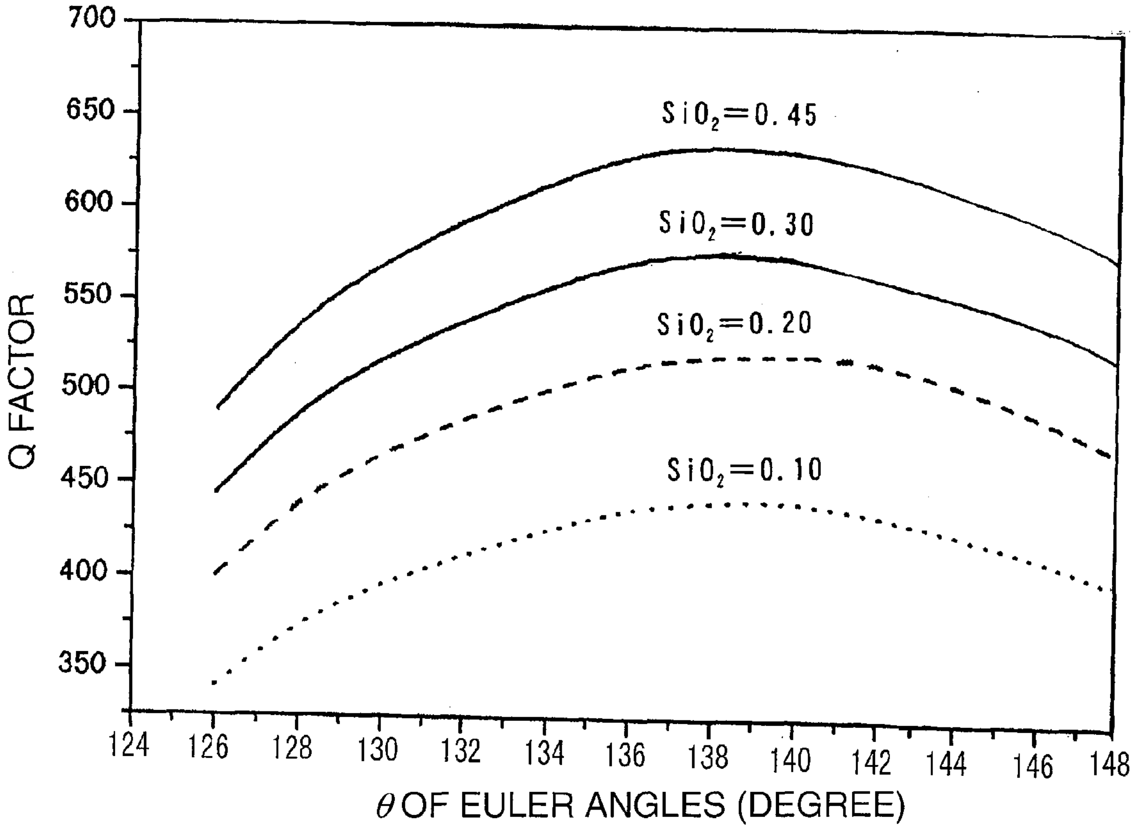
Q FACTOR
700
650
600
550
500
450
400
350
124 126 128 130 132 134 136 138 140 142 144 146 148
θ OF EULER ANGLES (DEGREE)
SiO2=0.45
SiO2=0.30
SiO2=0.20
SiO2=0.10

FIG. 27A

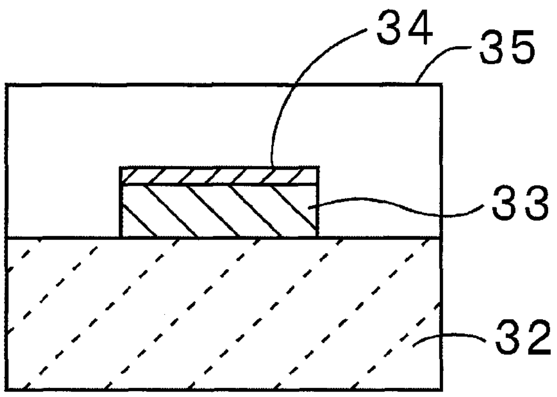


FIG. 27B

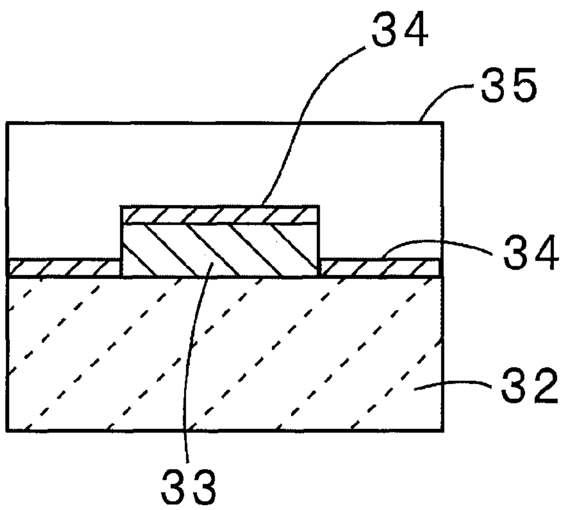


FIG. 27C

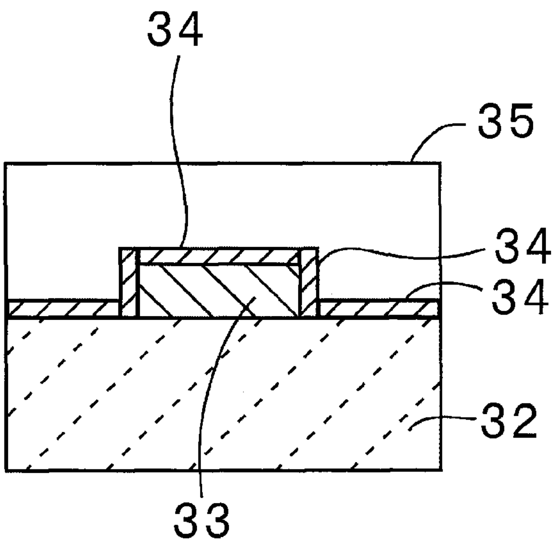

FIG. 28

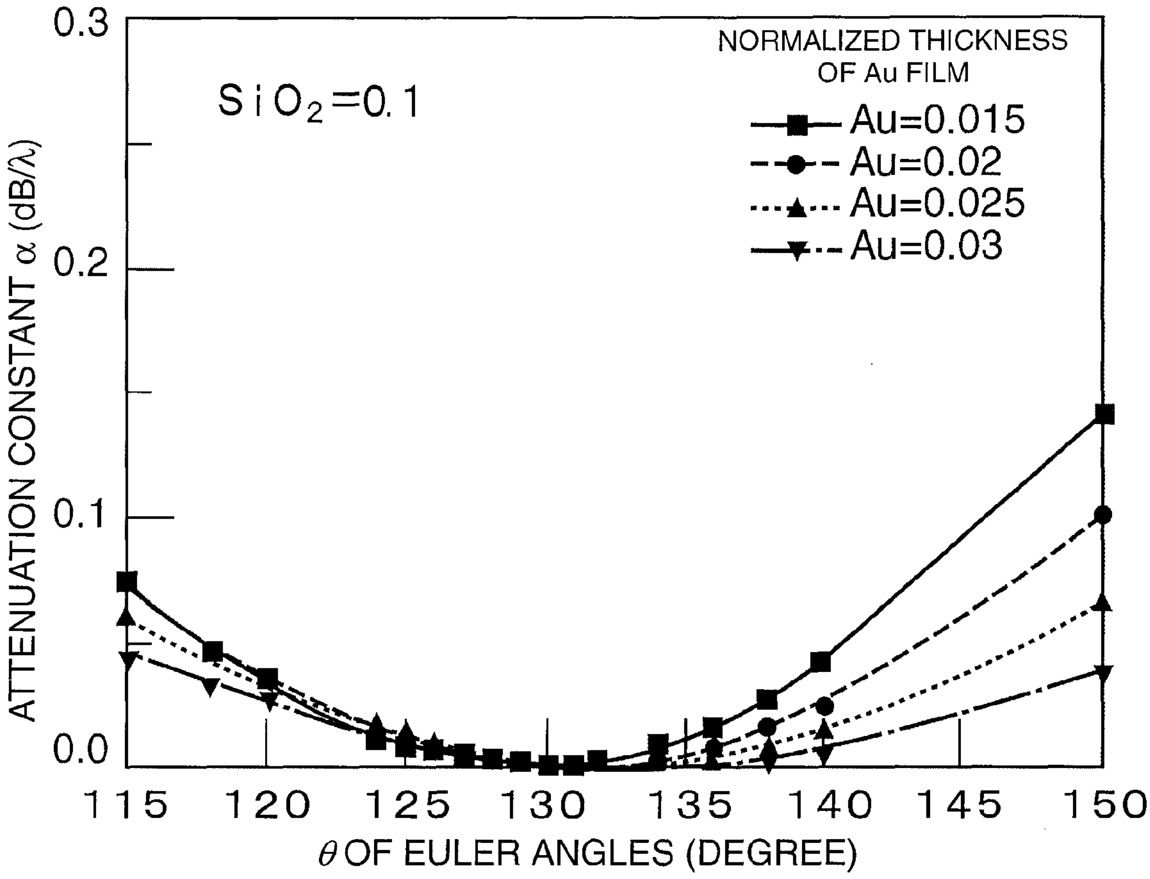
0.3
0.2
0.1
0.0
ATTENUATION CONSTANT α (dB/λ)
SiO2=0.1
NORMALIZED THICKNESS
OF Au FILM
Au=0.015
Au=0.02
Au=0.025
Au=0.03
115
120
125
130
135
140
145
150
θ OF EULER ANGLES (DEGREE)

FIG. 29

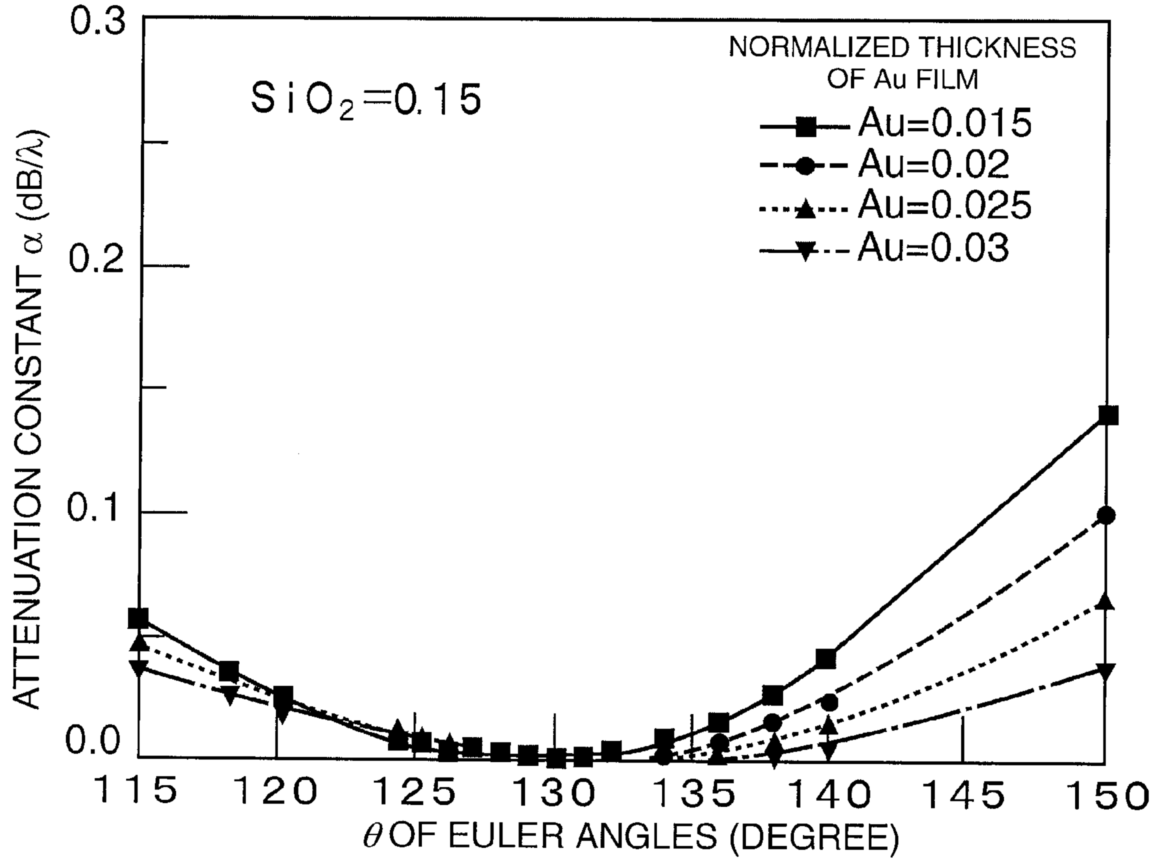
SiO2=0.15
NORMALIZED THICKNESS OF Au FILM
Au=0.015
Au=0.02
Au=0.025
Au=0.03
ATTENUATION CONSTANT α (dB/λ)
0.3
0.2
0.1
0.0
115
120
125
130
135
140
145
150
θ OF EULER ANGLES (DEGREE)

FIG. 30

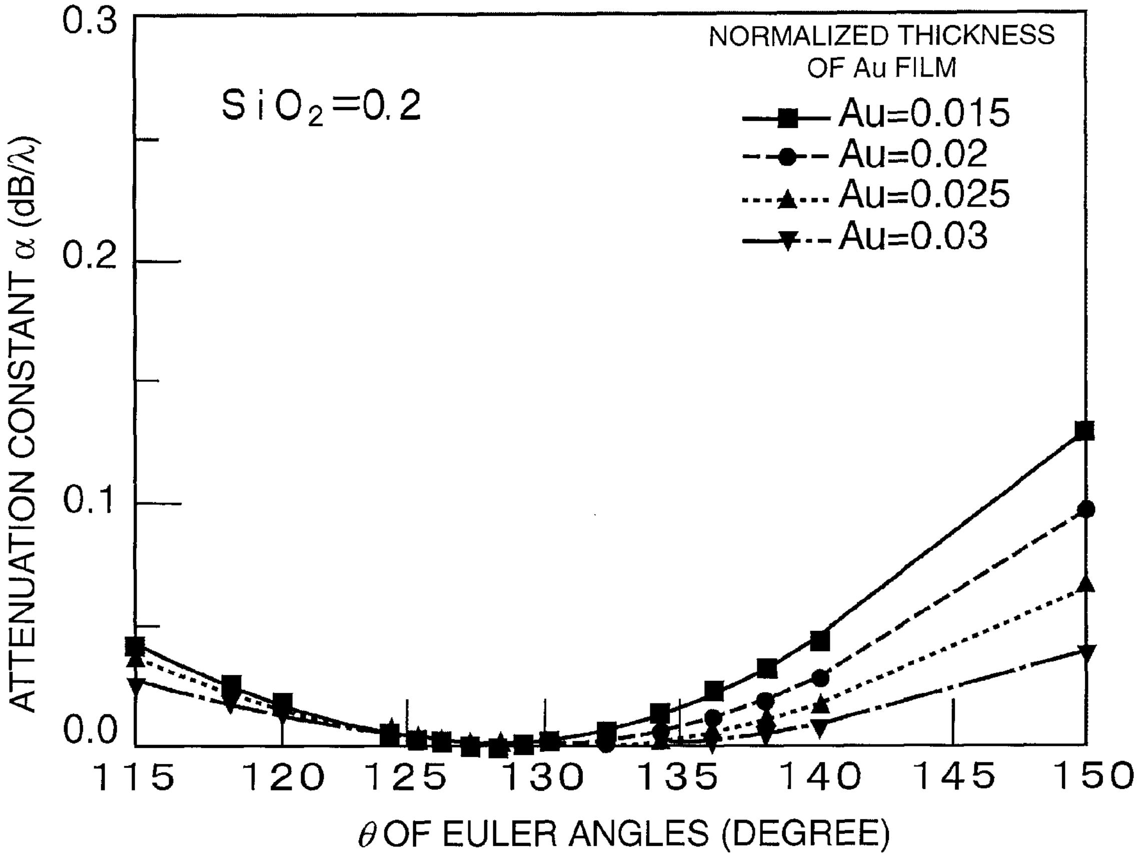
0.3
0.2
0.1
0.0
ATTENUATION CONSTANT α (dB/λ)
$SiO_2$=0.2
NORMALIZED THICKNESS
OF Au FILM
Au=0.015
Au=0.02
Au=0.025
Au=0.03
115
120
125
130
135
140
145
150
θ OF EULER ANGLES (DEGREE)

FIG. 31

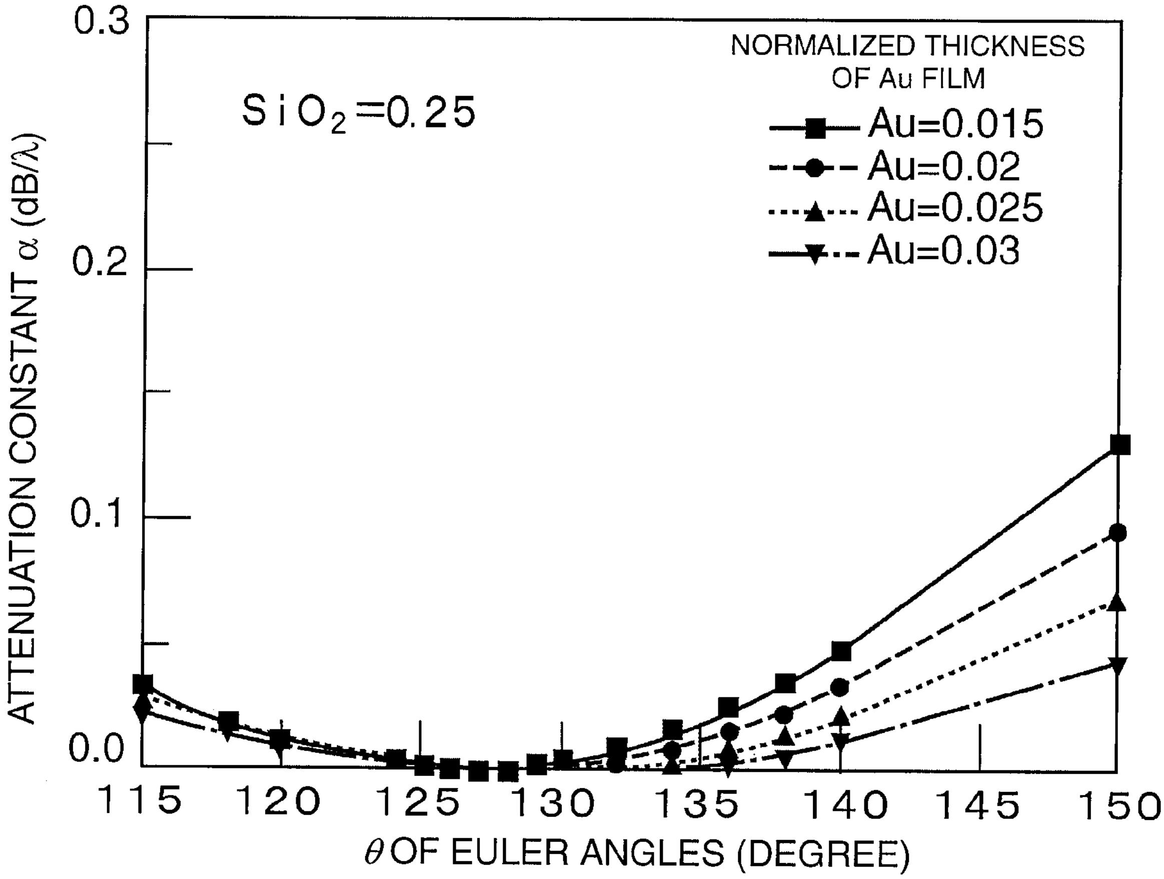
0.3
0.2
0.1
0.0
ATTENUATION CONSTANT α (dB/λ)
$SiO_2$=0.25
NORMALIZED THICKNESS OF Au FILM
Au=0.015
Au=0.02
Au=0.025
Au=0.03
115
120
125
130
135
140
145
150
θ OF EULER ANGLES (DEGREE)

FIG. 32

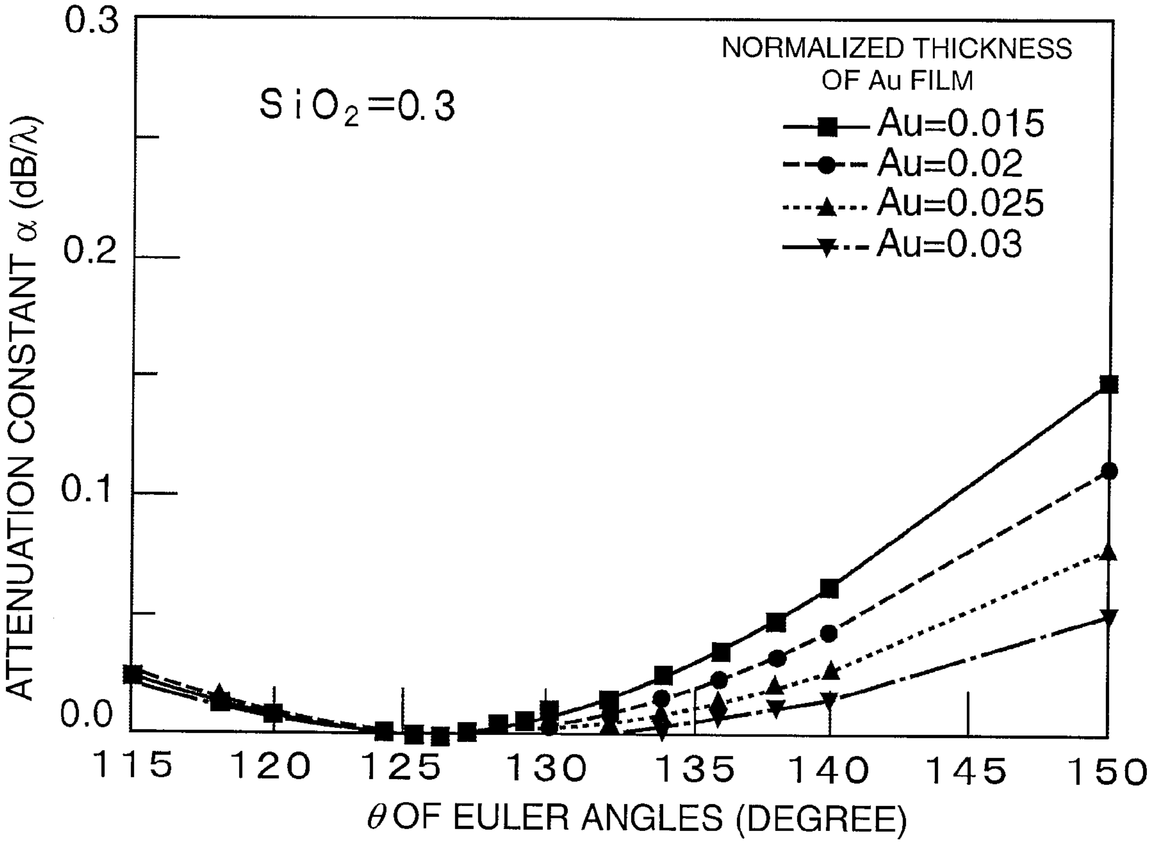

0.3
0.2
0.1
0.0
ATTENUATION CONSTANT α (dB/λ)
SiO2=0.3
NORMALIZED THICKNESS OF Au FILM
Au=0.015
Au=0.02
Au=0.025
Au=0.03
115
120
125
130
135
140
145
150
θ OF EULER ANGLES (DEGREE)

FIG. 33

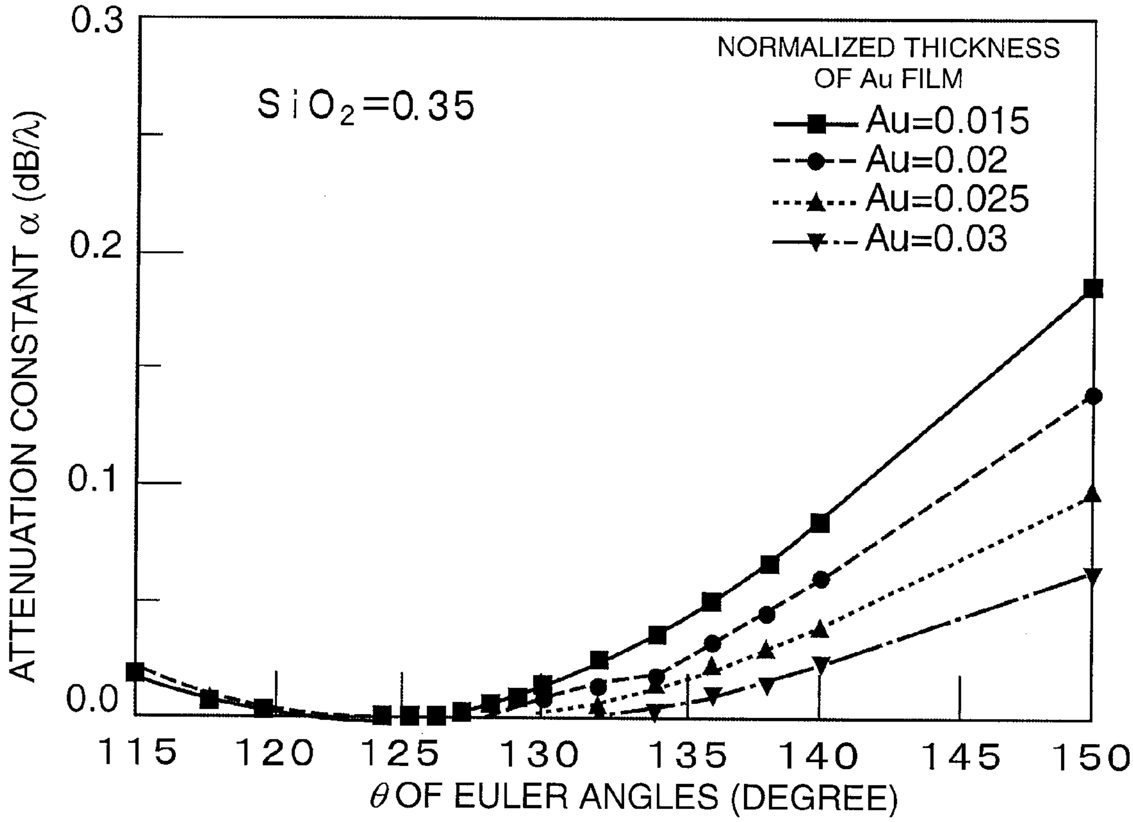
0.3
0.2
0.1
0.0
ATTENUATION CONSTANT α (dB/λ)
SiO2=0.35
NORMALIZED THICKNESS
OF Au FILM
Au=0.015
Au=0.02
Au=0.025
Au=0.03
115
120
125
130
135
140
145
150
θ OF EULER ANGLES (DEGREE)

FIG. 34

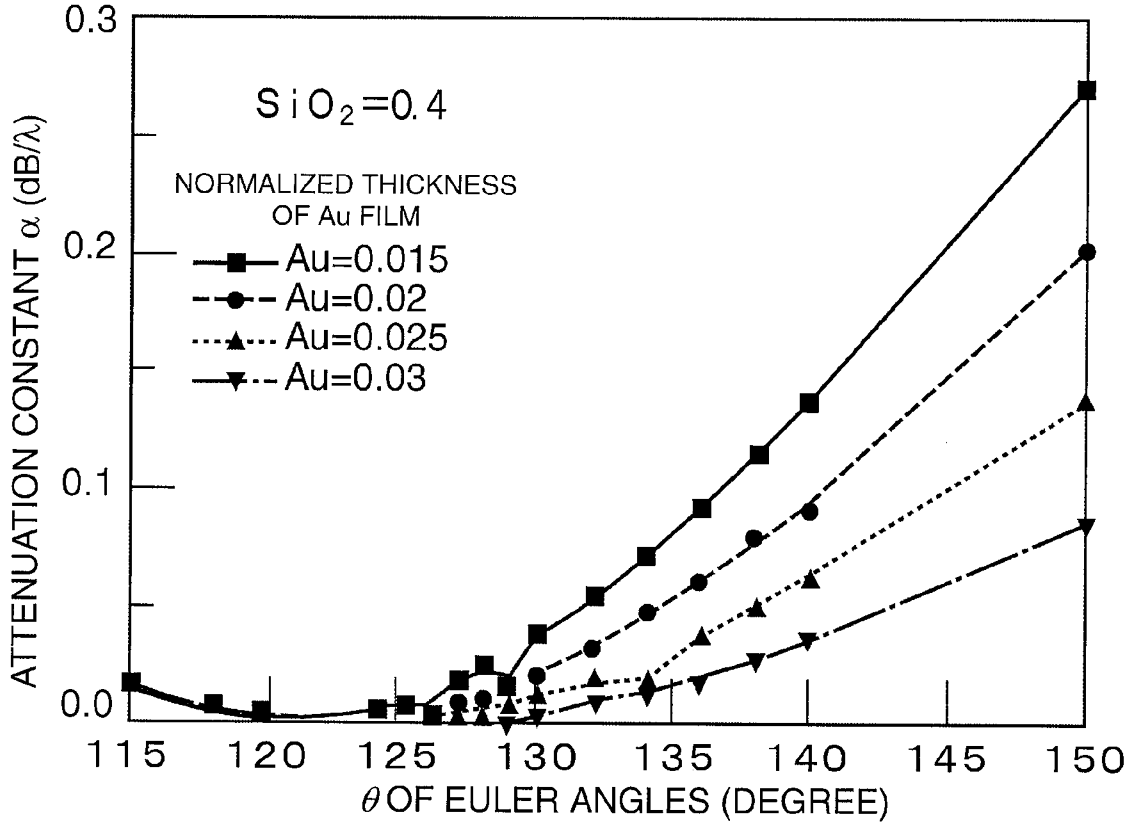
SiO2=0.4
NORMALIZED THICKNESS OF Au FILM
Au=0.015
Au=0.02
Au=0.025
Au=0.03
ATTENUATION CONSTANT α (dB/λ)
0.0
0.1
0.2
0.3
115
120
125
130
135
140
145
150
θ OF EULER ANGLES (DEGREE)

FIG. 35

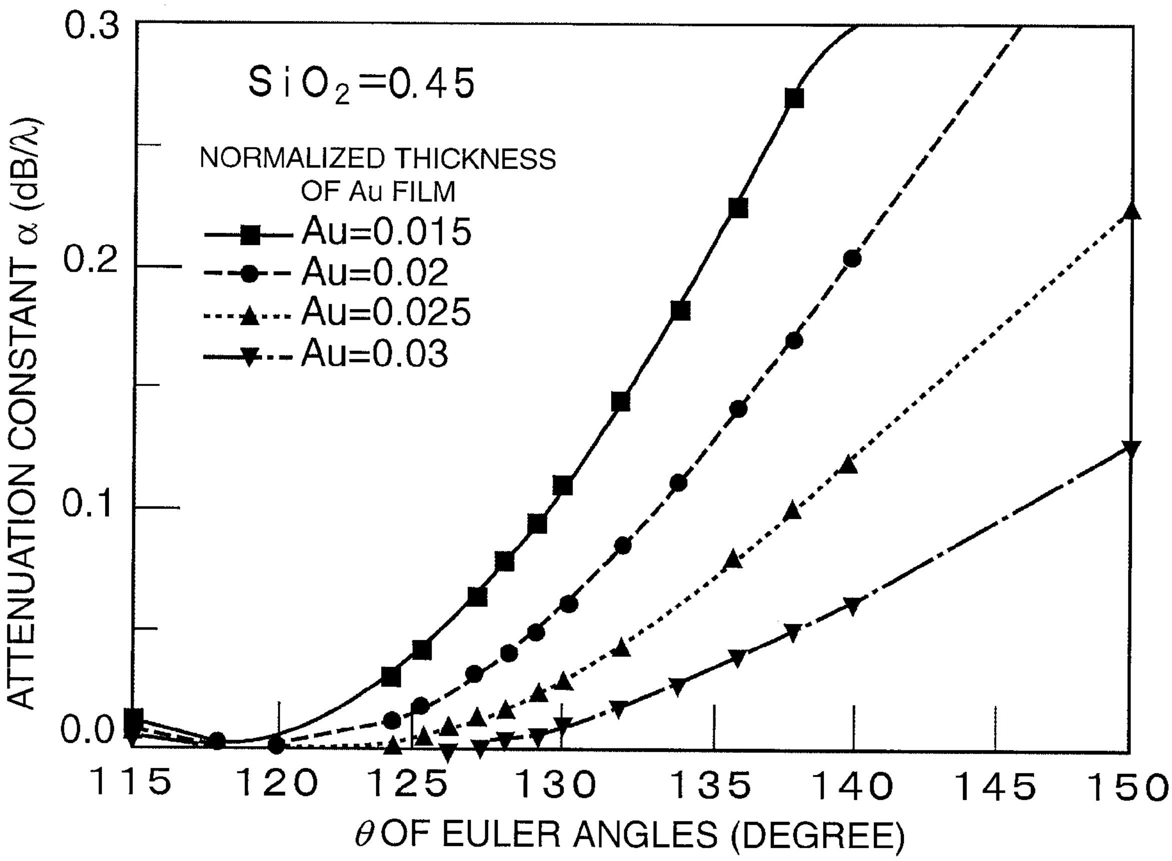
SiO2=0.45
NORMALIZED THICKNESS OF Au FILM
Au=0.015
Au=0.02
Au=0.025
Au=0.03
ATTENUATION CONSTANT α (dB/λ)
0.3
0.2
0.1
0.0
115
120
125
130
135
140
145
150
θ OF EULER ANGLES (DEGREE)

FIG. 36

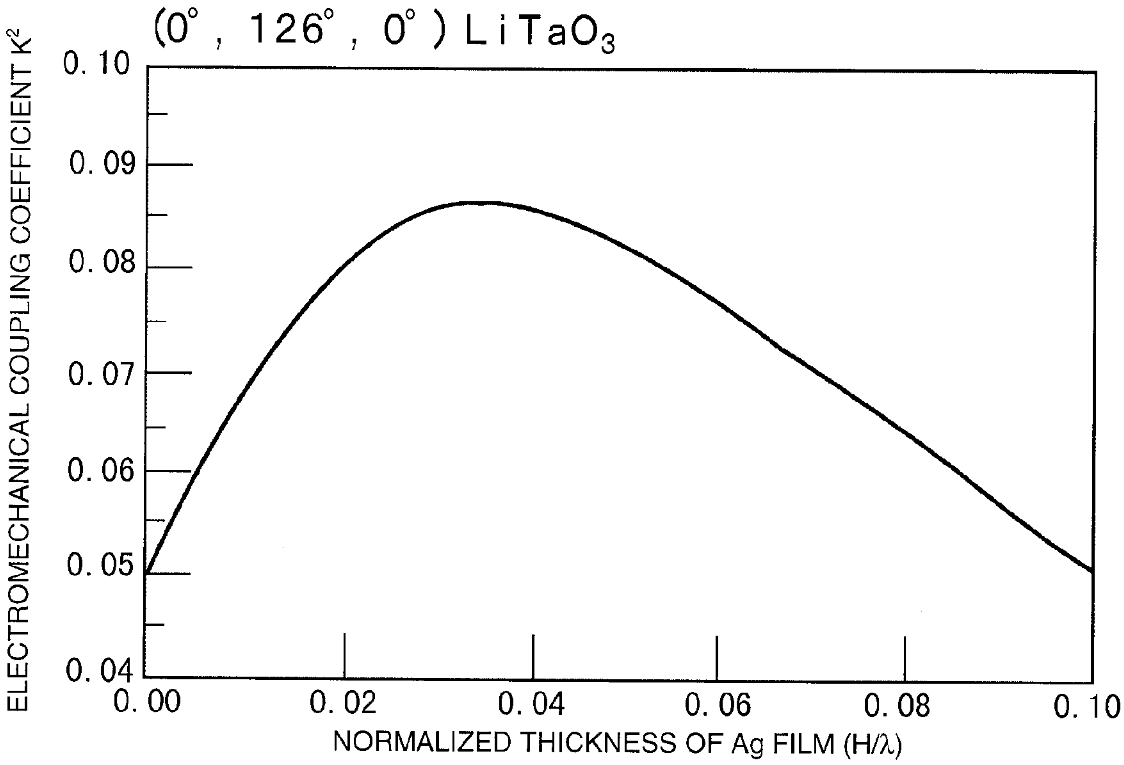
(0°, 126°, 0°) $LiTaO_3$
ELECTROMECHANICAL COUPLING COEFFICIENT $K^2$
0.10
0.09
0.08
0.07
0.06
0.05
0.04
0.00
0.02
0.04
0.06
0.08
0.10
NORMALIZED THICKNESS OF Ag FILM (H/λ)

FIG. 37

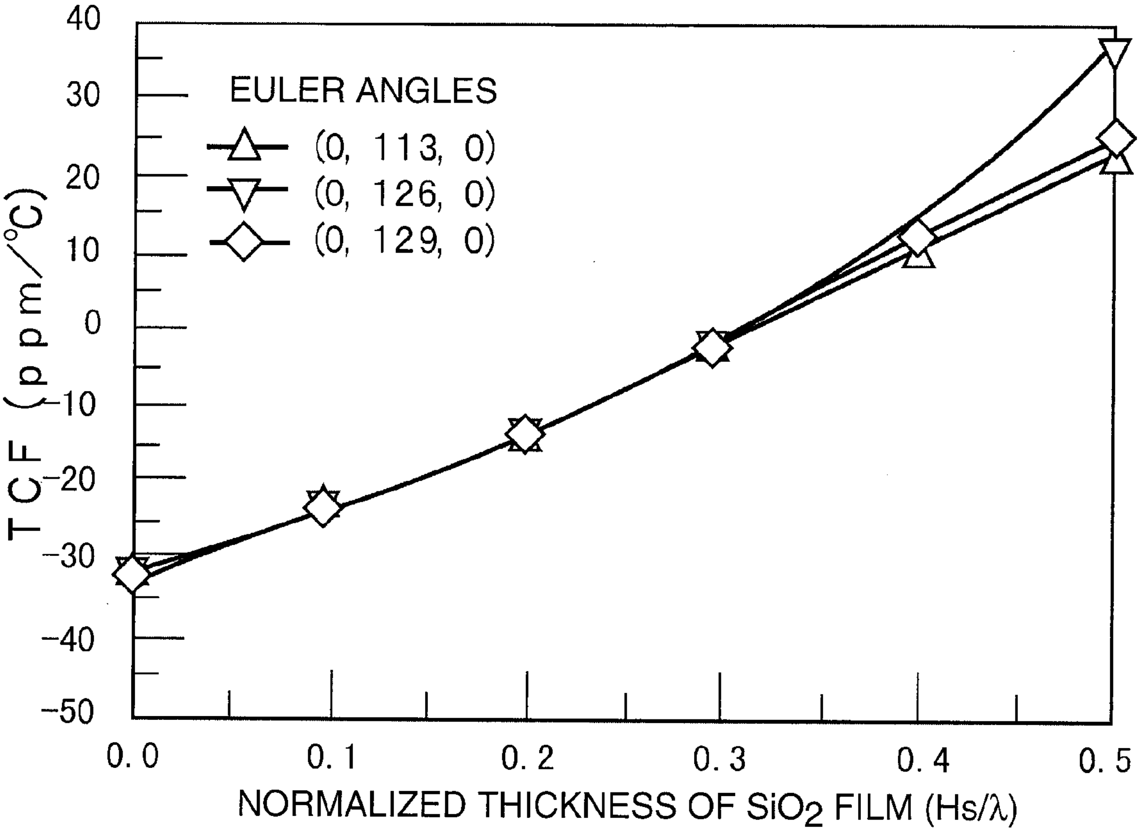
EULER ANGLES
(0, 113, 0)
(0, 126, 0)
(0, 129, 0)
TCF (ppm/°C)
40
30
20
10
0
−10
−20
−30
−40
−50
0. 0
0. 1
0. 2
0. 3
0. 4
0. 5
NORMALIZED THICKNESS OF SiO2 FILM (Hs/λ)

FIG. 38

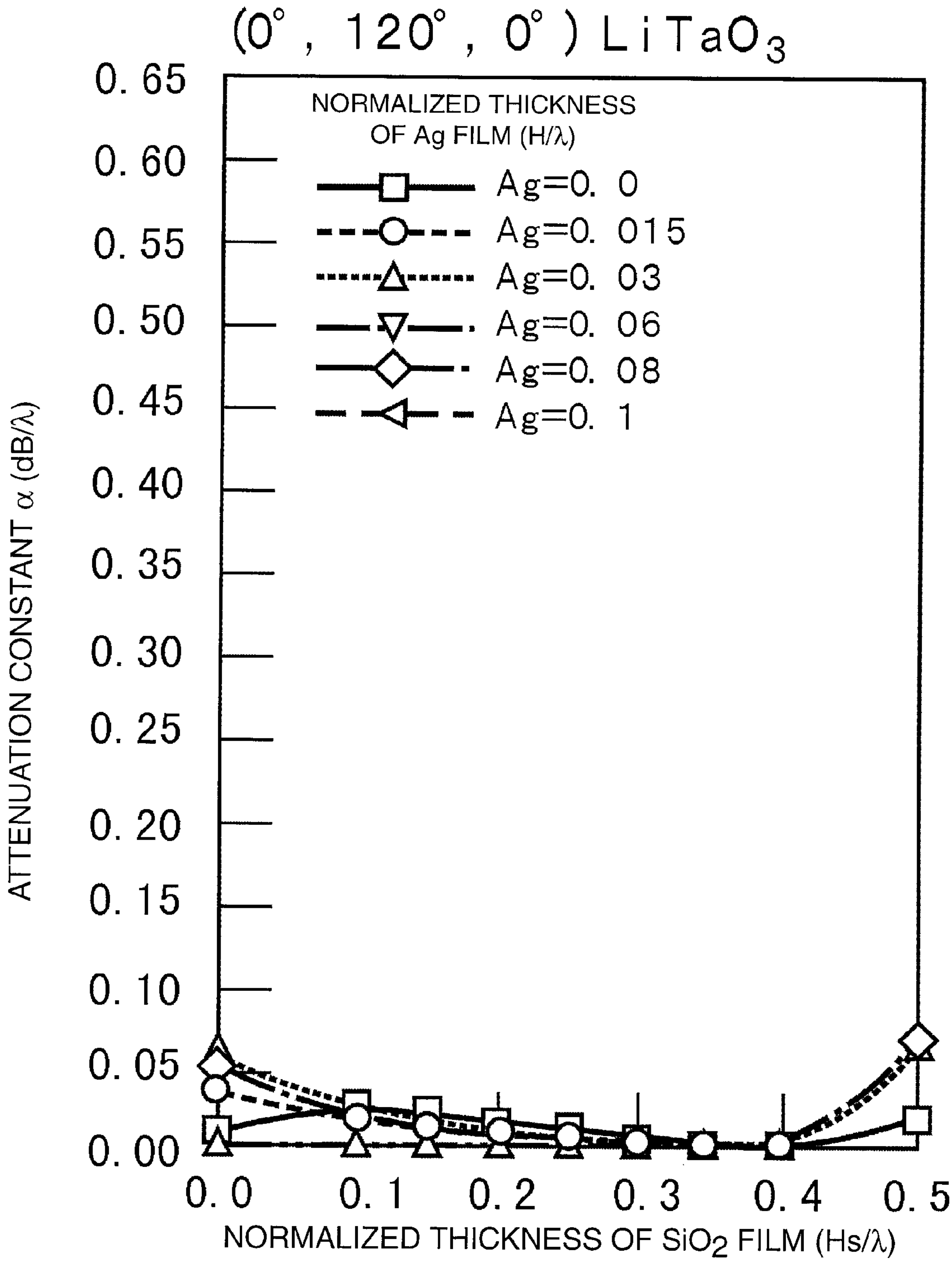
(0°, 120°, 0°) LiTaO3
NORMALIZED THICKNESS
OF Ag FILM (H/λ)
Ag=0. 0
Ag=0. 015
Ag=0. 03
Ag=0. 06
Ag=0. 08
Ag=0. 1
ATTENUATION CONSTANT α (dB/λ)
0. 65
0. 60
0. 55
0. 50
0. 45
0. 40
0. 35
0. 30
0. 25
0. 20
0. 15
0. 10
0. 05
0. 00
0. 0
0. 1
0. 2
0. 3
0. 4
0. 5
NORMALIZED THICKNESS OF SiO2 FILM (Hs/λ)

FIG. 39

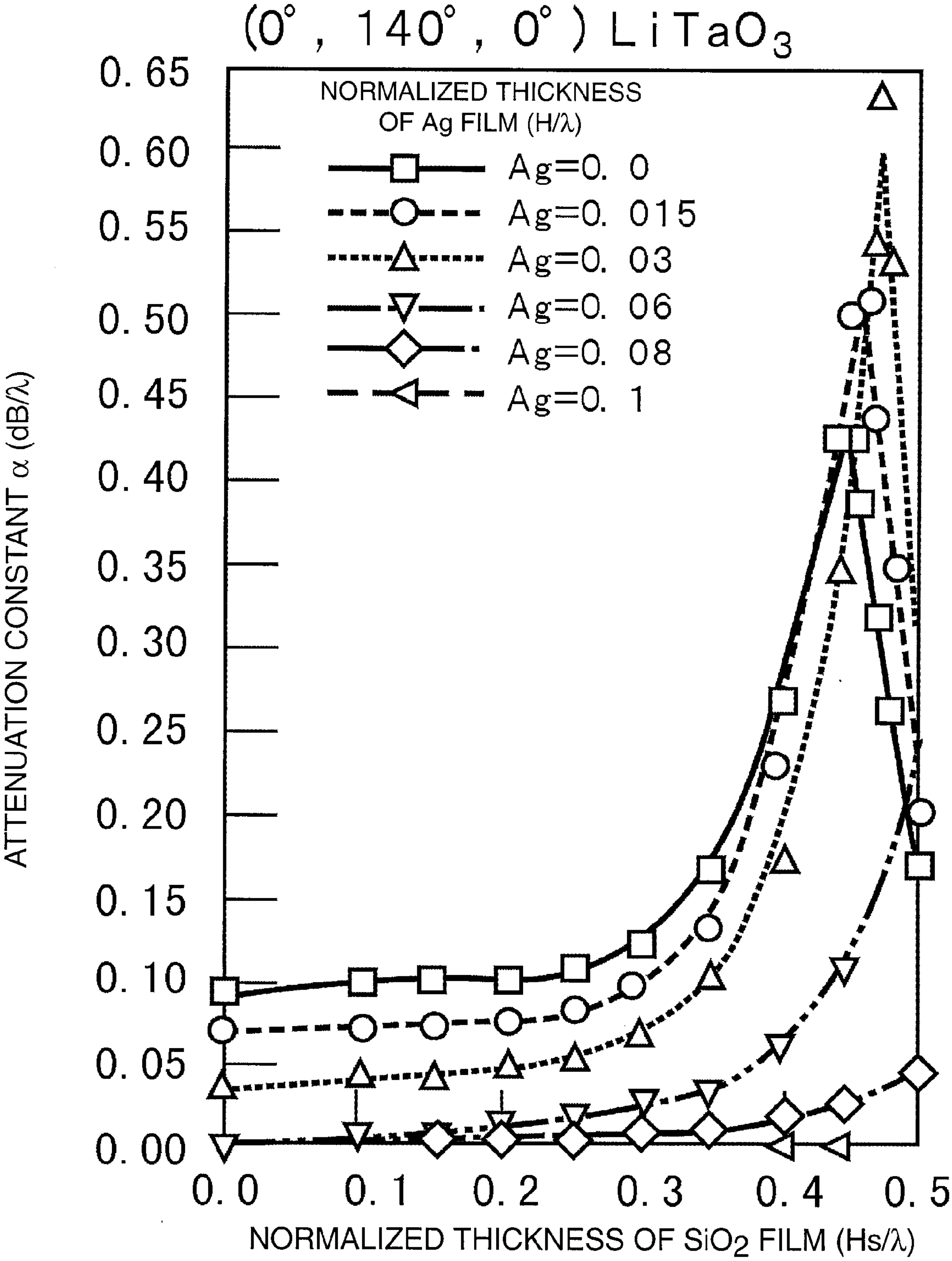
(0°, 140°, 0°) LiTaO3
NORMALIZED THICKNESS
OF Ag FILM (H/λ)
Ag=0. 0
Ag=0. 015
Ag=0. 03
Ag=0. 06
Ag=0. 08
Ag=0. 1
ATTENUATION CONSTANT α (dB/λ)
0. 65
0. 60
0. 55
0. 50
0. 45
0. 40
0. 35
0. 30
0. 25
0. 20
0. 15
0. 10
0. 05
0. 00
0. 0
0. 1
0. 2
0. 3
0. 4
0. 5
NORMALIZED THICKNESS OF SiO2 FILM (Hs/λ)

FIG. 40

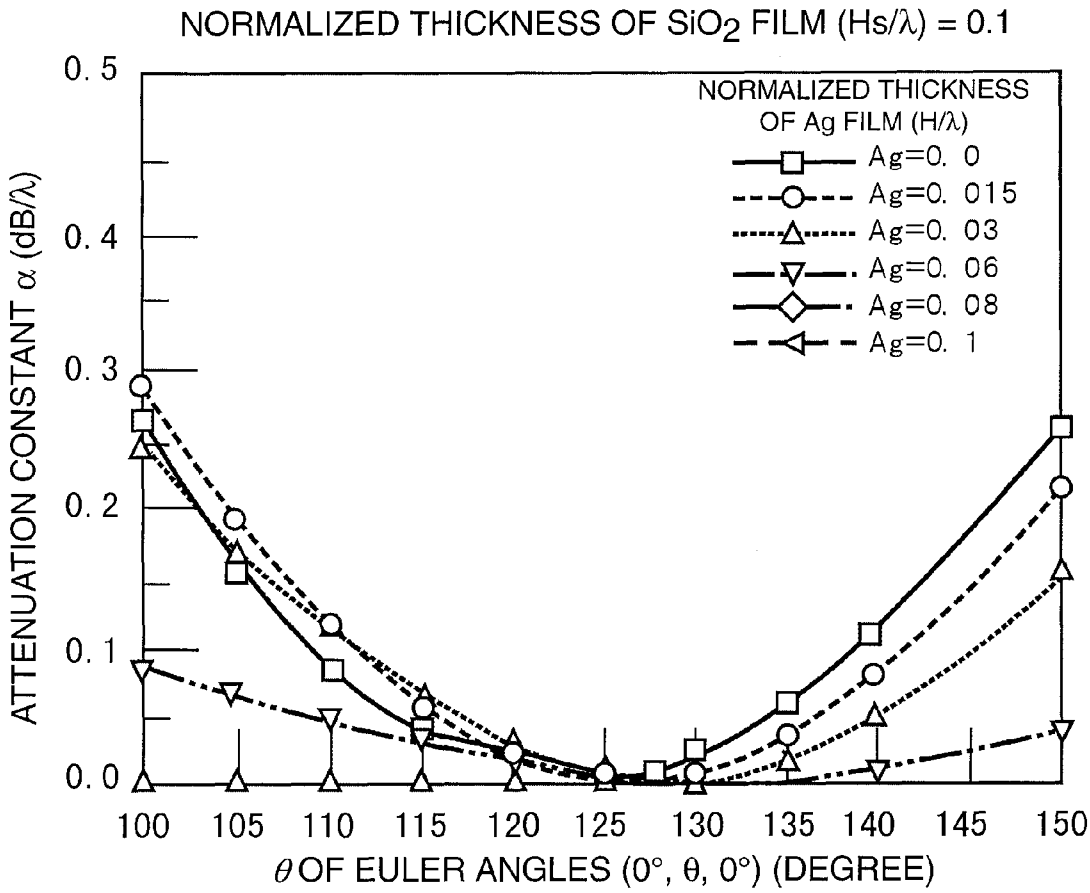
NORMALIZED THICKNESS OF SiO2 FILM (Hs/λ) = 0.1
NORMALIZED THICKNESS OF Ag FILM (H/λ)
Ag=0. 0
Ag=0. 015
Ag=0. 03
Ag=0. 06
Ag=0. 08
Ag=0. 1
ATTENUATION CONSTANT α (dB/λ)
0. 5
0. 4
0. 3
0. 2
0. 1
0. 0
100
105
110
115
120
125
130
135
140
145
150
θ OF EULER ANGLES (0°, θ, 0°) (DEGREE)

FIG. 41

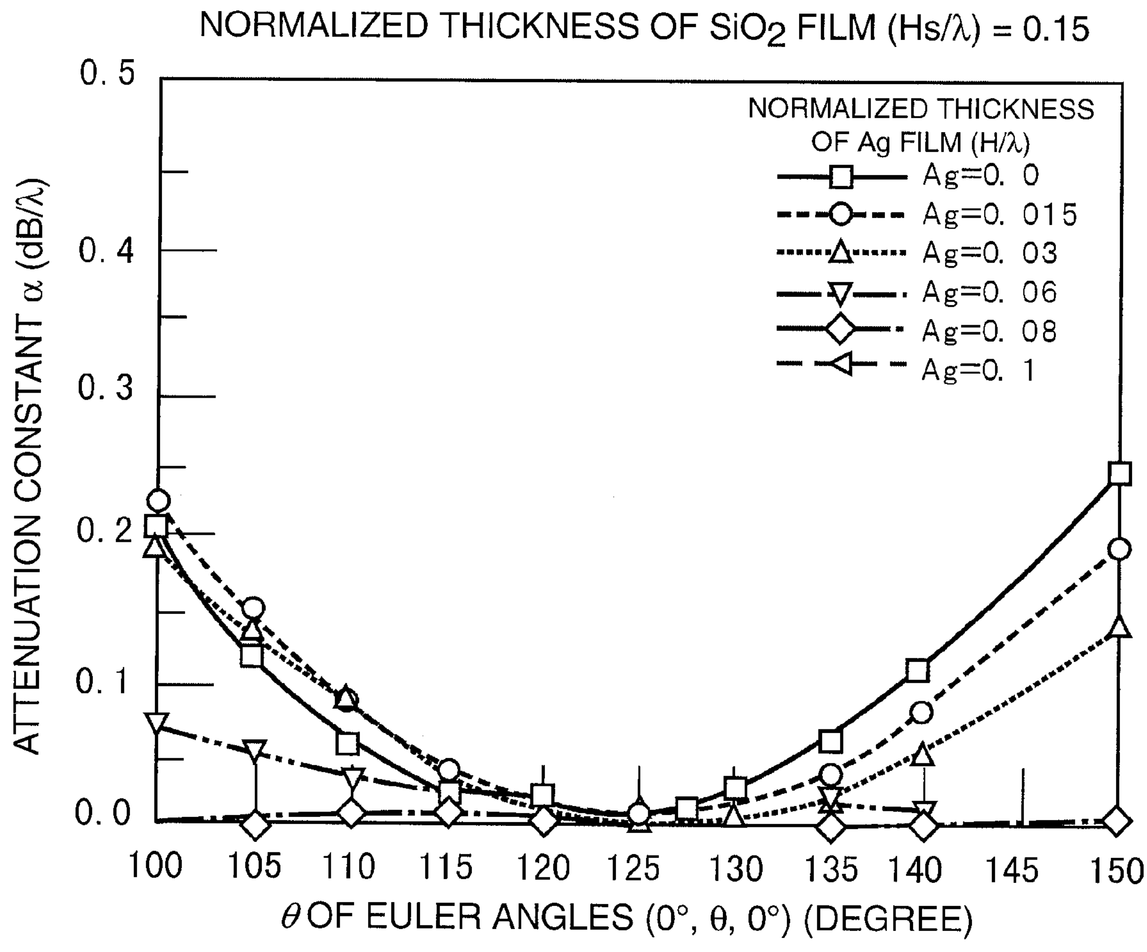
NORMALIZED THICKNESS OF SiO2 FILM (Hs/λ) = 0.15
NORMALIZED THICKNESS OF Ag FILM (H/λ)
Ag=0. 0
Ag=0. 015
Ag=0. 03
Ag=0. 06
Ag=0. 08
Ag=0. 1
ATTENUATION CONSTANT α (dB/λ)
0. 5
0. 4
0. 3
0. 2
0. 1
0. 0
100
105
110
115
120
125
130
135
140
145
150
θ OF EULER ANGLES (0°, θ, 0°) (DEGREE)

FIG. 42

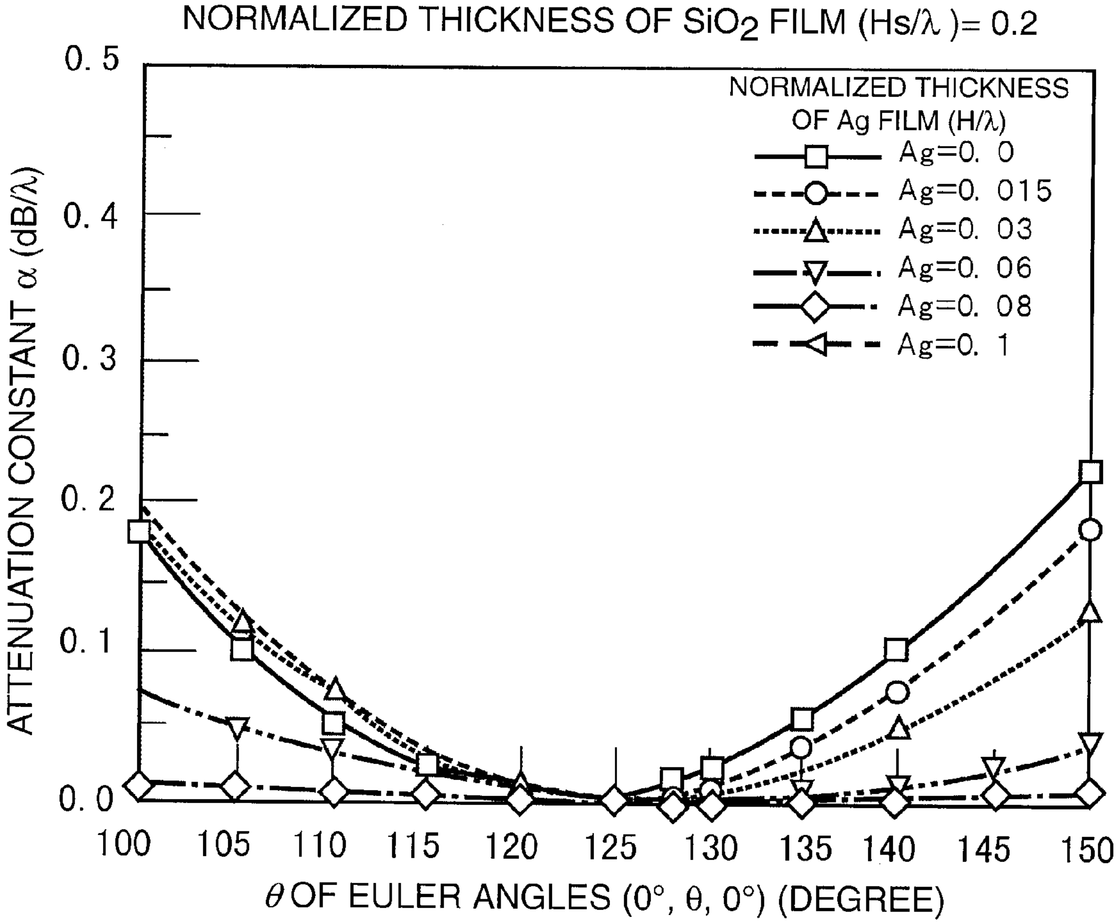
NORMALIZED THICKNESS OF SiO2 FILM (Hs/λ )= 0.2
NORMALIZED THICKNESS
OF Ag FILM (H/λ)
Ag=0. 0
Ag=0. 015
Ag=0. 03
Ag=0. 06
Ag=0. 08
Ag=0. 1
ATTENUATION CONSTANT α (dB/λ)
0. 5
0. 4
0. 3
0. 2
0. 1
0. 0
100
105
110
115
120
125
130
135
140
145
150
θ OF EULER ANGLES (0°, θ, 0°) (DEGREE)

FIG. 43

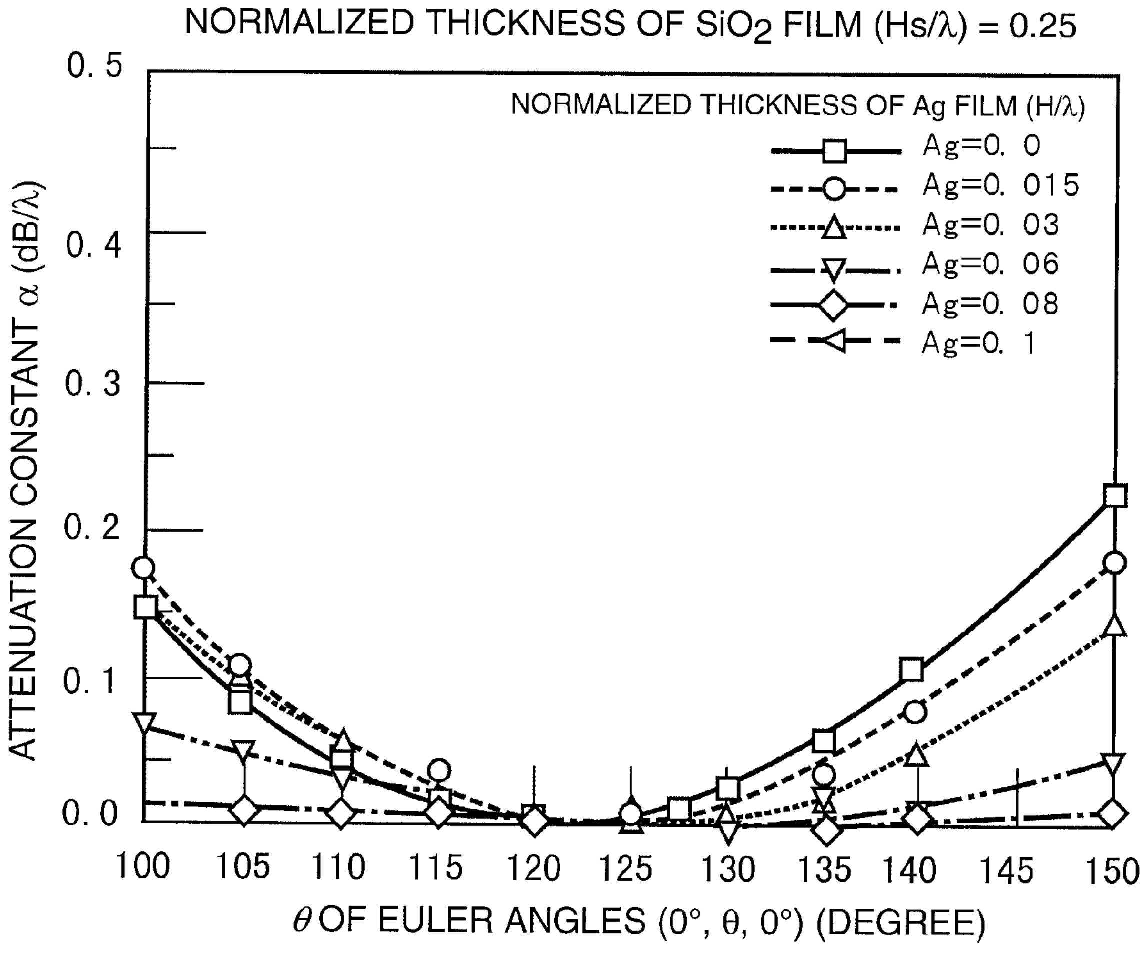
NORMALIZED THICKNESS OF SiO2 FILM (Hs/λ) = 0.25
NORMALIZED THICKNESS OF Ag FILM (H/λ)
Ag=0. 0
Ag=0. 015
Ag=0. 03
Ag=0. 06
Ag=0. 08
Ag=0. 1
ATTENUATION CONSTANT α (dB/λ)
0. 5
0. 4
0. 3
0. 2
0. 1
0. 0
100
105
110
115
120
125
130
135
140
145
150
θ OF EULER ANGLES (0°, θ, 0°) (DEGREE)

FIG. 44

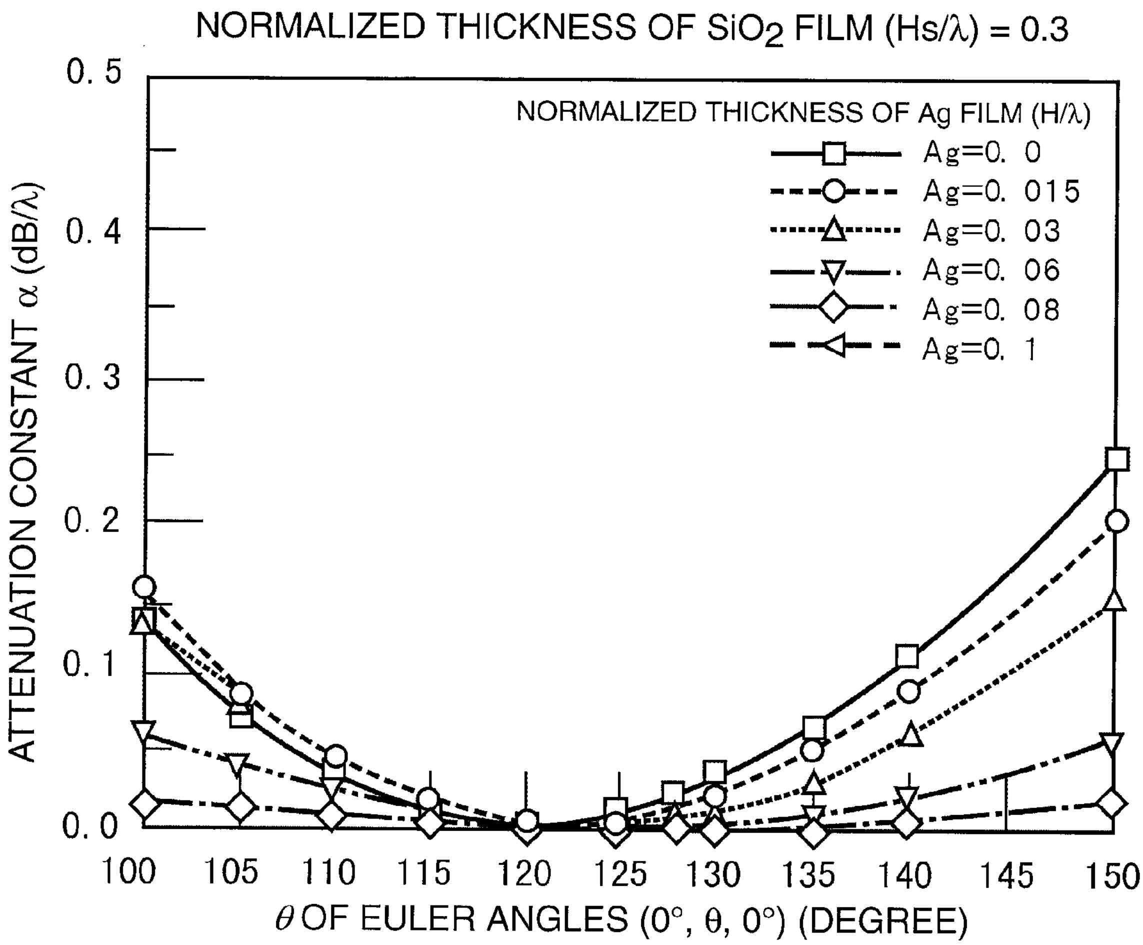
NORMALIZED THICKNESS OF $SiO_2$ FILM (Hs/λ) = 0.3
NORMALIZED THICKNESS OF Ag FILM (H/λ)
Ag=0. 0
Ag=0. 015
Ag=0. 03
Ag=0. 06
Ag=0. 08
Ag=0. 1
ATTENUATION CONSTANT α (dB/λ)
0. 5
0. 4
0. 3
0. 2
0. 1
0. 0
100
105
110
115
120
125
130
135
140
145
150
θ OF EULER ANGLES (0°, θ, 0°) (DEGREE)

FIG. 45

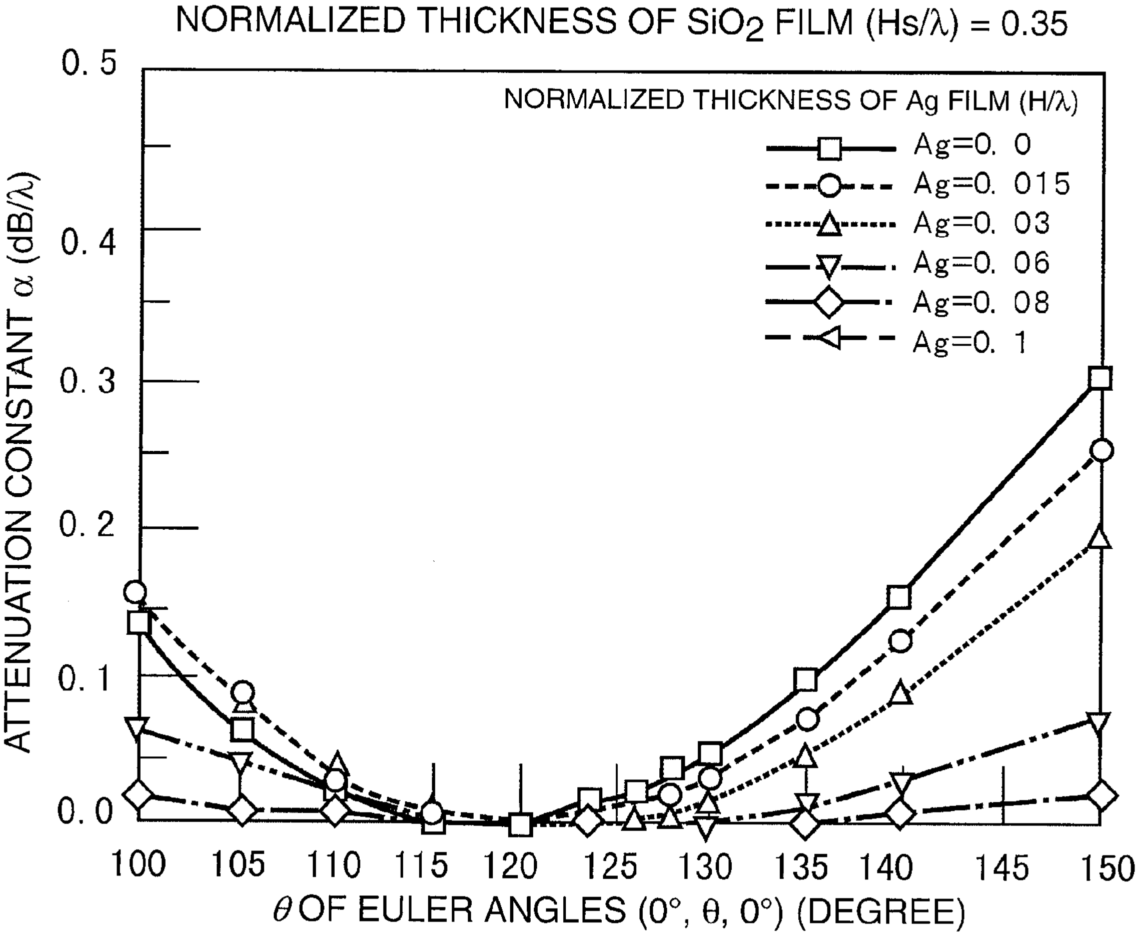
NORMALIZED THICKNESS OF SiO2 FILM (Hs/λ) = 0.35
NORMALIZED THICKNESS OF Ag FILM (H/λ)
Ag=0. 0
Ag=0. 015
Ag=0. 03
Ag=0. 06
Ag=0. 08
Ag=0. 1
ATTENUATION CONSTANT α (dB/λ)
0. 5
0. 4
0. 3
0. 2
0. 1
0. 0
100
105
110
115
120
125
130
135
140
145
150
θ OF EULER ANGLES (0°, θ, 0°) (DEGREE)

FIG. 46

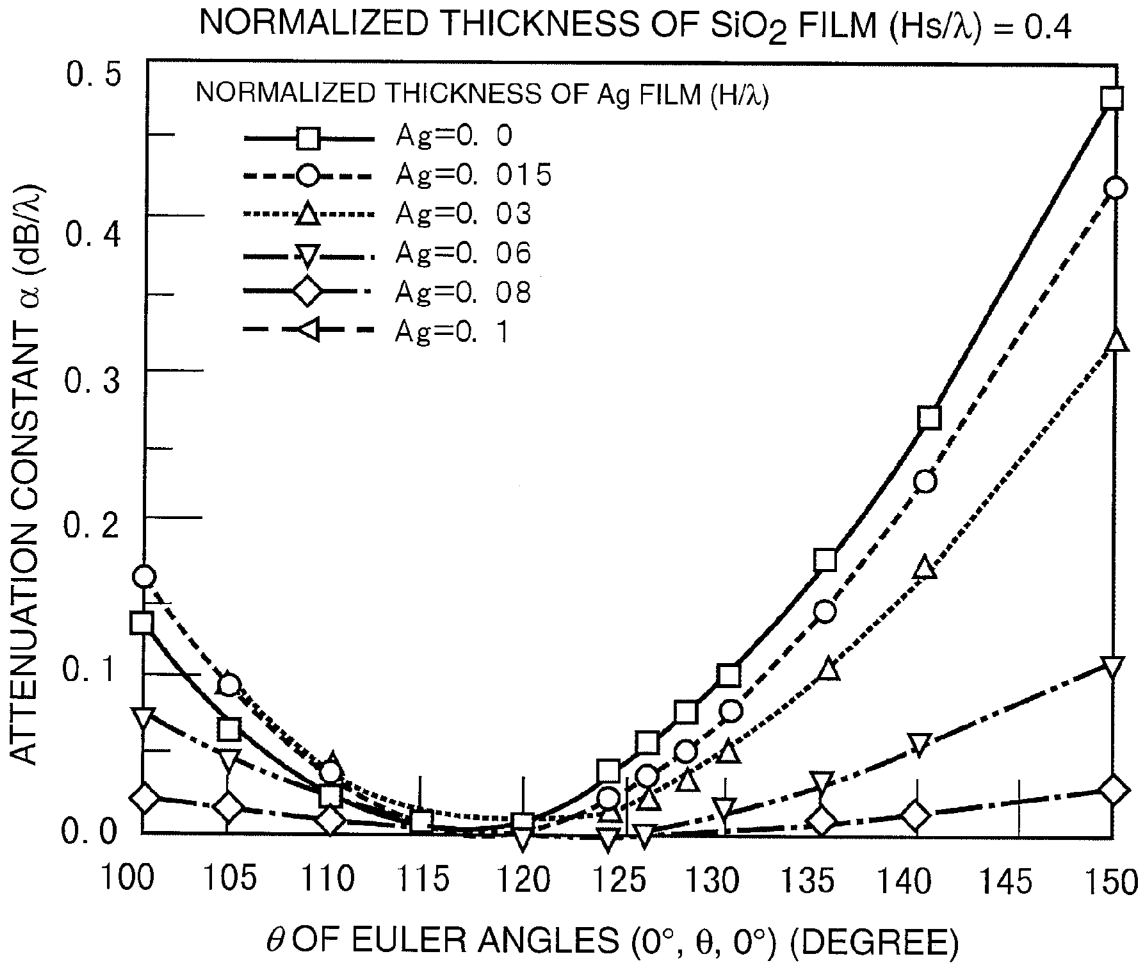

NORMALIZED THICKNESS OF SiO2 FILM (Hs/λ) = 0.4
NORMALIZED THICKNESS OF Ag FILM (H/λ)
Ag=0. 0
Ag=0. 015
Ag=0. 03
Ag=0. 06
Ag=0. 08
Ag=0. 1
ATTENUATION CONSTANT α (dB/λ)
0. 5
0. 4
0. 3
0. 2
0. 1
0. 0
100
105
110
115
120
125
130
135
140
145
150
θ OF EULER ANGLES (0°, θ, 0°) (DEGREE)

FIG. 47

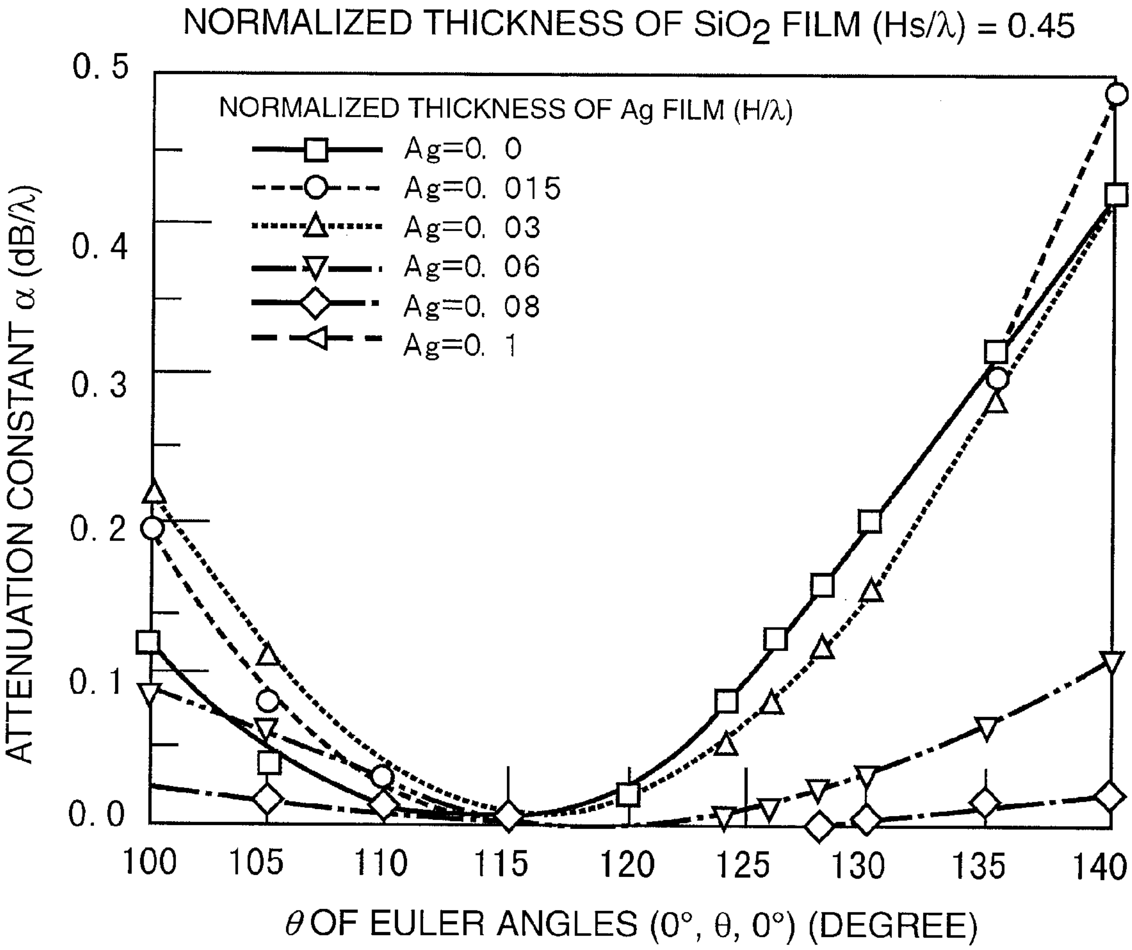
NORMALIZED THICKNESS OF SiO2 FILM (Hs/λ) = 0.45
NORMALIZED THICKNESS OF Ag FILM (H/λ)
Ag=0. 0
Ag=0. 015
Ag=0. 03
Ag=0. 06
Ag=0. 08
Ag=0. 1
ATTENUATION CONSTANT α (dB/λ)
0. 5
0. 4
0. 3
0. 2
0. 1
0. 0
100
105
110
115
120
125
130
135
140
θ OF EULER ANGLES (0°, θ, 0°) (DEGREE)

FIG. 48

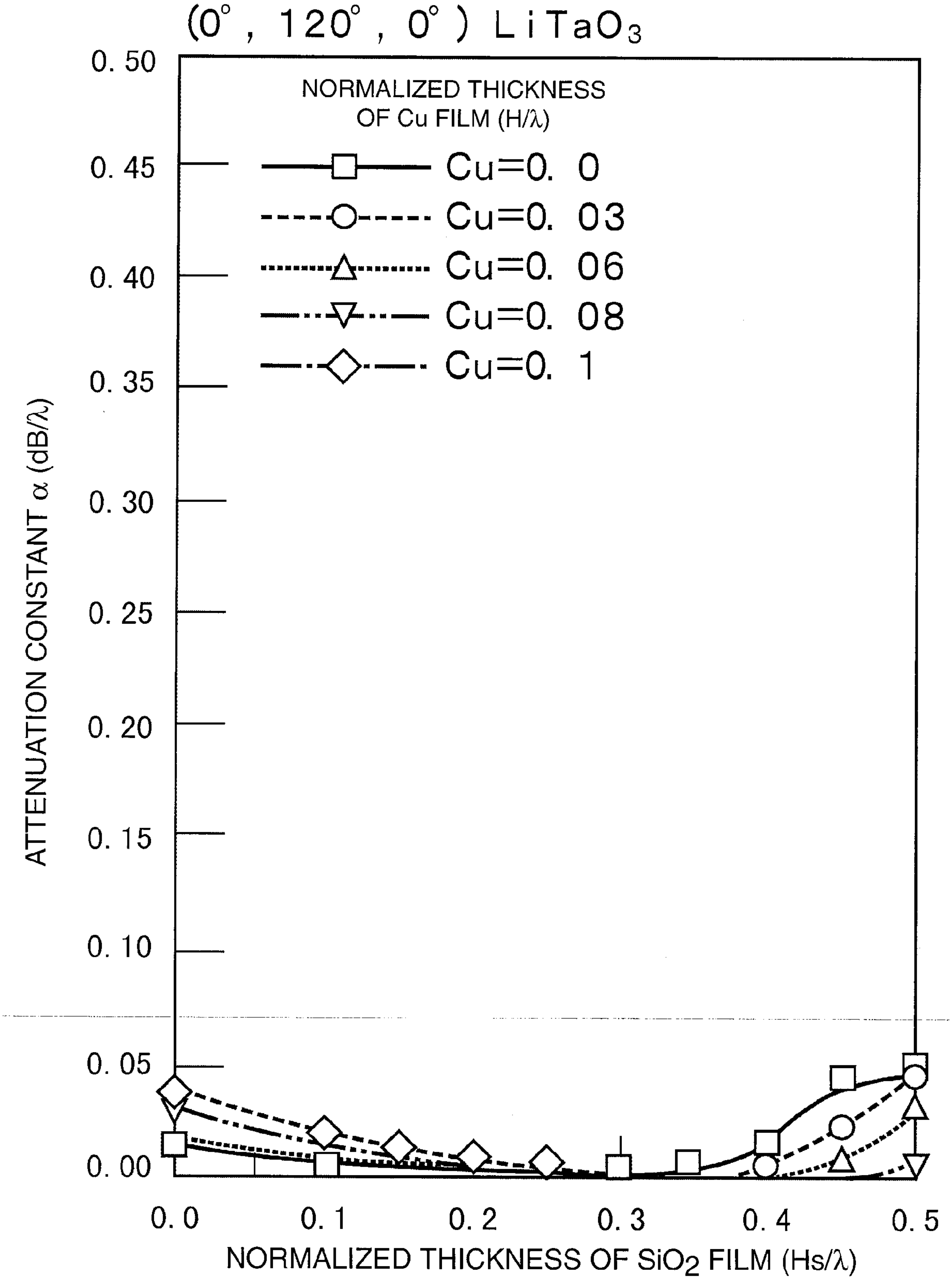
(0°, 120°, 0°) LiTaO3
NORMALIZED THICKNESS
OF Cu FILM (H/λ)
Cu=0. 0
Cu=0. 03
Cu=0. 06
Cu=0. 08
Cu=0. 1
0. 50
0. 45
0. 40
0. 35
0. 30
0. 25
0. 20
0. 15
0. 10
0. 05
0. 00
ATTENUATION CONSTANT α (dB/λ)
0. 0
0. 1
0. 2
0. 3
0. 4
0. 5
NORMALIZED THICKNESS OF SiO2 FILM (Hs/λ)

FIG. 49

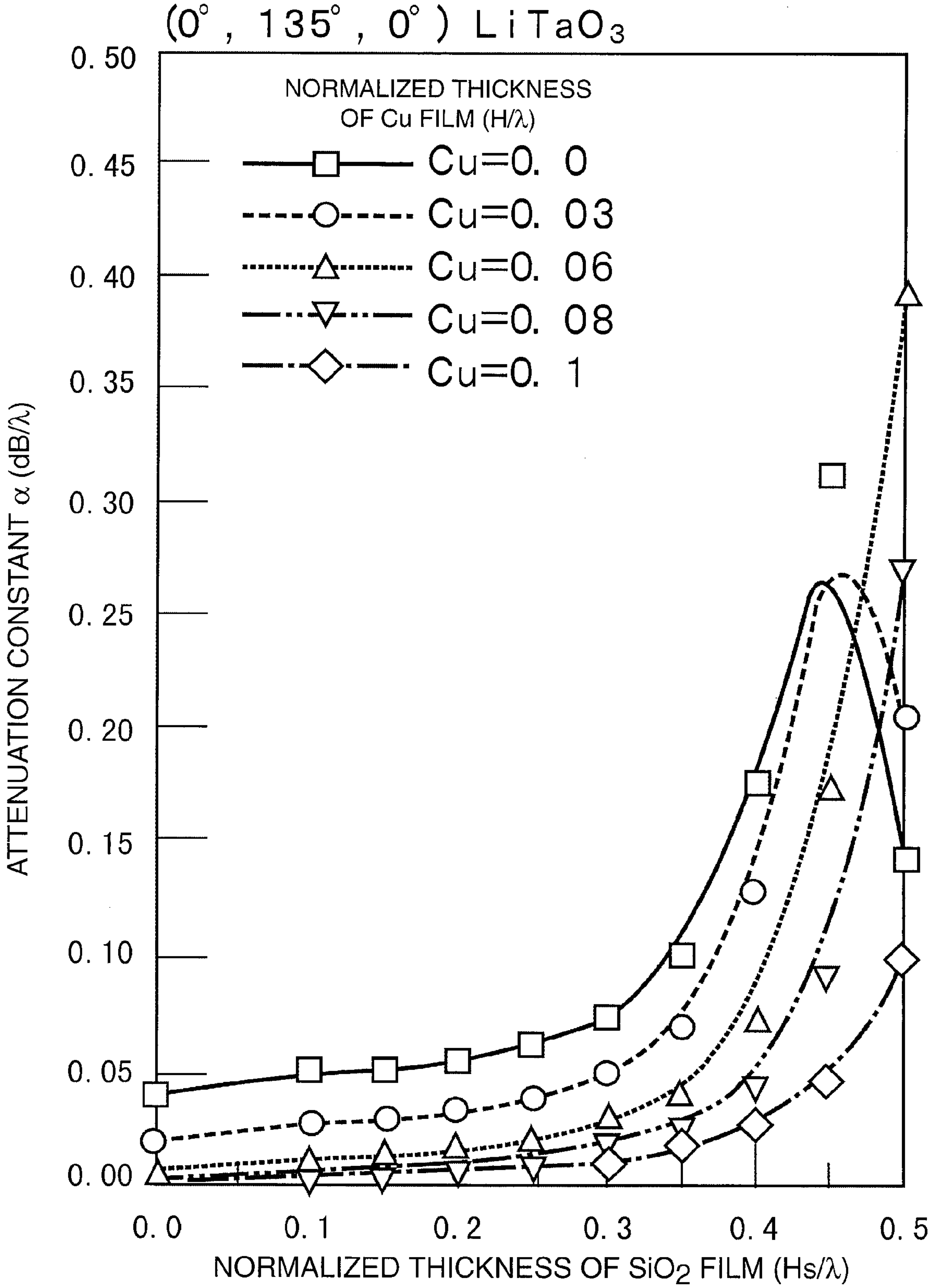
(0°, 135°, 0°) LiTaO3
NORMALIZED THICKNESS
OF Cu FILM (H/λ)
Cu=0. 0
Cu=0. 03
Cu=0. 06
Cu=0. 08
Cu=0. 1
ATTENUATION CONSTANT α (dB/λ)
0. 50
0. 45
0. 40
0. 35
0. 30
0. 25
0. 20
0. 15
0. 10
0. 05
0. 00
0. 0
0. 1
0. 2
0. 3
0. 4
0. 5
NORMALIZED THICKNESS OF SiO2 FILM (Hs/λ)

FIG. 50

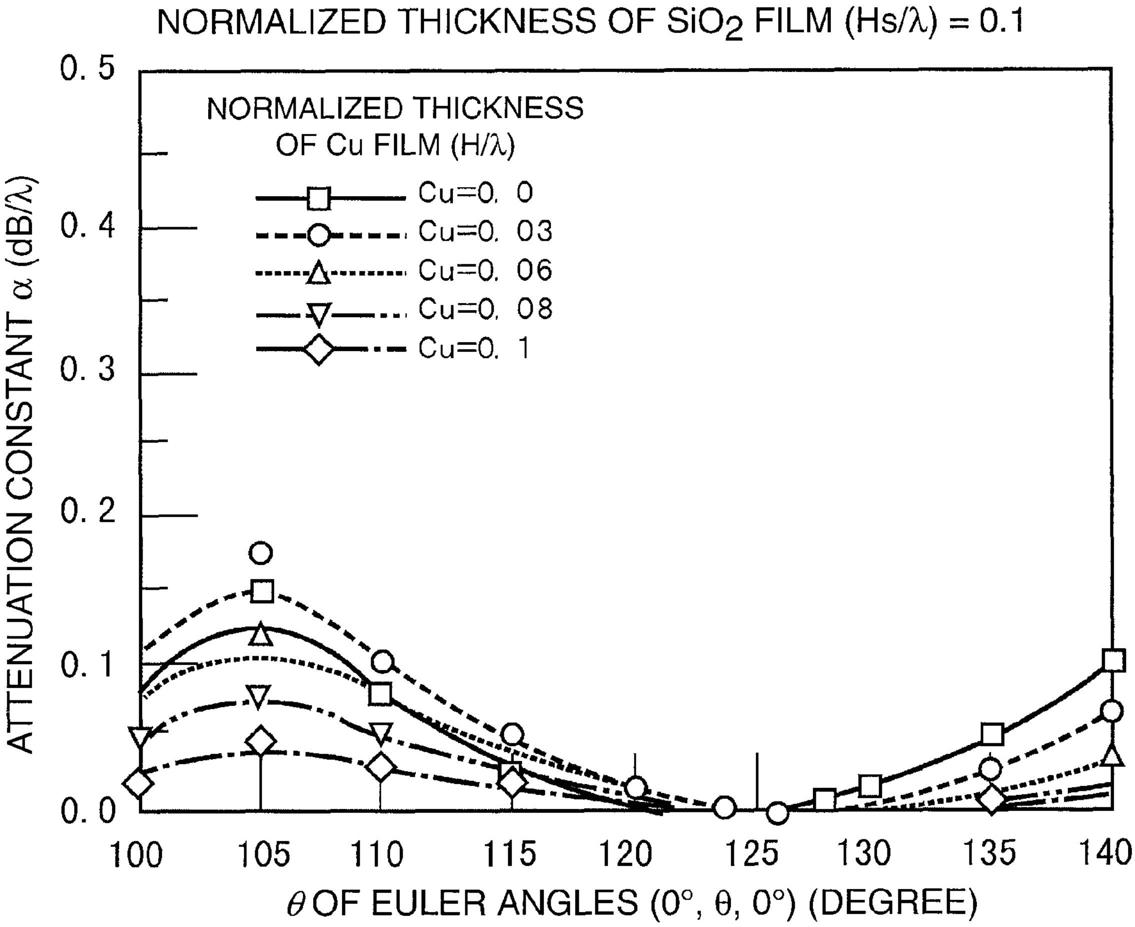
NORMALIZED THICKNESS OF SiO2 FILM (Hs/λ) = 0.1
NORMALIZED THICKNESS
OF Cu FILM (H/λ)
Cu=0. 0
Cu=0. 03
Cu=0. 06
Cu=0. 08
Cu=0. 1
ATTENUATION CONSTANT α (dB/λ)
0. 5
0. 4
0. 3
0. 2
0. 1
0. 0
100
105
110
115
120
125
130
135
140
θ OF EULER ANGLES (0°, θ, 0°) (DEGREE)

FIG. 51

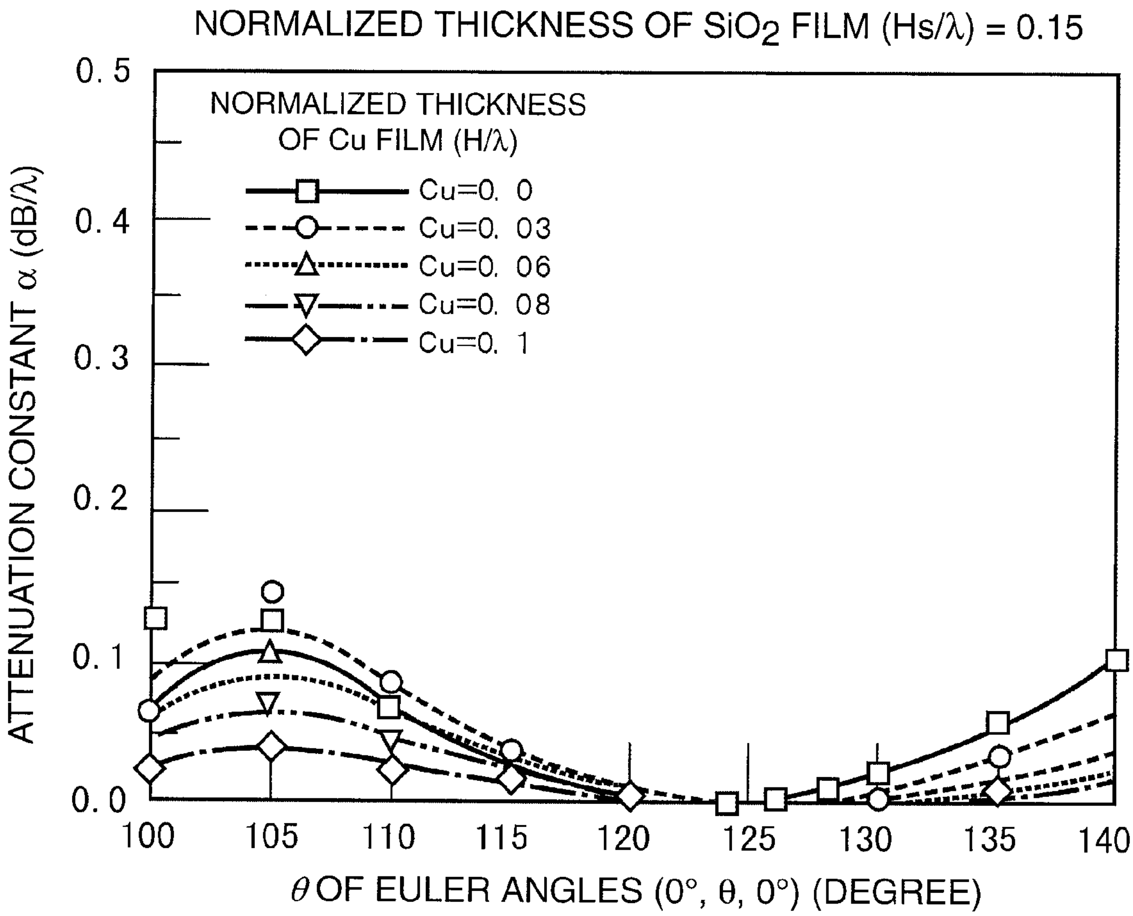
NORMALIZED THICKNESS OF SiO2 FILM (Hs/λ) = 0.15
NORMALIZED THICKNESS
OF Cu FILM (H/λ)
Cu=0. 0
Cu=0. 03
Cu=0. 06
Cu=0. 08
Cu=0. 1
ATTENUATION CONSTANT α (dB/λ)
0. 5
0. 4
0. 3
0. 2
0. 1
0. 0
100
105
110
115
120
125
130
135
140
θ OF EULER ANGLES (0°, θ, 0°) (DEGREE)

FIG. 52

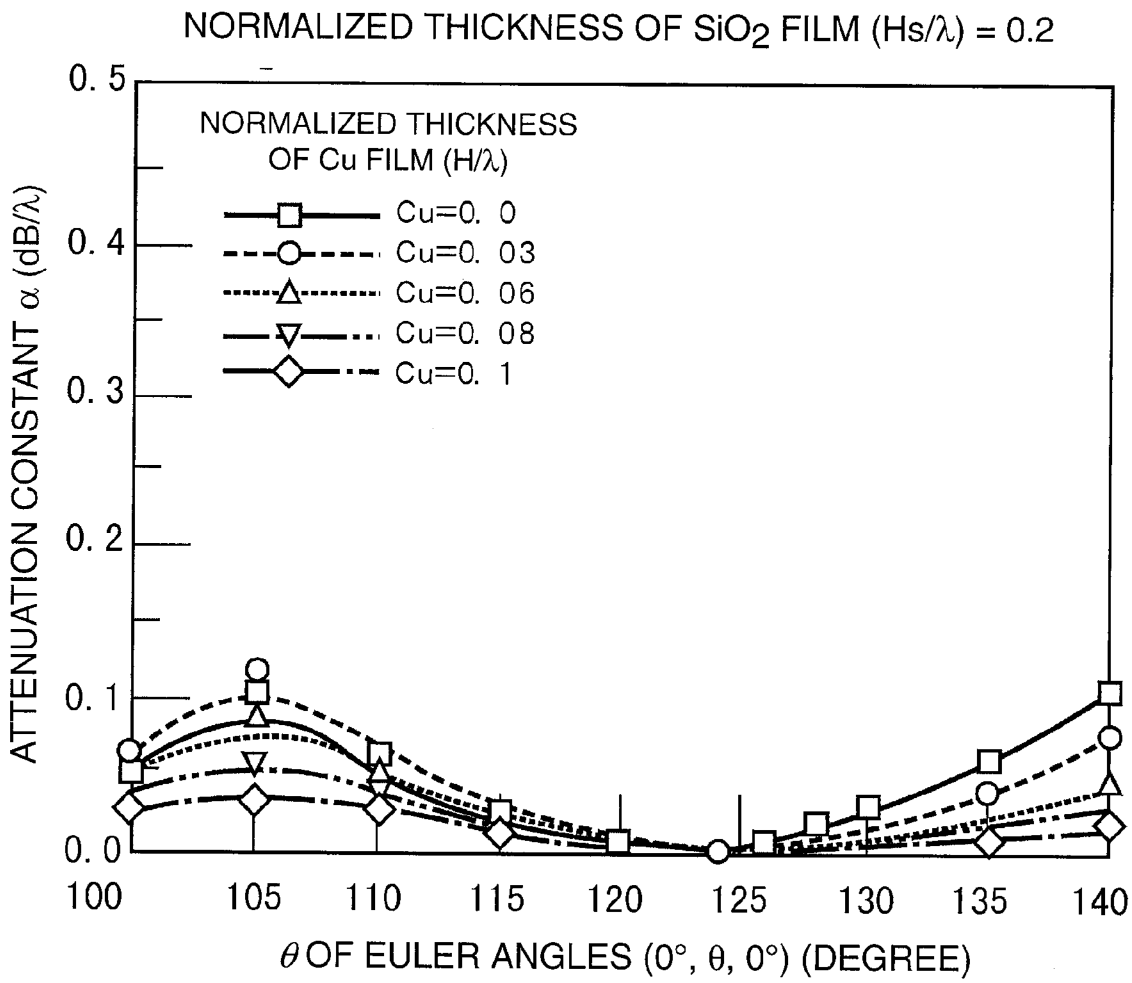
NORMALIZED THICKNESS OF SiO2 FILM (Hs/λ) = 0.2
NORMALIZED THICKNESS
OF Cu FILM (H/λ)
Cu=0. 0
Cu=0. 03
Cu=0. 06
Cu=0. 08
Cu=0. 1
ATTENUATION CONSTANT α (dB/λ)
0. 5
0. 4
0. 3
0. 2
0. 1
0. 0
100
105
110
115
120
125
130
135
140
θ OF EULER ANGLES (0°, θ, 0°) (DEGREE)

FIG. 53

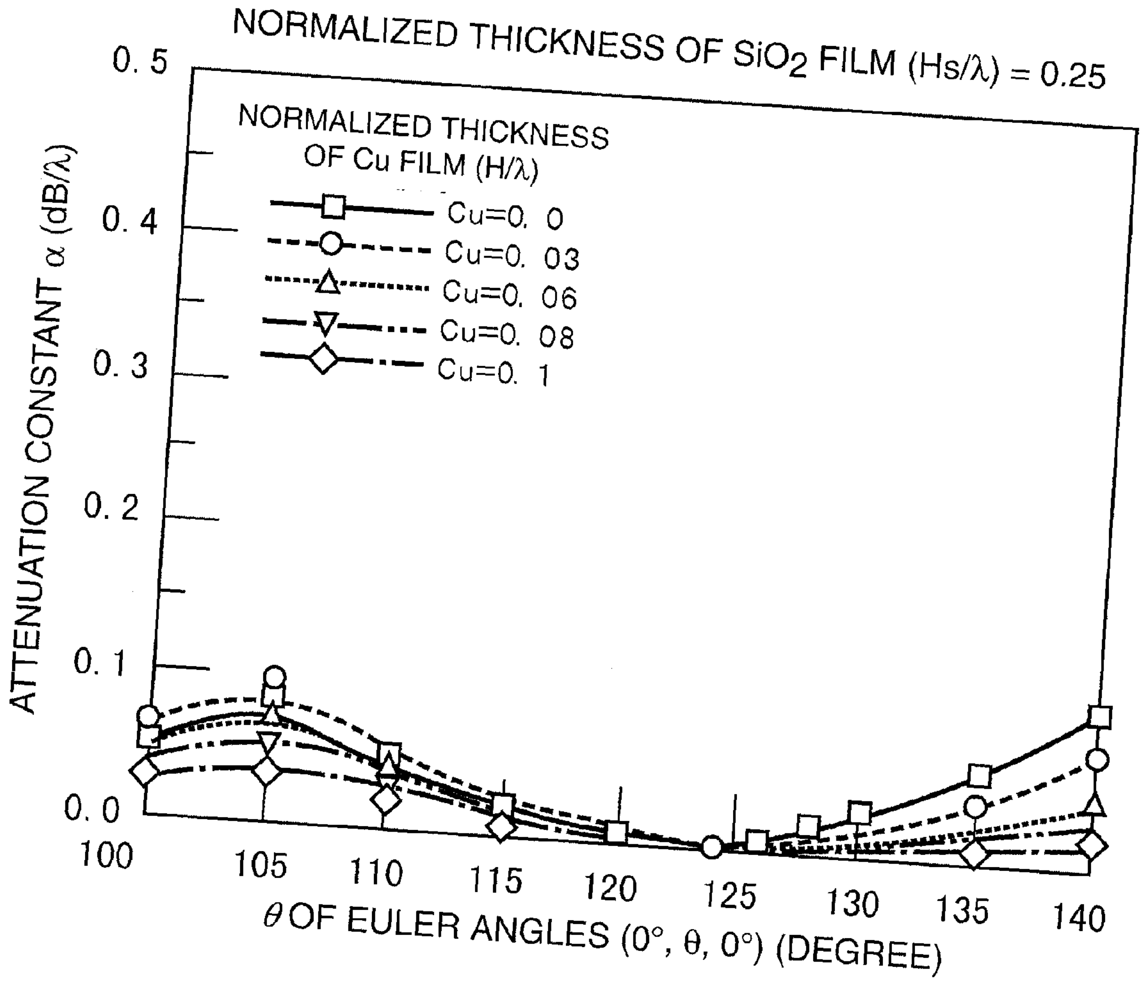

NORMALIZED THICKNESS OF SiO2 FILM (Hs/λ) = 0.25
NORMALIZED THICKNESS OF Cu FILM (H/λ)
Cu=0. 0
Cu=0. 03
Cu=0. 06
Cu=0. 08
Cu=0. 1
ATTENUATION CONSTANT α (dB/λ)
0. 5
0. 4
0. 3
0. 2
0. 1
0. 0
100
105
110
115
120
125
130
135
140
θ OF EULER ANGLES (0°, θ, 0°) (DEGREE)

FIG. 54

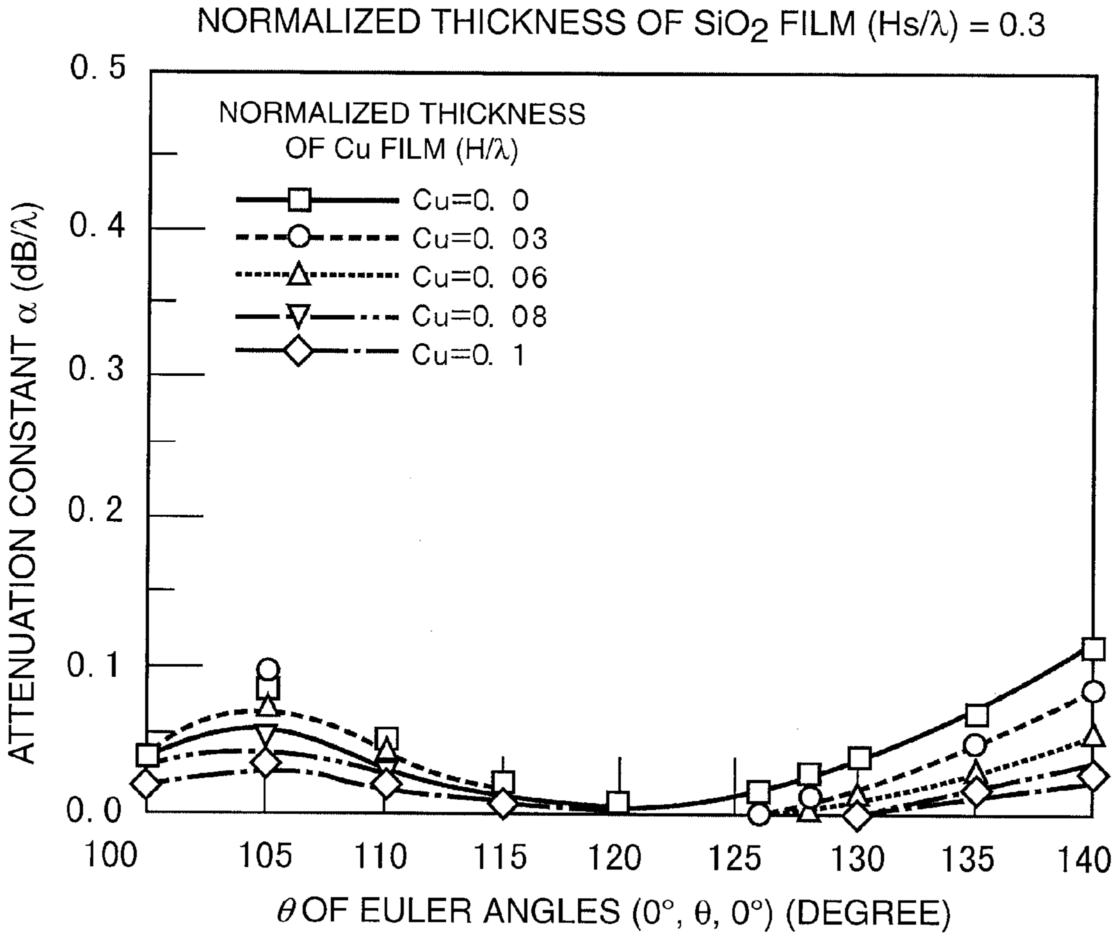
NORMALIZED THICKNESS OF SiO2 FILM (Hs/λ) = 0.3
NORMALIZED THICKNESS
OF Cu FILM (H/λ)
Cu=0. 0
Cu=0. 03
Cu=0. 06
Cu=0. 08
Cu=0. 1
ATTENUATION CONSTANT α (dB/λ)
0. 5
0. 4
0. 3
0. 2
0. 1
0. 0
100
105
110
115
120
125
130
135
140
θ OF EULER ANGLES (0°, θ, 0°) (DEGREE)

FIG. 55

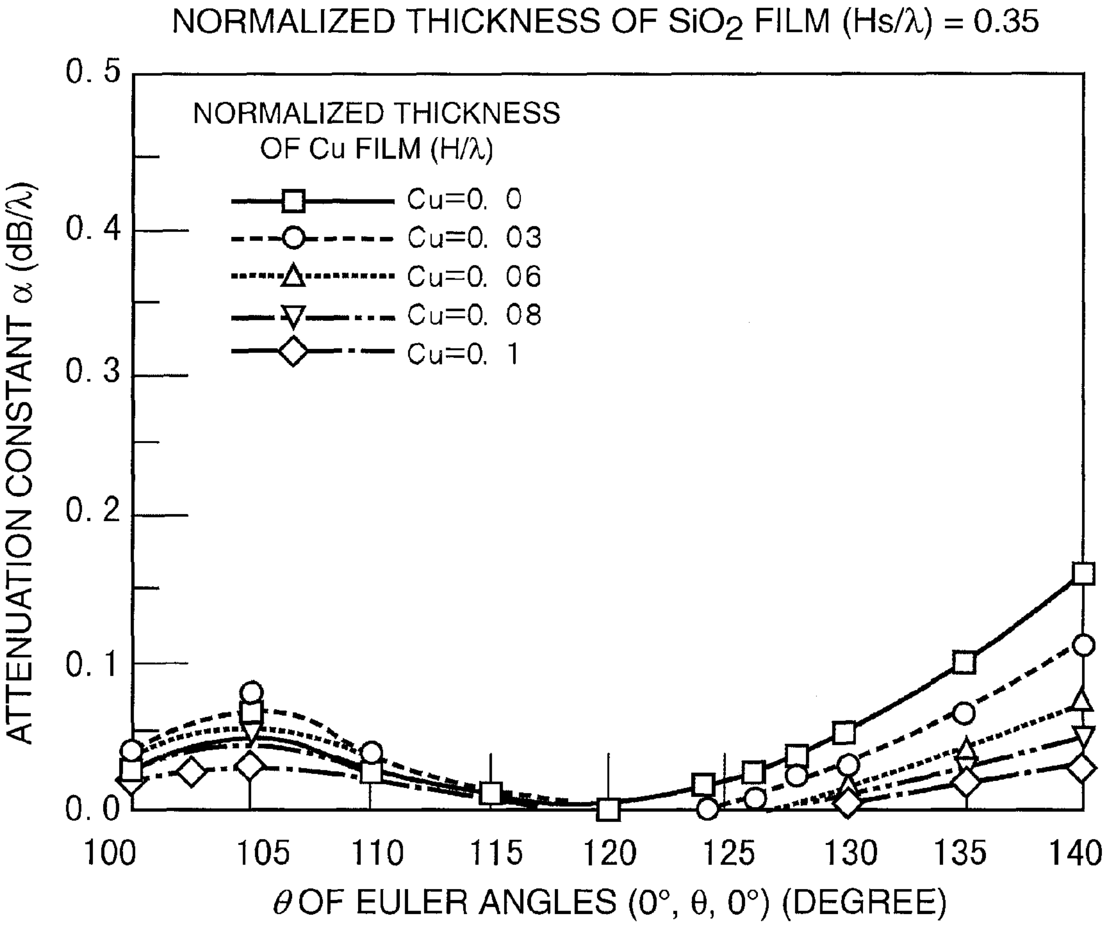
NORMALIZED THICKNESS OF SiO2 FILM (Hs/λ) = 0.35
NORMALIZED THICKNESS
OF Cu FILM (H/λ)
Cu=0. 0
Cu=0. 03
Cu=0. 06
Cu=0. 08
Cu=0. 1
ATTENUATION CONSTANT α (dB/λ)
0. 5
0. 4
0. 3
0. 2
0. 1
0. 0
100
105
110
115
120
125
130
135
140
θ OF EULER ANGLES (0°, θ, 0°) (DEGREE)

FIG. 56

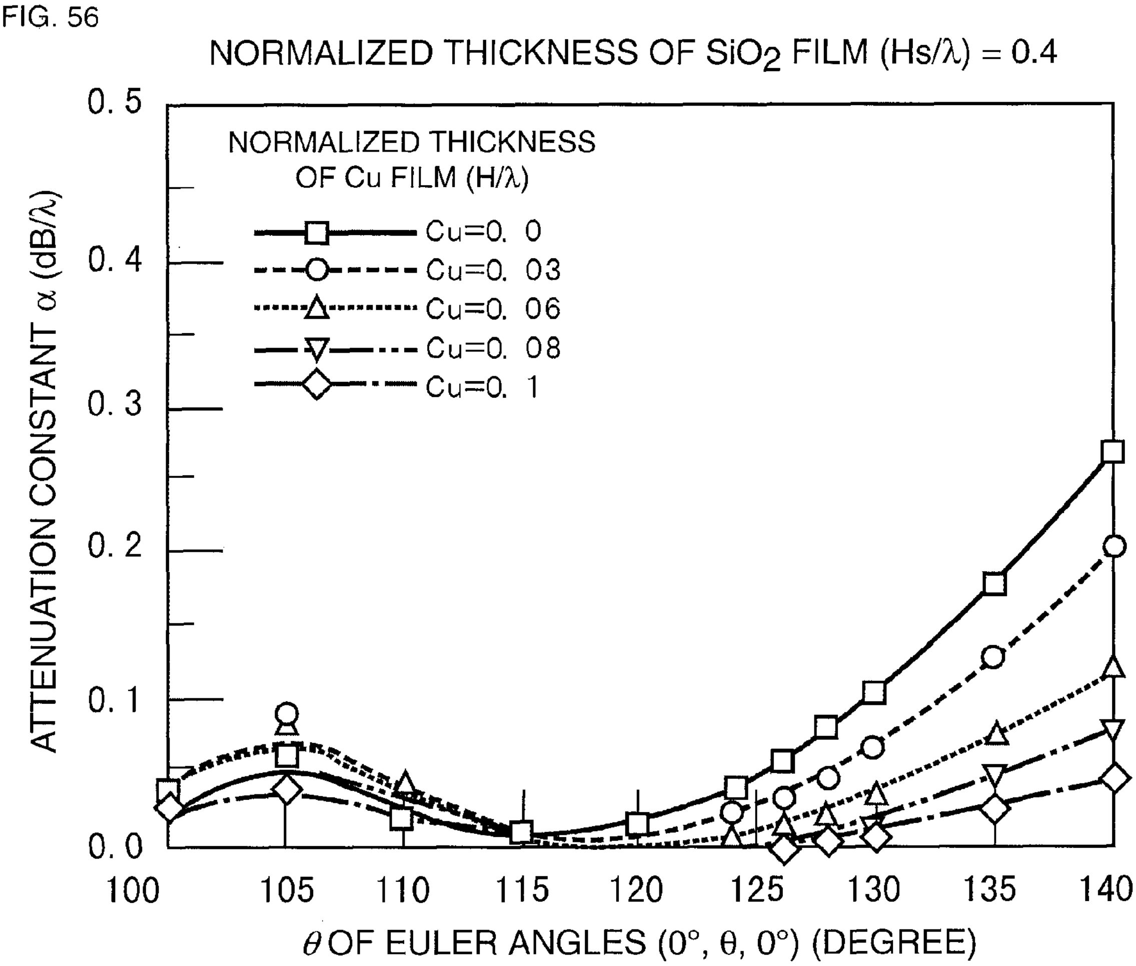
NORMALIZED THICKNESS OF SiO2 FILM (Hs/λ) = 0.4
NORMALIZED THICKNESS
OF Cu FILM (H/λ)
Cu=0. 0
Cu=0. 03
Cu=0. 06
Cu=0. 08
Cu=0. 1
ATTENUATION CONSTANT α (dB/λ)
0. 5
0. 4
0. 3
0. 2
0. 1
0. 0
100
105
110
115
120
125
130
135
140
θ OF EULER ANGLES (0°, θ, 0°) (DEGREE)

FIG. 57

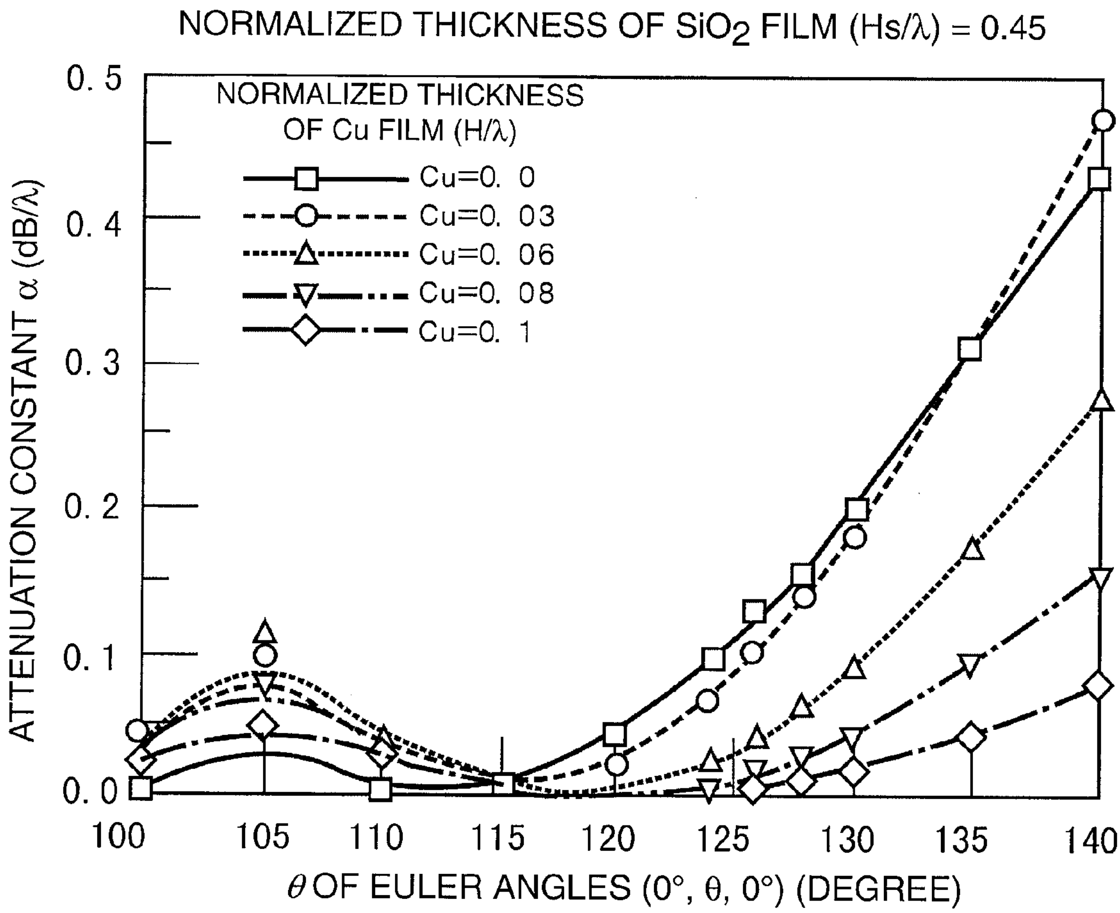
NORMALIZED THICKNESS OF $SiO_2$ FILM (Hs/λ) = 0.45
NORMALIZED THICKNESS
OF Cu FILM (H/λ)
Cu=0. 0
Cu=0. 03
Cu=0. 06
Cu=0. 08
Cu=0. 1
ATTENUATION CONSTANT α (dB/λ)
0. 5
0. 4
0. 3
0. 2
0. 1
0. 0
100
105
110
115
120
125
130
135
140
θ OF EULER ANGLES (0°, θ, 0°) (DEGREE)

FIG. 58

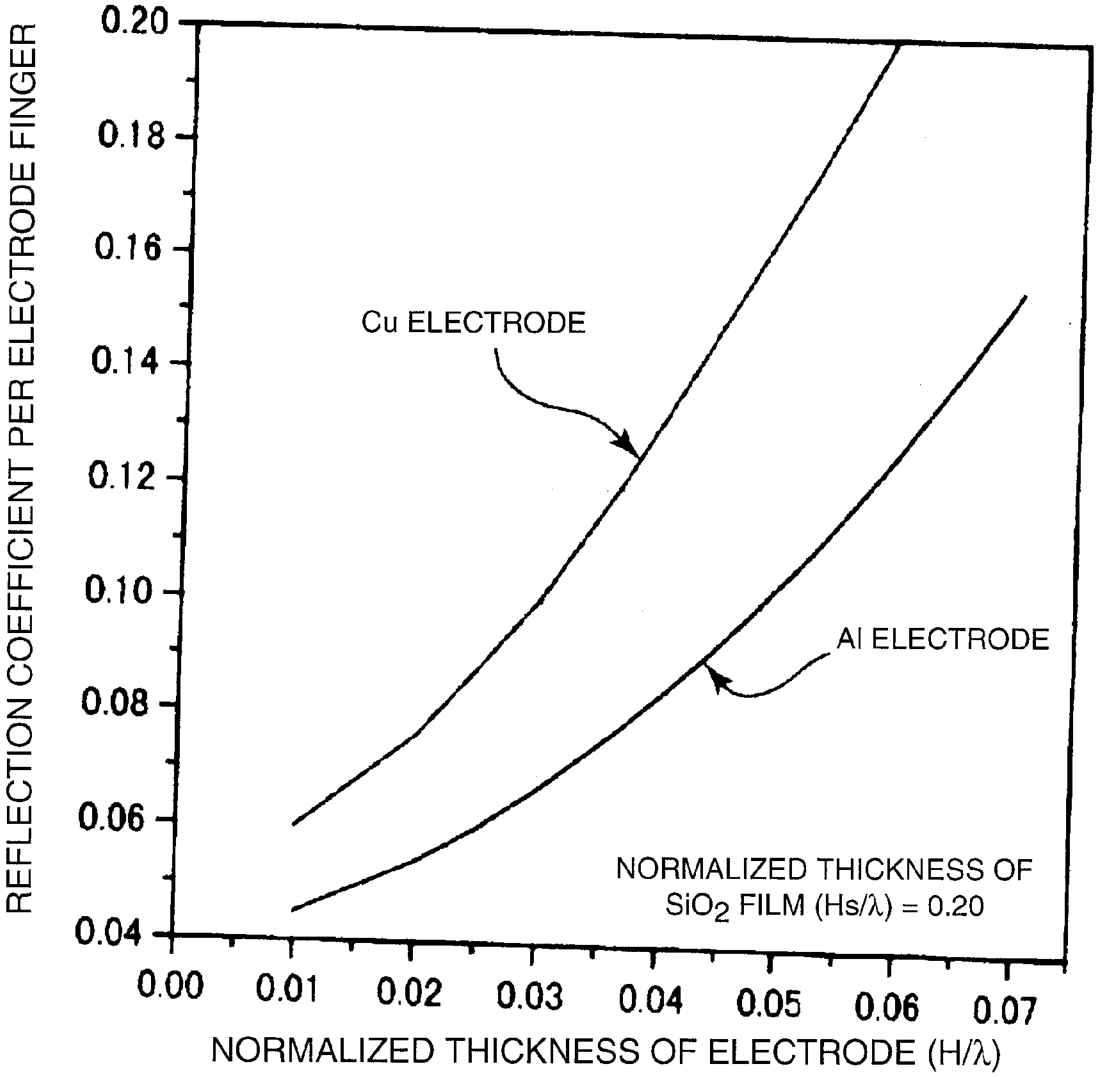
REFLECTION COEFFICIENT PER ELECTRODE FINGER
0.20
0.18
0.16
0.14
0.12
0.10
0.08
0.06
0.04
Cu ELECTRODE
Al ELECTRODE
NORMALIZED THICKNESS OF
SiO2 FILM (Hs/λ) = 0.20
0.00
0.01
0.02
0.03
0.04
0.05
0.06
0.07
NORMALIZED THICKNESS OF ELECTRODE (H/λ)

FIG. 59

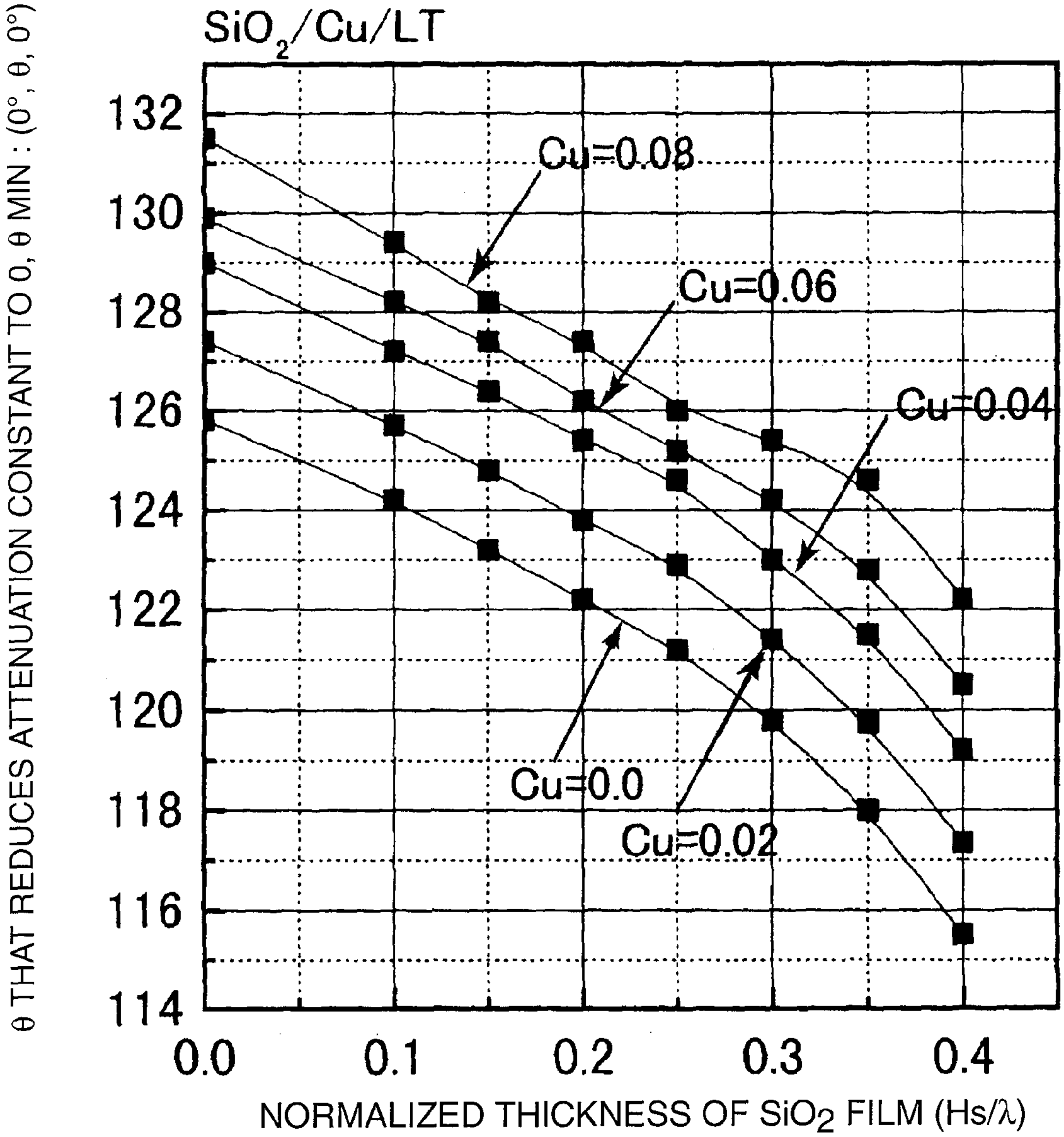
SiO2/Cu/LT
θ THAT REDUCES ATTENUATION CONSTANT TO 0, θ MIN : (0°, θ, 0°)
132
130
128
126
124
122
120
118
116
114
0.0
0.1
0.2
0.3
0.4
NORMALIZED THICKNESS OF SiO2 FILM (Hs/λ)
Cu=0.08
Cu=0.06
Cu=0.04
Cu=0.0
Cu=0.02

FIG. 60

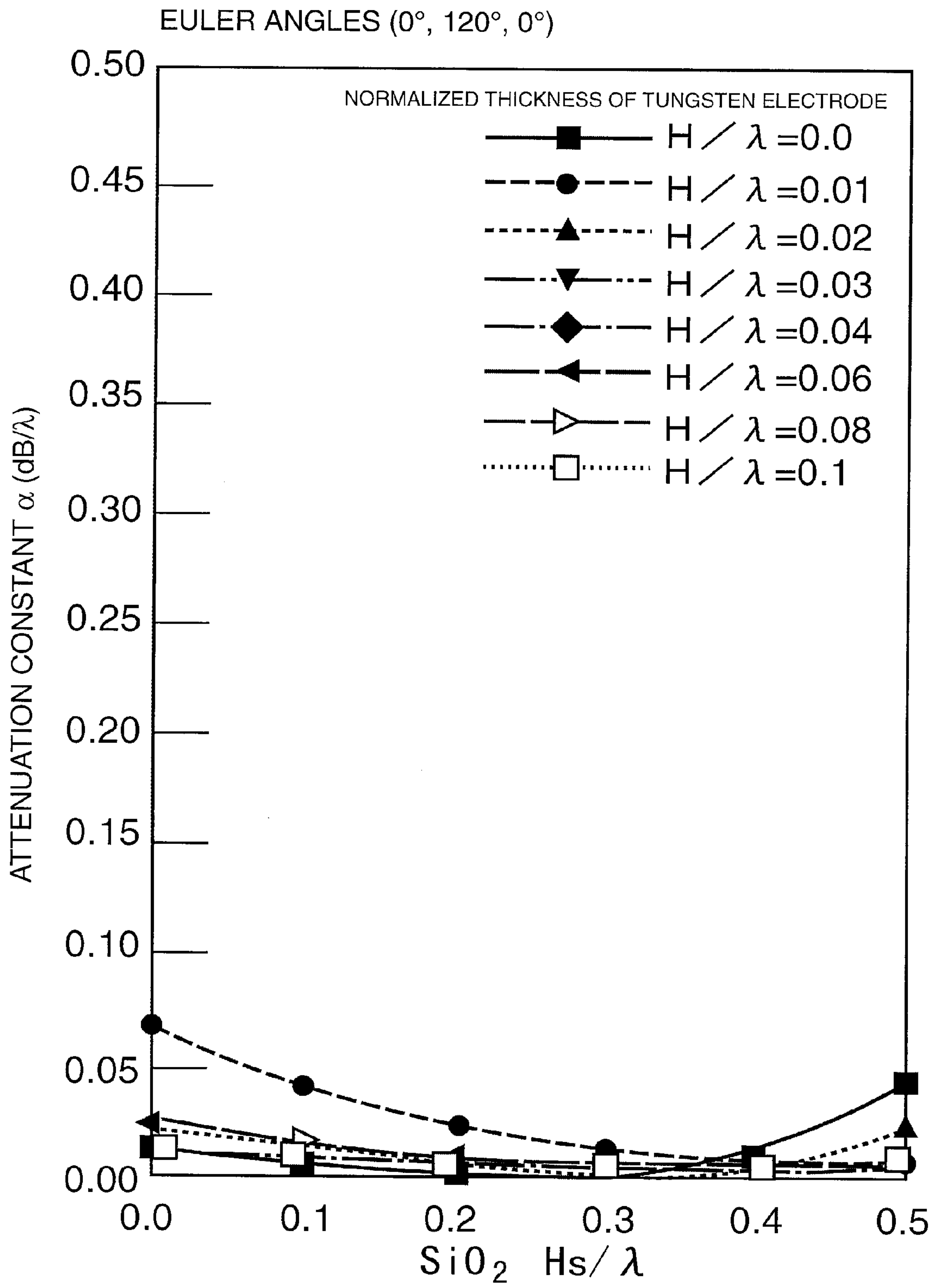
EULER ANGLES (0°, 120°, 0°)
NORMALIZED THICKNESS OF TUNGSTEN ELECTRODE
H／λ =0.0
H／λ =0.01
H／λ =0.02
H／λ =0.03
H／λ =0.04
H／λ =0.06
H／λ =0.08
H／λ =0.1
ATTENUATION CONSTANT α (dB/λ)
0.50
0.45
0.40
0.35
0.30
0.25
0.20
0.15
0.10
0.05
0.00
0.0
0.1
0.2
0.3
0.4
0.5
SiO2 Hs/λ

FIG. 61

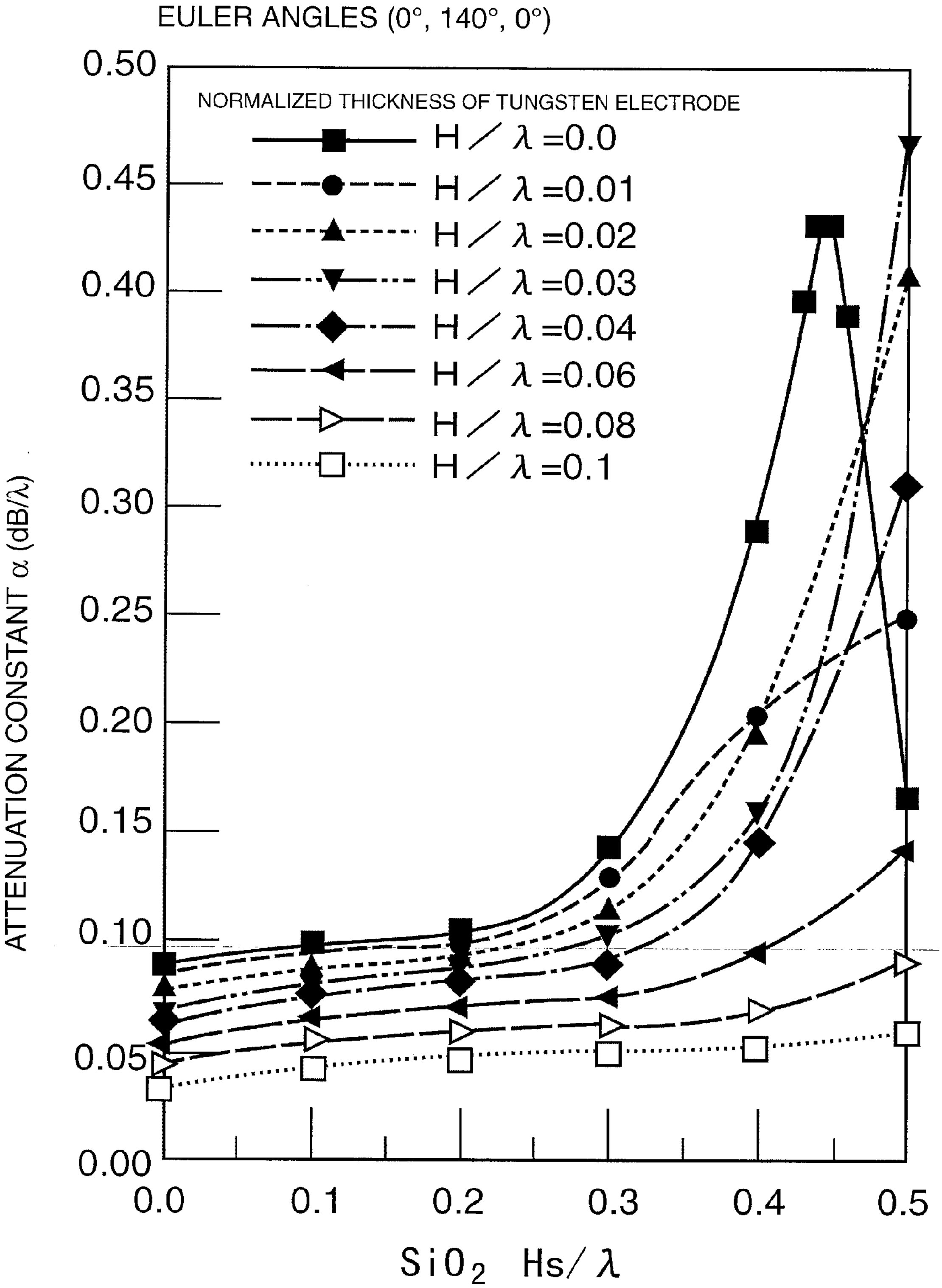
EULER ANGLES (0°, 140°, 0°)
NORMALIZED THICKNESS OF TUNGSTEN ELECTRODE
H／λ =0.0
H／λ =0.01
H／λ =0.02
H／λ =0.03
H／λ =0.04
H／λ =0.06
H／λ =0.08
H／λ =0.1
ATTENUATION CONSTANT α (dB/λ)
0.50
0.45
0.40
0.35
0.30
0.25
0.20
0.15
0.10
0.05
0.00
0.0
0.1
0.2
0.3
0.4
0.5
SiO2 Hs/λ

FIG. 62

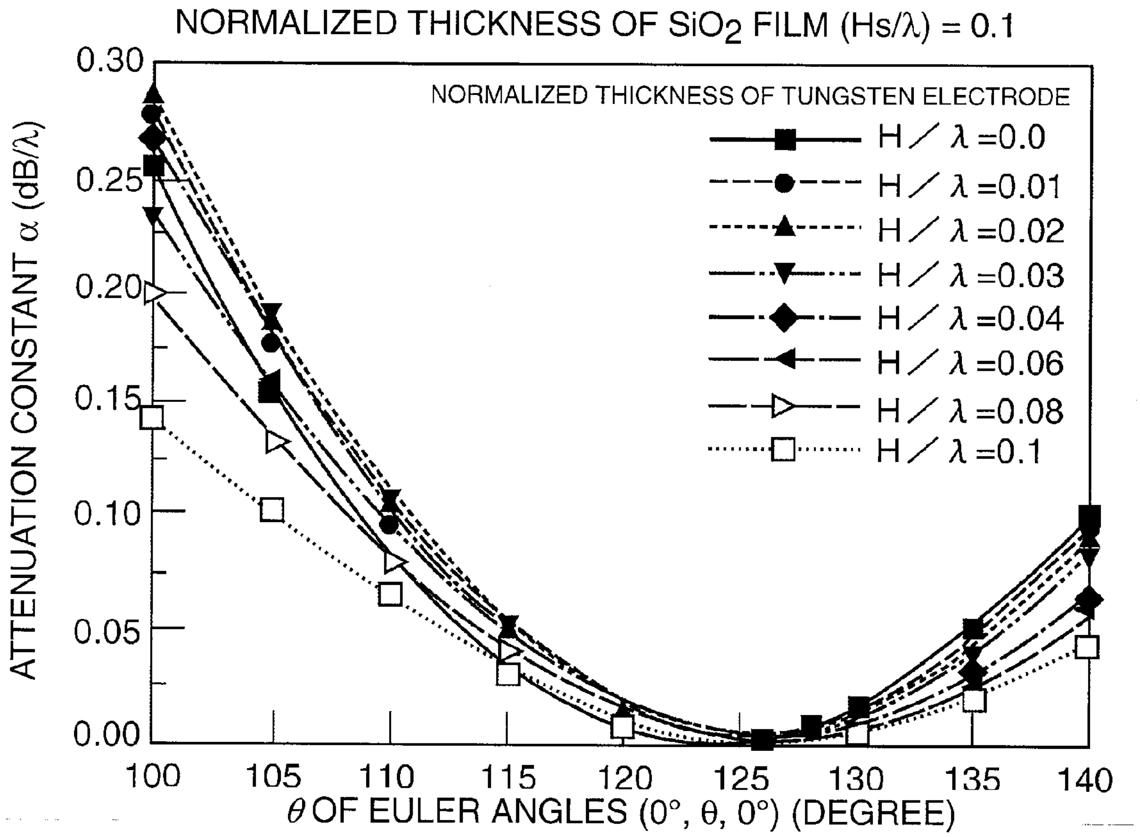
NORMALIZED THICKNESS OF SiO2 FILM (Hs/λ) = 0.1
NORMALIZED THICKNESS OF TUNGSTEN ELECTRODE
H／λ =0.0
H／λ =0.01
H／λ =0.02
H／λ =0.03
H／λ =0.04
H／λ =0.06
H／λ =0.08
H／λ =0.1
ATTENUATION CONSTANT α (dB/λ)
0.30
0.25
0.20
0.15
0.10
0.05
0.00
100
105
110
115
120
125
130
135
140
θ OF EULER ANGLES (0°, θ, 0°) (DEGREE)

FIG. 63

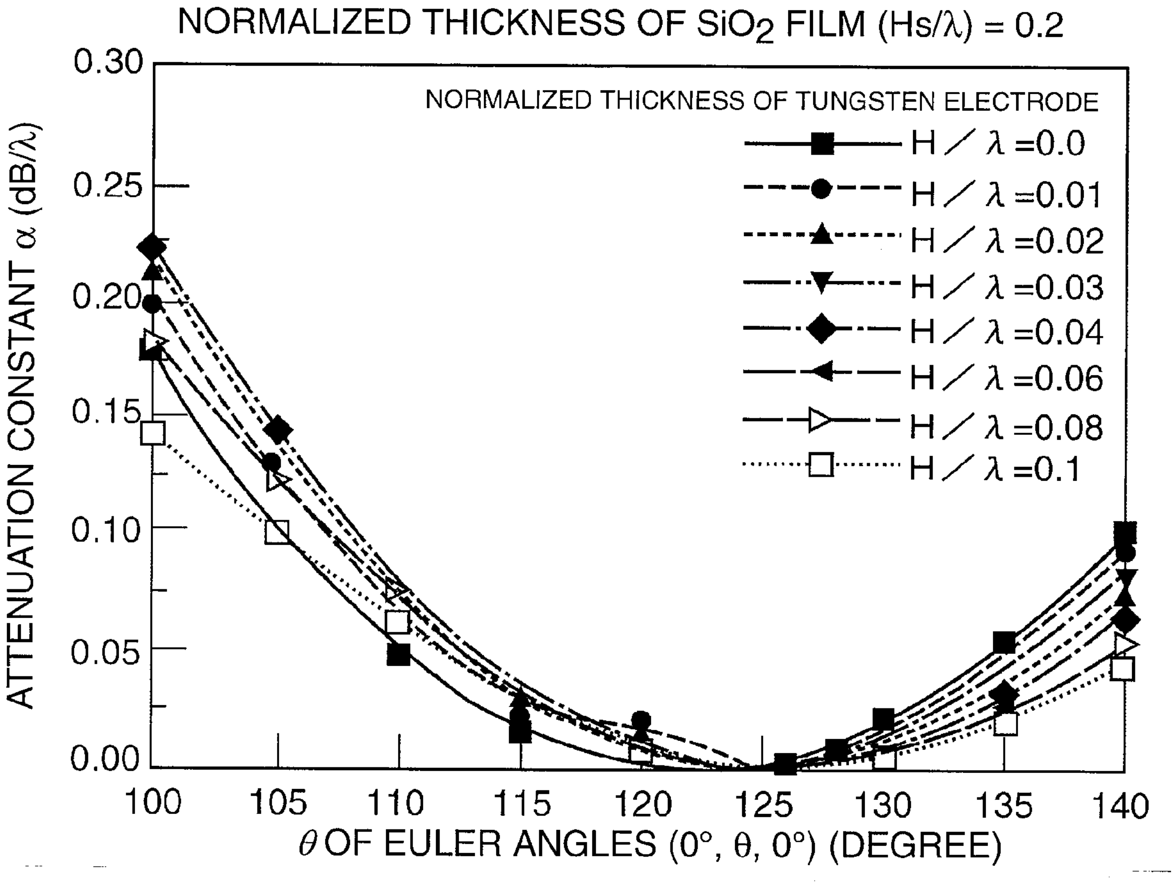
NORMALIZED THICKNESS OF SiO2 FILM (Hs/λ) = 0.2
NORMALIZED THICKNESS OF TUNGSTEN ELECTRODE
H／λ =0.0
H／λ =0.01
H／λ =0.02
H／λ =0.03
H／λ =0.04
H／λ =0.06
H／λ =0.08
H／λ =0.1
ATTENUATION CONSTANT α (dB/λ)
0.30
0.25
0.20
0.15
0.10
0.05
0.00
100
105
110
115
120
125
130
135
140
θ OF EULER ANGLES (0°, θ, 0°) (DEGREE)

FIG. 64

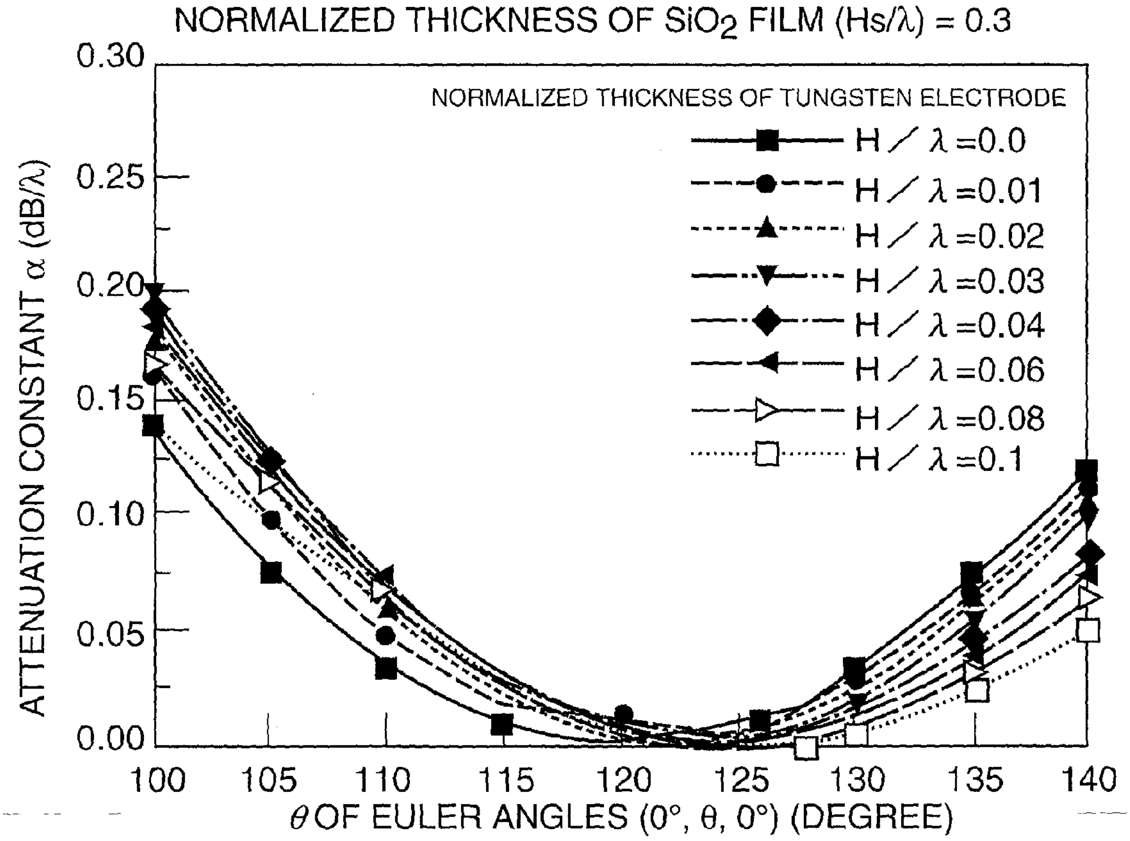
NORMALIZED THICKNESS OF SiO2 FILM (Hs/λ) = 0.3
NORMALIZED THICKNESS OF TUNGSTEN ELECTRODE
H／λ=0.0
H／λ=0.01
H／λ=0.02
H／λ=0.03
H／λ=0.04
H／λ=0.06
H／λ=0.08
H／λ=0.1
ATTENUATION CONSTANT α (dB/λ)
0.30
0.25
0.20
0.15
0.10
0.05
0.00
100
105
110
115
120
125
130
135
140
θ OF EULER ANGLES (0°, θ, 0°) (DEGREE)

FIG. 65

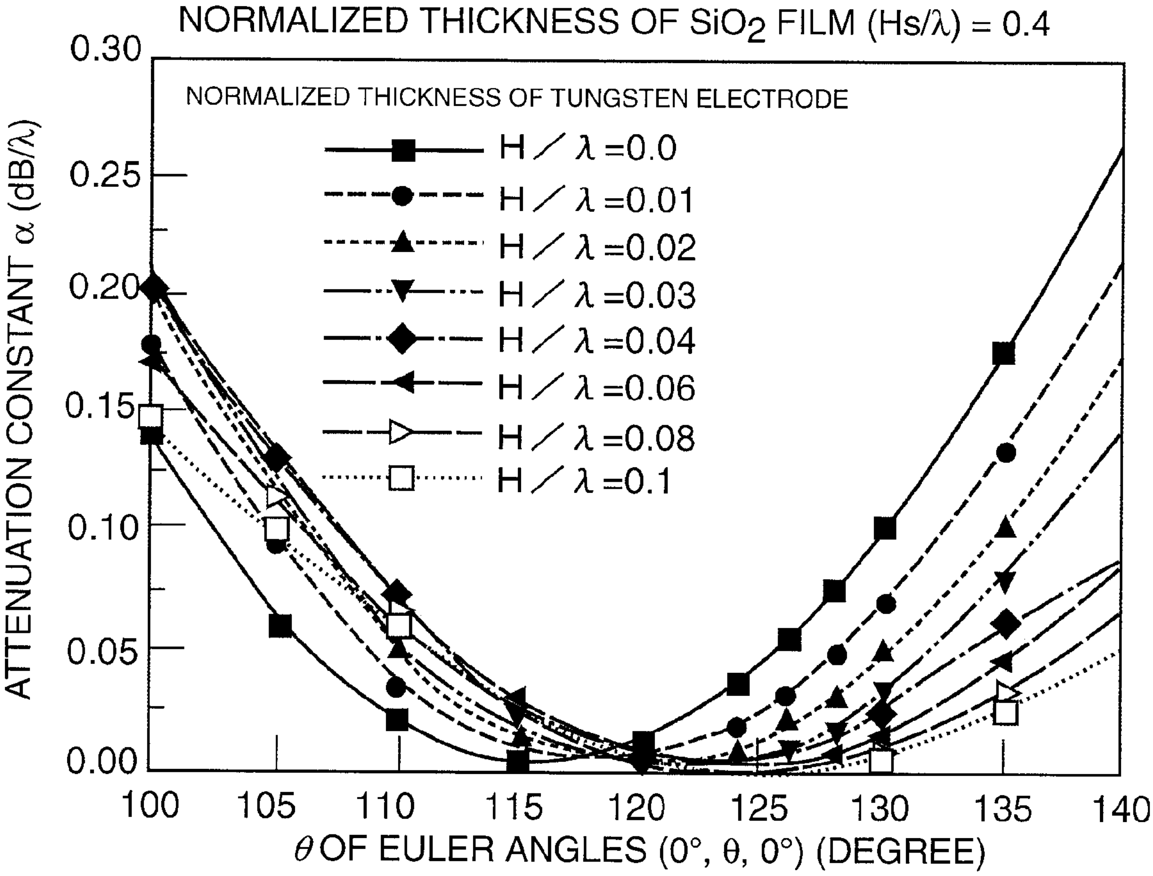
NORMALIZED THICKNESS OF SiO2 FILM (Hs/λ) = 0.4
NORMALIZED THICKNESS OF TUNGSTEN ELECTRODE
H／λ=0.0
H／λ=0.01
H／λ=0.02
H／λ=0.03
H／λ=0.04
H／λ=0.06
H／λ=0.08
H／λ=0.1
ATTENUATION CONSTANT α (dB/λ)
0.30
0.25
0.20
0.15
0.10
0.05
0.00
100
105
110
115
120
125
130
135
140
θ OF EULER ANGLES (0°, θ, 0°) (DEGREE)

FIG. 66

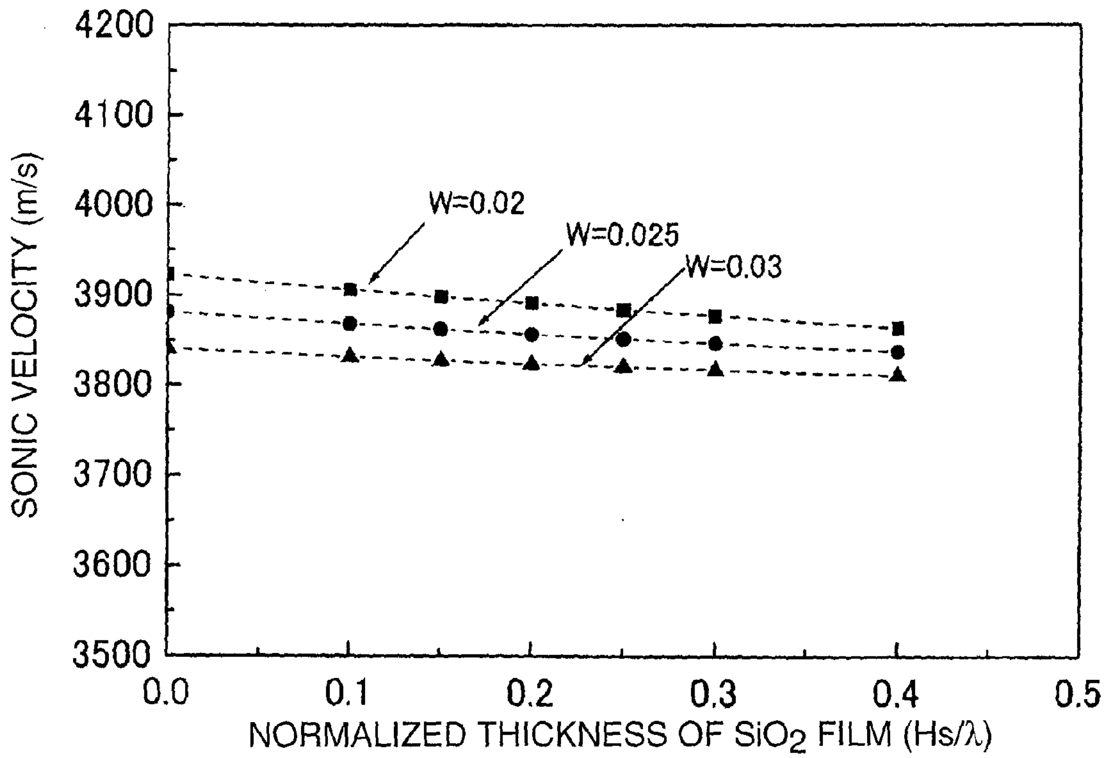
4200
4100
4000
3900
3800
3700
3600
3500
SONIC VELOCITY (m/s)
W=0.02
W=0.025
W=0.03
0.0
0.1
0.2
0.3
0.4
0.5
NORMALIZED THICKNESS OF SiO2 FILM (Hs/λ)

FIG. 67

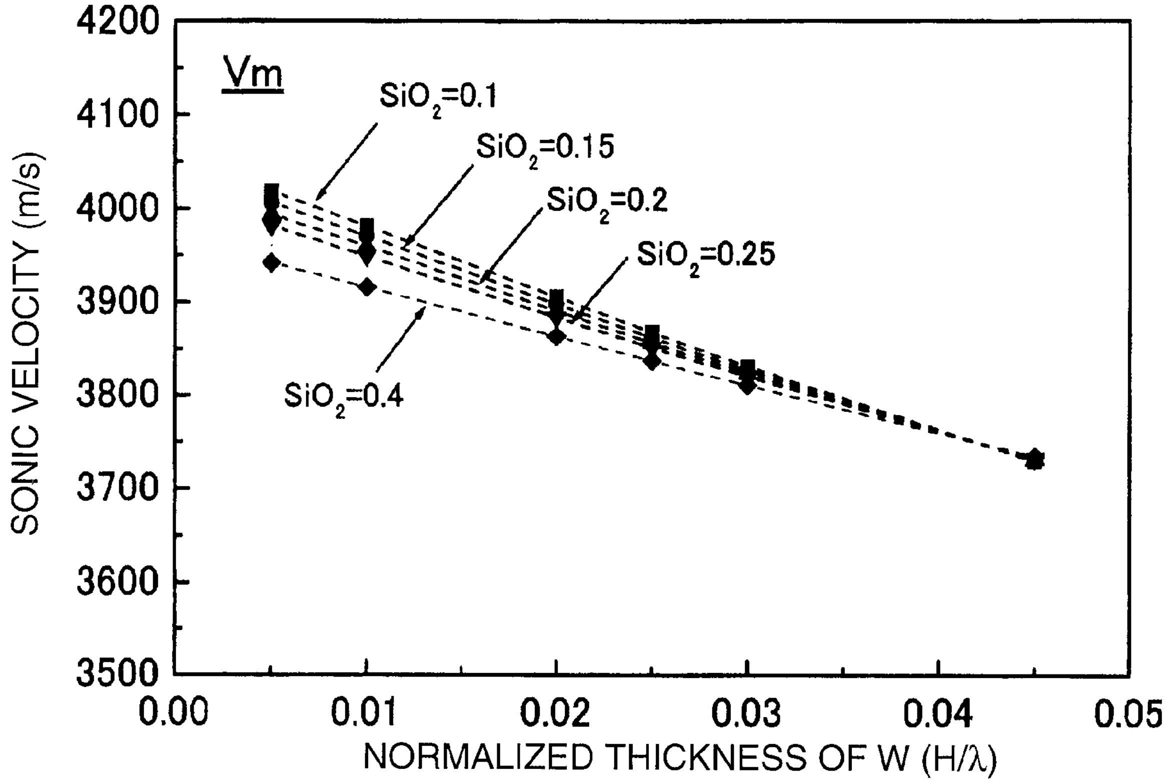
Vm
SiO2=0.1
SiO2=0.15
SiO2=0.2
SiO2=0.25
SiO2=0.4
4200
4100
4000
3900
3800
3700
3600
3500
SONIC VELOCITY (m/s)
0.00
0.01
0.02
0.03
0.04
0.05
NORMALIZED THICKNESS OF W (H/λ)

FIG. 68

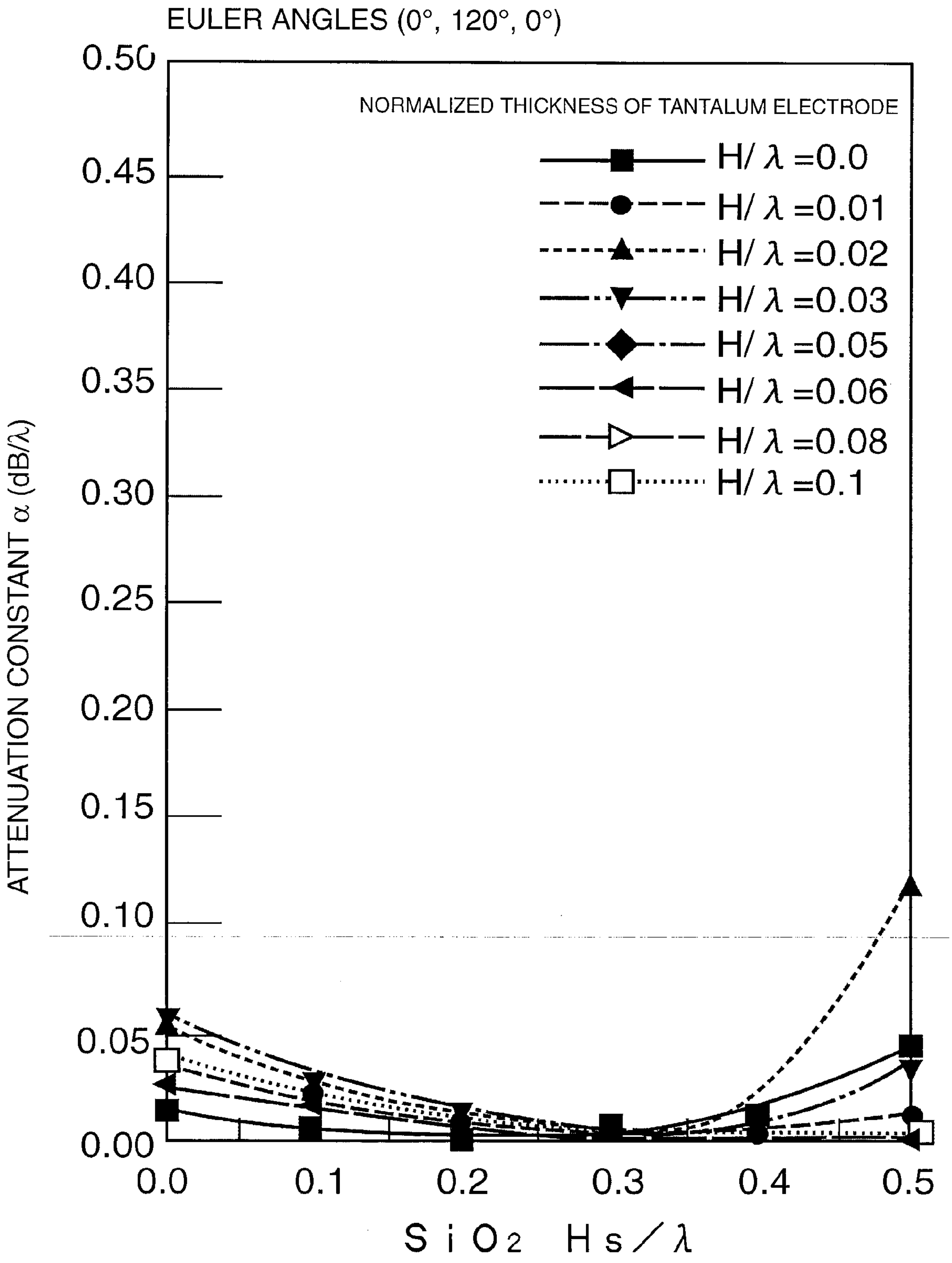
EULER ANGLES (0°, 120°, 0°)
NORMALIZED THICKNESS OF TANTALUM ELECTRODE
H/λ =0.0
H/λ =0.01
H/λ =0.02
H/λ =0.03
H/λ =0.05
H/λ =0.06
H/λ =0.08
H/λ =0.1
ATTENUATION CONSTANT α (dB/λ)
0.50
0.45
0.40
0.35
0.30
0.25
0.20
0.15
0.10
0.05
0.00
0.0
0.1
0.2
0.3
0.4
0.5
SiO2 Hs/λ

FIG. 69

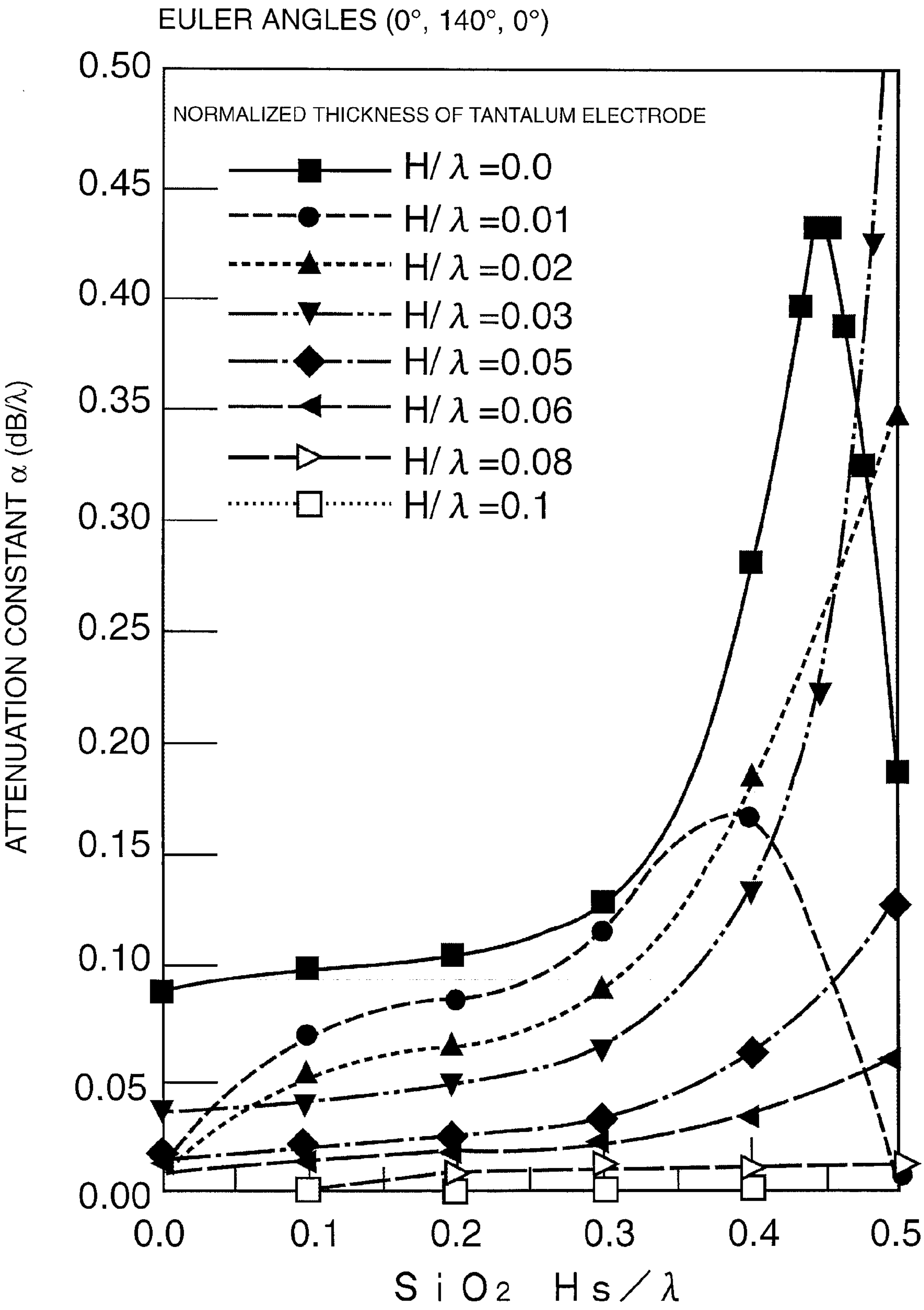
EULER ANGLES (0°, 140°, 0°)
NORMALIZED THICKNESS OF TANTALUM ELECTRODE
H/ λ =0.0
H/ λ =0.01
H/ λ =0.02
H/ λ =0.03
H/ λ =0.05
H/ λ =0.06
H/ λ =0.08
H/ λ =0.1
ATTENUATION CONSTANT α (dB/λ)
0.50
0.45
0.40
0.35
0.30
0.25
0.20
0.15
0.10
0.05
0.00
0.0
0.1
0.2
0.3
0.4
0.5
SiO2 Hs/λ

FIG. 70

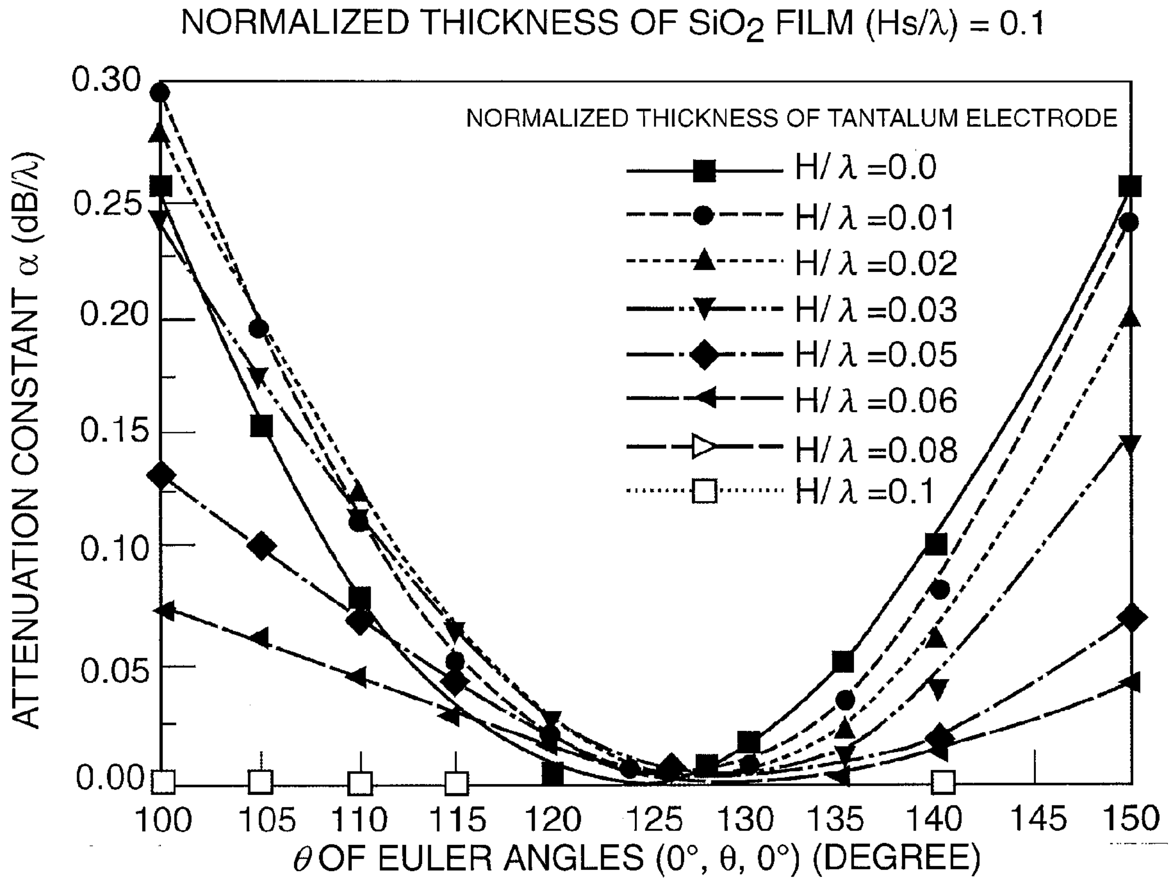
NORMALIZED THICKNESS OF SiO2 FILM (Hs/λ) = 0.1
NORMALIZED THICKNESS OF TANTALUM ELECTRODE
H/λ =0.0
H/λ =0.01
H/λ =0.02
H/λ =0.03
H/λ =0.05
H/λ =0.06
H/λ =0.08
H/λ =0.1
ATTENUATION CONSTANT α (dB/λ)
0.30
0.25
0.20
0.15
0.10
0.05
0.00
100
105
110
115
120
125
130
135
140
145
150
θ OF EULER ANGLES (0°, θ, 0°) (DEGREE)

FIG. 71

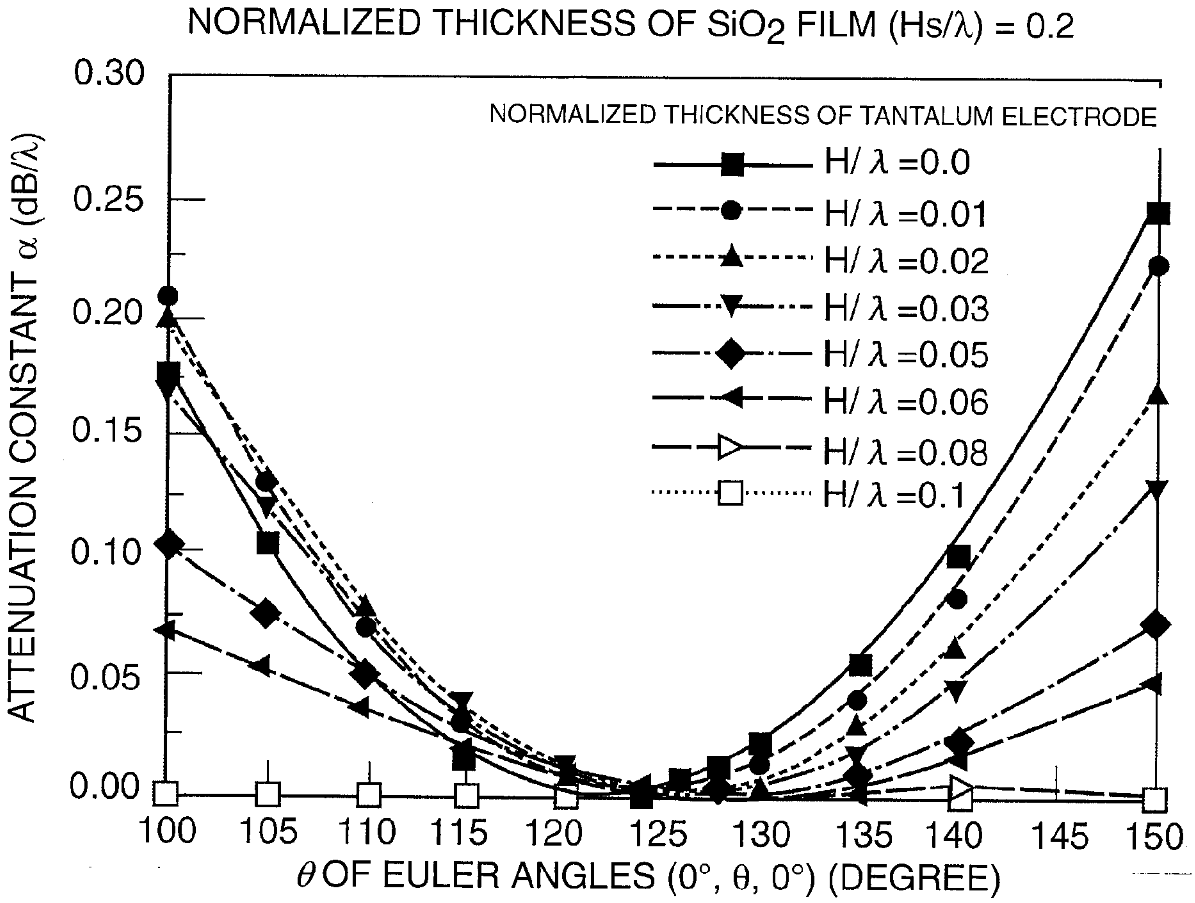
NORMALIZED THICKNESS OF SiO2 FILM (Hs/λ) = 0.2
NORMALIZED THICKNESS OF TANTALUM ELECTRODE
H/ λ =0.0
H/ λ =0.01
H/ λ =0.02
H/ λ =0.03
H/ λ =0.05
H/ λ =0.06
H/ λ =0.08
H/ λ =0.1
ATTENUATION CONSTANT α (dB/λ)
0.30
0.25
0.20
0.15
0.10
0.05
0.00
100 105 110 115 120 125 130 135 140 145 150
θ OF EULER ANGLES (0°, θ, 0°) (DEGREE)

FIG. 72

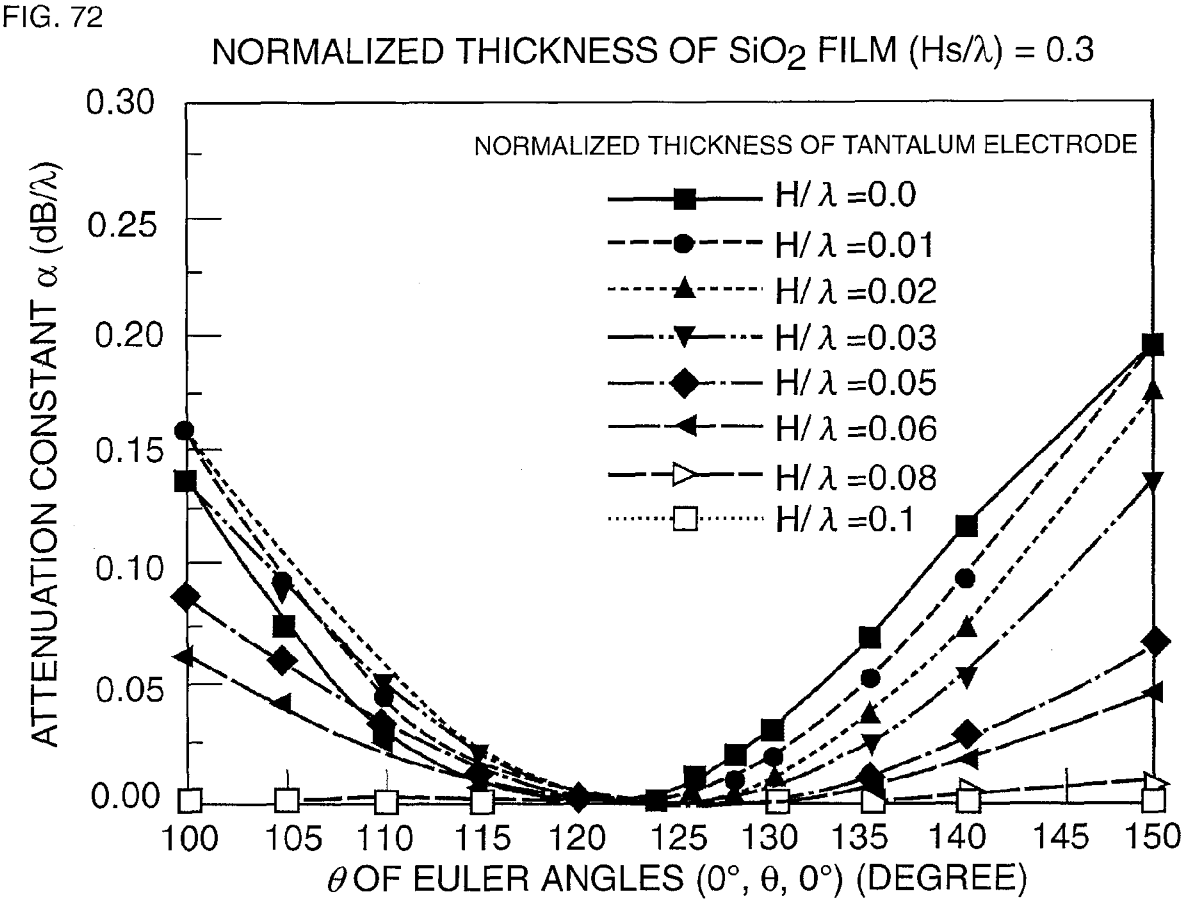
NORMALIZED THICKNESS OF SiO2 FILM (Hs/λ) = 0.3
NORMALIZED THICKNESS OF TANTALUM ELECTRODE
H/λ =0.0
H/λ =0.01
H/λ =0.02
H/λ =0.03
H/λ =0.05
H/λ =0.06
H/λ =0.08
H/λ =0.1
ATTENUATION CONSTANT α (dB/λ)
0.30
0.25
0.20
0.15
0.10
0.05
0.00
100
105
110
115
120
125
130
135
140
145
150
θ OF EULER ANGLES (0°, θ, 0°) (DEGREE)

FIG. 73

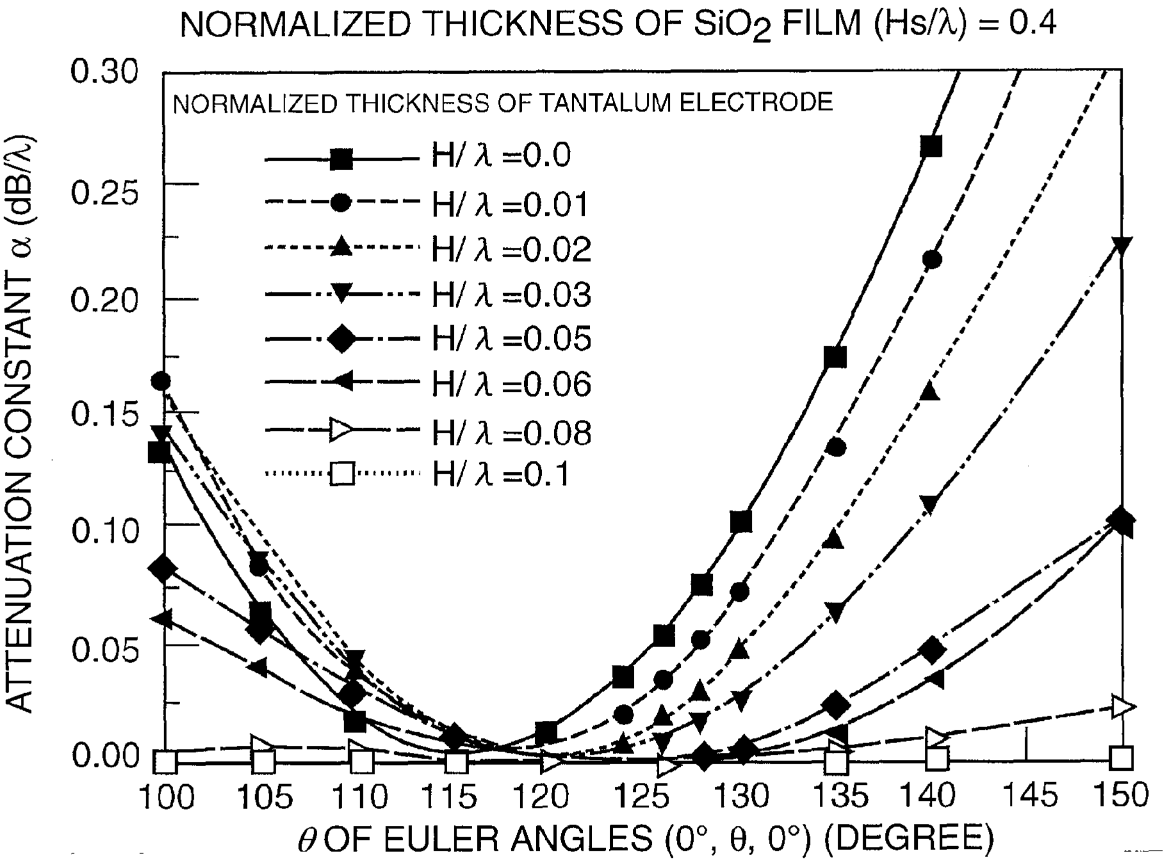
NORMALIZED THICKNESS OF SiO2 FILM (Hs/λ) = 0.4
NORMALIZED THICKNESS OF TANTALUM ELECTRODE
H/λ =0.0
H/λ =0.01
H/λ =0.02
H/λ =0.03
H/λ =0.05
H/λ =0.06
H/λ =0.08
H/λ =0.1
ATTENUATION CONSTANT α (dB/λ)
0.30
0.25
0.20
0.15
0.10
0.05
0.00
100
105
110
115
120
125
130
135
140
145
150
θ OF EULER ANGLES (0°, θ, 0°) (DEGREE)

FIG. 74

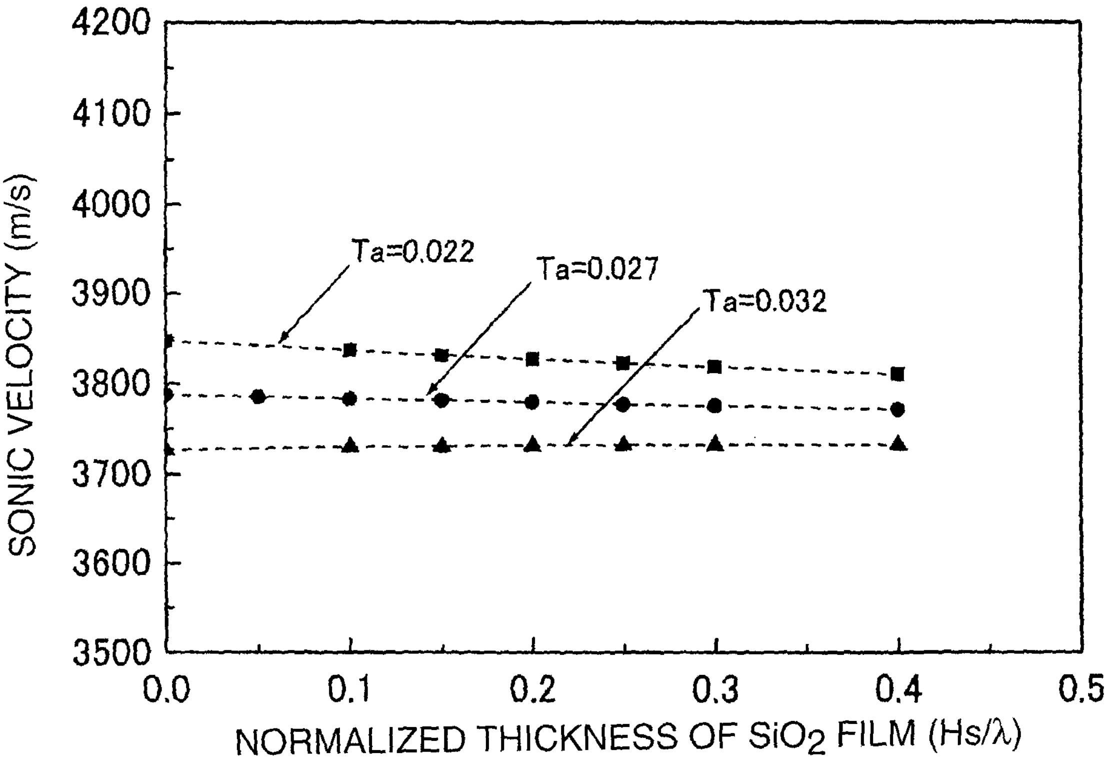
4200
4100
4000
3900
3800
3700
3600
3500
SONIC VELOCITY (m/s)
Ta=0.022
Ta=0.027
Ta=0.032
0.0
0.1
0.2
0.3
0.4
0.5
NORMALIZED THICKNESS OF SiO2 FILM (Hs/λ)

FIG. 75

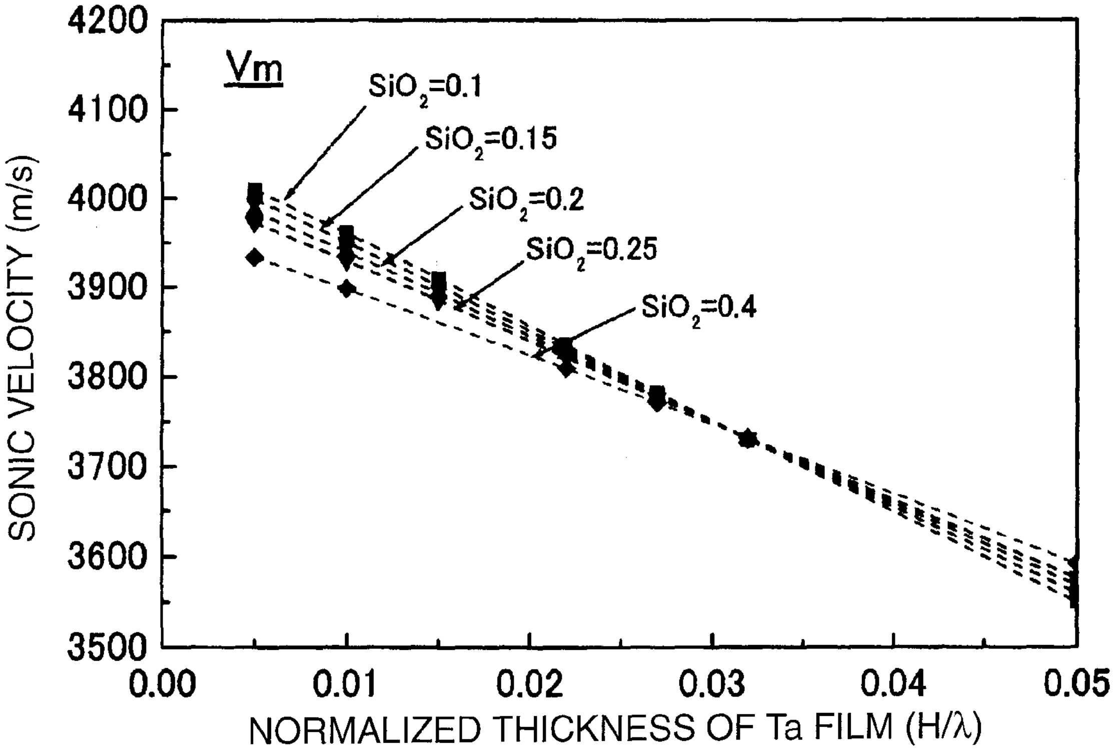
Vm
SiO2=0.1
SiO2=0.15
SiO2=0.2
SiO2=0.25
SiO2=0.4
4200
4100
4000
3900
3800
3700
3600
3500
SONIC VELOCITY (m/s)
0.00
0.01
0.02
0.03
0.04
0.05
NORMALIZED THICKNESS OF Ta FILM (H/λ)

FIG. 76

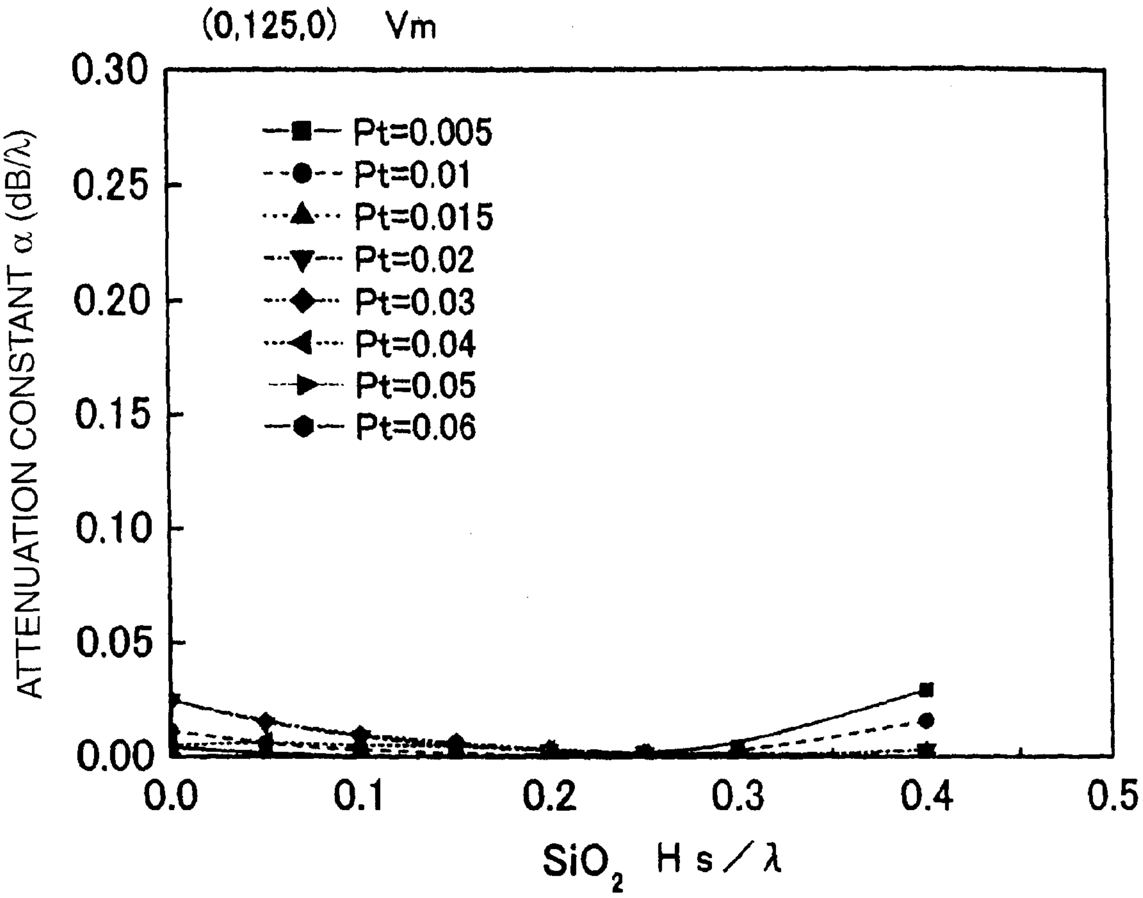
(0,125,0) Vm
0.30
0.25
0.20
0.15
0.10
0.05
0.00
ATTENUATION CONSTANT α (dB/λ)
Pt=0.005
Pt=0.01
Pt=0.015
Pt=0.02
Pt=0.03
Pt=0.04
Pt=0.05
Pt=0.06
0.0
0.1
0.2
0.3
0.4
0.5
SiO2 Hs/λ

FIG. 77

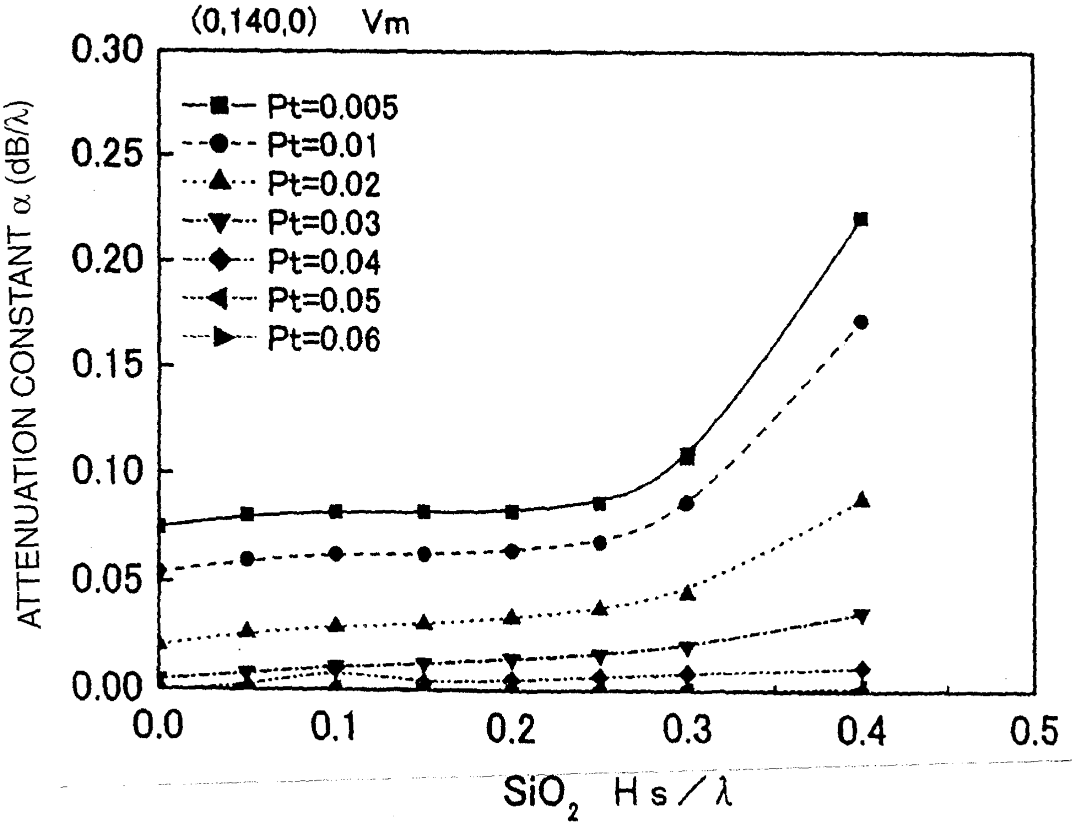
(0,140,0) Vm
0.30
0.25
0.20
0.15
0.10
0.05
0.00
ATTENUATION CONSTANT α (dB/λ)
Pt=0.005
Pt=0.01
Pt=0.02
Pt=0.03
Pt=0.04
Pt=0.05
Pt=0.06
0.0
0.1
0.2
0.3
0.4
0.5
SiO2 Hs／λ

FIG. 78

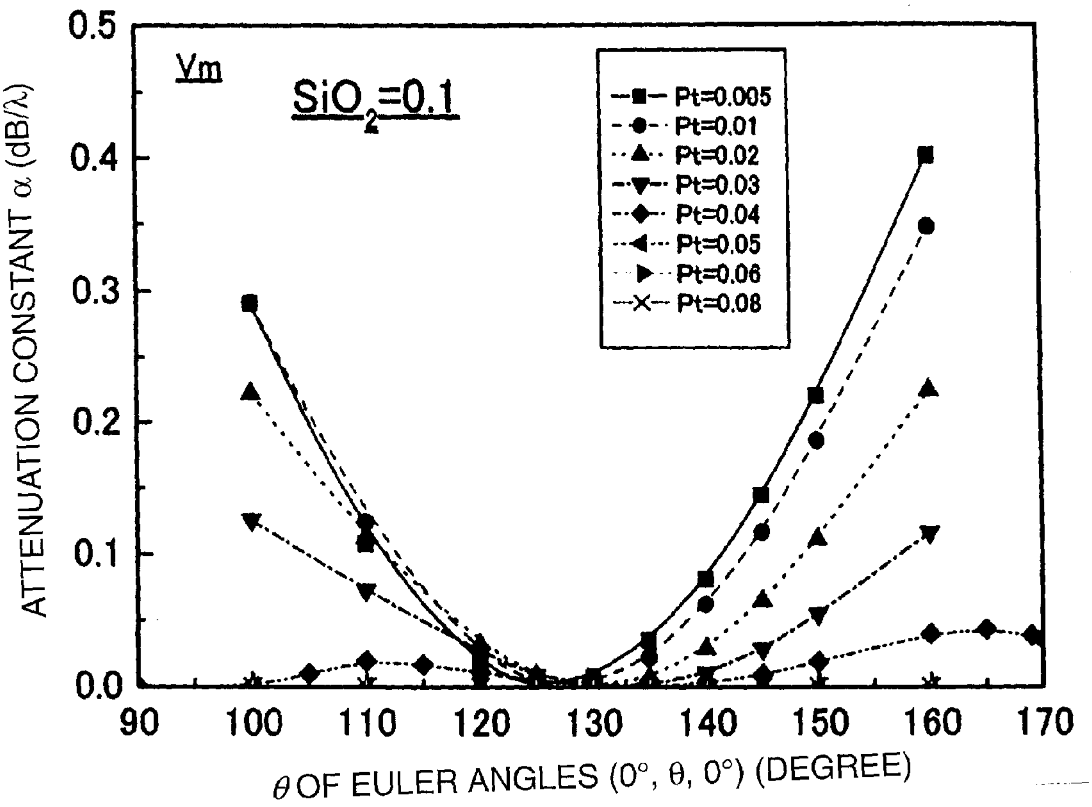
Vm
SiO2=0.1
Pt=0.005
Pt=0.01
Pt=0.02
Pt=0.03
Pt=0.04
Pt=0.05
Pt=0.06
Pt=0.08
ATTENUATION CONSTANT α (dB/λ)
0.0
0.1
0.2
0.3
0.4
0.5
90
100
110
120
130
140
150
160
170
θ OF EULER ANGLES (0°, θ, 0°) (DEGREE)

FIG. 79

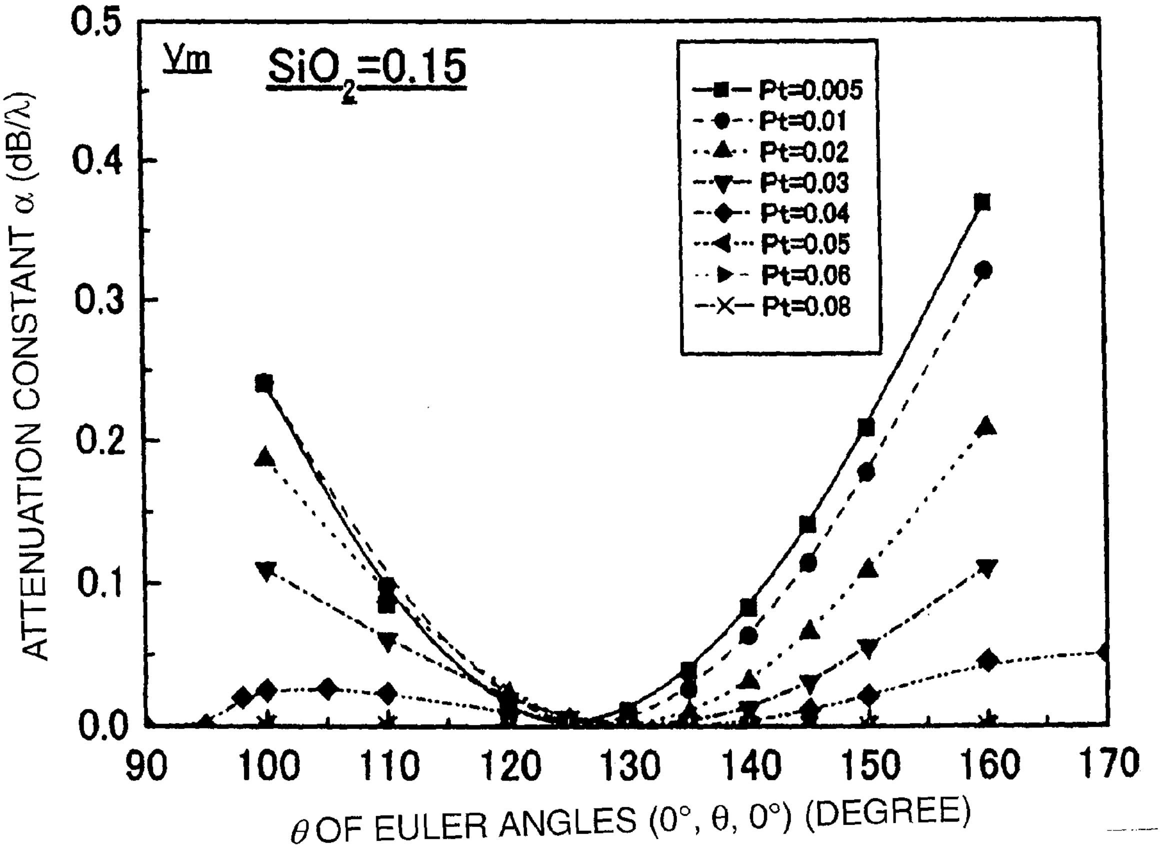
Ym
$SiO_2$=0.15
Pt=0.005
Pt=0.01
Pt=0.02
Pt=0.03
Pt=0.04
Pt=0.05
Pt=0.06
Pt=0.08
ATTENUATION CONSTANT α (dB/λ)
0.5
0.4
0.3
0.2
0.1
0.0
90
100
110
120
130
140
150
160
170
θ OF EULER ANGLES (0°, θ, 0°) (DEGREE)

FIG. 80

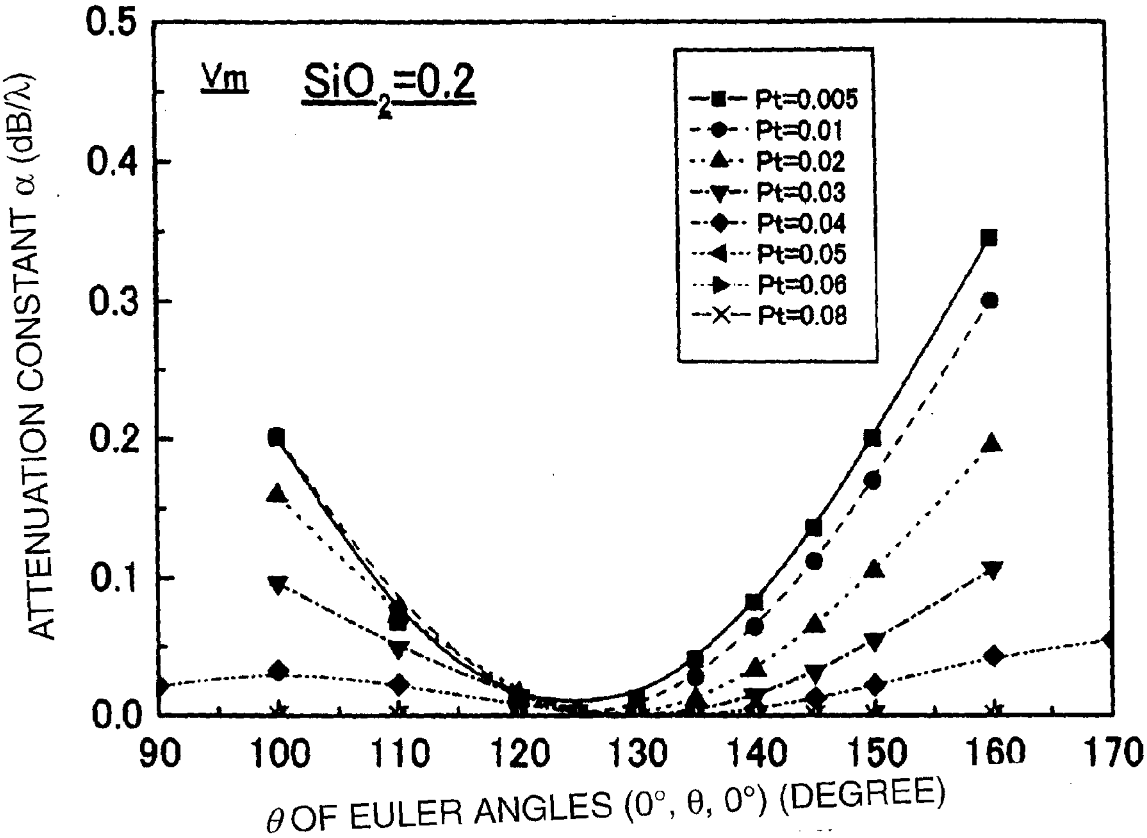
Vm SiO2=0.2
Pt=0.005
Pt=0.01
Pt=0.02
Pt=0.03
Pt=0.04
Pt=0.05
Pt=0.06
Pt=0.08
ATTENUATION CONSTANT α (dB/λ)
0.5
0.4
0.3
0.2
0.1
0.0
90
100
110
120
130
140
150
160
170
θ OF EULER ANGLES (0°, θ, 0°) (DEGREE)

FIG. 81

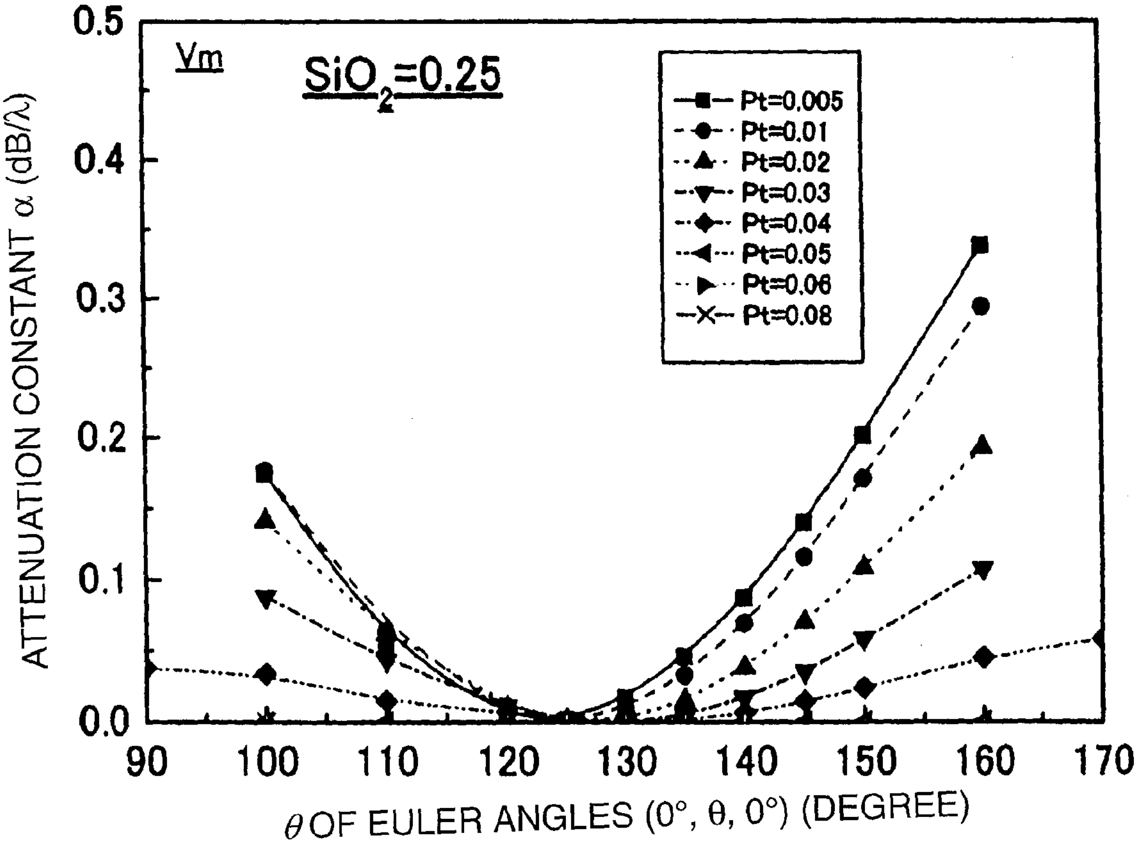
Vm
$SiO_2$=0.25
Pt=0.005
Pt=0.01
Pt=0.02
Pt=0.03
Pt=0.04
Pt=0.05
Pt=0.06
Pt=0.08
ATTENUATION CONSTANT α (dB/λ)
0.5
0.4
0.3
0.2
0.1
0.0
90
100
110
120
130
140
150
160
170
θ OF EULER ANGLES (0°, θ, 0°) (DEGREE)

FIG. 82

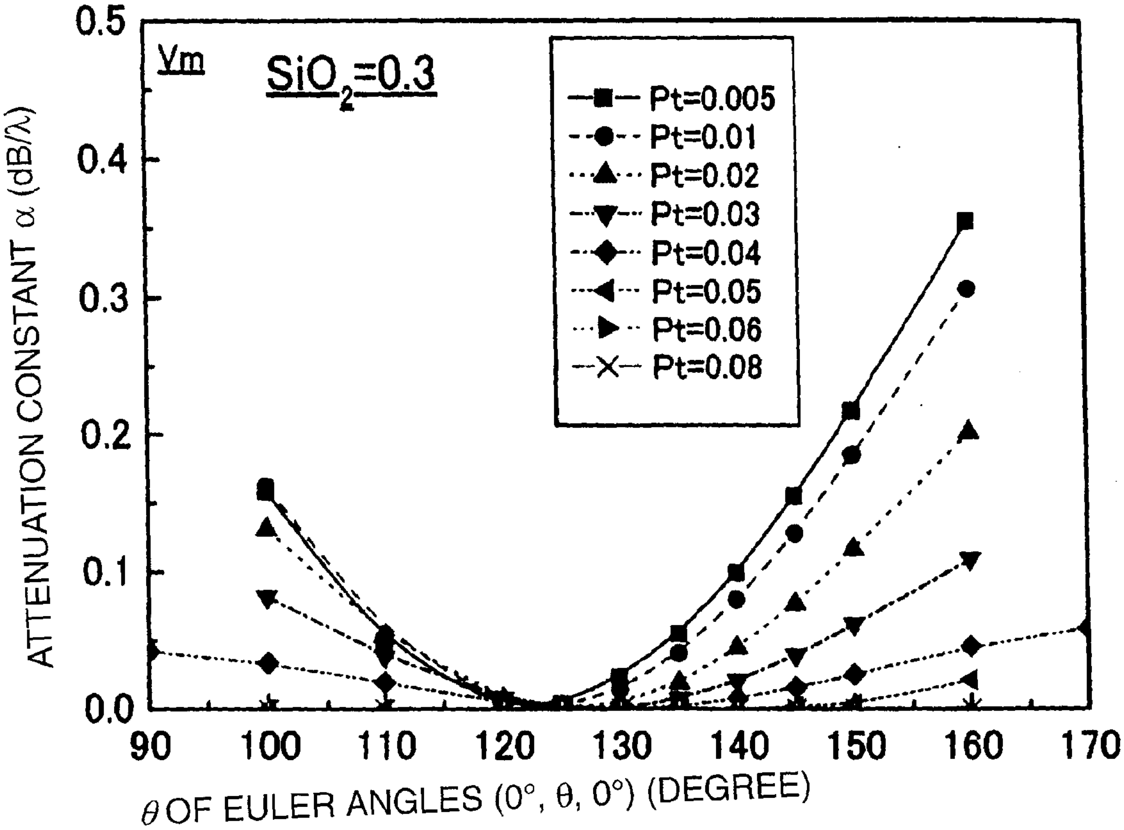

0.5
0.4
0.3
0.2
0.1
0.0
ATTENUATION CONSTANT α (dB/λ)
Vm
SiO2=0.3
Pt=0.005
Pt=0.01
Pt=0.02
Pt=0.03
Pt=0.04
Pt=0.05
Pt=0.06
Pt=0.08
90
100
110
120
130
140
150
160
170
θ OF EULER ANGLES (0°, θ, 0°) (DEGREE)

FIG. 83

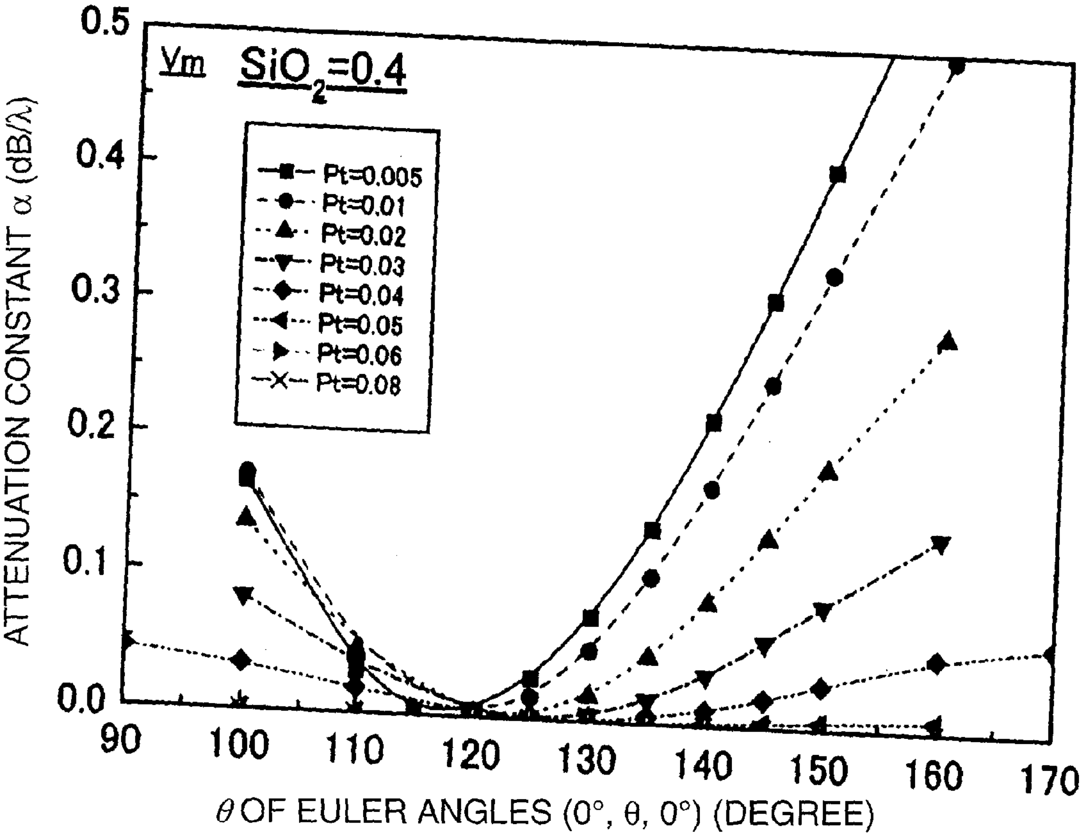
Ym SiO2=0.4
Pt=0.005
Pt=0.01
Pt=0.02
Pt=0.03
Pt=0.04
Pt=0.05
Pt=0.06
Pt=0.08
0.5
0.4
0.3
0.2
0.1
0.0
90
100
110
120
130
140
150
160
170
ATTENUATION CONSTANT α (dB/λ)
θ OF EULER ANGLES (0°, θ, 0°) (DEGREE)

FIG. 84

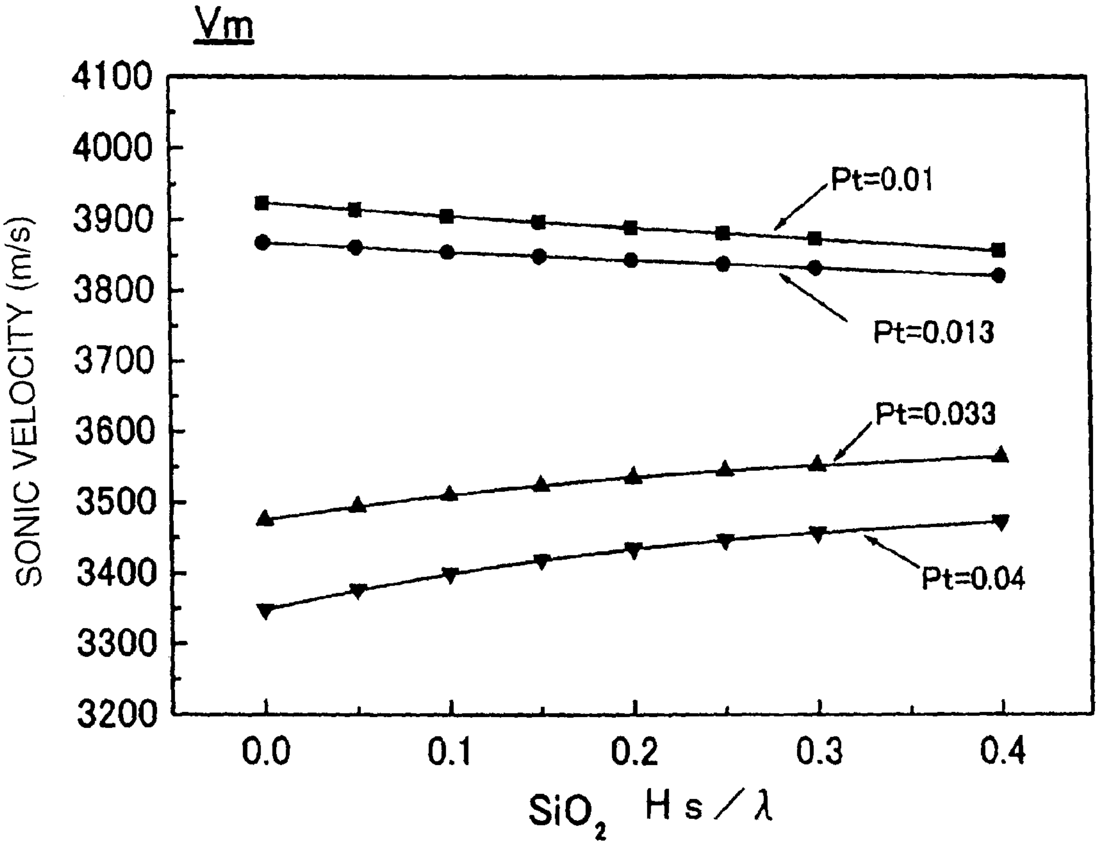
Vm
SONIC VELOCITY (m/s)
4100
4000
3900
3800
3700
3600
3500
3400
3300
3200
Pt=0.01
Pt=0.013
Pt=0.033
Pt=0.04
0.0
0.1
0.2
0.3
0.4
SiO2 Hs／λ

FIG. 85

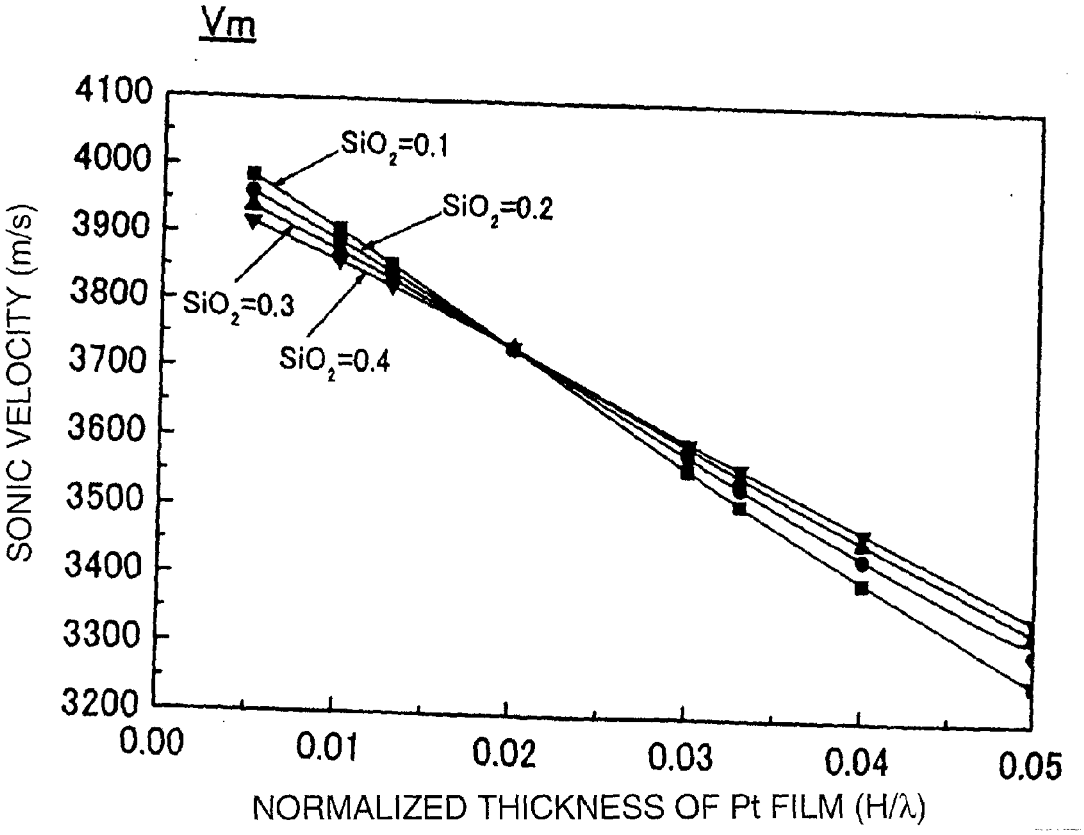
Vm
SONIC VELOCITY (m/s)
4100
4000
3900
3800
3700
3600
3500
3400
3300
3200
SiO2=0.1
SiO2=0.2
SiO2=0.3
SiO2=0.4
0.00
0.01
0.02
0.03
0.04
0.05
NORMALIZED THICKNESS OF Pt FILM (H/λ)

FIG. 86

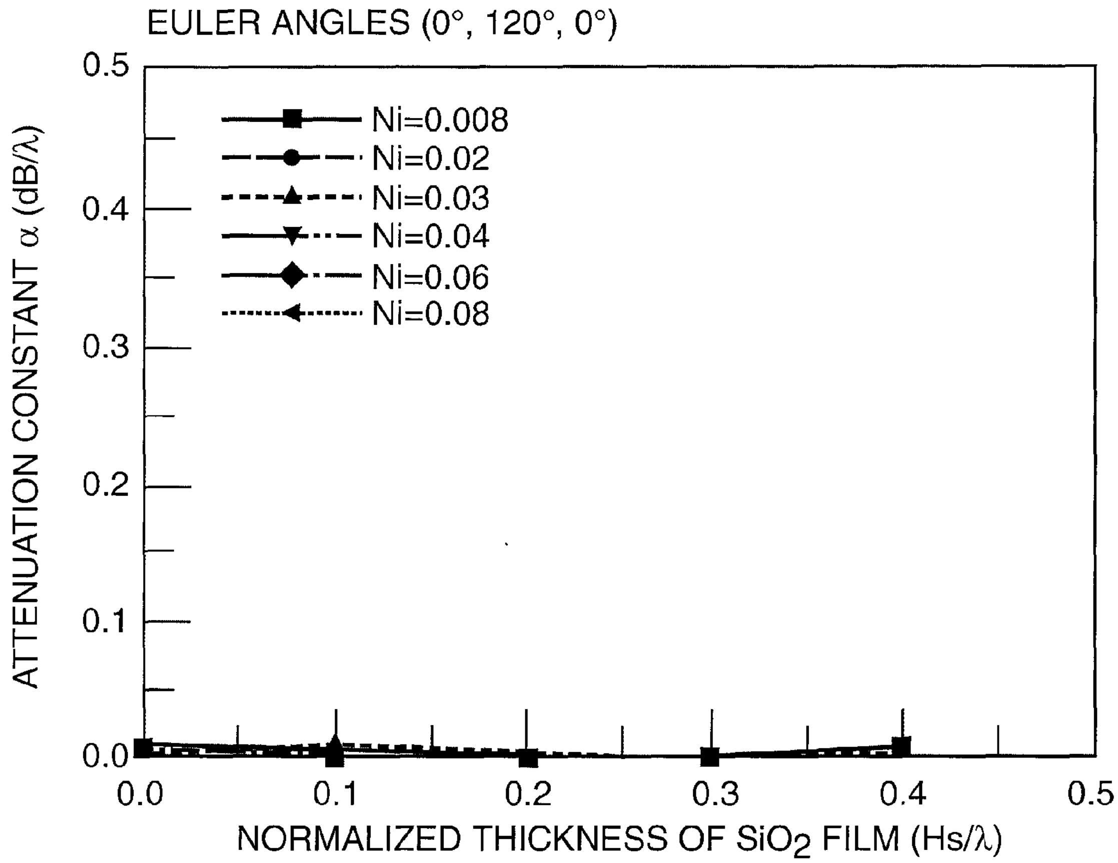
EULER ANGLES (0°, 120°, 0°)
ATTENUATION CONSTANT α (dB/λ)
NORMALIZED THICKNESS OF SiO2 FILM (Hs/λ)
Ni=0.008
Ni=0.02
Ni=0.03
Ni=0.04
Ni=0.06
Ni=0.08
0.0
0.1
0.2
0.3
0.4
0.5

FIG. 87

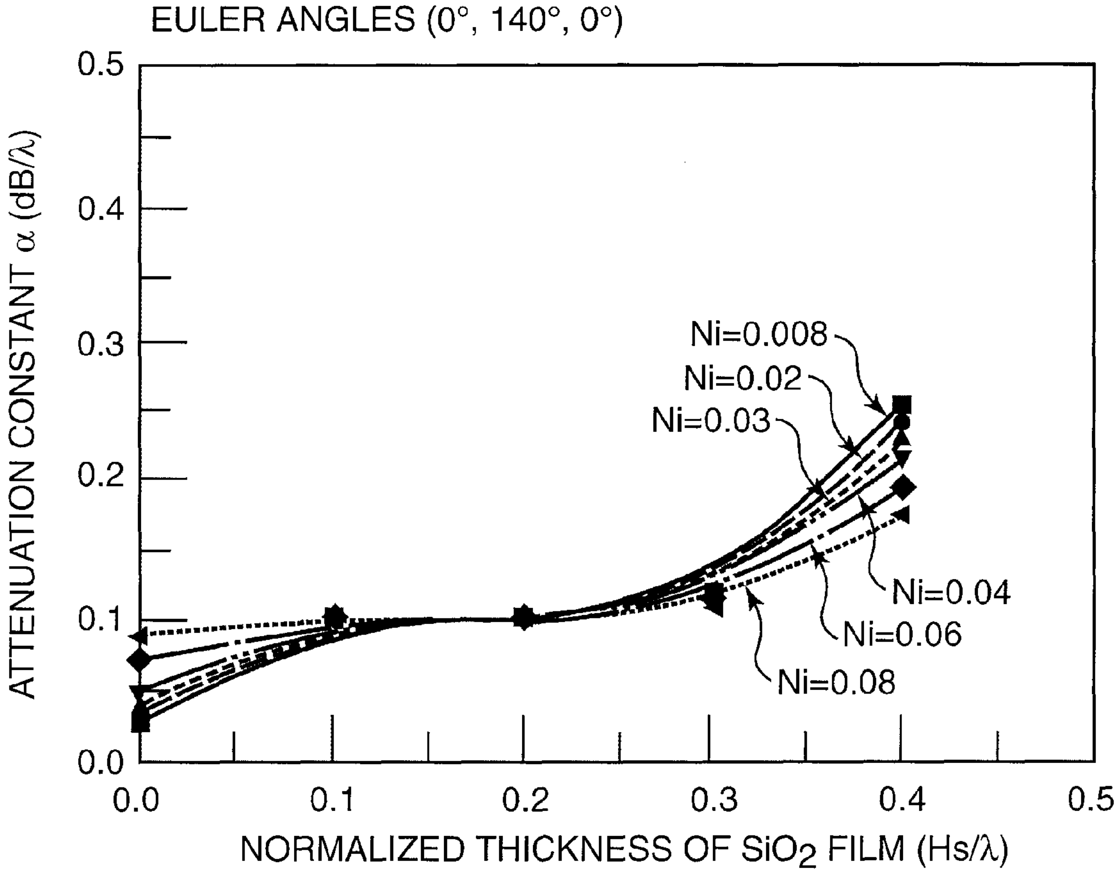
EULER ANGLES (0°, 140°, 0°)
ATTENUATION CONSTANT α (dB/λ)
0.0
0.1
0.2
0.3
0.4
0.5
Ni=0.008
Ni=0.02
Ni=0.03
Ni=0.04
Ni=0.06
Ni=0.08
NORMALIZED THICKNESS OF SiO2 FILM (Hs/λ)

FIG. 88

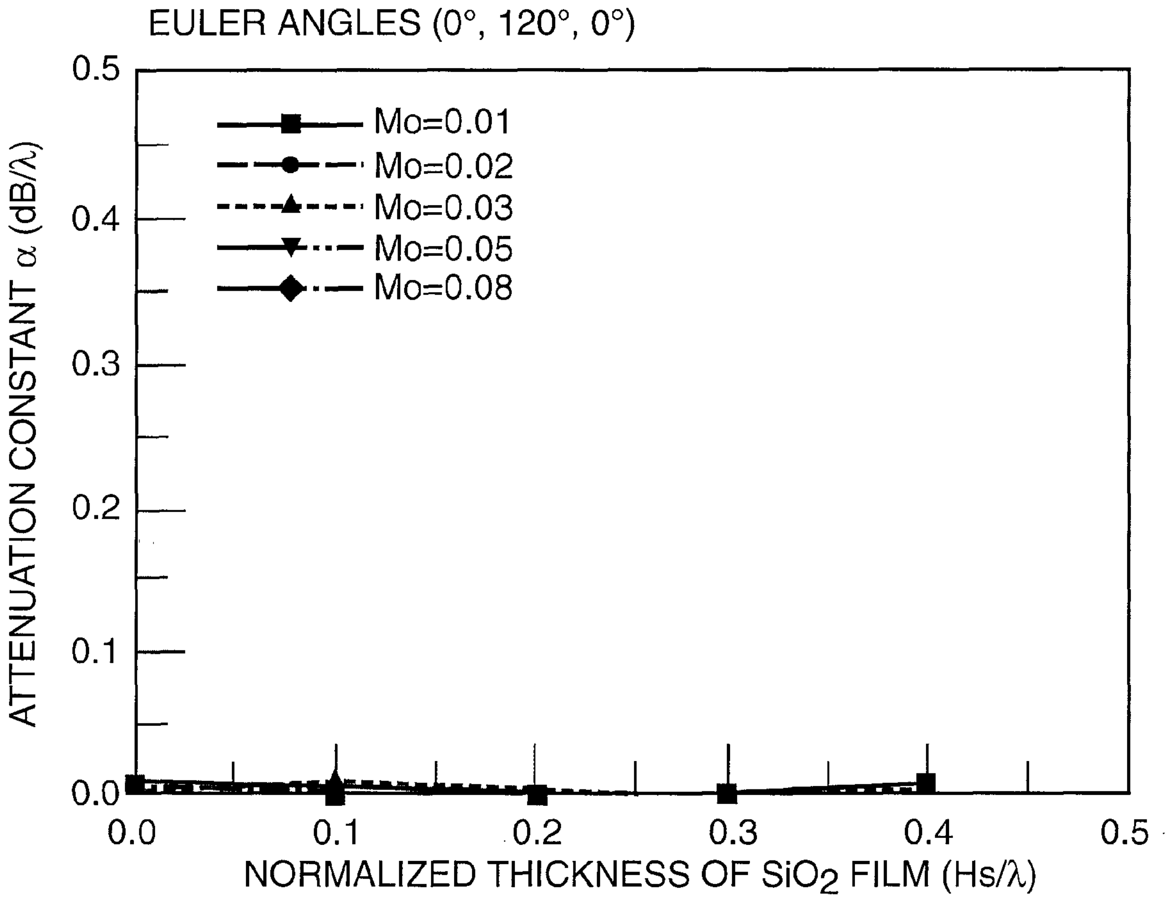
EULER ANGLES (0°, 120°, 0°)
ATTENUATION CONSTANT α (dB/λ)
0.5
0.4
0.3
0.2
0.1
0.0
Mo=0.01
Mo=0.02
Mo=0.03
Mo=0.05
Mo=0.08
0.0
0.1
0.2
0.3
0.4
0.5
NORMALIZED THICKNESS OF SiO2 FILM (Hs/λ)

FIG. 89

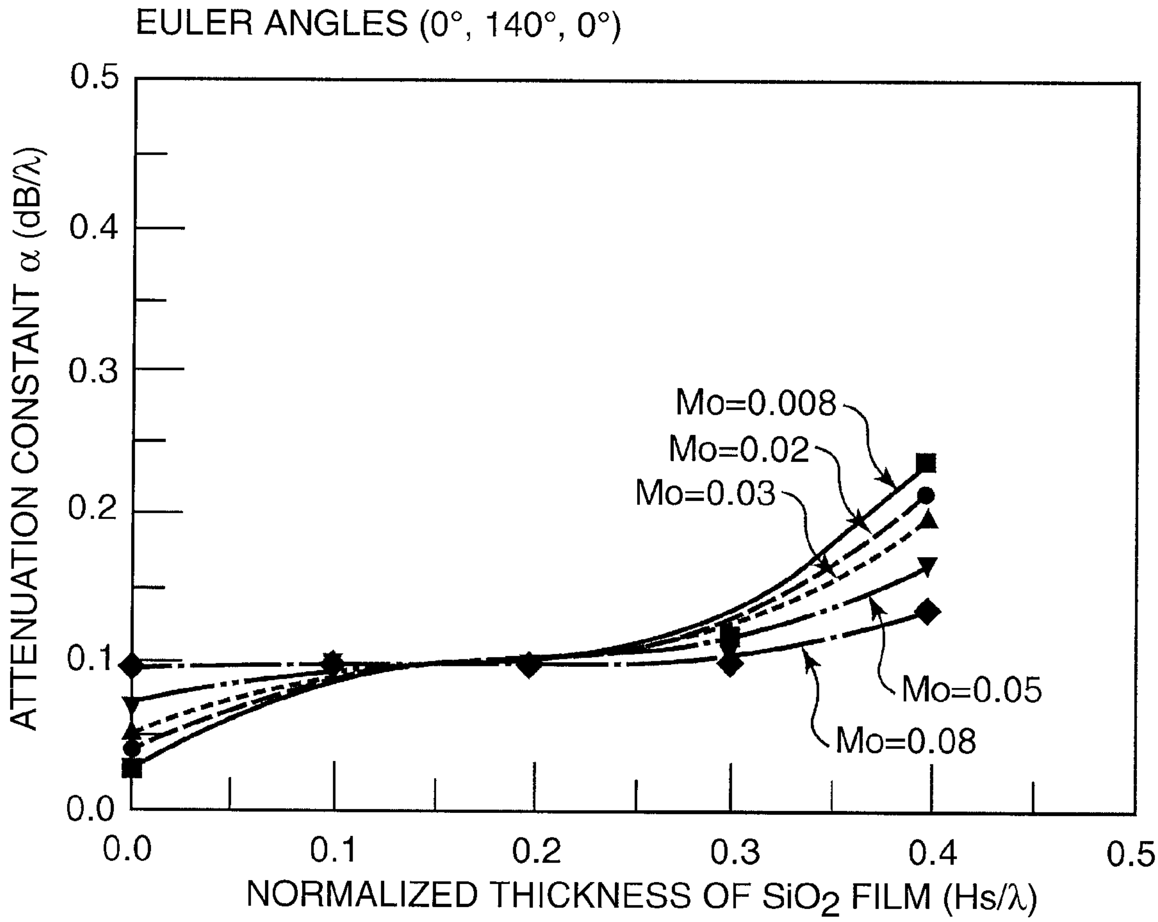
EULER ANGLES (0°, 140°, 0°)
ATTENUATION CONSTANT α (dB/λ)
0.0
0.1
0.2
0.3
0.4
0.5
Mo=0.008
Mo=0.02
Mo=0.03
Mo=0.05
Mo=0.08
0.0
0.1
0.2
0.3
0.4
0.5
NORMALIZED THICKNESS OF SiO2 FILM (Hs/λ)

FIG. 90

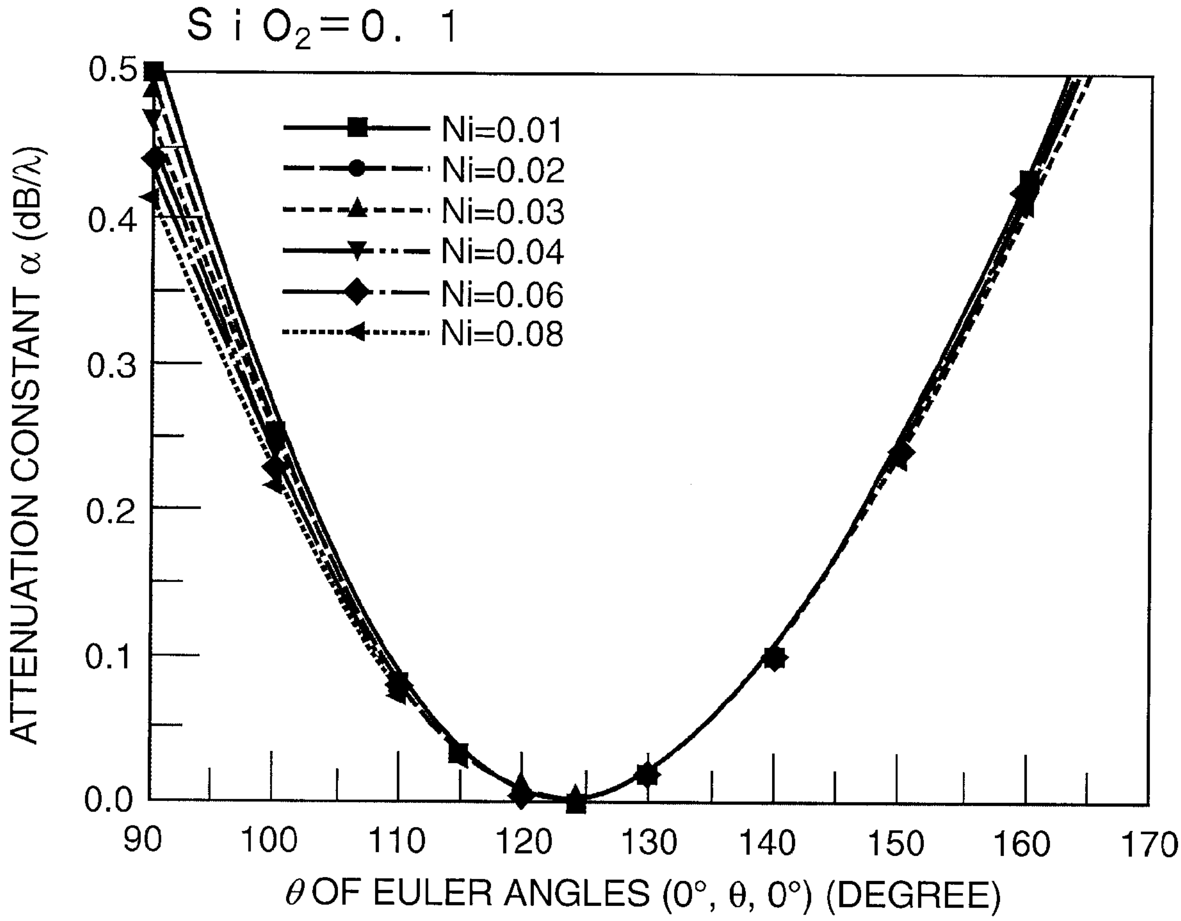
SiO2=0. 1
ATTENUATION CONSTANT α (dB/λ)
0.5
0.4
0.3
0.2
0.1
0.0
90
100
110
120
130
140
150
160
170
θ OF EULER ANGLES (0°, θ, 0°) (DEGREE)
Ni=0.01
Ni=0.02
Ni=0.03
Ni=0.04
Ni=0.06
Ni=0.08

FIG. 91

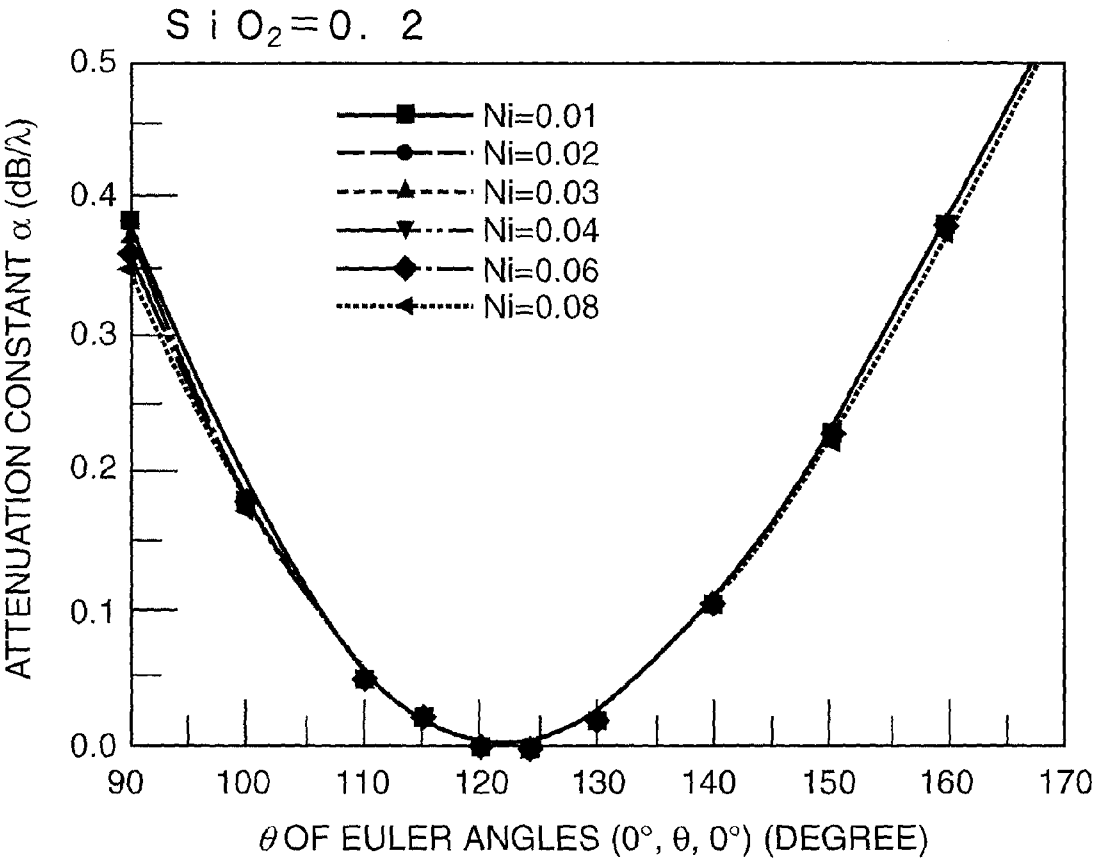

SiO2=0. 2
0.5
0.4
0.3
0.2
0.1
0.0
Ni=0.01
Ni=0.02
Ni=0.03
Ni=0.04
Ni=0.06
Ni=0.08
ATTENUATION CONSTANT α (dB/λ)
90
100
110
120
130
140
150
160
170
θ OF EULER ANGLES (0°, θ, 0°) (DEGREE)

FIG. 92

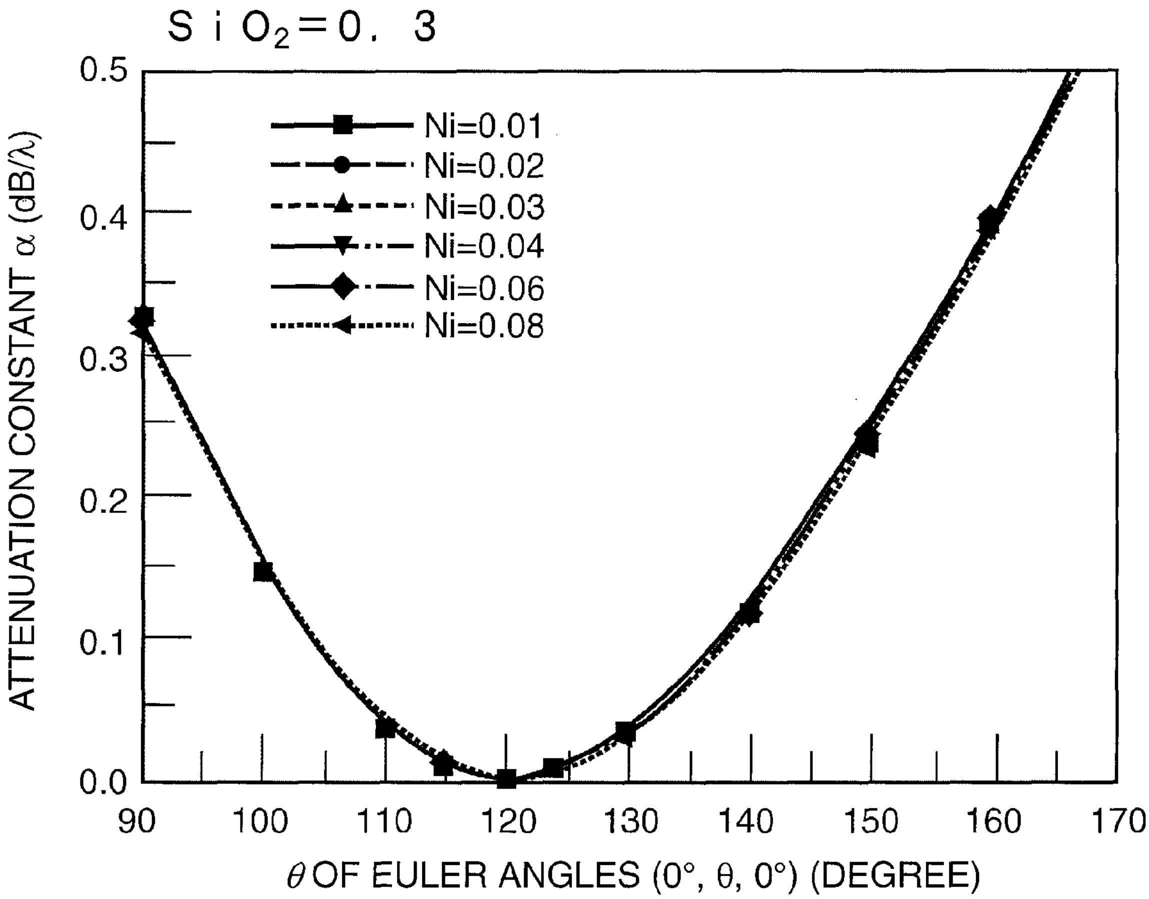
$SiO_2$=0. 3
ATTENUATION CONSTANT α (dB/λ)
0.5
0.4
0.3
0.2
0.1
0.0
Ni=0.01
Ni=0.02
Ni=0.03
Ni=0.04
Ni=0.06
Ni=0.08
90
100
110
120
130
140
150
160
170
θ OF EULER ANGLES (0°, θ, 0°) (DEGREE)

FIG. 93

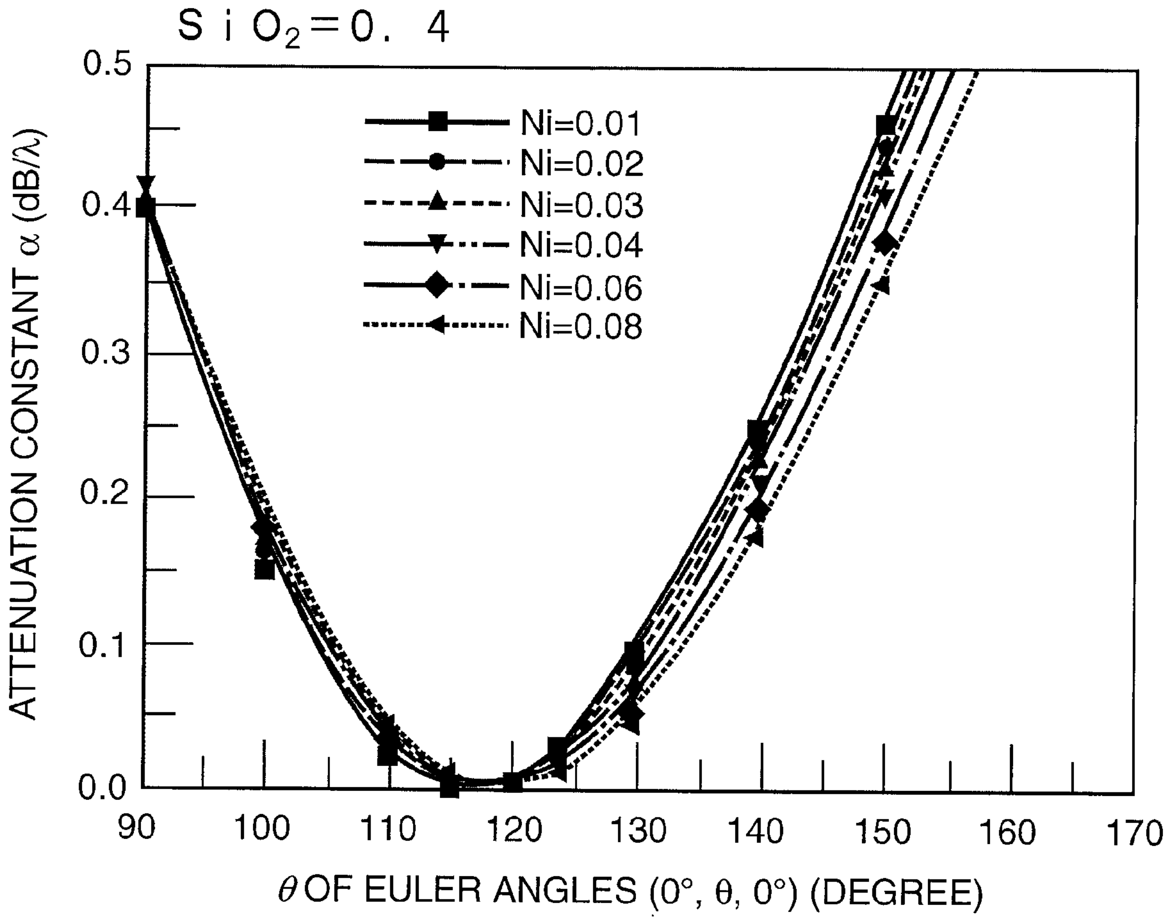
$SiO_2=0.4$
ATTENUATION CONSTANT α (dB/λ)
0.5
0.4
0.3
0.2
0.1
0.0
90
100
110
120
130
140
150
160
170
θ OF EULER ANGLES (0°, θ, 0°) (DEGREE)
Ni=0.01
Ni=0.02
Ni=0.03
Ni=0.04
Ni=0.06
Ni=0.08

FIG. 94

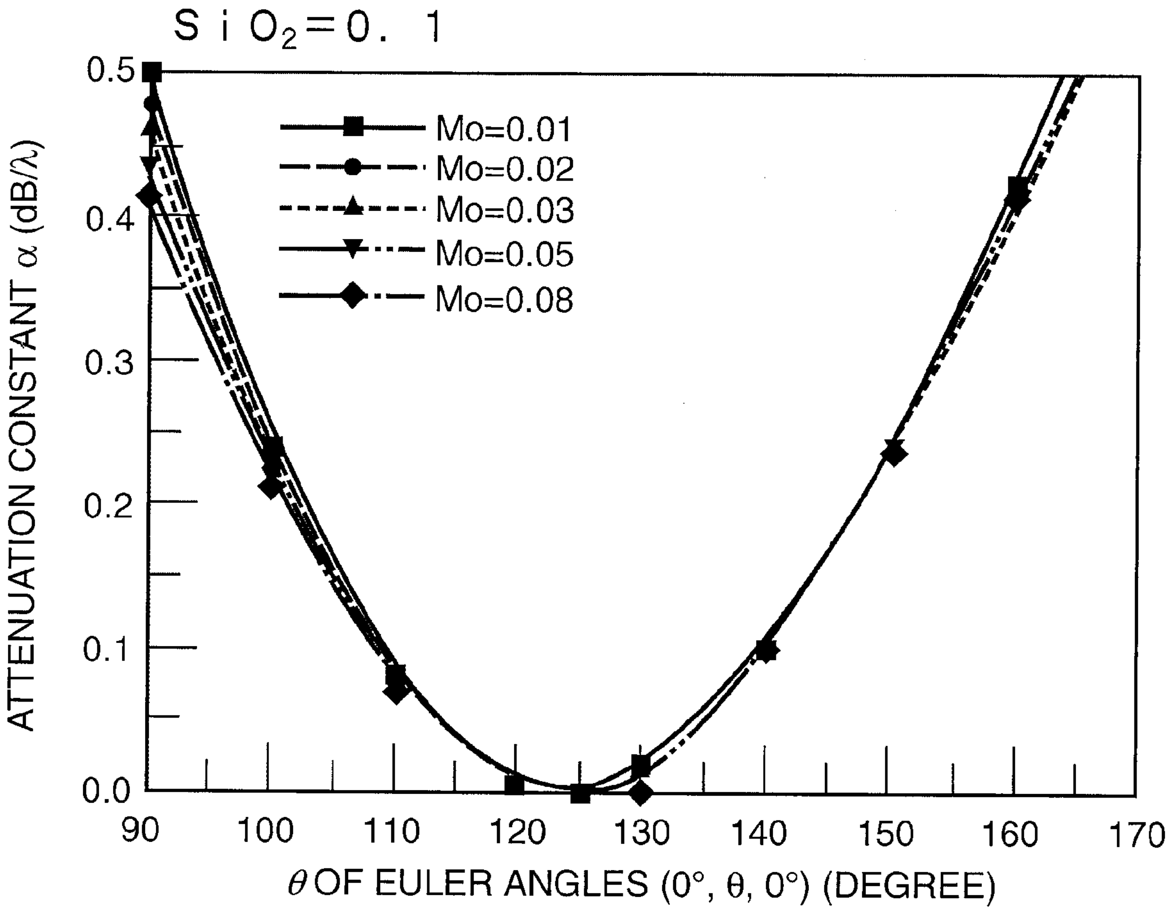
SiO2=0. 1
0.5
0.4
0.3
0.2
0.1
0.0
90
100
110
120
130
140
150
160
170
ATTENUATION CONSTANT α (dB/λ)
θ OF EULER ANGLES (0°, θ, 0°) (DEGREE)
Mo=0.01
Mo=0.02
Mo=0.03
Mo=0.05
Mo=0.08

FIG. 95

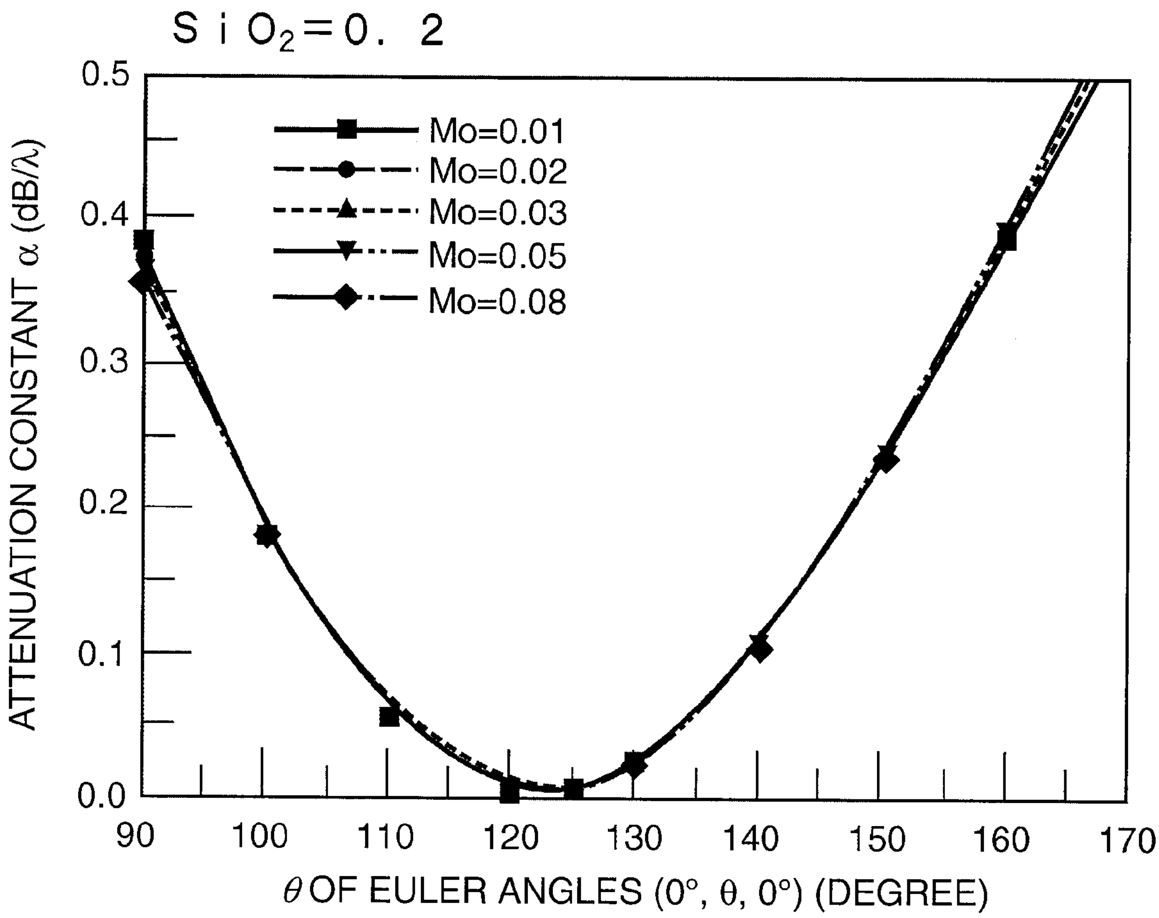
$SiO_2$=0. 2
Mo=0.01
Mo=0.02
Mo=0.03
Mo=0.05
Mo=0.08
ATTENUATION CONSTANT α (dB/λ)
0.5
0.4
0.3
0.2
0.1
0.0
90
100
110
120
130
140
150
160
170
θ OF EULER ANGLES (0°, θ, 0°) (DEGREE)

FIG. 96

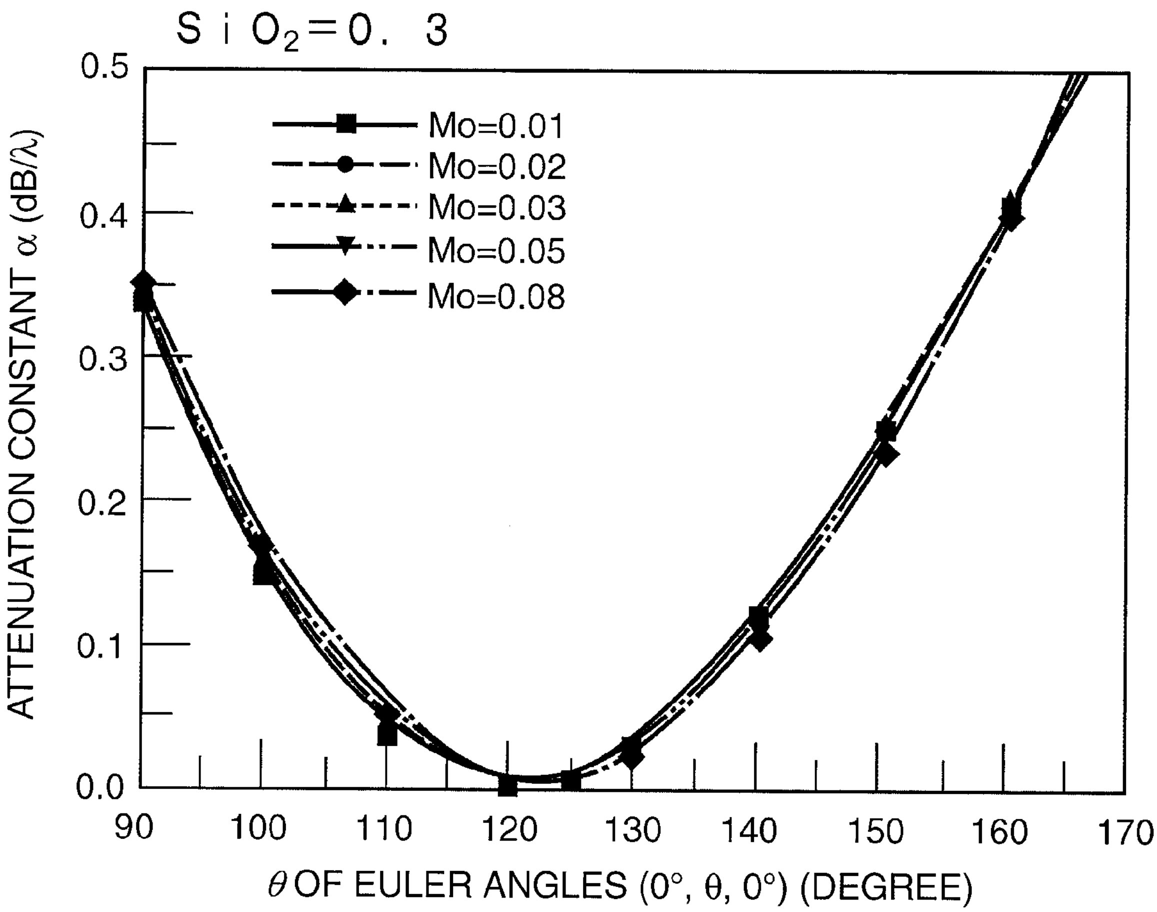
$SiO_2$=0. 3
ATTENUATION CONSTANT α (dB/λ)
0.5
0.4
0.3
0.2
0.1
0.0
Mo=0.01
Mo=0.02
Mo=0.03
Mo=0.05
Mo=0.08
90
100
110
120
130
140
150
160
170
θ OF EULER ANGLES (0°, θ, 0°) (DEGREE)

FIG. 97

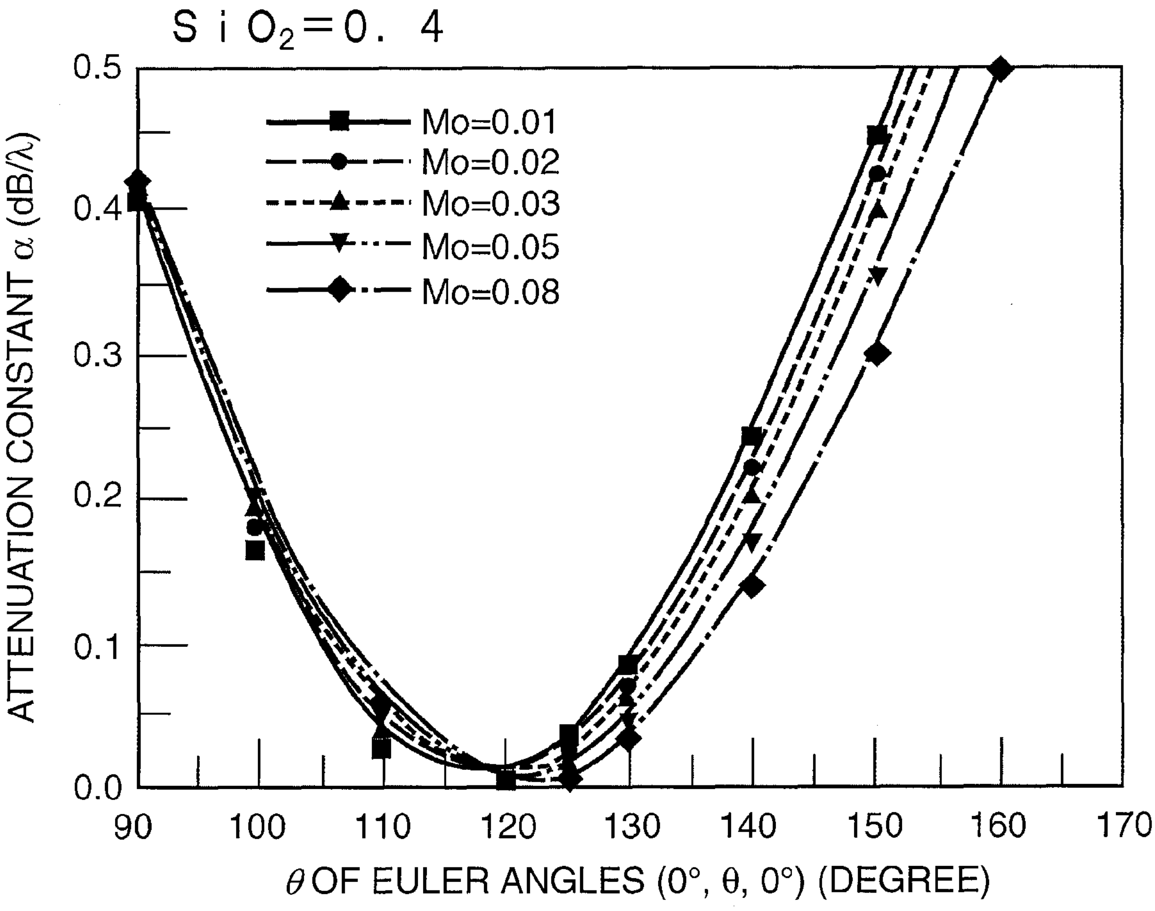
SiO2=0. 4
ATTENUATION CONSTANT α (dB/λ)
0.5
0.4
0.3
0.2
0.1
0.0
Mo=0.01
Mo=0.02
Mo=0.03
Mo=0.05
Mo=0.08
90
100
110
120
130
140
150
160
170
θ OF EULER ANGLES (0°, θ, 0°) (DEGREE)

FIG. 98

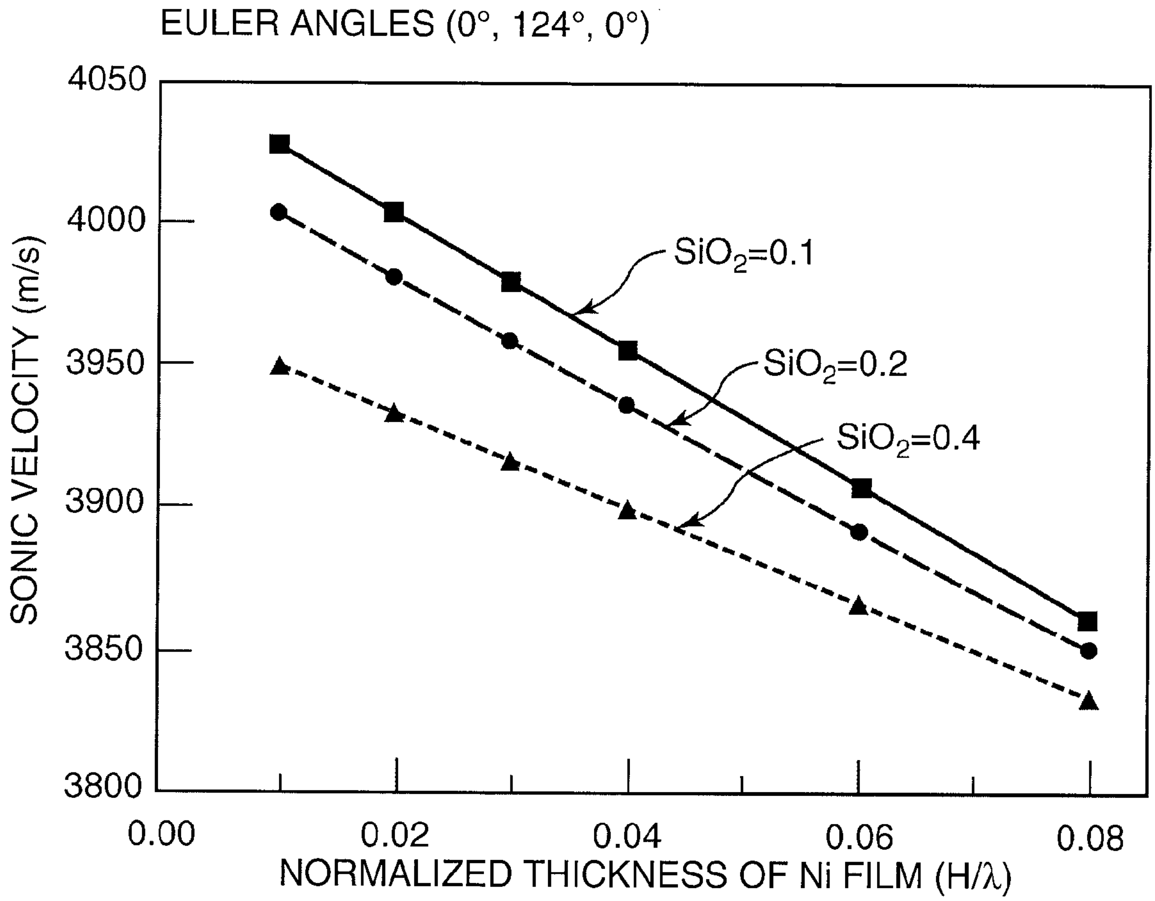
EULER ANGLES (0°, 124°, 0°)
SONIC VELOCITY (m/s)
4050
4000
3950
3900
3850
3800
0.00
0.02
0.04
0.06
0.08
NORMALIZED THICKNESS OF Ni FILM (H/λ)
SiO2=0.1
SiO2=0.2
SiO2=0.4

FIG. 99

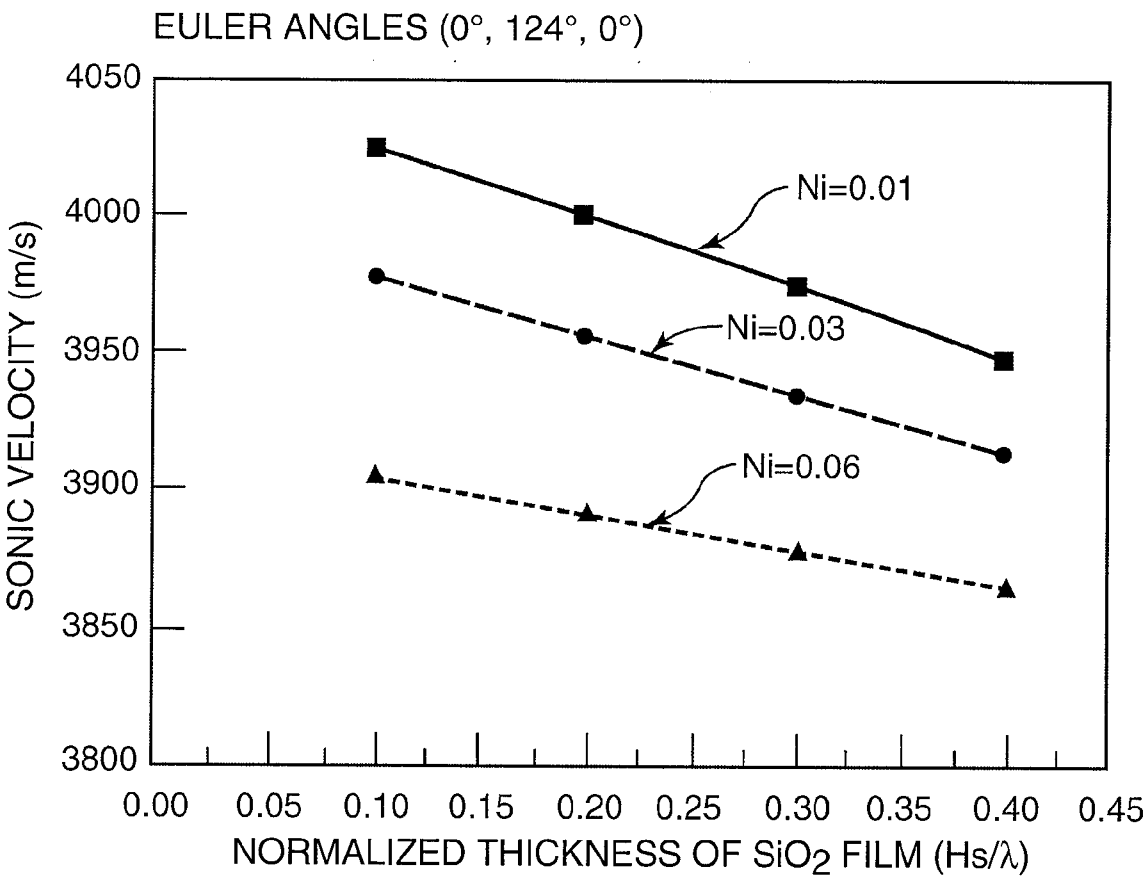
EULER ANGLES (0°, 124°, 0°)
4050
4000
3950
3900
3850
3800
SONIC VELOCITY (m/s)
Ni=0.01
Ni=0.03
Ni=0.06
0.00
0.05
0.10
0.15
0.20
0.25
0.30
0.35
0.40
0.45
NORMALIZED THICKNESS OF SiO2 FILM (Hs/λ)

FIG. 100

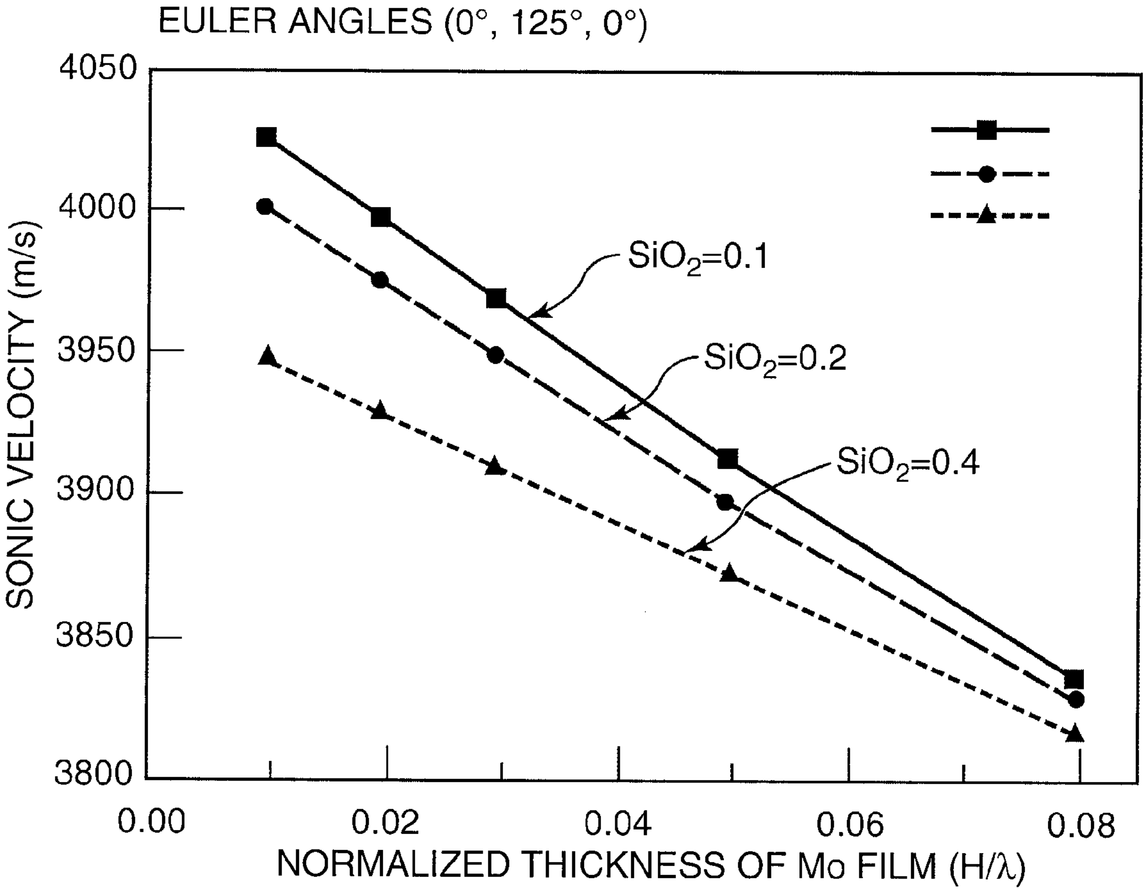
EULER ANGLES (0°, 125°, 0°)
4050
4000
3950
3900
3850
3800
SONIC VELOCITY (m/s)
SiO2=0.1
SiO2=0.2
SiO2=0.4
0.00
0.02
0.04
0.06
0.08
NORMALIZED THICKNESS OF Mo FILM (H/λ)

FIG. 101

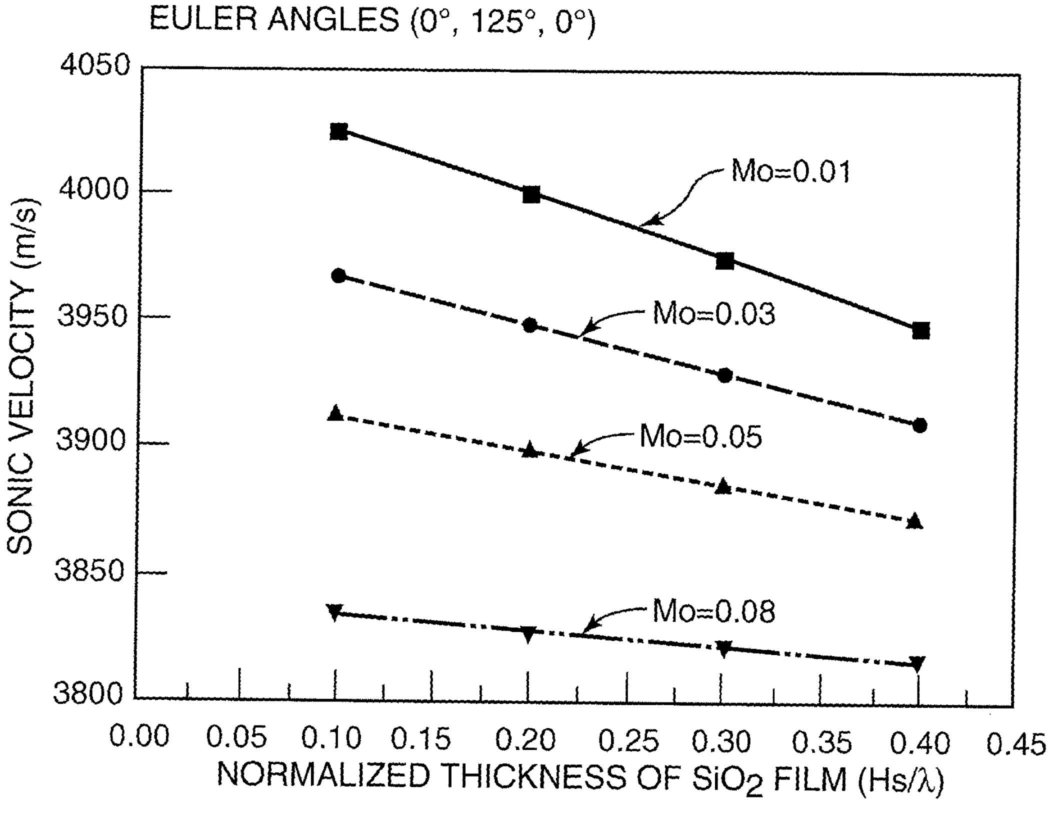
EULER ANGLES (0°, 125°, 0°)
SONIC VELOCITY (m/s)
4050
4000
3950
3900
3850
3800
Mo=0.01
Mo=0.03
Mo=0.05
Mo=0.08
0.00 0.05 0.10 0.15 0.20 0.25 0.30 0.35 0.40 0.45
NORMALIZED THICKNESS OF SiO2 FILM (Hs/λ)

FIG. 102A

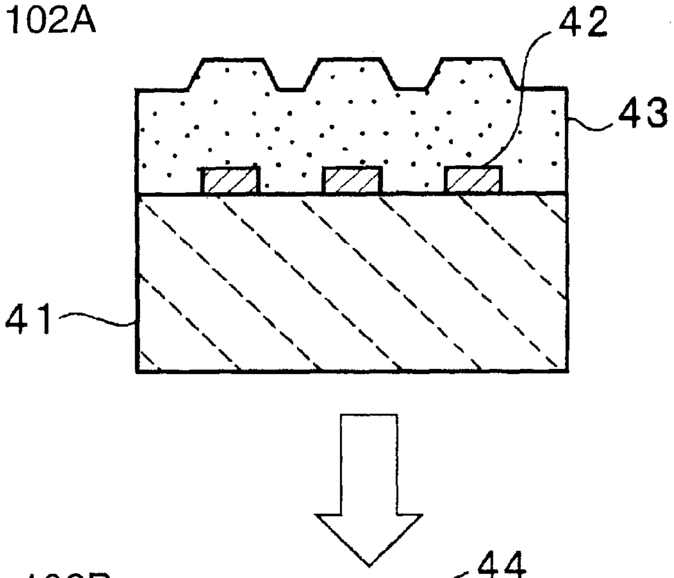


FIG. 102B

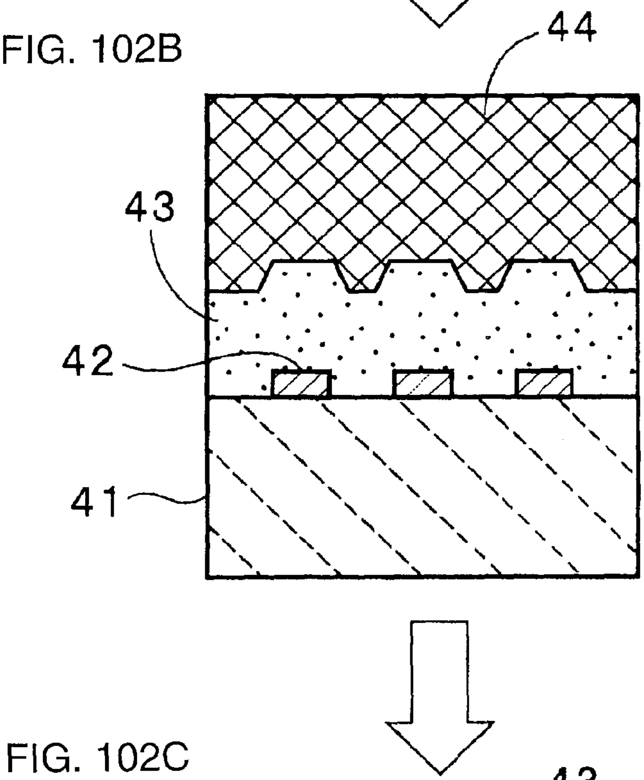


FIG. 102C

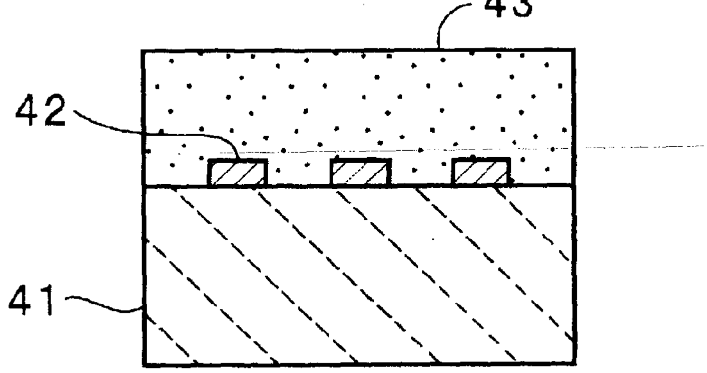

FIG. 103A

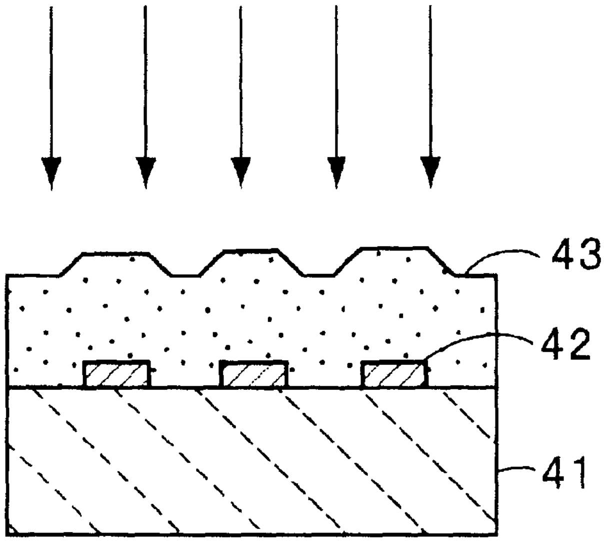


FIG. 103B

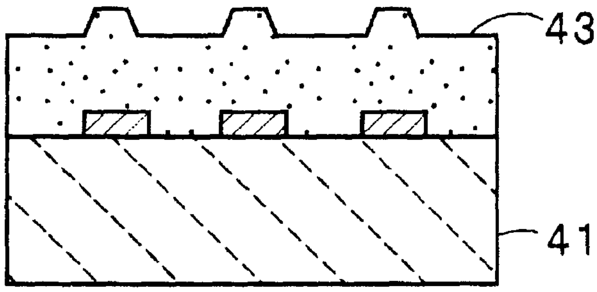


FIG. 103C

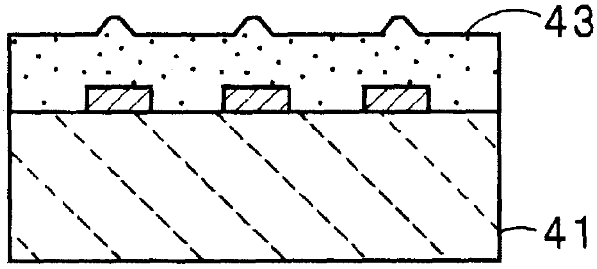


FIG. 103D

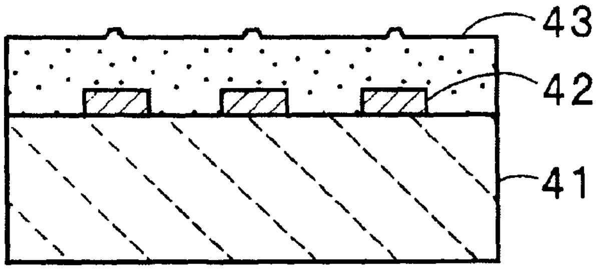

FIG. 104A

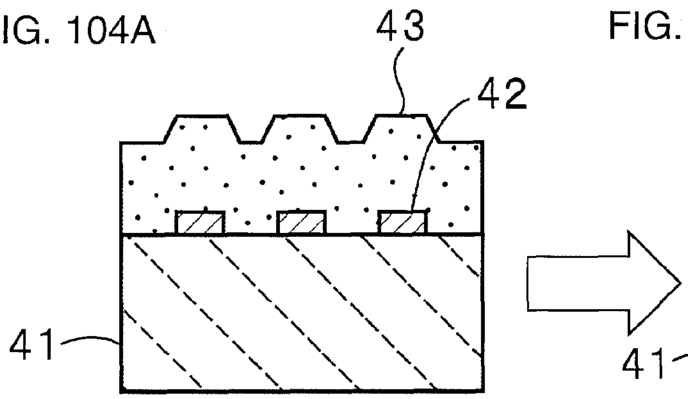


FIG. 104B

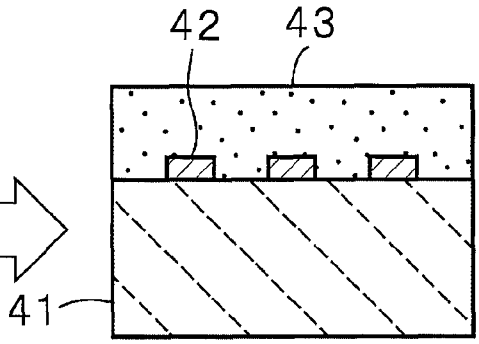

FIG. 105A

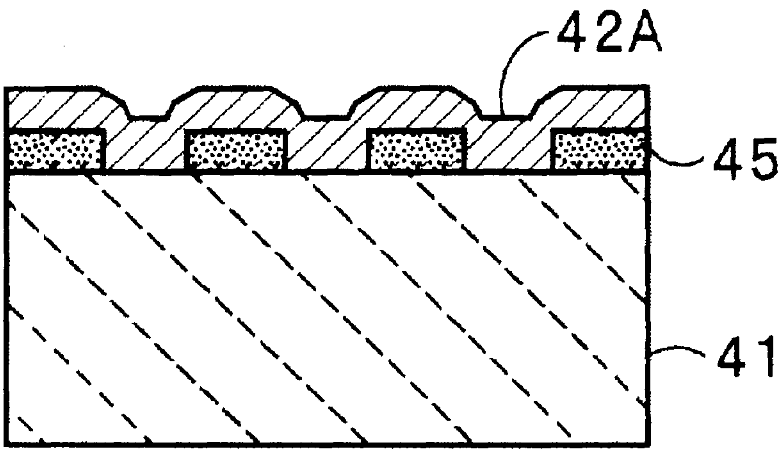


FIG. 105B

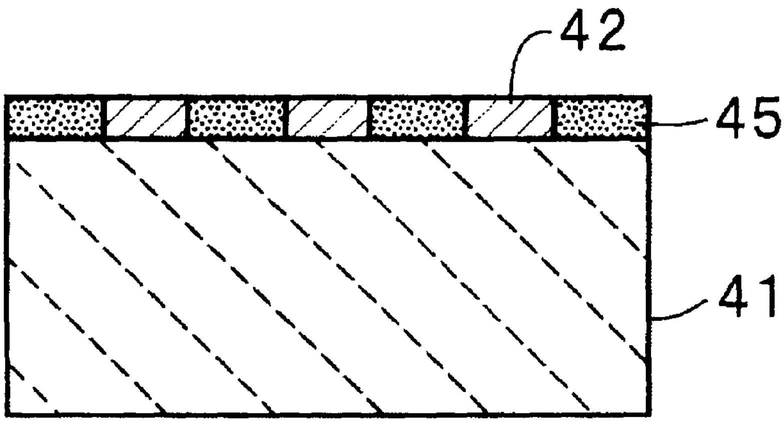


FIG. 105C

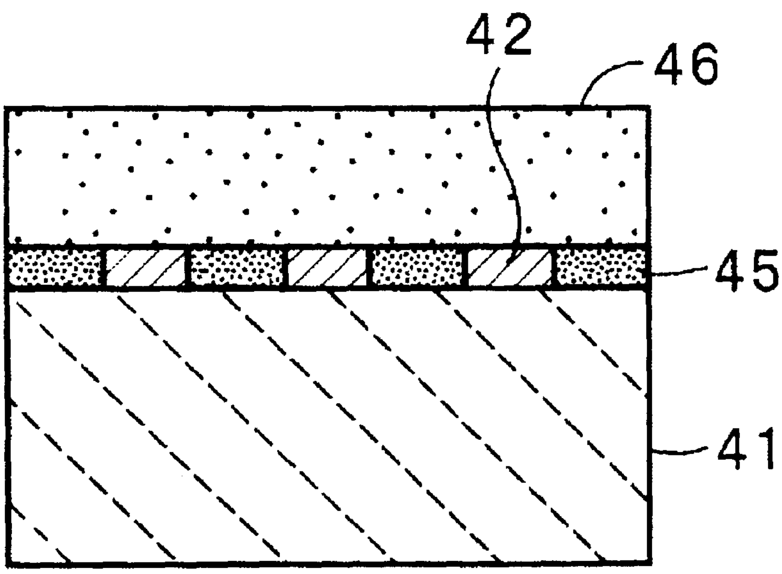

FIG. 106A

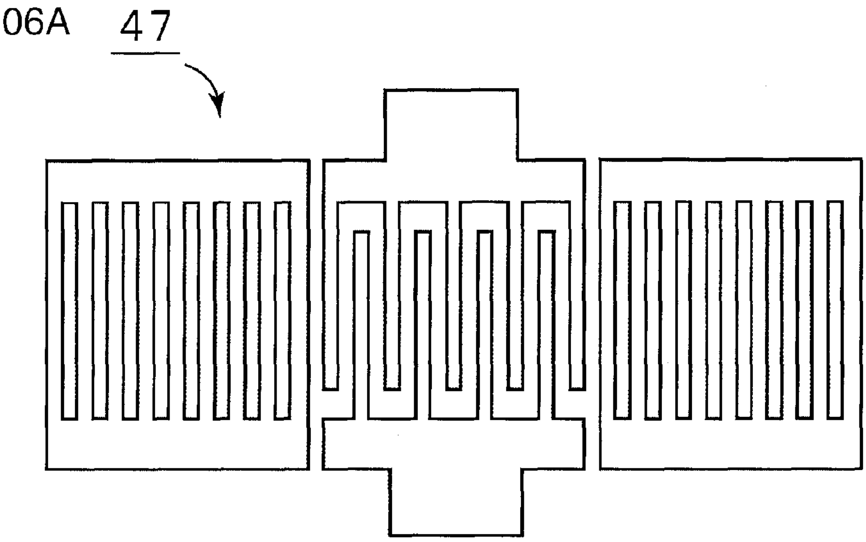


FIG. 106B

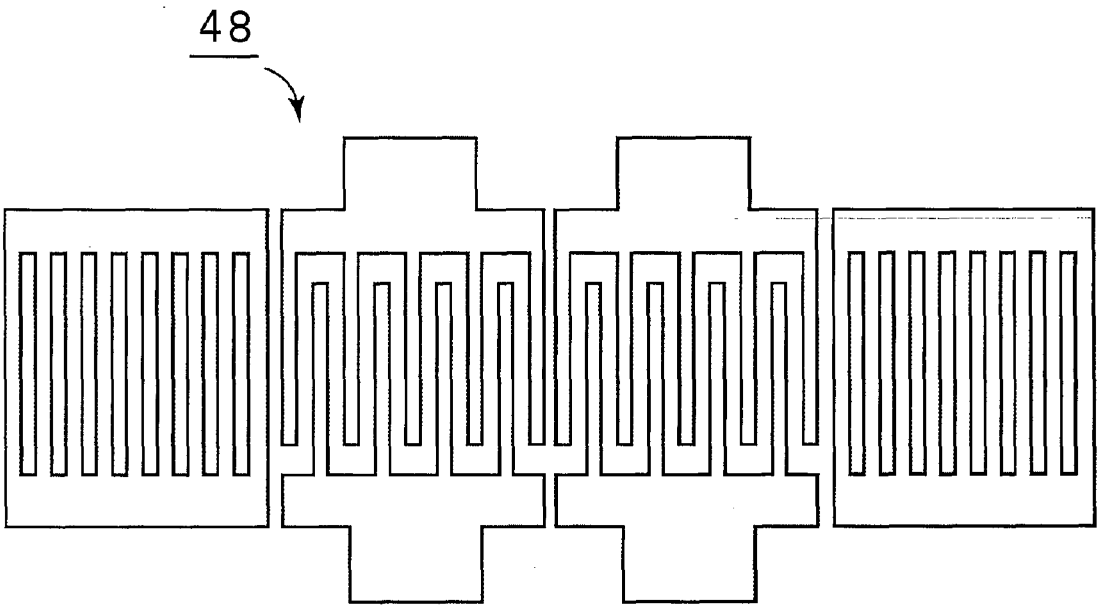

FIG. 107

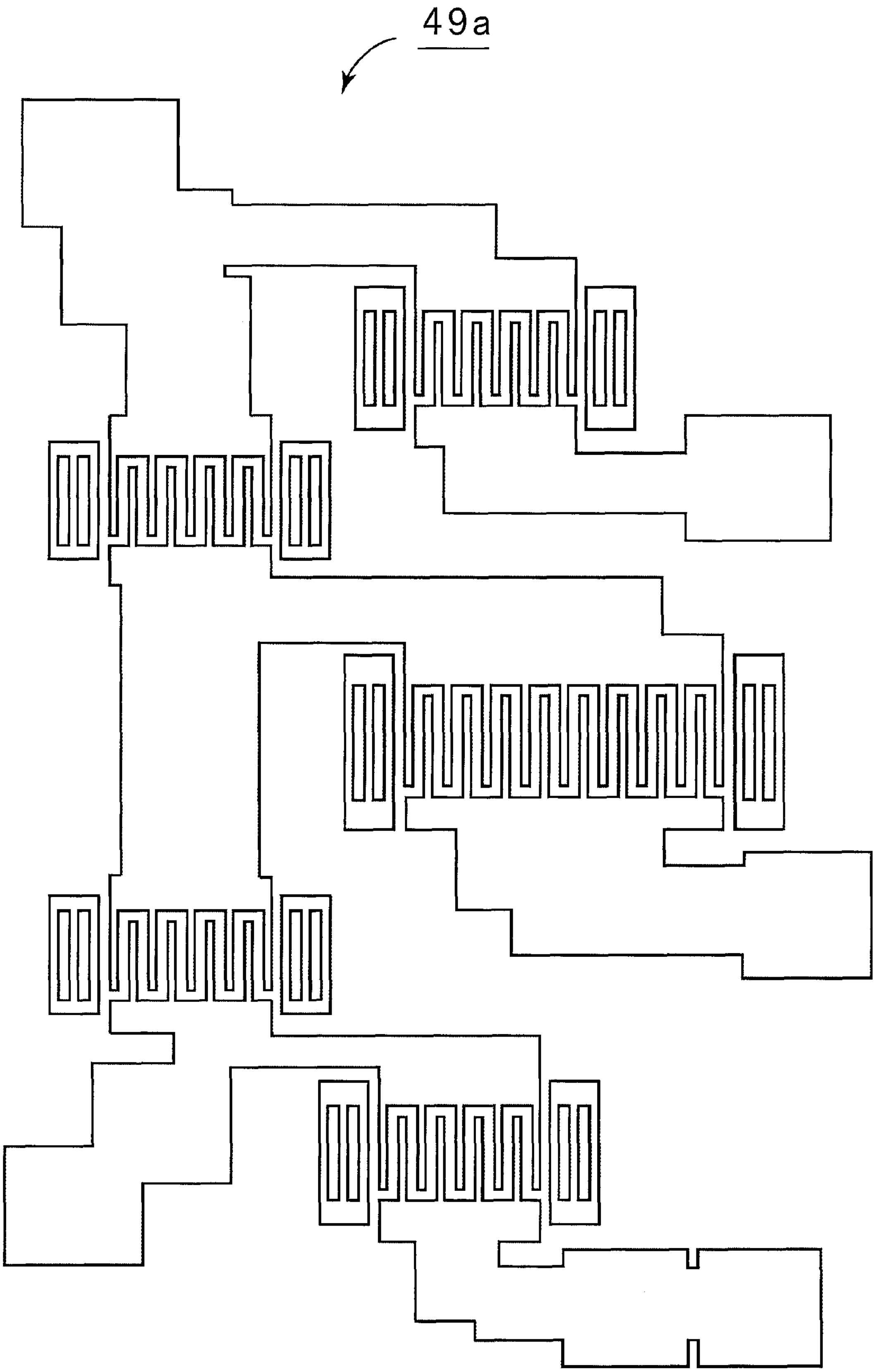

FIG. 108

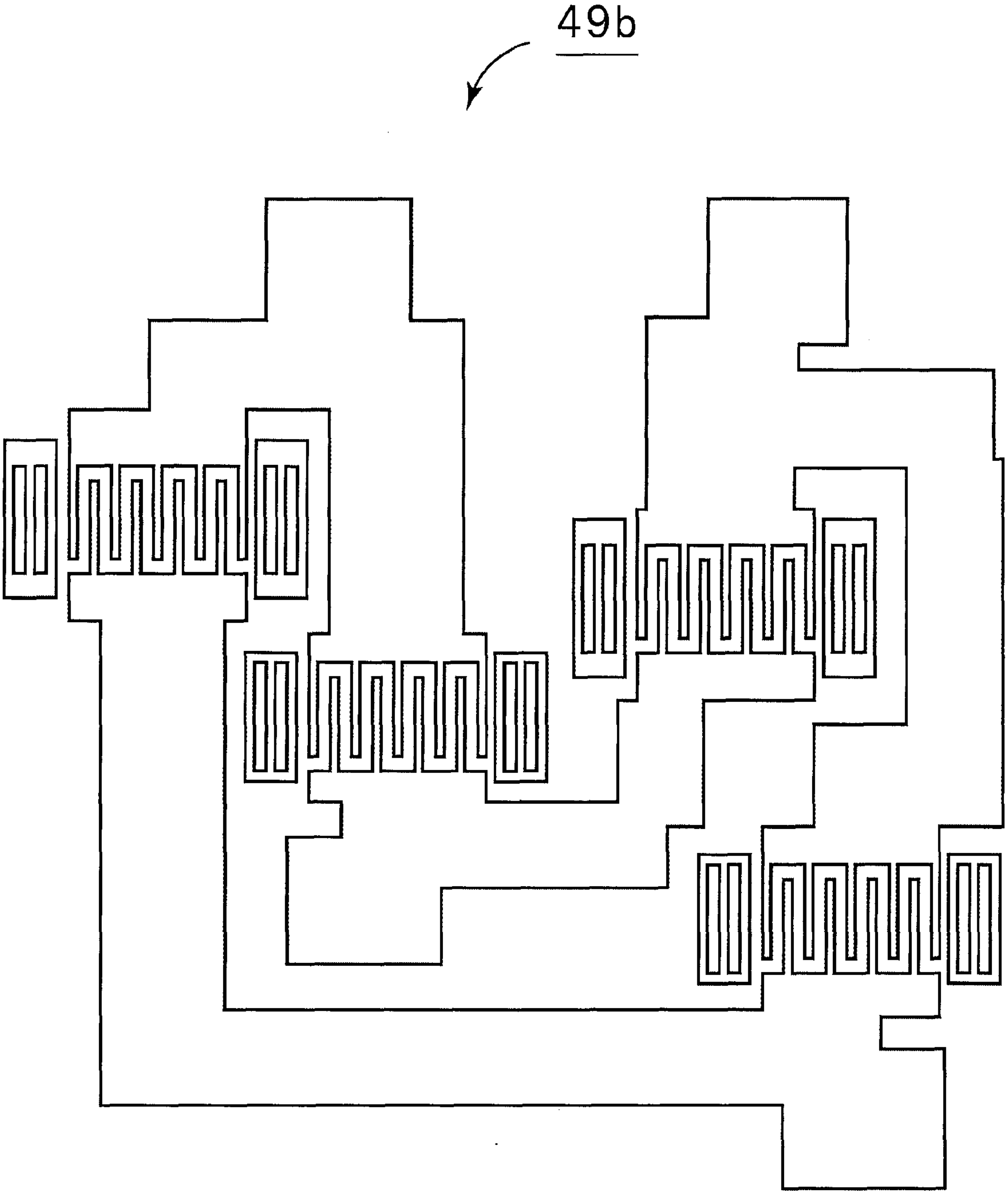

FIG. 109A

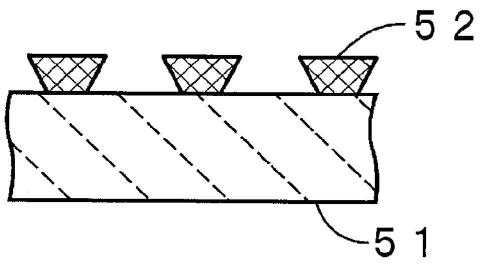


FIG. 109B

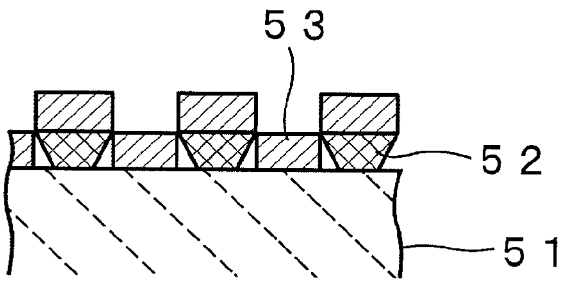


FIG. 109C

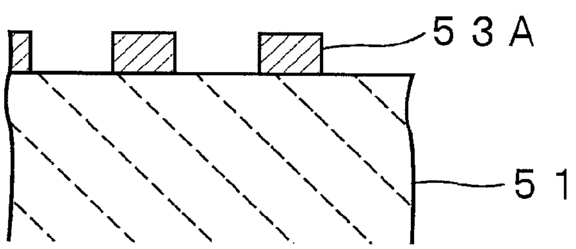


FIG. 109D

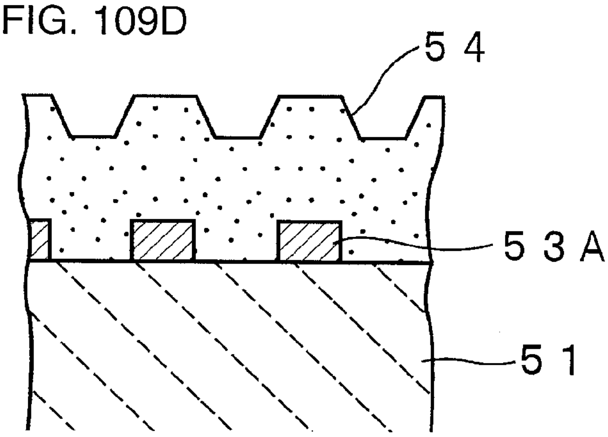

FIG. 110

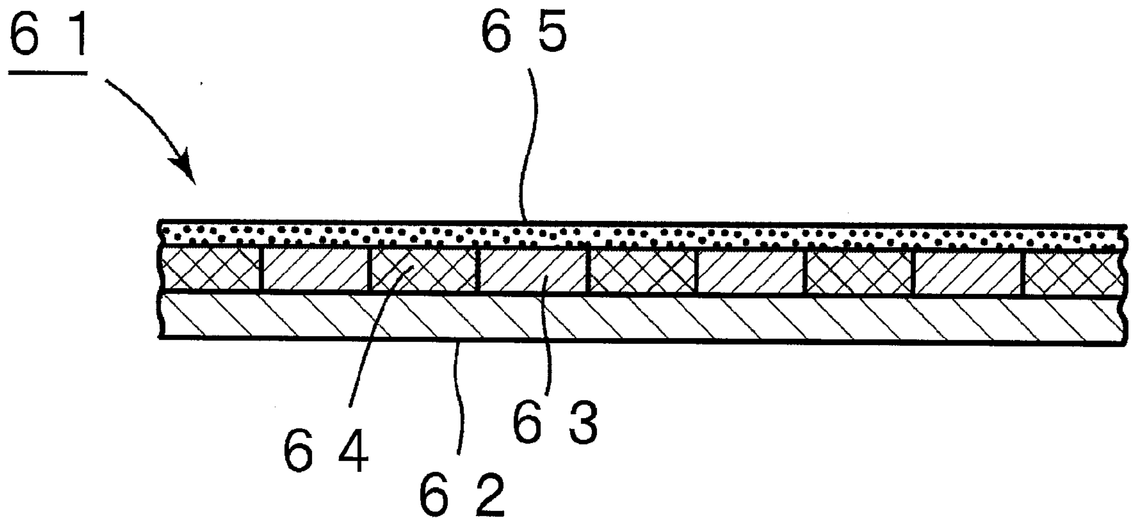

Europäisches Patentamt
European Patent Office
Office européen des brevets

# EUROPEAN SEARCH REPORT

Application Number
EP 10 17 8787

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 5 923 231 A (SATO TAKAHIRO ET AL) 13 July 1999 (1999-07-13) * figures 27A-27D,28,29B * * column 14, lines 14,15,17,18,22-24,37-39,50,59-63 * * column 15, lines 63-67 * * column 17, lines 33-37 * ----- | 1,2 | INV. H03H9/02 |
| A | KOSKELA J ET AL: "SUPPRESSION OF THE LEAKY SAW ATTENUATION WITH HEAVY MECHANICAL LOADING", IEEE TRANSACTIONS ON ULTRASONICS, FERROELECTRICS AND FREQUENCY CONTROL, IEEE INC. NEW.YORK, US, vol. 45, no. 2, 1 March 1998 (1998-03-01), pages 439-449, XP000775482, ISSN: 0885-3010 * abstract * * page 439, left-hand column, lines 36-39 * * page 440, left-hand column, lines 9-15 * ----- | 1,2 | |
| | | | TECHNICAL FIELDS SEARCHED (IPC) |
| A | WO 02/19522 A (SAWTEK INC) 7 March 2002 (2002-03-07) * abstract * * figures 2,8-12 * ----- | 1,2 | H03H |
| A | JP 5 022067 A (OKI ELECTRIC IND CO LTD) 29 January 1993 (1993-01-29) * abstract * ----- | 1,2 | |

The present search report has been drawn up for all claims

4

| Place of search | Date of completion of the search | Examiner |
|---|---|---|
| Munich | 13 January 2011 | Plathner, B |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT ON EUROPEAN PATENT APPLICATION NO.

EP 10 17 8787

This annex lists the patent family members relating to the patent documents cited in the above-mentioned European search report.
The members are as contained in the European Patent Office EDP file on
The European Patent Office is in no way liable for these particulars which are merely given for the purpose of information.

13-01-2011

| Patent document cited in search report | Publication date | Patent family member(s) | Publication date |
|---|---|---|---|
| US 5923231 A | 13-07-1999 | WO 9604713 A1 | 15-02-1996 |
| WO 0219522 A | 07-03-2002 | AU 5944701 A | 13-03-2002 |
| | | CN 1476668 A | 18-02-2004 |
| | | DE 10196571 B4 | 05-07-2007 |
| | | DE 10196571 T0 | 03-07-2003 |
| | | JP 2004507960 T | 11-03-2004 |
| JP 5022067 A | 29-01-1993 | NONE | |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 11186866 A
- JP 61136312 A
- JP 6164306 A


### Non-patent literature cited in the description


- **J. J. Chambell ; W. R. Jones.** IEEE Trans. Sonic & Ultrason, 1968, vol. SU-15, 209